# EUROPEAN PATENT SPECIFICATION

(11) **EP 4 311 849 B1**
(45) Date of publication and mention of the grant of the patent: **29.01.2025**
(21) Application number: 23186504.9
(22) Date of filing: 19.07.2023
(51) Int. Cl.: C09K 11/06, H10K 50/12, H10K 85/30, H10K 85/60, H10K 101/10, H10K 101/00

(54) **METAL COMPLEXES**
METALLKOMPLEXE
COMPLEXES METALLIQUES

(30) Priority: 27.07.2022 EP 22187158; 18.10.2022 EP 22202099; 13.07.2023 US 202318351857
(43) Date of publication of application: 31.01.2024
(73) Proprietor: UDC Ireland Limited, Ballycoolin, Dublin 15 (IE)
(72) Inventor: STOESSEL, Philipp, 64293 Darmstadt (DE); AUCH, Armin, 64293 Darmstadt (DE)
(74) Representative: Maiwald GmbH

(56) References cited:
- WO-A1-2019/158453
- US-A1- 2005 170 206
- US-A1- 2005 170 207
- REITHMEIER R. O. ET AL: "Synthesis and characterization of trinuclear iridium (III) based catalyst for the photocatalytic reduction of CO2", DALTON TRANSACTIONS, vol. 44, no. 14, 9 March 2015 (2015-03-09), Cambridge, pages 6466 - 6472, XP093112694, ISSN: 1477-9226, DOI: 10.1039/C5DT00370A
- GABRIEL ST-PIERRE ET AL: "Fraternal twin iridium hemicage chelates", DALTON TRANSACTIONS, vol. 40, no. 44, 1 January 2011 (2011-01-01), Cambridge, pages 11726, XP055575190, ISSN: 1477-9226, DOI: 10.1039/c1dt11236h

## Description

### FIELD

The present invention relates to iridium complexes suitable for use in organic electroluminescent devices, particularly as emitters.

### BACKGROUND

According to the prior art, in phosphorescent organic electroluminescent devices (OLEDs), mainly bis- and tris-ortho-metalated iridium complexes with aromatic ligands are used as triplet emitters, the ligands having a negatively charged carbon atom and a neutral nitrogen atom. Examples of such complexes are tris(phenylpyridyl) iridium(III) and derivatives thereof. Such complexes are also known with polypodal ligands, as for example described in US 7,332,232, WO 2016/124304 and WO 2019/158453. Even though these complexes with polypodal ligands show advantages over complexes that otherwise have the same ligand structure, whose individual ligands are not polypodally bridged, there is also still need for improvement, for example in terms of efficiency, voltage and lifetime.

It is therefore an object of the present invention to provide improved iridium complexes which are suitable as emitters for use in OLEDs. In particular, it is the object of the present invention to provide green and yellow emitting iridium complexes which have a particularly narrow emission spectrum and are therefore particularly suitable as emitters in top emission OLEDs.

### SUMMARY OF THE INVENTION

The present invention relates to compounds of formula (1)

Ir(L) Formula (1)

wherein the ligand L has a structure of formula (2): 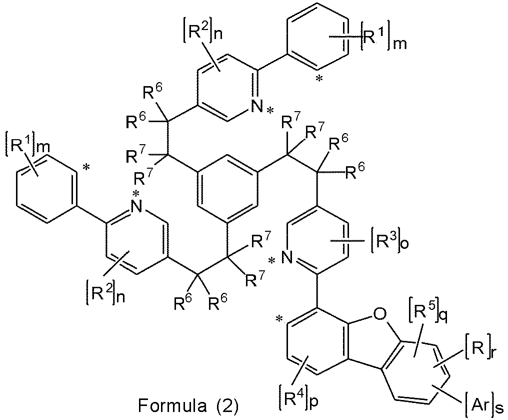
wherein the ligand L coordinates to the iridium atom via the positions marked with * and wherein the hydrogen atoms not explicitly shown may also be partially or completely replaced by deuterium, and wherein the symbols and indices used apply:
   - R: at each occurrence is the same or different and is F or CN;
   - Ar: is a phenyl or biphenyl group which may be unsubstituted or substituted by one or more radicals, each of which are the same or different and are selected from the group consisting of F, CN, Si(CH₃)₃ , a straight-chain alkyl group having 1 to 10 C atoms, a branched alkyl group having 3 to 10 C atoms or a cyclic alkyl group having 4 to 8 C atoms; in this case the phenyl or biphenyl group or the substituents on this phenyl or biphenyl group are optionally partially or completely deuterated;
   - R¹: at each occurrence is the same or different and is F, CN, a straight-chain alkyl group having 1 to 10 C atoms, a branched alkyl group having 3 to 10 C atoms, a cyclic alkyl group having 4 to 8 C atoms, phenyl or biphenyl, wherein R¹ is optionally partially or completely deuterated; and wherein when two adjacent radicals R¹ represent a straight-chain, branched or cyclic alkyl group, the two radicals R¹ may form a ring system with one another;
   - R², R³: at each occurrence is the same or different and is F, a straight-chain alkyl group having 1 to 10 C atoms, a branched alkyl group having 3 to 10 C atoms or a cyclic alkyl group having 4 to 8 C atoms, wherein R² and R³ are optionally partially or completely deuterated; and wherein two adjacent radicals R² or two adjacent radicals R³ may form a ring system with one another;
   - R⁴: at each occurrence is the same or different and is a straight-chain alkyl group having 1 to 10 C atoms, a branched alkyl group having 3 to 10 C atoms, a cyclic alkyl group having 4 to 8 C atoms, phenyl or biphenyl, wherein R⁴ is optionally partially or completely deuterated; wherein when two adjacent radicals R⁴ represent a straight-chain, branched or cyclic alkyl group, the two radicals R⁴ may form a ring system with one another;
   - R⁵: at each occurrence is the same or different and is a straight-chain alkyl group having 1 to 10 C atoms, a branched alkyl group having 3 to 10 C atoms or a cyclic alkyl group having 4 to 8 C atoms; wherein R⁵ is optionally partially or fully deuterated; wherein two adjacent radicals R⁵ may form a ring system with one another;
   - R⁶, R⁷: at each occurrence is the same or different and is H, D, CH₃ or C₂H₅ , wherein the CH₃ group or the C₂H₅ group is optionally partially or completely deuterated;
   - r: is 1 or 2;
   - s: is 0 or 1;
   - m: at each occurrence is the same or different and is 0, 1, 2, 3 or 4;
   - n, o: at each occurrence of is the same or different and is 0, 1, 2, or 3;
   - p: is 0, 1 or 2;
   - q: is 0, 1, 2, or 3; with the proviso that the sum of q + r + s ≤ 4.

### BRIEF DESCRIPTION OF THE DRAWINGS

Figure 1 shows the photoluminescence spectrum (ca. 10⁻⁵ M in degassed toluene) of compound Ir3 according to the invention and the reference emitters Ref-D1, Ref-D2 and Ref-D3.
Figure 2 shows the photoluminescence spectra (ca. 10⁻⁵ M in degassed toluene) of compounds Ir3, Ir178, Ir179 according to the invention and the reference emitter Ref-D3.

### DETAILED DESCRIPTION

Surprisingly, it was found that iridium complexes with a hexadentate tripodal ligand having the structure described below solve this problem and are very well suited for use in an organic electroluminescence device . These iridium complexes and organic electroluminescence devices containing these complexes are therefore the subject of the present invention.

Thus, the subject-matter of the invention is a compound of formula (1),

Ir(L) Formula (1)

wherein the ligand L has a structure represented by the following formula (2): 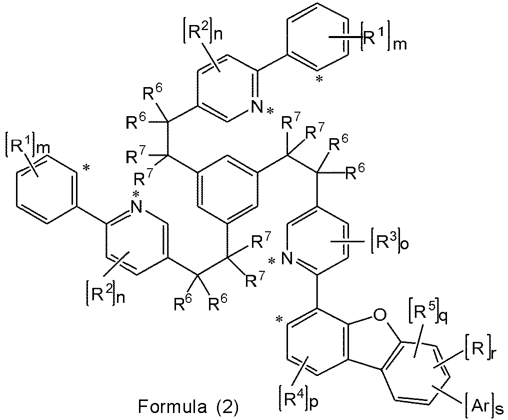
wherein the ligand L coordinates to the iridium atom via the positions marked with * and wherein the hydrogen atoms not explicitly shown may also be partially or completely replaced by deuterium, and wherein the symbols and indices used apply:
   - R: at each occurrence is the same or different and is F or CN;
   - Ar: is a phenyl or biphenyl group which may be unsubstituted or substituted by one or more radicals each of which are the same or different and are selected from the group consisting of F, CN, Si(CH₃)₃ , a straight-chain alkyl group having 1 to 10 C atoms, a branched alkyl group having 3 to 10 C atoms or a cyclic alkyl group having 4 to 8 C atoms; the phenyl or biphenyl group or the substituents on this phenyl or biphenyl group are optionally partially or completely deuterated;
   - R¹: at each occurrence is the same or different and is F, CN, a straight-chain alkyl group having 1 to 10 C atoms, a branched alkyl group having 3 to 10 C atoms, a cyclic alkyl group having 4 to 8 C atoms, phenyl or biphenyl, wherein R¹ is optionally partially or completely deuterated; and wherein when two adjacent radicals R¹ represent a straight-chain, branched or cyclic alkyl group, the two radicals R¹ may form a ring system with one another;
   - R², R³: at each occurrence is the same or different and is F, a straight-chain alkyl group having 1 to 10 C atoms, a branched alkyl group having 3 to 10 C atoms or a cyclic alkyl group having 4 to 8 C atoms; wherein R² and R³ are optionally partially or completely deuterated; and wherein two adjacent radicals R² or two adjacent radicals R³ may form a ring system with one another;
   - R⁴: at each occurrence is the same or different and is a straight-chain alkyl group having 1 to 10 C atoms, a branched alkyl group having 3 to 10 C atoms, a cyclic alkyl group having 4 to 8 C atoms, phenyl or biphenyl; wherein R⁴ is optionally partially or completely deuterated; wherein when two adjacent radicals R⁴ represent a straight-chain, branched or cyclic alkyl group, the two radicals R⁴ may form a ring system with one another;
   - R⁵: at each occurrence is the same or different and is a straight-chain alkyl group having 1 to 10 C atoms, a branched alkyl group having 3 to 10 C atoms or a cyclic alkyl group having 4 to 8 C atoms; wherein R⁵ is optionally partially or completely deuterated; wherein two adjacent radicals R⁵ may form a ring system with one another;
   - R⁶, R⁷: at each occurrence of is the same or different and is H, D, CH₃ or C₂H₅, wherein the CH₃ group or the C₂H₅ group is optionally partially or completely deuterated;
   - r: is 1 or 2;
   - s: is 0 or 1;
   - m: at each occurrence is the same or different and is 0, 1, 2, 3 or 4;
   - n, o: at each occurrence is the same or different and is 0, 1, 2, or 3;
   - p: is 0, 1 or 2;
   - q: is 0, 1, 2, or 3; with the proviso that the sum of q + r + s ≤ 4.

The ligand L of formula (2) is thus a hexadentate, tripodal ligand with two bidentate phenylpyridine partial ligands and one bidentate dibenzofuranyl-pyridine partial ligand. The complex Ir(L) of formula (1) formed with this ligand thus has the following structure: 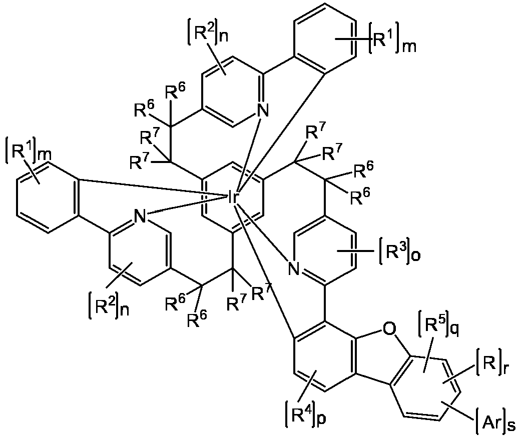 wherein the symbols and indices have the meanings given above and the hydrogen atoms not shown may also be partially or completely replaced by deuterium.

In this case, the coordinating dibenzofuran group has, as a mandatory feature on the non-coordinating phenyl ring, at least one group R representing fluorine and/or cyano.

If two radicals R¹ or two radicals R² or two radicals R³ or two radicals R⁴ or two radicals R⁵ form a ring system with one another, this can be monocyclic or polycyclic. In this case, the radicals that form a ring system with one other are adjacent, i.e., these radicals bond to carbon atoms that are directly bonded to one another. By the formulation that two radicals can form a ring with each other, it is to be understood in the context of the present description that the two radicals are linked to each other by a chemical bond with formal cleavage of two hydrogen atoms. This is illustrated by the following scheme:

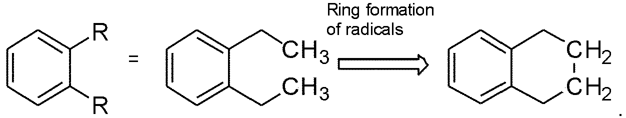

In a preferred embodiment of the invention, the radicals R¹ or R² or R³ or R⁴ or R⁵ do not form a ring system with each other.

A cyclic alkyl group within the meaning of the present invention is understood to be a monocyclic, a bicyclic or a polycyclic group .

In the context of the present invention, a C₁- to C₁₀-alkyl group includes, for example, the radicals methyl, ethyl, n-propyl, i-Propyl, cyclopropyl, n-butyl, i-butyl, s-butyl, t-butyl, cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neohexyl, cyclohexyl, 1-methyl cyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]octyl, 2-(2,6-dimethyl)octyl, 3-(3,7-dimethyl)octyl, Adamantyl, 1,1-dimethyl-n-hex-1-yl, 1,1-dimethyl-n-hept-1-yl, 1,1-dimethyl-n-oct-1-yl, 1,1-diethyl-n-hex-1-yl, 1-(n-propyl)-cyclohex-1-yl and 1-(n-butyl)-cyclohex-1-yl. These can also each be partially or fully permanently deuterated.

If the indices m, n, o, p, q or s = 0, a hydrogen atom or a deuterium atom is bonded instead of the substituents.

In a preferred embodiment of the invention, r = 1, and the ligand has a structure of the following formula (3), (4), (5), or (6), 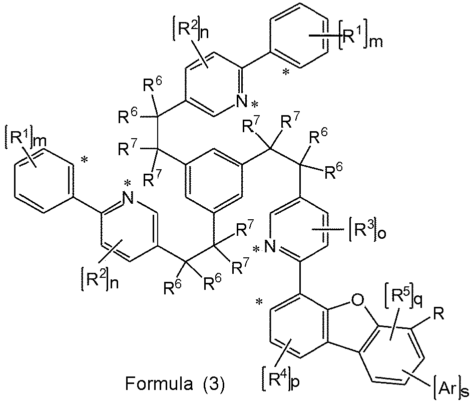 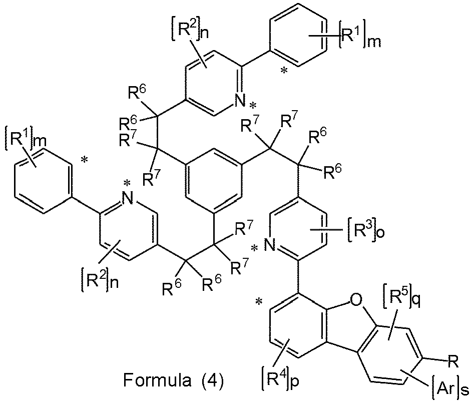 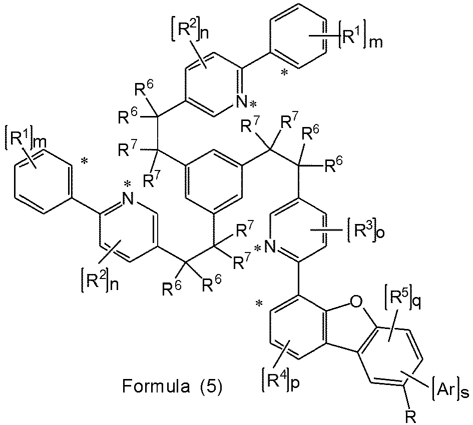 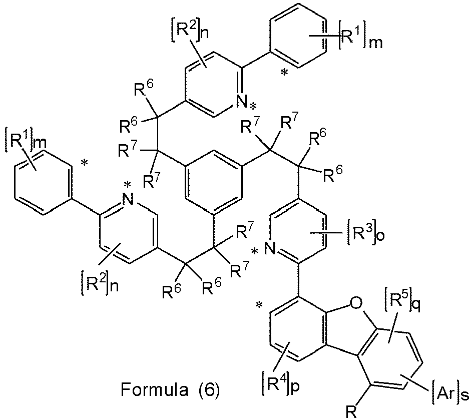 wherein the symbols and indices used have the meanings given above and the hydrogen atoms which are not explicitly shown may also be partially or completely replaced by deuterium. In this context, each occurrence of R⁶ is preferably the same or different and represents H, D or CH₃, which may also be partially or completely deuterated, and each occurrence of R⁷ is preferably the same or different and represents H or D. In this context, the ligand of the formula (4) is preferred .

When r = 2, it is preferred that one residue R represents CN, and the other residue R represents F.

It is preferred that when R = CN, s = 0, i.e., the ligand does not have a group Ar. Further, it is preferred when R = F that s = 1, i.e., that the ligand has a group Ar. Furthermore, it is preferred when R = F that s = 0 and q = 1, wherein R⁵ represents a cyclopentyl or cyclohexyl group, which is optionally partially or fully deuterated.

When s = 1, the ligand preferably has a structure according to one of the following formulae (7), (8), (9) or (10), 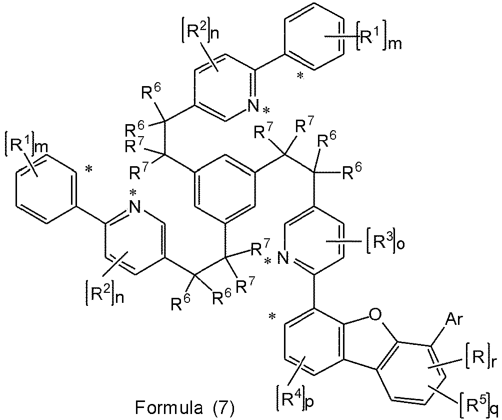 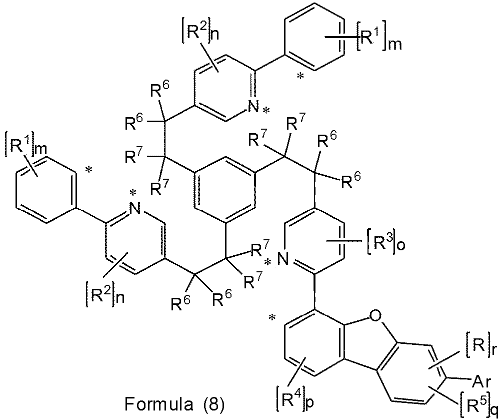 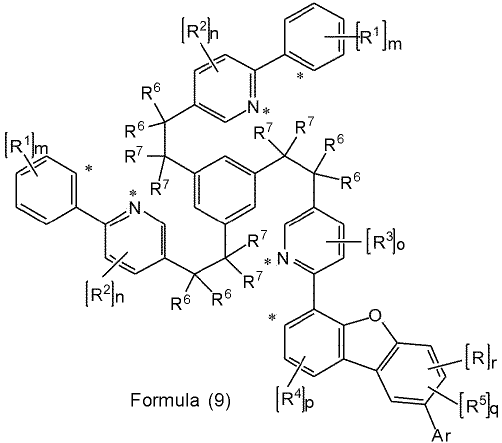 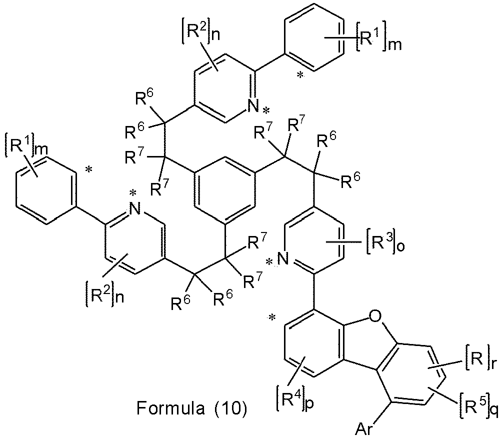 wherein the symbols and indices used have the meanings given above and the hydrogen atoms which are not explicitly shown may also be partially or completely replaced by deuterium. In these formulae, R preferably represents F. Each occurrence of R⁶ is preferably the same or different and represents H, D or CH₃, which may also be partially or completely deuterated, and each occurrence of R⁷ is preferably the same or different and represents H or D. Preferred is the ligand of the formula (7).

In a particularly preferred embodiment, r = 1, R = CN and s = 0 and the ligand L represents a structure of the following formula (11a), or r = 1, R = F and s = 1 and the ligand L represents a structure of the following formula (11b), or r = 1, R = F or CN, s = 0 and q = 1 and the ligand L represents a structure of the following formula (11c), 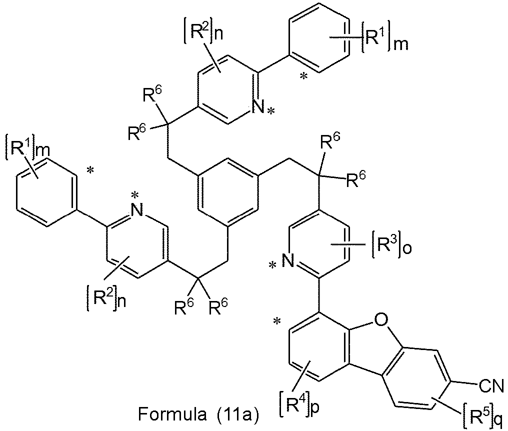 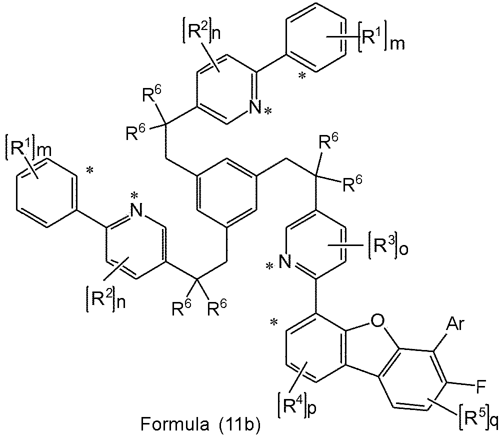 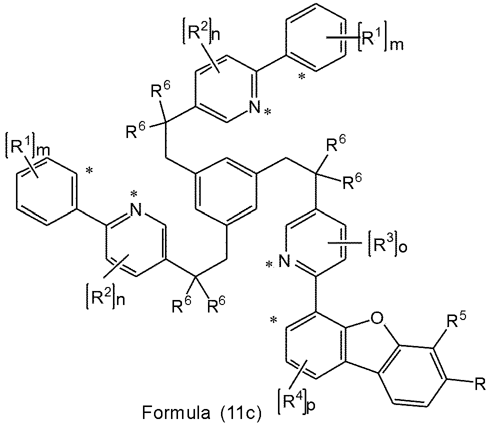 wherein the symbols and indices used have the meanings given above, the hydrogen atoms which are not explicitly shown may also be partially or completely replaced by deuterium, R⁶ is H, D, CH₃ or CD₃ and R⁵ in formula (11c) preferably represents a cyclopentyl or cyclohexyl group which is optionally partially or completely deuterated, deuteration at the C atom with which this group bonds to the dibenzofuran, i.e. at the tertiary C atom, being particularly preferred.

In another preferred embodiment of the present invention, a deuterium is bound in all ortho-positions to R in which Ar or R⁵ is not bound. Preferred embodiments of formulae (11a), (11b) and (11c) for q = 0 are thus the following formulae (11a-1), (11b-1) and (11c-1), respectively, 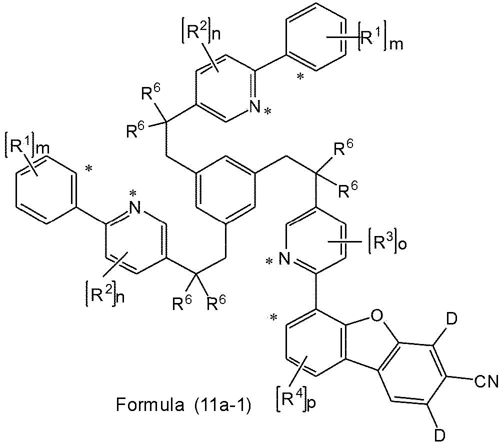 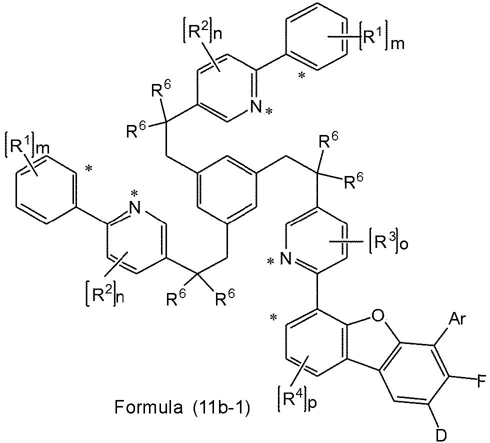 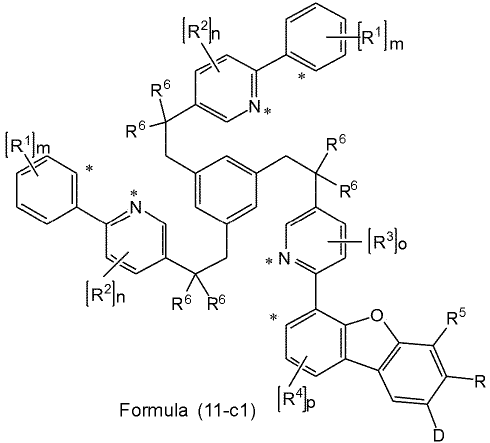 wherein the symbols and indices used have the abovementioned meanings, the hydrogen atoms which are not explicitly shown may also be partially or completely replaced by deuterium, each occurrence of R⁶ is identical or different and is H, D, CH₃ or CDs, and R⁵ in formula (11c-1) is preferably a cyclopentyl or cyclohexyl group which is optionally partially or completely deuterated, where in particular deuteration at the C atom with which this group bonds to the dibenzofuran is preferred.

Preferred embodiments of the bridgehead, i.e., the triethylenebenzene group, are the following structures (A) to (I): 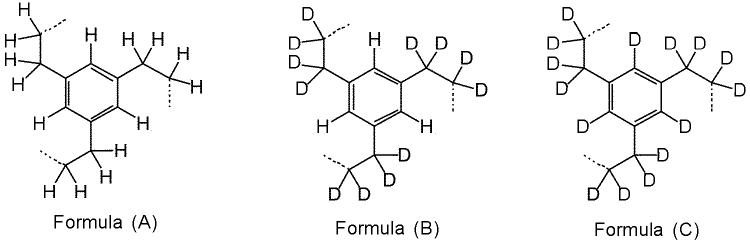 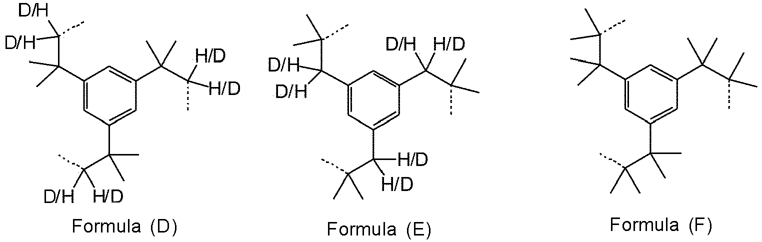 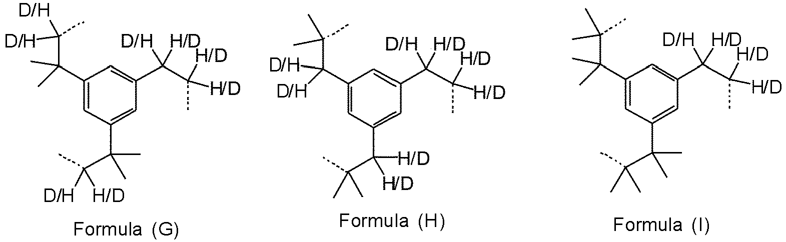 wherein the dashed bond represents the bond to the two phenylpyridine partial ligands and to the dibenzofuranpyridine partial ligand, respectively. Here, H/D in formulas (D) to (I) is the same or different for hydrogen or deuterium, and the methyl groups and/or the benzene group in these formulas may be partially or fully deuterated. In formulae (G), (H) and (I), the ethylene group which is not substituted by methyl groups is attached to the pyridine-dibenzofuran partial ligand, and the two ethylene groups, each substituted by two or four methyl groups, are attached to the two phenylpyridine partial ligands. Preferred embodiments are the groups of formula (B), (E) and (H).

Preferred embodiments of substituents Ar and R¹ to R⁷ are elaborated below.

Ar is preferably a phenyl group which is optionally partially or fully deuterated and which is otherwise unsubstituted or substituted by a methyl group which is optionally partially or fully deuterated.

Particularly preferred groups Ar are selected from the groups of the following formulae (Ar-1) to (Ar-4), 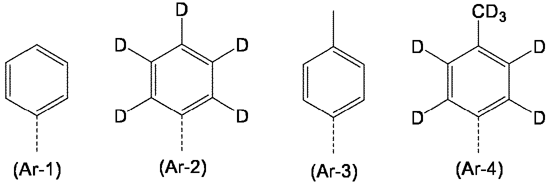 wherein the dashed bond represents binding to the dibenzofuran group of the ligand.

In another preferred embodiment of the invention, each occurrence of R¹ is the same or different and is selected from the group consisting of CN, a straight chain alkyl group having 1 to 4 C atoms, a branched alkyl group having 3 to 5 C atoms, a cyclic alkyl group having 5 or 6 C atoms, or a phenyl group, each of which groups are optionally partially or fully deuterated. In a particularly preferred embodiment of the invention, each occurrence of R¹ is the same or different and is selected from the group consisting of methyl, iso-propyl, tert-butyl, neo-pentyl, phenyl, cyclopentyl or cyclohexyl, wherein these groups in each case are optionally partially or completely deuterated. It is particularly preferred if the benzylic positions, i.e., the positions that bind directly to the phenyl ring, are deuterated.

In this case, each occurrence of the index m is preferably the same or different and is 0, 1, 2 or 3, particularly preferably 0, 1 or 2 and most preferably 0 or 1.

In a further embodiment of the invention, each occurrence of R² and R³ is the same or different and is selected from the group consisting of a straight-chain alkyl group having 1 to 4 C atoms, a branched alkyl group having 3 to 5 C atoms, or a cyclic alkyl group having 5 or 6 C atoms, each of which groups are optionally partially or fully deuterated. In a particularly preferred embodiment of the invention, each occurrence of R² and R³ is the same or different and is selected from the group consisting of methyl, iso-propyl, tert-butyl, neo-pentyl, cyclopentyl or cyclohexyl, wherein these groups are optionally partially or completely deuterated. It is particularly preferred if the benzylic positions, i.e., the positions that bind directly to the pyridine ring, are deuterated.

Thereby each occurrence of the indices n and o is preferably the same or different and is 0, 1 or 2, especially preferably 0 or 1.

In another preferred embodiment of the invention, each occurrence of R⁴ is the same or different selected from the group consisting of a straight chain alkyl group having 1 to 4 C atoms, a branched alkyl group having 3 to 5 C atoms, a cyclic alkyl group having 5 or 6 C atoms, or phenyl, each of which groups are optionally partially or fully deuterated. In a particularly preferred embodiment of the invention, each occurrence of R⁴ is the same or different and is selected from the group consisting of methyl, iso-propyl, tert-butyl, neo-pentyl or phenyl, wherein these groups are optionally partially or completely deuterated. It is particularly preferred if the benzylic positions, i.e., the positions that bind directly to the dibenzofuran, are deuterated.

In another preferred embodiment of the invention, each occurrence of R⁵ is the same or different and is selected from the group consisting of a straight chain alkyl group having 1 to 4 C atoms, a branched alkyl group having 3 to 5 C atoms, or a cyclic alkyl group having 5 or 6 C atoms, which groups are optionally partially or fully deuterated. In a particularly preferred embodiment of the invention, each occurrence of R⁵ is the same or different and is selected from the group consisting of methyl, iso-propyl, tert-butyl, neo-pentyl, cyclopentyl or cyclohexyl, wherein these groups may optionally be partially or completely deuterated. It is particularly preferred if the benzylic positions, i.e., the positions that bind directly to the dibenzofuran, are deuterated.

In another preferred embodiment of the invention, each occurrence of R⁶ is the same or different and is H, D, CH₃ or CDs .

In another preferred embodiment of the invention, each occurrence of R⁷ is the same or different and is H or D, in particular D.

The index p is preferably 0 or 1 and particularly preferably 0. The index q is preferably 0 or 1 and particularly preferably 0.

In another preferred embodiment of the invention, the two phenylpyridine partial ligands are identical, i.e. the substituents R¹ on the two partial ligands are the same, the substituents R² on the two partial ligands are the same, the indices m are the same and the indices n are the same, and when substituents R¹ and/or R² are present, they are each attached to the two phenylpyridine partial ligands at the same position.

Furthermore, it is preferred if the above-mentioned preferred embodiments occur simultaneously. Thus, ligands of the formulae (2) to (11), (11a), (11b), (11c), (11a-1), (11b-1) and (11c-1), for which applies, are preferred:
- Ar: is a phenyl group which is optionally partially or fully deuterated and which is optionally substituted by a methyl group which is partially or fully deuterated;
- R¹: at each occurrence is the same or different and is selected from the group consisting of CN, a straight chain alkyl group having 1 to 4 C atoms, a branched alkyl group having 3 to 5 C atoms, a cyclic alkyl group having 5 or 6 C atoms, or a phenyl group, each of which groups are optionally partially or fully deuterated;
- R², R³: at each occurrence is the same or different and is selected from the group consisting of a straight chain alkyl group having 1 to 4 C atoms, a branched alkyl group having 3 to 5 C atoms, or a cyclic alkyl group having 5 or 6 C atoms, each of which groups are optionally partially or fully deuterated;
- R⁴: at each occurrence is the same or different and is selected from the group consisting of a straight chain alkyl group having 1 to 4 C atoms, a branched alkyl group having 3 to 5 C atoms, a cyclic alkyl group having 5 or 6 C atoms, or phenyl, each of which groups are optionally partially or fully deuterated;
- R⁵: at each occurrence is the same or different and is selected from the group consisting of a straight chain alkyl group having 1 to 4 C atoms, a branched alkyl group having 3 to 5 C atoms, or a cyclic alkyl group having 5 or 6 C atoms, each of which groups are optionally partially or fully deuterated;
- R⁶: at each occurrence is the same or different and is H, D, or CH₃ , which are optionally partially or completely deuterated;
- R⁷: at each occurrence is the same or different and is H or D;
- m: at each occurrence is the same or different and is 0, 1, 2 or 3;
- n, o: at each occurrence is the same or different and is 0, 1 or 2;
- p: is 0 or 1;
- q: is 0 or 1;
- s: is 0 for R = CN and is 1 for R = F.

Particularly preferred are ligands of the formulae (2) to (11), (11a), (11b), (11c), (11a-1), (11b-1) and (11c-1), for which holds:
- Ar: is selected from the groups of the following formulas (Ar-1) to (Ar-4), as described above;
- R¹: at each occurrence is the same or different and is selected from the group consisting of methyl, iso-propyl, tert-butyl, neo-pentyl, cyclopentyl, cyclohexyl or phenyl, each of which groups are optionally partially or fully deuterated;
- R², R³: at each occurrence is the same or different and is selected from the group consisting of methyl, iso-propyl, tert-butyl, neo-pentyl, cyclopentyl or cyclohexyl, each of which groups are optionally partially or fully deuterated;
- R⁴: at each occurrence is the same or different and is selected from the group consisting of a straight chain alkyl group having 1 to 4 C atoms, a branched alkyl group having 3 to 5 C atoms, a cyclic alkyl group having 5 or 6 C atoms, or phenyl, each of which groups are optionally partially or fully deuterated;
- R⁵: at each occurrence is the same or different and is selected from the group consisting of a straight chain alkyl group having 1 to 4 C atoms, a branched alkyl group having 3 to 5 C atoms, or a cyclic alkyl group having 5 or 6 C atoms, each of which groups are optionally partially or fully deuterated;
- R⁶: at each occurrence is the same or different and is H, D, CH₃ or CDs ;
- R⁷: at each occurrence is the same or different and is H or D;
- m: at each occurrence is the same or different and is 0, 1 or 2, more preferably 0 or 1;
- n, o: at each occurrence is the same or different and is 0 or 1;
- p, q: is 0;
- s: is 0 for R = CN and is 1 for R = F.

The above-mentioned preferred embodiments can be combined with each other as desired. In a particularly preferred embodiment of the invention, the above preferred embodiments apply simultaneously.

Examples of suitable structures according to the invention are the compounds illustrated below.

| | |
|---|---|
| 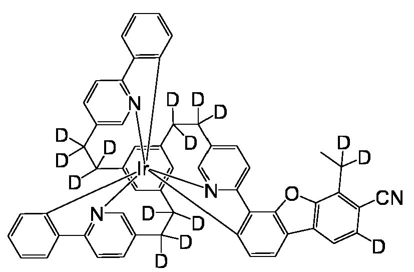 | 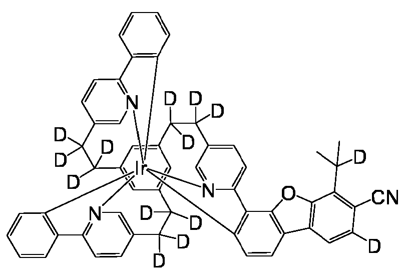 |
| 1 | 2 |
| 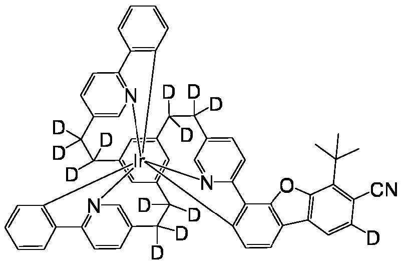 | 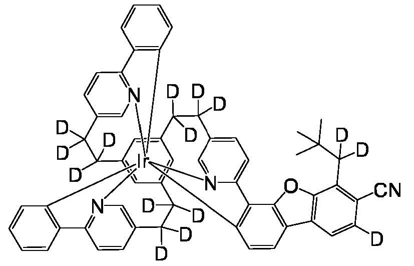 |
| 3 | 4 |
| 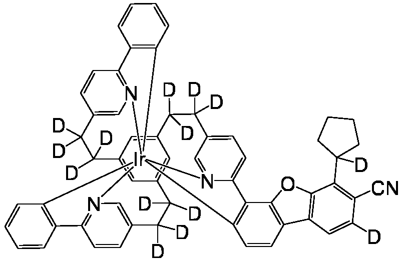 | 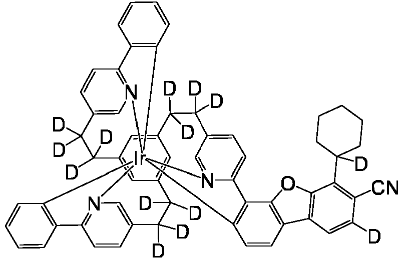 |
| 5 | 6 |
| 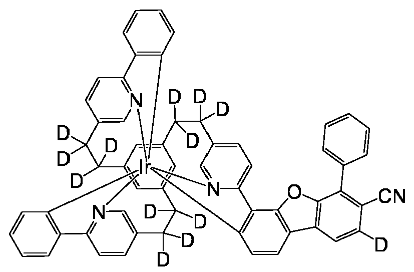 | 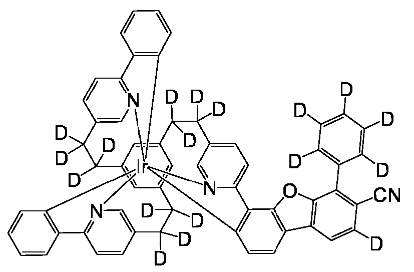 |
| 7 | 8 |
| 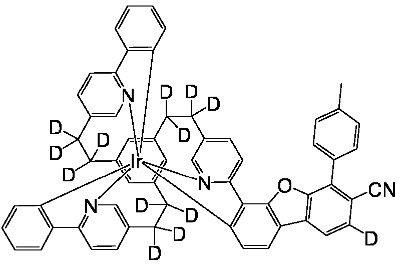 | 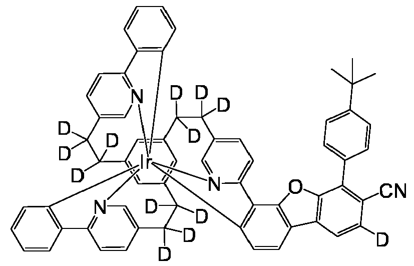 |
| 9 | 10 |
| 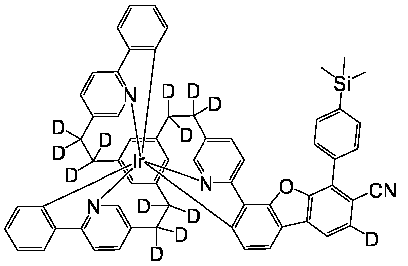 | 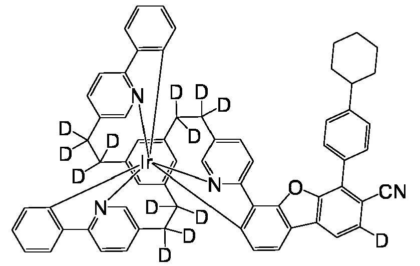 |
| 11 | 12 |
| 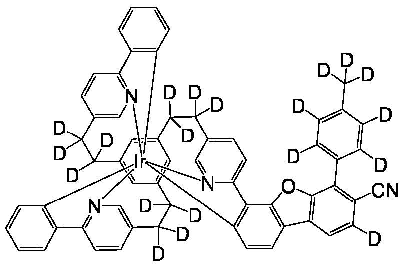 | 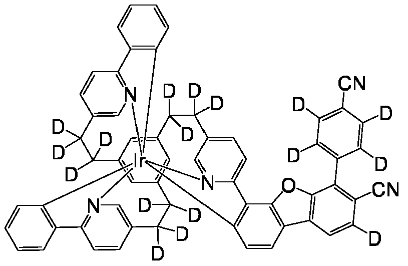 |
| 13 | 14 |
| 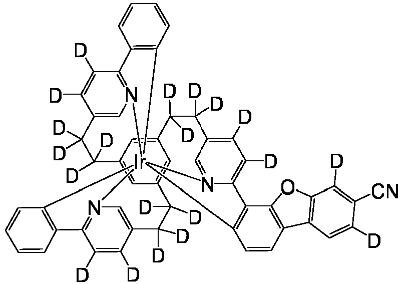 | 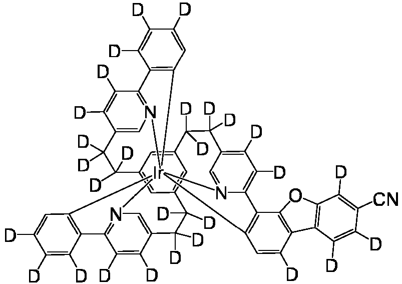 |
| 15 | 16 |
| 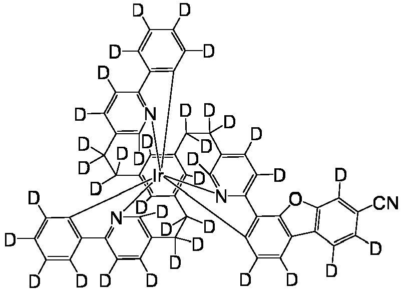 | 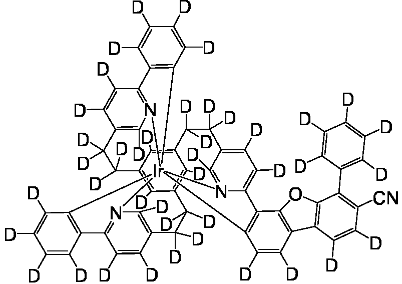 |
| 17 | 18 |
| 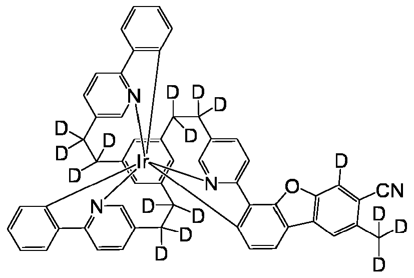 | 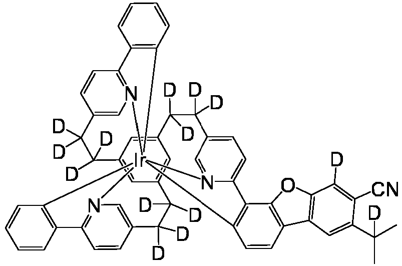 |
| 19 | 20 |
| 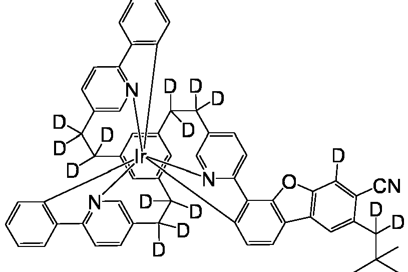 | 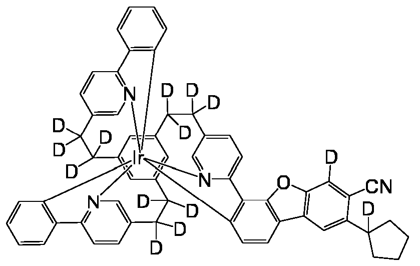 |
| 21 | 22 |
| 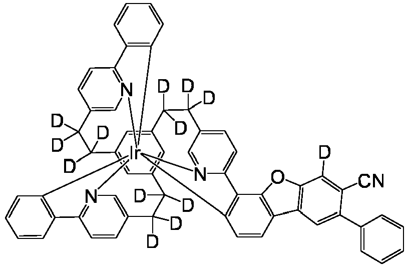 | 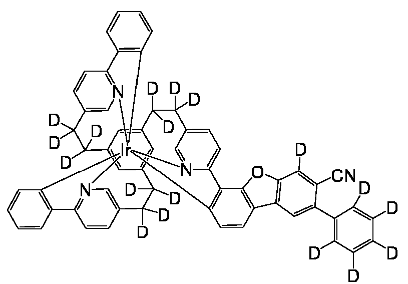 |
| 23 | 24 |
| 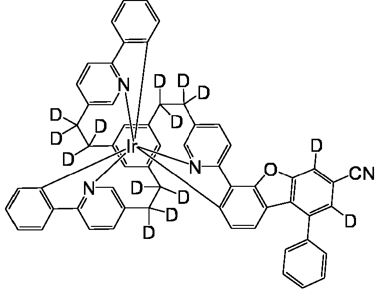 | 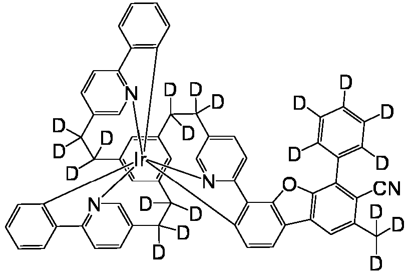 |
| 25 | 26 |
| 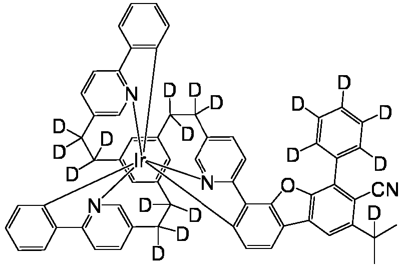 | 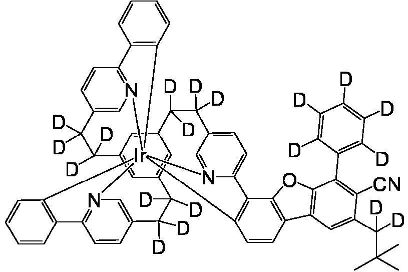 |
| 27 | 28 |
| 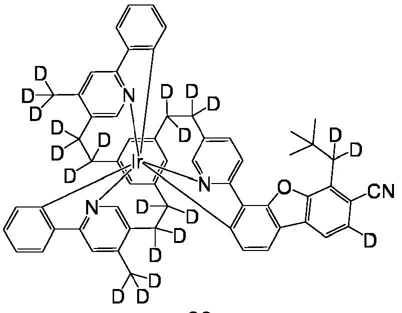 | 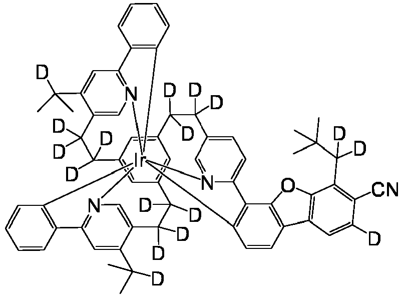 |
| 29 | 30 |
| 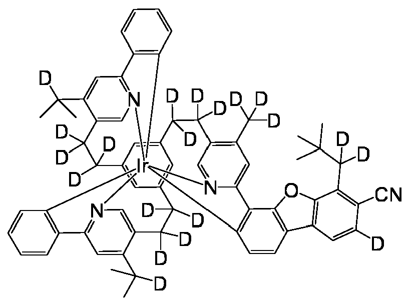 | 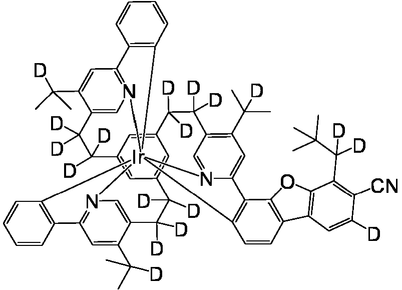 |
| 31 | 32 |
| 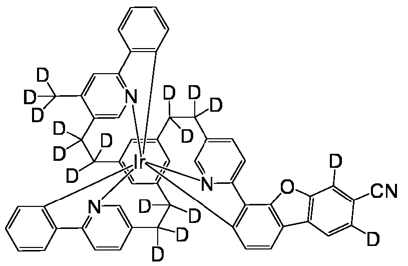 | 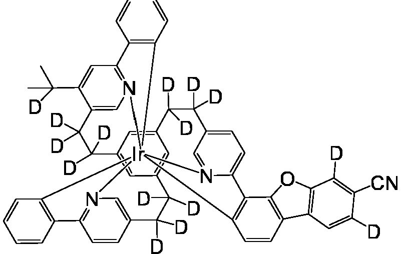 |
| 33 | 34 |
| 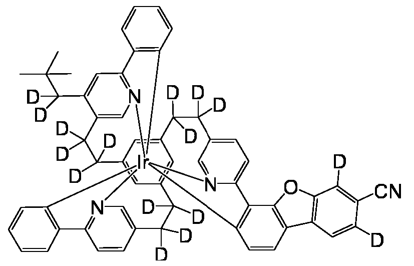 | 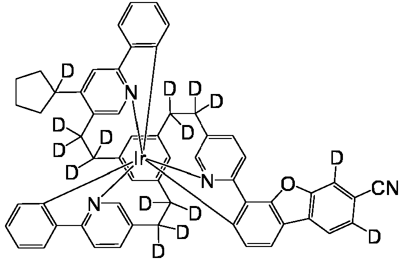 |
| 35 | 36 |
| 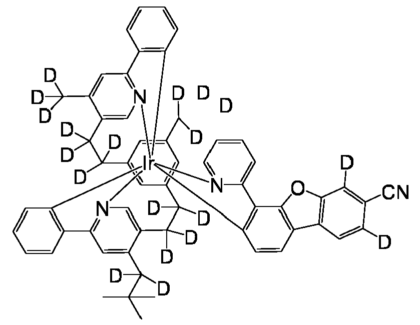 | 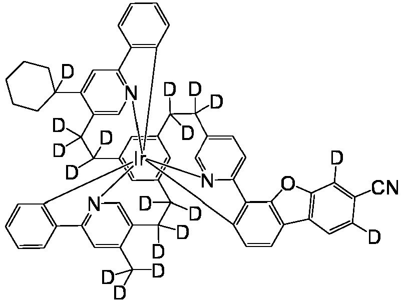 |
| 37 | 38 |
| 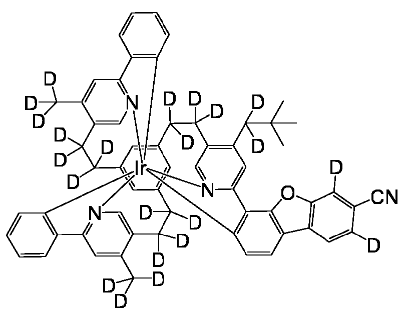 | 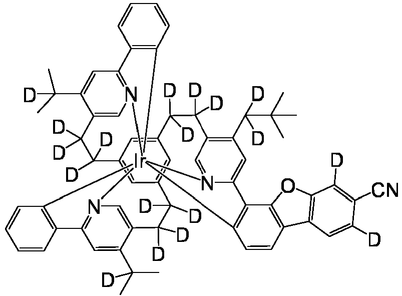 |
| 39 | 40 |
| 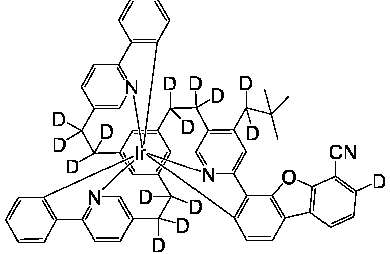 | 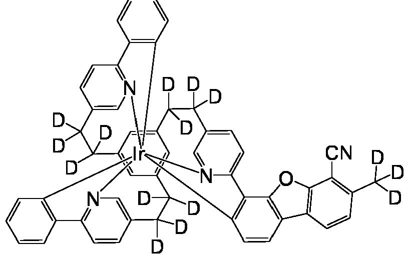 |
| 41 | 42 |
| 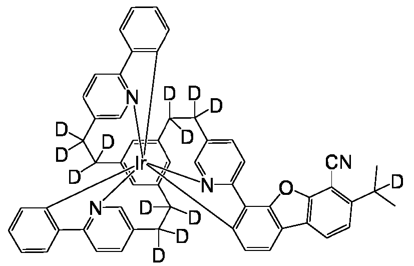 | 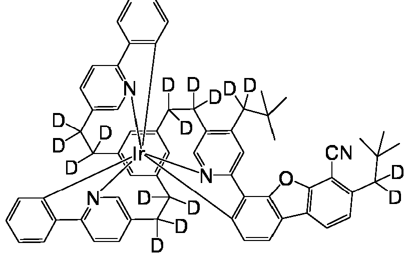 |
| 43 | 44 |
| 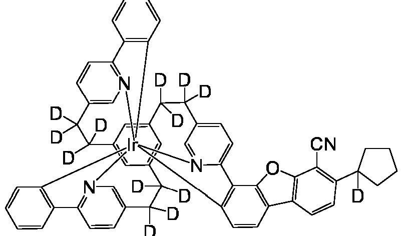 | 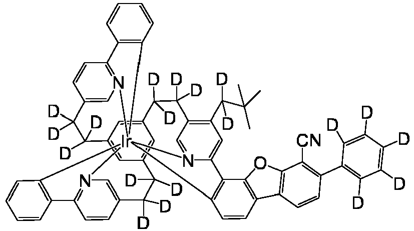 |
| 45 | 46 |
| 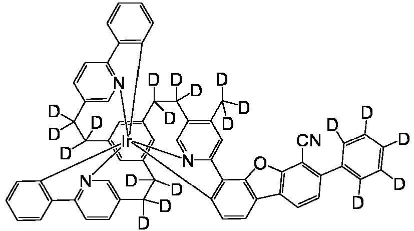 | 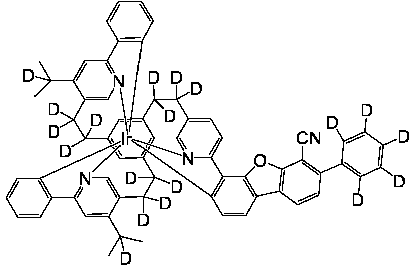 |
| 47 | 48 |
| 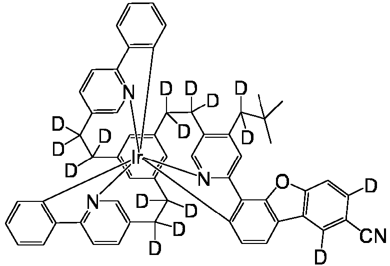 | 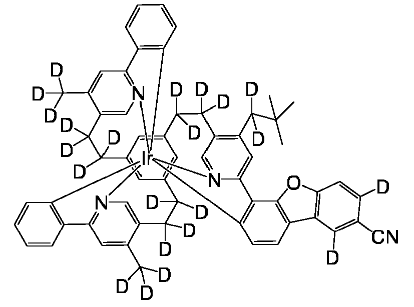 |
| 49 | 50 |
| 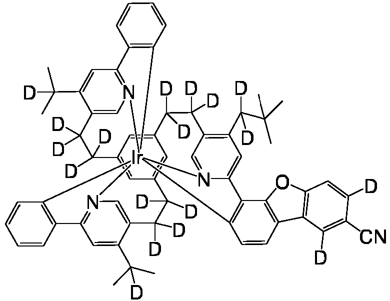 | 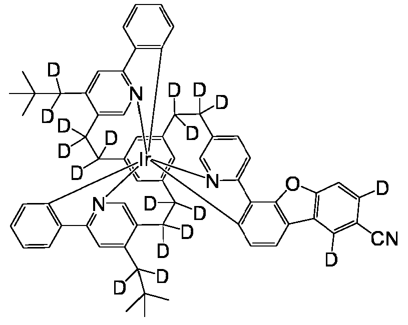 |
| 51 | 52 |
| 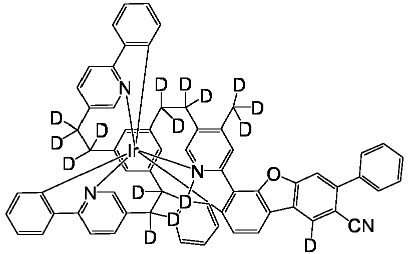 | 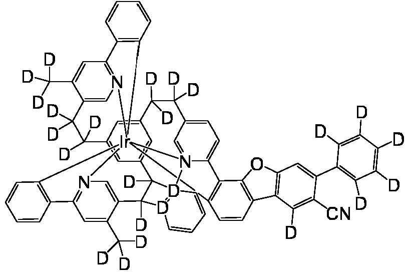 |
| 53 | 54 |
| 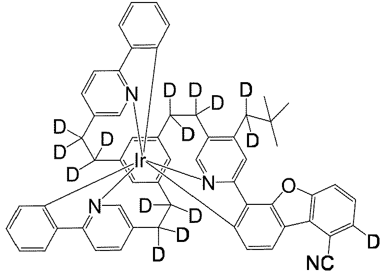 | 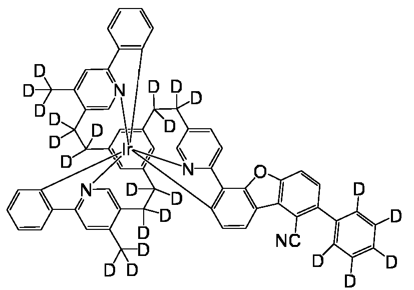 |
| 55 | 56 |
| 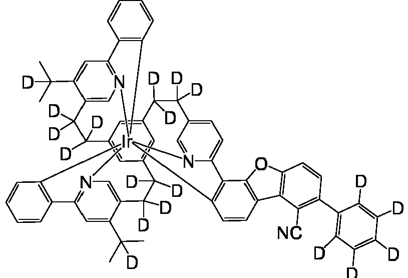 | 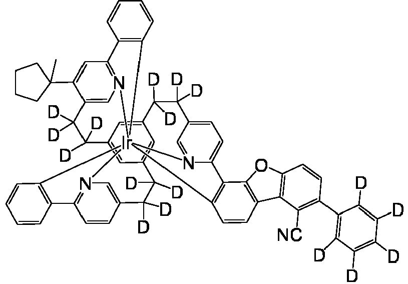 |
| 57 | 58 |
| 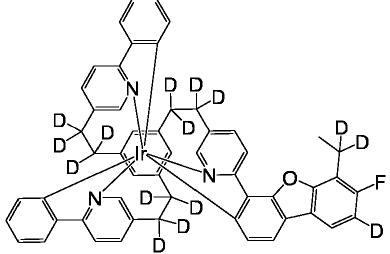 | 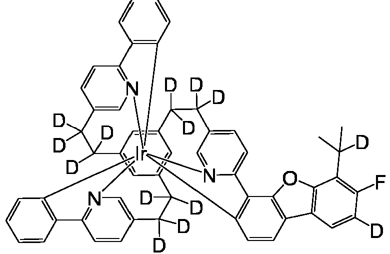 |
| 59 | 60 |
| 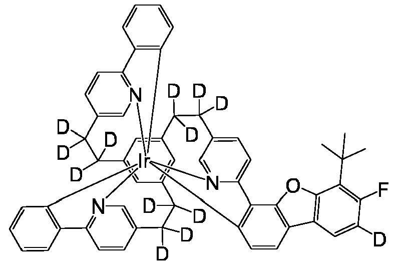 | 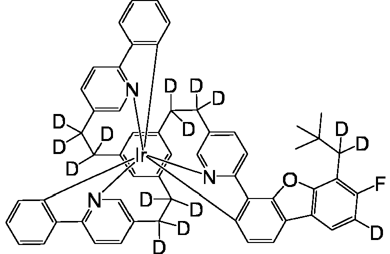 |
| 61 | 62 |
| 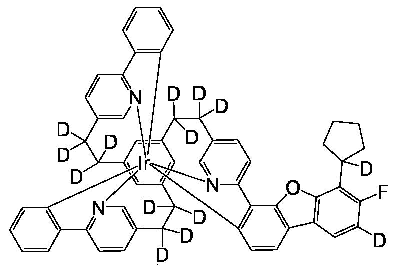 | 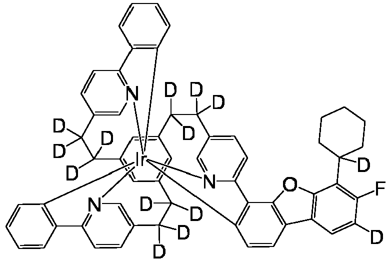 |
| 63 | 64 |
| 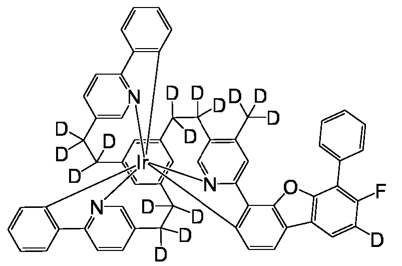 | 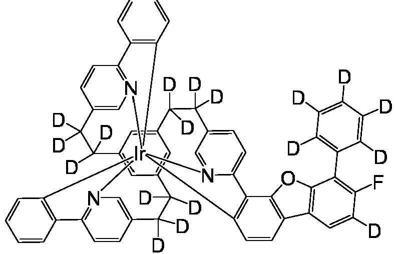 |
| 65 | 66 |
| 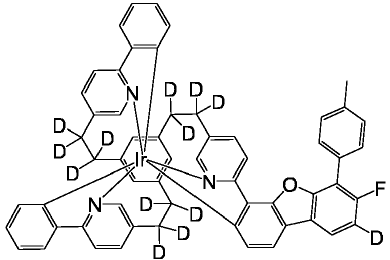 | 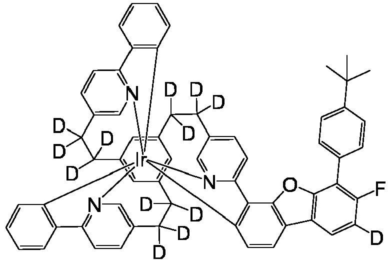 |
| 67 | 68 |
| 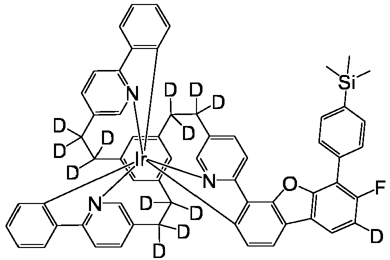 | 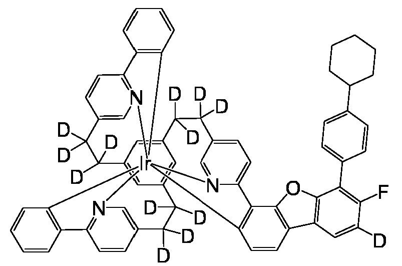 |
| 69 | 70 |
| 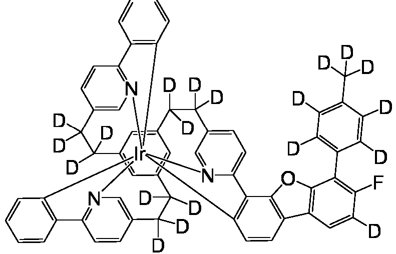 | 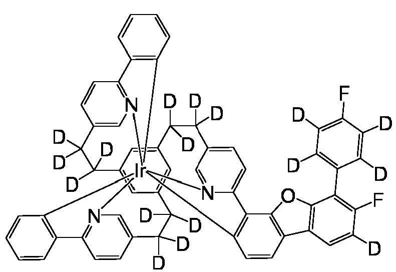 |
| 71 | 72 |
| 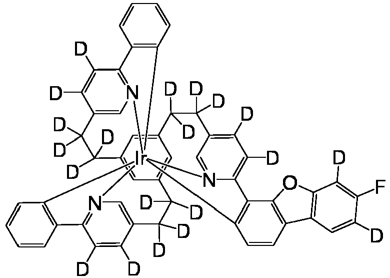 | 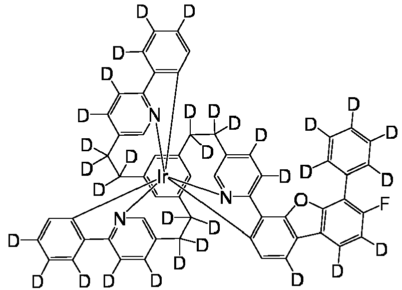 |
| 73 | 74 |
| 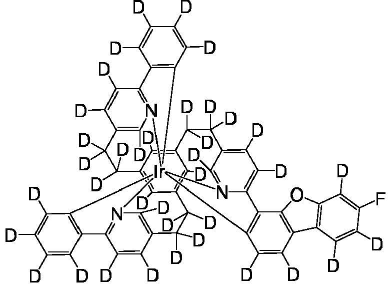 | 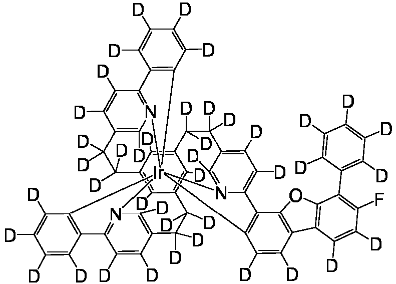 |
| 75 | 76 |
| 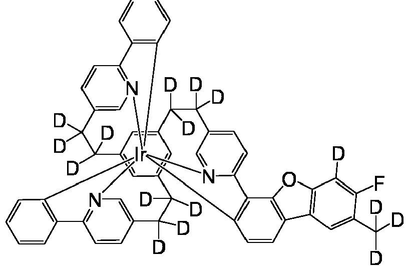 | 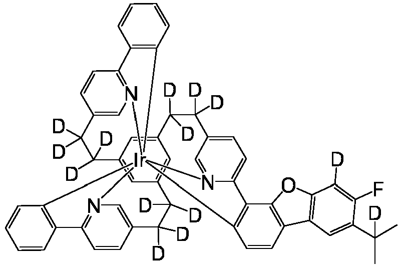 |
| 77 | 78 |
| 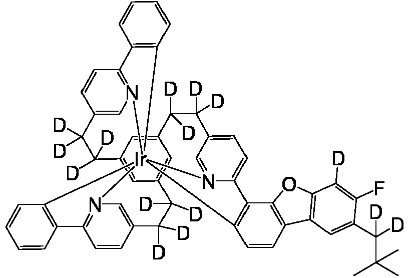 | 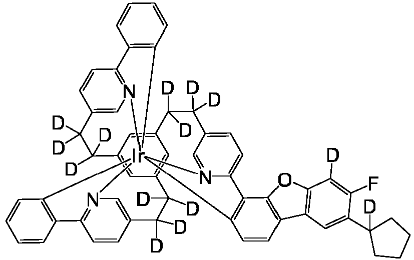 |
| 79 | 80 |
| 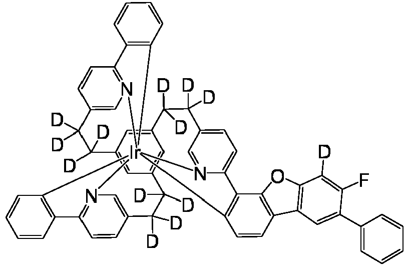 | 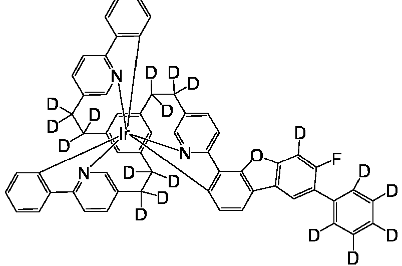 |
| 81 | 82 |
| 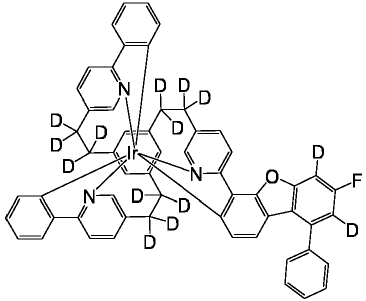 | 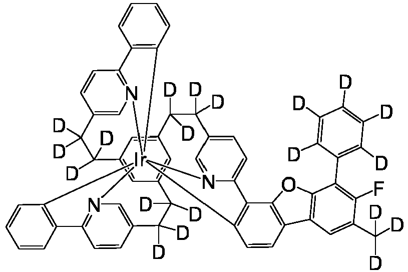 |
| 83 | 84 |
| 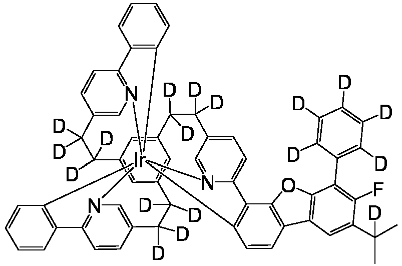 | 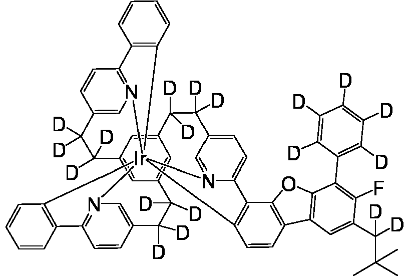 |
| 85 | 86 |
| 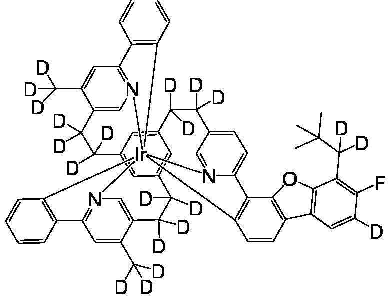 | 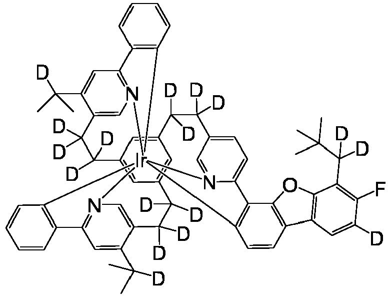 |
| 87 | 88 |
| 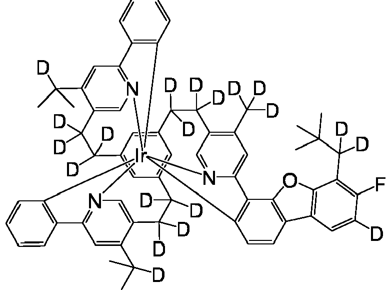 | 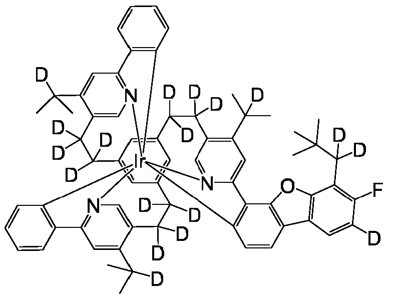 |
| 89 | 90 |
| 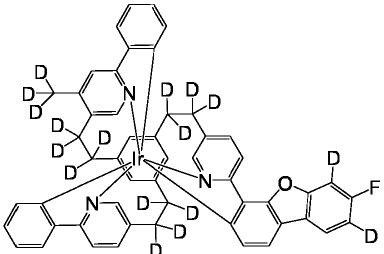 | 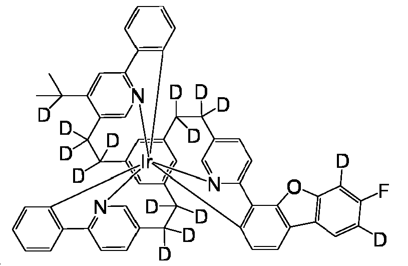 |
| 91 | 92 |
| 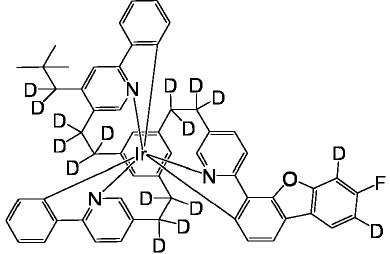 | 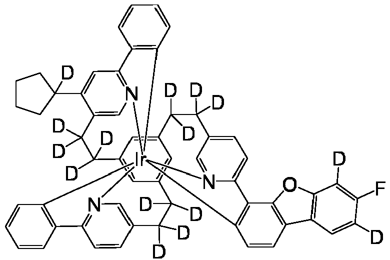 |
| 93 | 94 |
| 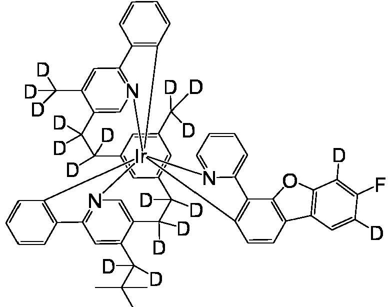 | 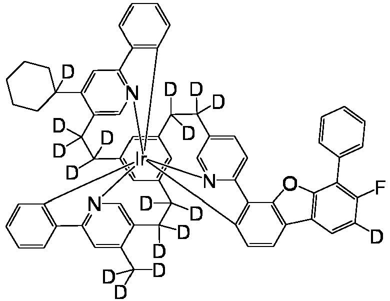 |
| 95 | 96 |
| 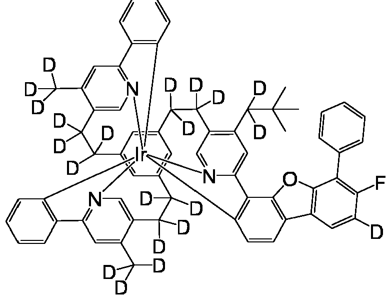 | 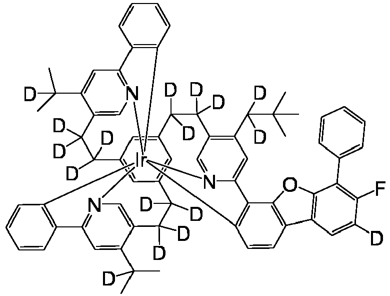 |
| 97 | 98 |
| 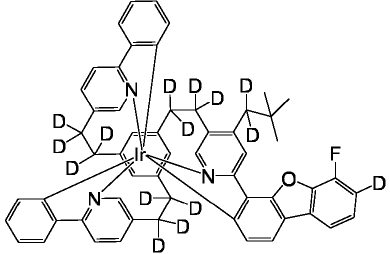 | 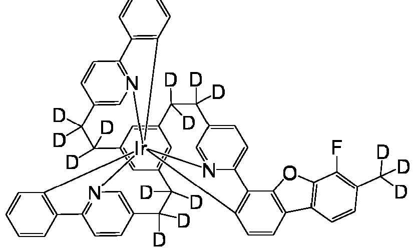 |
| 99 | 100 |
| 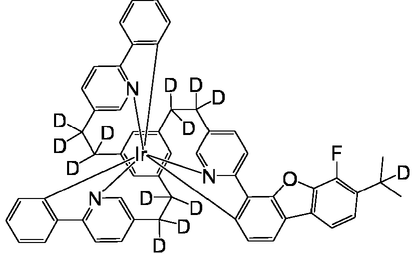 | 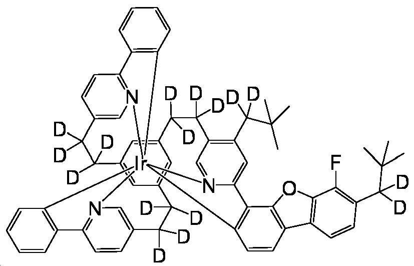 |
| 101 | 103 |
| 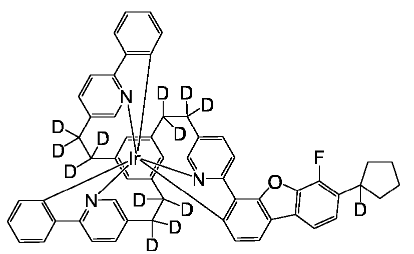 | 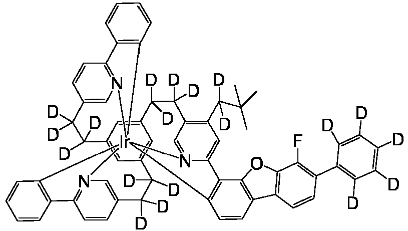 |
| 103 | 104 |
| 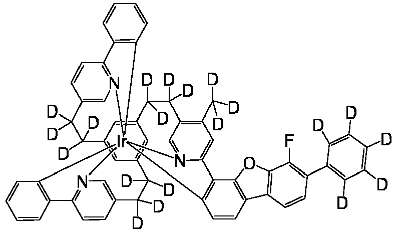 | 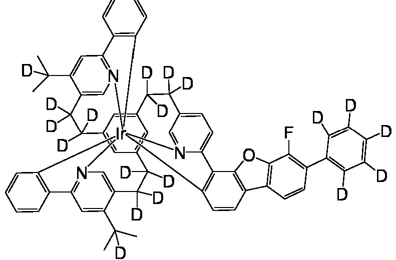 |
| 105 | 106 |
| 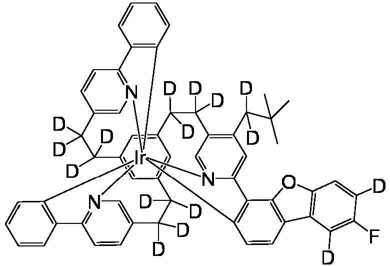 | 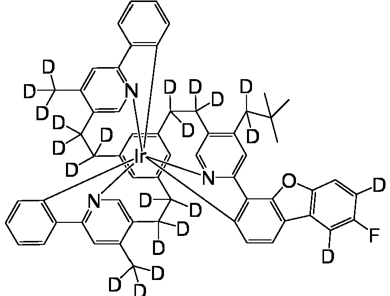 |
| 107 | 108 |
| 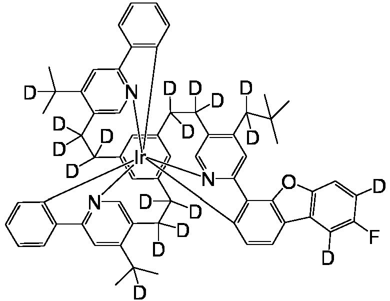 | 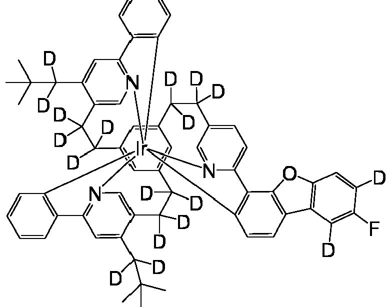 |
| 109 | 110 |
| 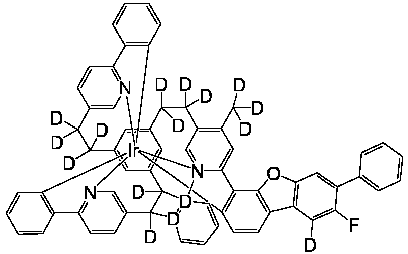 | 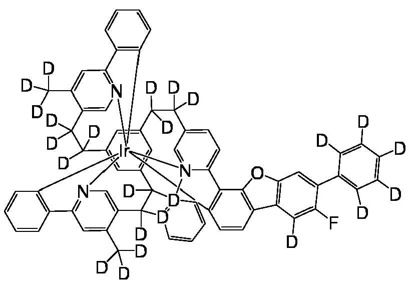 |
| 111 | 112 |
| 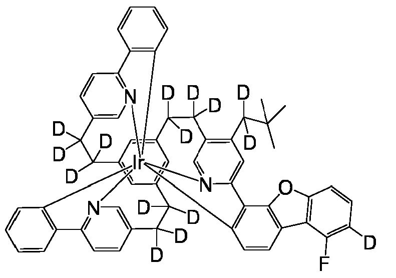 | 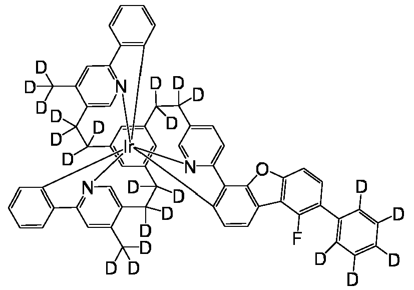 |
| 113 | 114 |
| 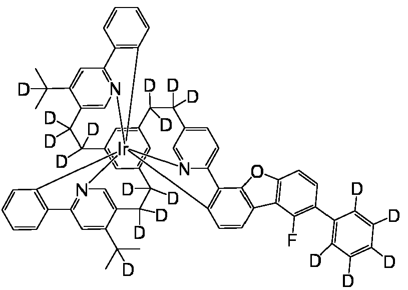 | 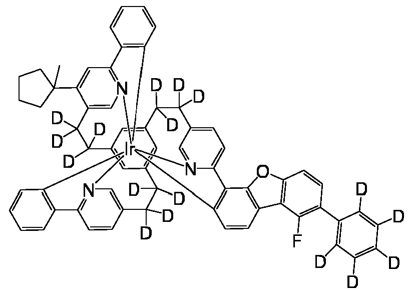 |
| 115 | 116 |
| 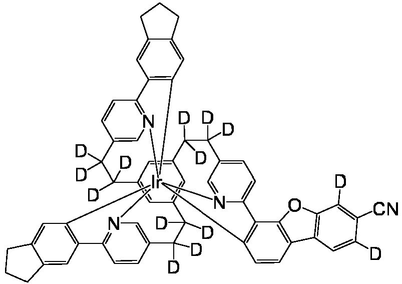 | 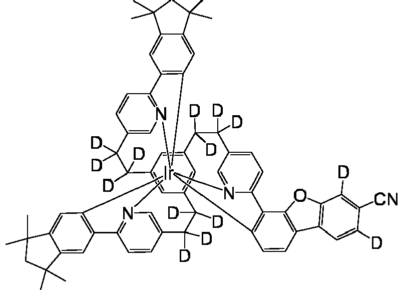 |
| 117 | 118 |
| 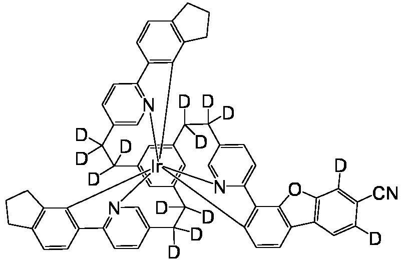 | 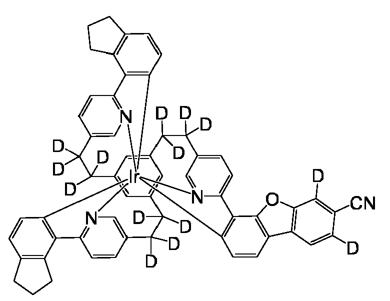 |
| 119 | 120 |
| 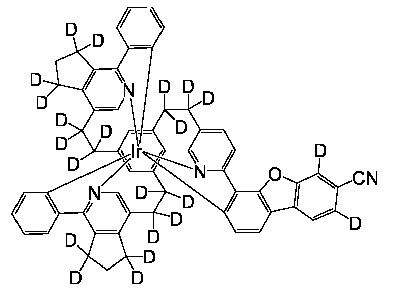 | 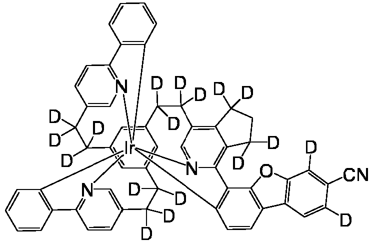 |
| 121 | 122 |
| 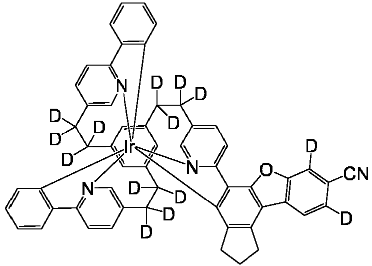 | 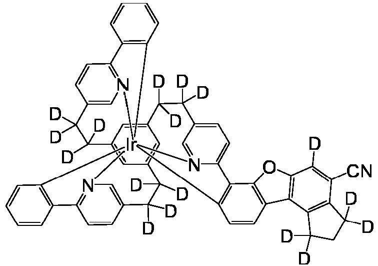 |
| 123 | 124 |
| 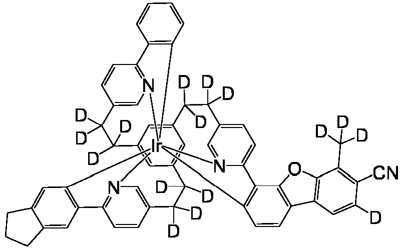 | 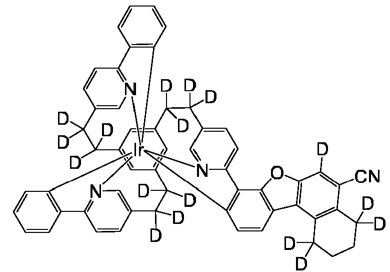 |
| 125 | 126 |
| 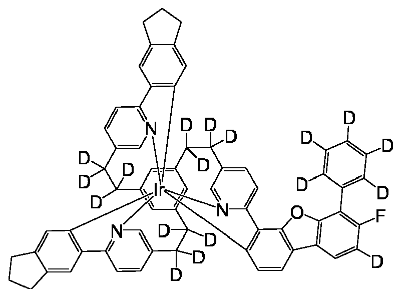 | 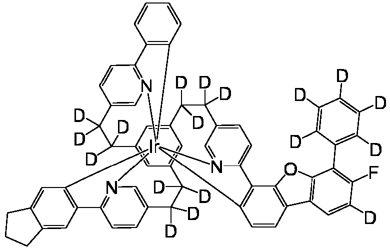 |
| 127 | 128 |
| 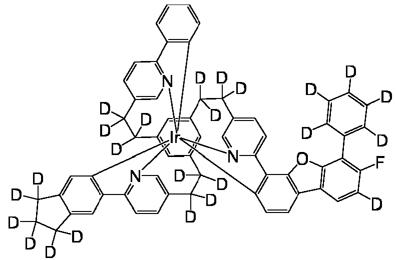 | 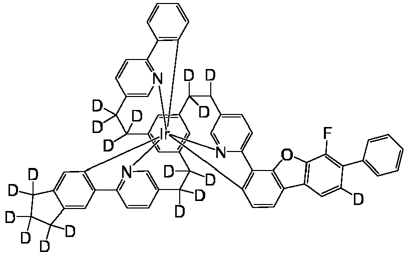 |
| 129 | 130 |
| 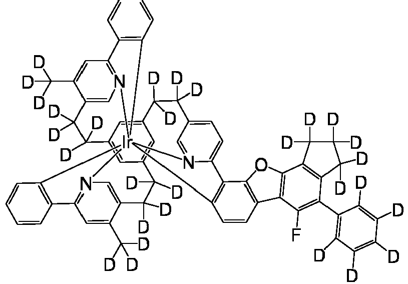 | 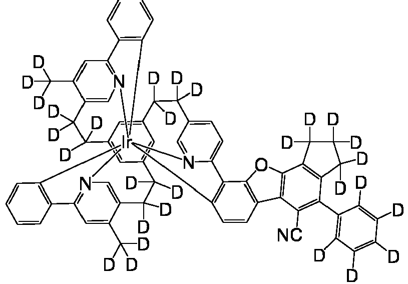 |
| 131 | 132 |
| 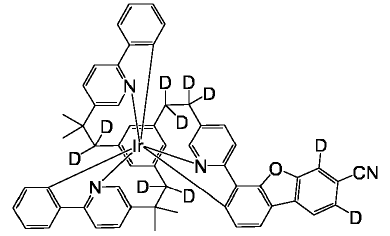 | 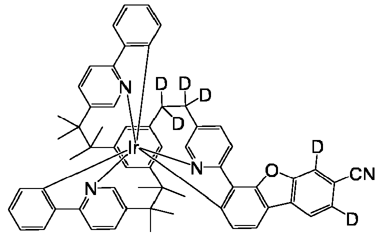 |
| 133 | 134 |
| 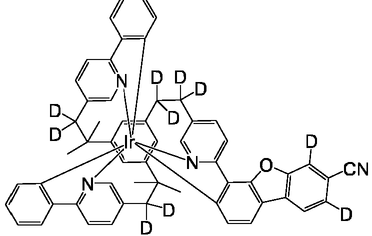 | 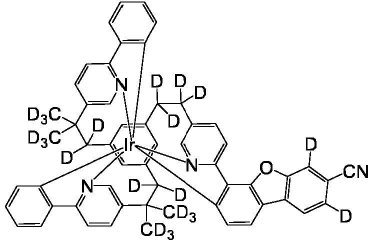 |
| 135 | 136 |
| 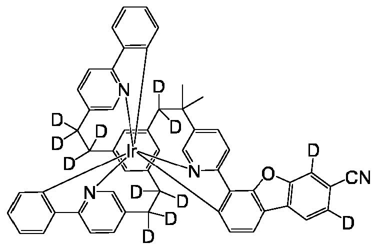 | 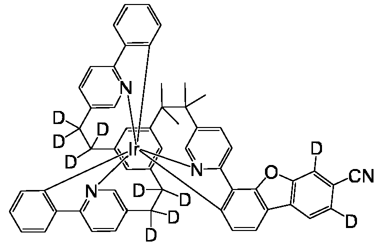 |
| 137 | 138 |
| 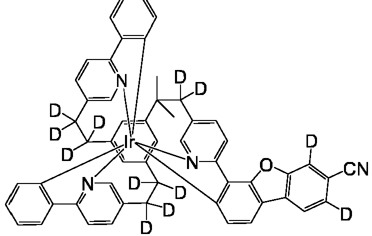 | 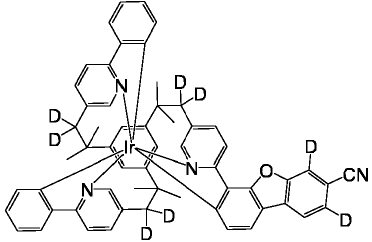 |
| 139 | 140 |
| 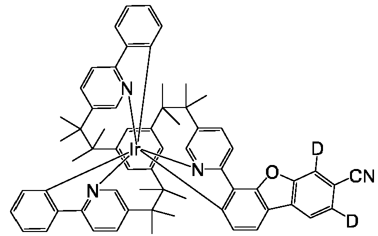 | 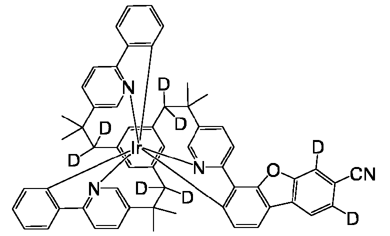 |
| 141 | 142 |
| 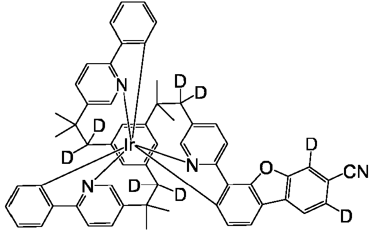 | 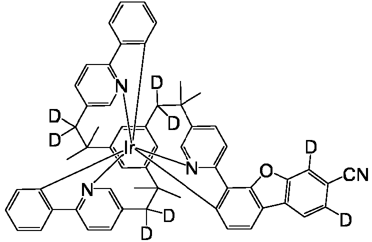 |
| 143 | 144 |
| 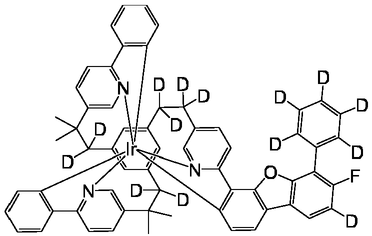 | 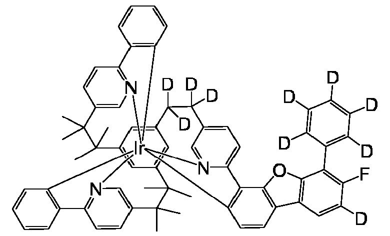 |
| 145 | 146 |
| 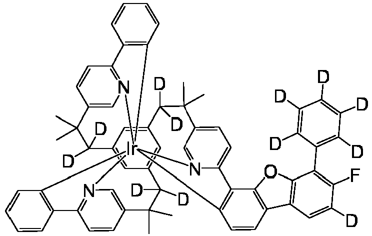 | 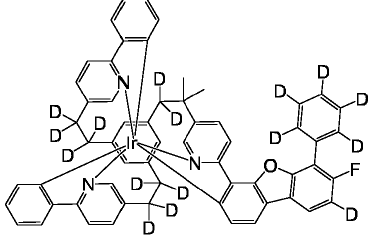 |
| 147 | 148 |
| 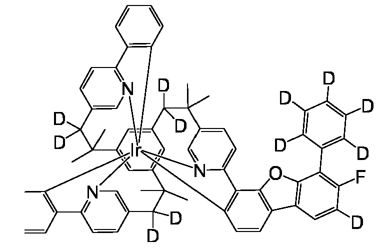 | 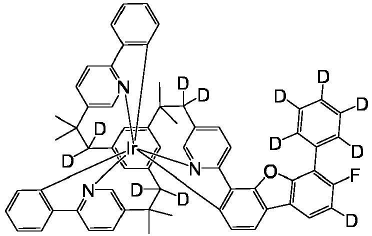 |
| 149 | 150 |
| 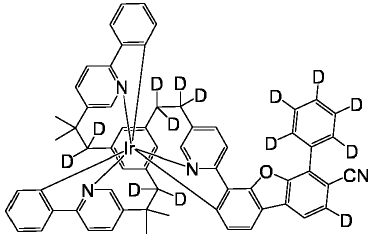 | 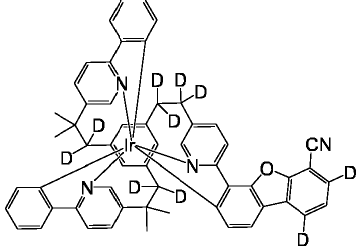 |
| 151 | 152 |
| 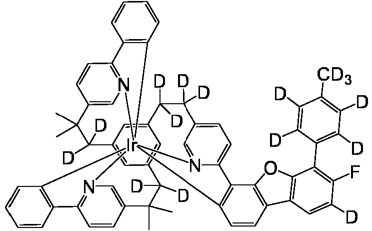 | 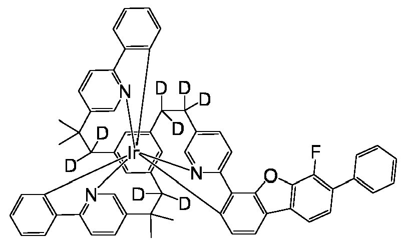 |
| 153 | 154 |
| 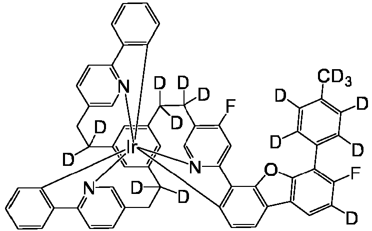 | 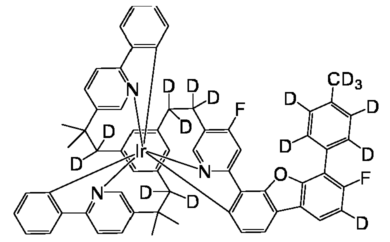 |
| 155 | 156 |
| 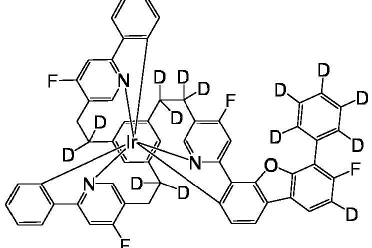 | 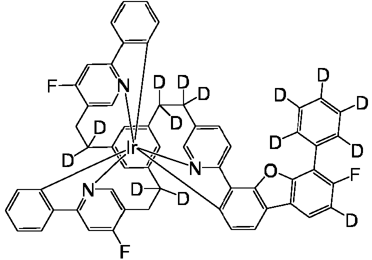 |
| 157 | 158 |
| 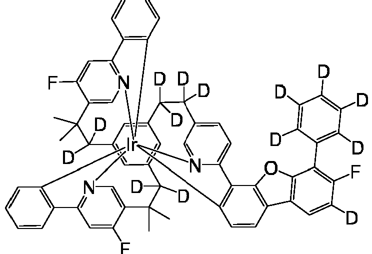 | 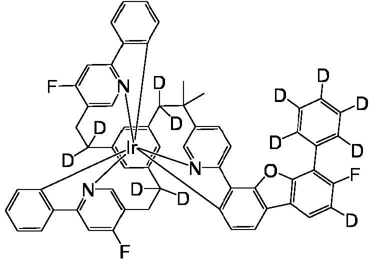 |
| 159 | 160 |
| 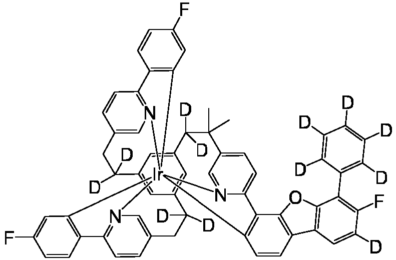 | 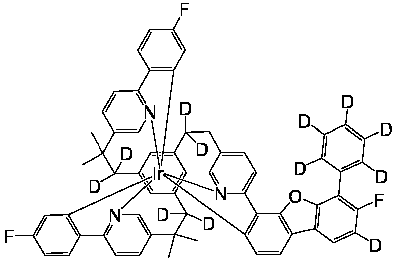 |
| 161 | 162 |
| 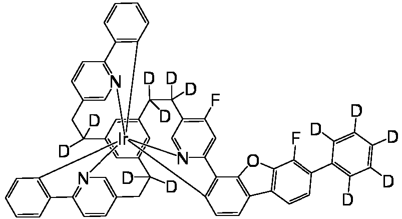 | 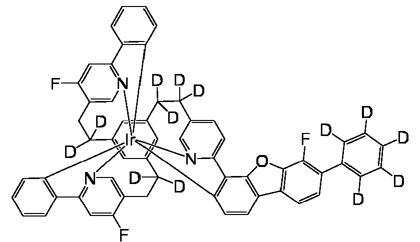 |
| 163 | 164 |
| 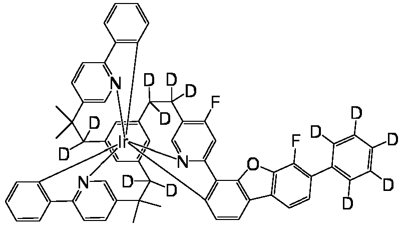 | 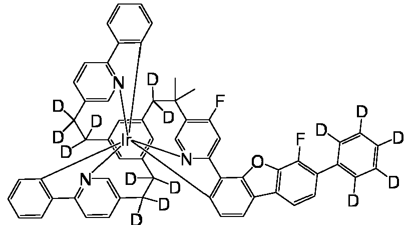 |
| 165 | 166 |
| 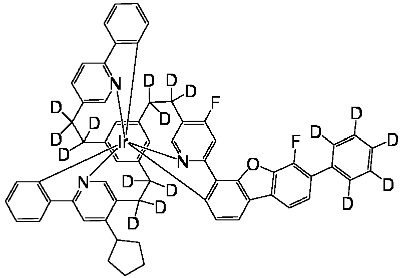 | 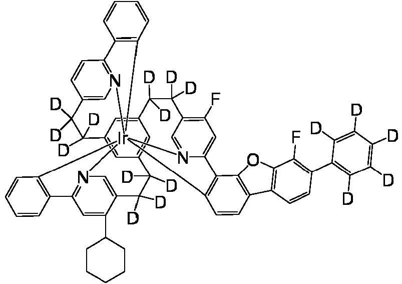 |
| 167 | 168 |
| 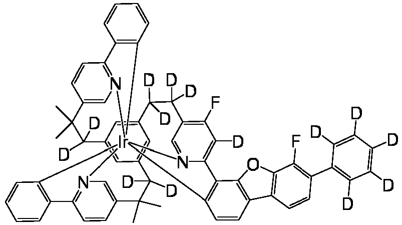 | 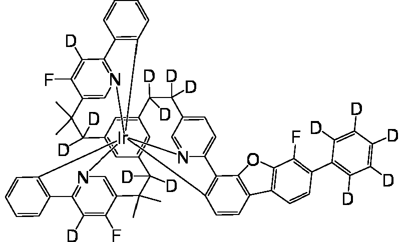 |
| 169 | 170 |
| 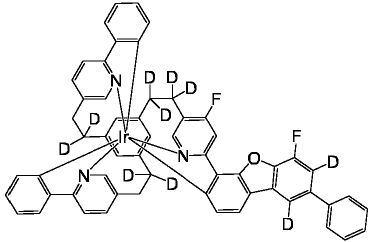 | 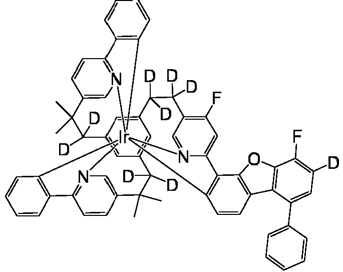 |
| 171 | 172 |
| 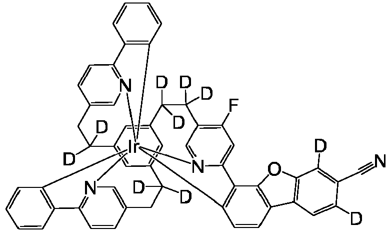 | 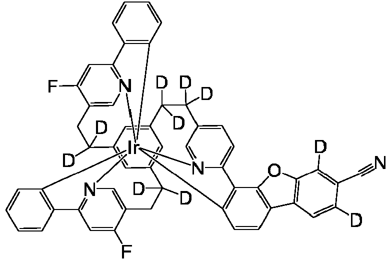 |
| 173 | 174 |
| 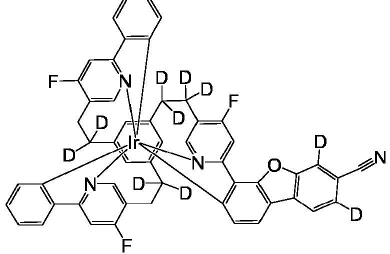 | 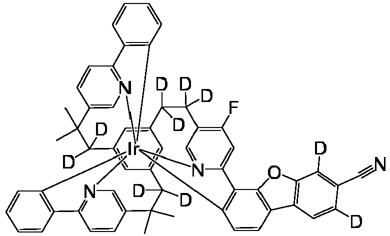 |
| 175 | 176 |
| 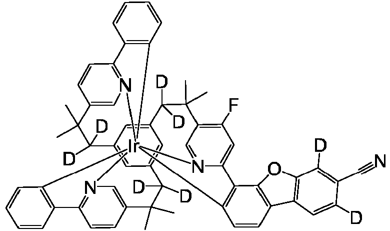 | 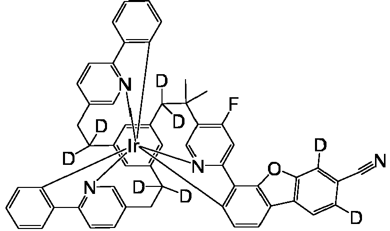 |
| 177 | 178 |
| 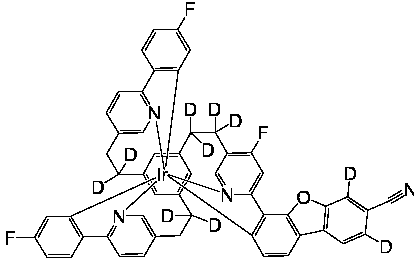 | 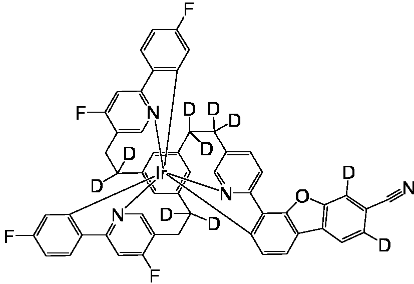 |
| 179 | 180 |
| 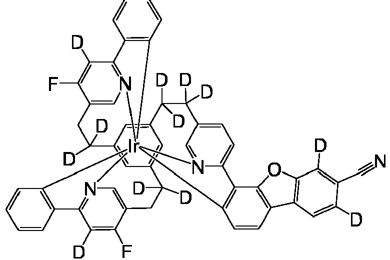 | 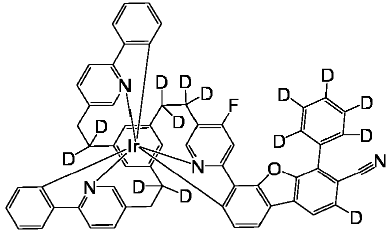 |
| 181 | 182 |
| 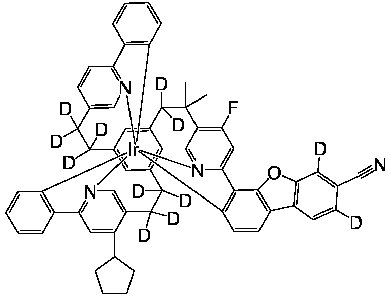 | 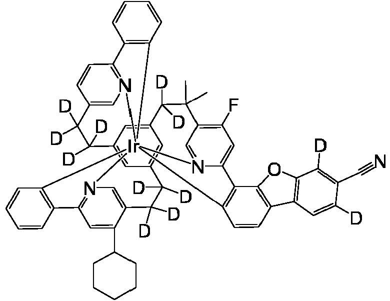 |
| 183 | 184 |
| 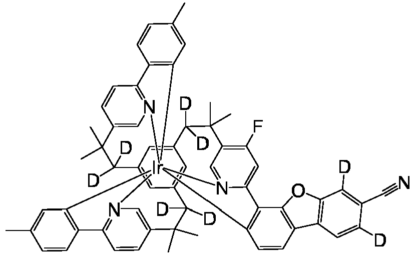 | 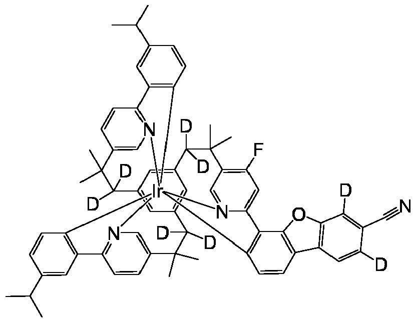 |
| 185 | 186 |
| 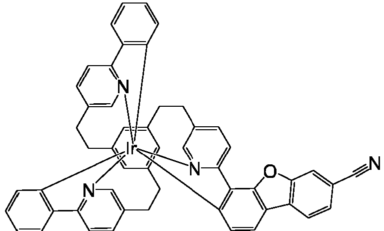 | 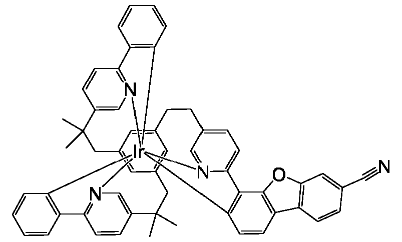 |
| 187 | 188 |
| 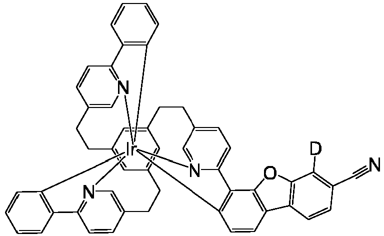 | 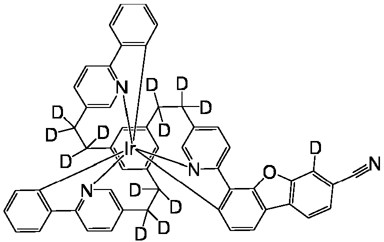 |
| 189 | 190 |
| 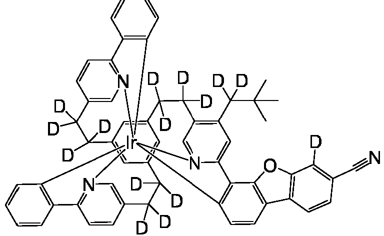 | 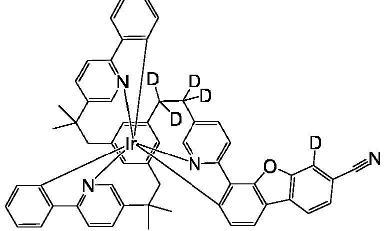 |
| 191 | 192 |
| 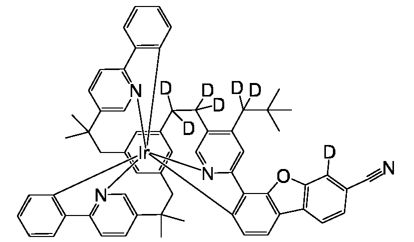 | 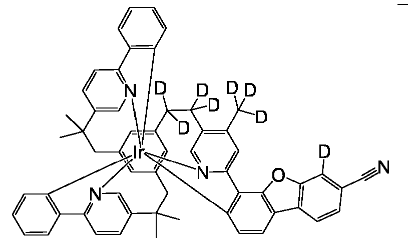 |
| 193 | 194 |

The metal complexes according to the invention are chiral structures. If, in addition, the ligand L is also chiral, the formation of diastereomers and several pairs of enantiomers is possible. The complexes according to the invention then include both the mixtures of the diastereomers and the corresponding racemates, as well as the individual isolated diastereomers and enantiomers.

If ligands with two identical partial ligands are used in ortho-metalation, a racemic mixture of the C₁-symmetric complexes, i.e., the Δ and the A enantiomers, is usually obtained. These can be separated by common methods (chromatography on chiral materials/columns or racemate separation by crystallization) as shown in the following scheme, wherein for clarity the optional substituents are not shown:

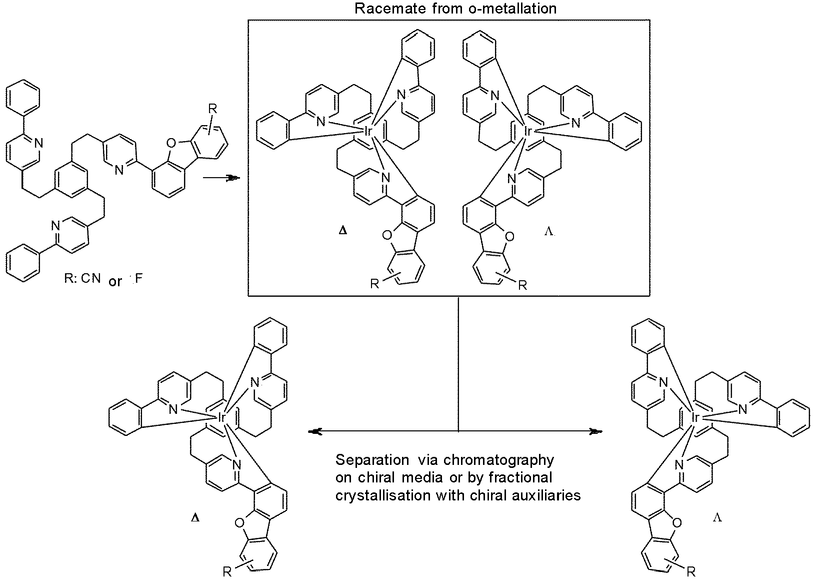

Racemate separation via fractional crystallization of diastereomeric salt pairs can be performed according to standard methods. For this purpose, it is useful to oxidize the neutral Ir(III) complexes (e.g., with peroxides, H₂O₂ or electrochemically), to add the salt of an enantiomerically pure, monoanionic base (chiral base) to the cationic Ir(IV) complexes thus produced, to separate the diastereomeric salts thus produced by fractionized crystallization, and then to convert them to the enantiomeric salts with the aid of a reduction agent (e.g., zinc, hydrazine hydrate, ascorbic acid, etc.). e.g., zinc, hydrazine hydrate, ascorbic acid, etc.) to the enantiomerically pure neutral complex, as shown schematically below:

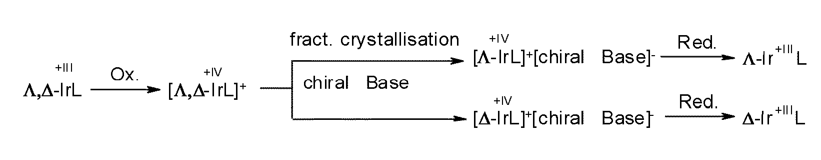

In addition, enantiomerically pure or enantiomerically enriched synthesis is possible by complexation in a chiral medium (e.g., R- or S-1,1-binaphthol).

If ligands with three different part ligands are used in the complexation, a diastereomeric mixture of the complexes is usually obtained, which can be separated by common methods (chromatography, crystallization, etc.).

Enantiomerically pure C₁ -symmetric complexes can also be specifically synthesized. For this purpose, an enantiomerically pure C₁ -symmetric ligand is presented, complexed, the diastereomeric mixture obtained is separated and then the chiral group is cleaved off.

The synthesis of the ligands can be presented starting from the boron esters (1) and (3) known from the literature. For the sake of clarity, the following description of the synthesis deliberately omits substituents at the bridgehead, at the phenyl or pyridine rings and, apart from the substituent R, also at the dibenzofuran.

The boronic ester (1) is regioselectively coupled to the 2-position of a 2,6-dihalopyridine in a Suzuki coupling to form the 5-halopyridine-2-dibenzofuran (2) (Scheme 1).

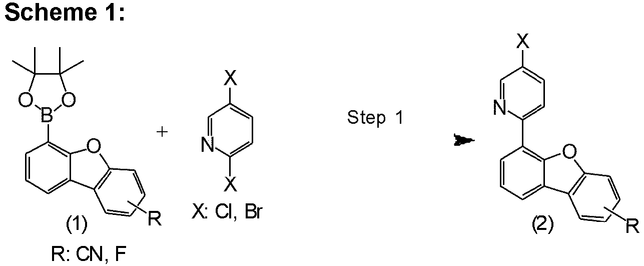

The boronic ester (3) can first be converted to the bromide (4) by reaction with copper(II) bromide (Scheme 2, Step 2), which can then be converted to the alkyne (5) by Sonogashira reaction with trimethylsilylacetylene (Scheme 2, Step 3).

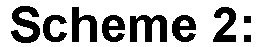

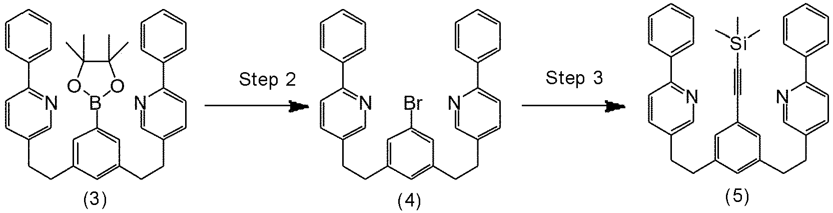

The alkyne (5) can be deprotected in situ by reaction with methanol in the presence of potassium carbonate and then coupled with the 5-halopyridine-2-dibenzofuran (2) to give the alkyne (6) (Scheme 3, step 4), which can then be Pd-catalyzed with hydrogen to give the ligand (7) (Scheme 3, step 5). Subsequent ortho-metallation of the ligand is possible according to procedures known in the literature. For example, the reaction starting from iridium tris-acetylacetonate or tris(2,2,6,6-tetramethyl-3,5-heptane *dionato-κO*³ ,*κO*⁵ )-iridium in a hydroquinone melt at elevated temperature, for example, in the range of about 250 °C, (WO 2016/124304) or from going from iridium(III)acetate in a salicylic acid-mesitylene mixture at elevated temperature, for example in the range of about 160 °C, (WO 2021/013775), the complexes according to the invention in good yields (Scheme 3, step 6). These are finally purified by methods known from literature (chromatography, hot extraction crystallization, fractional sublimation).

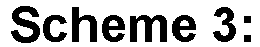

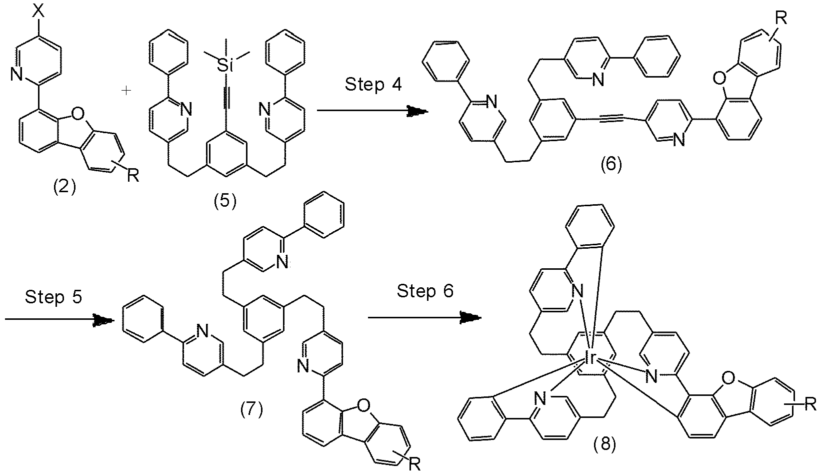

If deuterated synthesis building blocks (1) or (3) are used, or if hydrogenation of the alkyne (6) is carried out with deuterium (D₂) instead of hydrogen (H₂ ), partially or fully deuterated complexes (8) can be obtained. Furthermore, non-deuterated or partially deuterated complexes can be further deuterated at the alkyl and aryl groups by methods known from literature (WO 2019/158453).

The synthesis of the compounds according to the invention is possible in principle by reacting an iridium salt with the corresponding free ligand.

Therefore, a further object of the present invention is a process for preparing the compounds of the invention by reacting the corresponding free ligands with iridium alkoxides of formula (Ir-1), with iridium ketoketonates of formula (Ir-2), with iridium halides of formula (Ir-3) or with iridium carboxylates of formula (Ir-4), 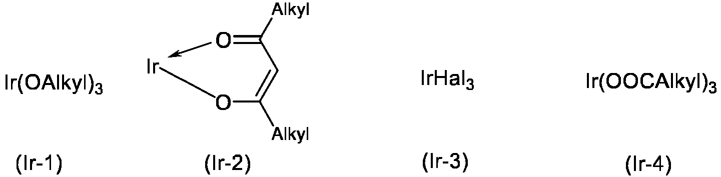 wherein R has the meanings given above, Hal = F, Cl, Br or I and the iridium educts may also be present as the corresponding hydrates. In this context, alkyl preferably stands for an alkyl group having 1 to 4 C atoms.

Iridium compounds bearing both alkoxide and/or halide and/or hydroxide as well as ketoketonate residues can also be used . These compounds may also be charged. Corresponding iridium compounds that are particularly suitable as reactants are disclosed in WO 2004/085449. Particularly suitable are [IrCl₂(acac)₂]⁻ , for example Na[IrCl₂(acac)₂], metal complexes with acetylacetonate derivatives as ligand, for example Ir(acac)₃ or tris(2,2,6,6-tetramethylheptane-3,5-dionato)iridium, and IrCl₃·xH₂ O, where x usually stands for a number between 2 and 4.

The synthesis of the complexes is preferably carried out as described in WO 2002/060910 and in WO 2004/085449. Synthesis in an organic acid or a mixture of an organic acid and an organic solvent, as described in WO 2021/013775, is also particularly suitable, with particularly suitable reaction media being, for example, acetic acid or a mixture of salicylic acid and an organic solvent, for example mesitylene. In this context, the synthesis can also be activated thermally, photochemically and/or by microwave radiation. Furthermore, the synthesis can also be carried out in the autoclave at elevated pressure and/or temperature by .

The reactions can be carried out without the addition of solvents or melting aids in a melt of the corresponding ligands to be o metalated. If necessary, solvents or melting aids can also be added. Suitable solvents are protic or aprotic solvents, such as aliphatic and / or aromatic alcohols (methanol, ethanol, iso-propanol, t-butanol, etc.), oligo- and polyalcohol's (ethylene glycol, 1,2-propanediol, glycerol, etc.), alcohol ethers (ethoxyethanol, diethylene glycol, triethylene glycol, polyethylene glycol, etc.), ethers (di- and triethylene glycol dimethyl ether, diphenyl ether, etc.), aromatic, heteroaromatic and or aliphatic hydrocarbons (toluene, xylene, mesitylene, chlorobenzene, pyridine, lutidine, quinoline, isoquinoline, tridecane, hexadecane, etc.), amides (DMF, DMAC, etc.), lactams (NMP), sulfoxides (DMSO), or sulfones (dimethyl sulfone, sulfane, etc.). Suitable melting aids are compounds that are solid at room temperature but melt and dissolve the reactants when the reaction mixture is heated, resulting in a homogeneous melt. Particularly suitable are biphenyl, m-terphenyl-, triphenylene, R- or S-binaphthol or also the corresponding racemate, 1,2-, 1,3-, 1,4-bis phenoxybenzene, tri phenyl phosphine oxide, 18-crown-6, phenol, 1-naphthol, hydroquinone, etc. The use of hydroquinone is particularly preferred.

As described above and in the example section, the synthesis of the fully or partially deuterated complexes is possible either by using the partially or fully deuterated ligand in the complexation reaction and/or by deuterating the complex after the complexation reaction.

By these methods, optionally followed by purification, such as recrystallization or sublimation, the compounds of the invention according to formula (1) can be obtained in high purity, preferably more than 99% (determined by¹ H-NMR and/or HPLC).

Formulations of the iridium complexes of the invention are required for processing the iridium complexes of the invention from liquid phase, for example by spin coating or by pressure processes. These formulations may be, for example, solutions, dispersions or emulsions. It may be preferred to use mixtures of two or more solvents for this purpose. Suitable and preferred solvents are, for example, toluene, anisole, o-, m- or p-xylene, methylbenzoate, mesitylene, tetralin, veratrol, THF, methyl-THF, THP, chlorobenzene, dioxane, phenoxytoluene, in particular 3-phenoxytoluene, (-)-fenchone, 1,2,3,5-tetramethylbenzene, 1,2,4,5-tetramethylbenzene, 1-methyl naphthalene, 2-methylbenzothiazole, 2-phenoxyethanol, 2-pyrrolidinone, 3-methylanisole, 4-methylanisole, 3,4-dimethylanisole, 3,5-dimethyl anisole, acetophenone, α-terpineol Benzothiazole, butyl benzoate, cumene, cyclohexanol, cyclohexanone, cyclohexylbenzene, decalin, dodecylbenzene, ethyl benzoate, indane, NMP, p-cymene, phenetol, 1,4-diisopropylbenzene, dibenzyl ether, diethylene glycol butyl methyl ether, triethylene glycol butyl methyl ether, diethylene glycol dibutyl ether, triethylene glycol dimethyl ether, di ethylene glycol monobutyl ether, tripropylene glycol dimethyl ether, tetra ethylene glycol dimethyl ether, 2-isopropylnaphthalene, pentylbenzene, hexyl benzene, heptylbenzene, octylbenzene, 1,1-Bis(3,4-dimethylphenyl)ethane, hexamethylindane, 2-methylbiphenyl, 3-Methylbiphenyl, 1-Methylnaphthalene, 1-ethylnaphthalene, ethyl octanoate, sebacic acid diethyl ester, octyl octanoate, heptylbenzene, menthyl isovalerate, cyclohexyl hexanoate or mixtures of these solvents.

A further object of the present invention is therefore a formulation comprising at least one compound according to the invention and at least one further compound. The further compound may be, for example, a solvent, in particular one of the solvents mentioned above or a mixture of these solvents. However, the further compound may also be a further organic or inorganic compound which is also used in the electronic device, for example a matrix material. This further compound may also be polymeric.

The compound according to the invention can be used in an electronic device as an active component, preferably as an emitter in the emissive layer of an organic electroluminescent device. A further object of the present invention is thus the use of the compounds according to the invention in an electronic device, in particular in an organic electroluminescence device.

Still another object of the present invention is an electronic device containing at least one compound according to the invention, in particular an organic electroluminescent device.

An electronic device is understood to be a device which contains an anode, a cathode and at least one layer, this layer containing at least one organic or organometallic compound. The electronic device according to the invention thus contains an anode, cathode and at least one layer, which contains at least one iridium complex according to the invention. In this context, preferred electronic devices are selected from the group consisting of organic electroluminescence devices (OLEDs, PLEDs), organic integrated circuits (O-ICs), organic field-effect transistors (O-FETs), organic thin-film transistors (O-TFTs), organic light-emitting transistors (O-LETs), organic solar cells (O-SCs)-, where this includes both purely organic solar cells and dye-sensitized solar cells, organic optical detectors, organic photoreceptors, organic field quench devices (O-FQDs), light-emitting electrochemical cells (LECs), oxygen sensors or organic laser diodes (O-Lasers), containing in at least one layer at least one compound of the invention. Compounds that emit in the infrared are suitable for use in organic infrared electroluminescent devices and infrared sensors. Organic electroluminescence devices are particularly preferred. Active components are generally the organic or inorganic materials which are introduced between the anode and cathode, for example charge injection, charge transport or charge blocking materials, but in particular emission materials and matrix materials. The compounds according to the invention show particularly good properties as emission materials in organic electroluminescence devices. A preferred embodiment of the invention is therefore organic electroluminescent devices . Furthermore, the compounds according to the invention can be used for the generation of singlet oxygen or in photocatalysis.

The organic electroluminescent device includes cathode, anode and at least one emitting layer. In addition to these layers, it may contain other layers, for example one or more hole injection layers, hole transport layers, hole blocking layers, electron transport layers, electron injection layers, exciton blocking layers, electron blocking layers, charge generation layers and/or organic or inorganic p/n transitions. It is possible that one or more hole transport layers are p-doped and/or that one or more electron transport layers are n-doped. Likewise, interlayers can be introduced between two emitting layers, which, for example, exhibit an exciton-blocking function and/or control the charge balance in the electroluminescence before direction and/or generate charges (charge-generation layer, e.g., in layer systems with multiple emitting layers, e.g., in white-emitting OLED devices). It should be noted, however, that not necessarily each of these layers must be present.

The organic electroluminescence device may contain one emitting layer, or it may contain several emitting layers. If several emitting layers are present, these preferably have in total several emission maxima between 380 nm and 750 nm, so that overall white emission results, i.e., different emitting compounds that can fluoresce or phosphoresce are used in the emitting layers. Particularly preferred are three-layer systems, wherein the three layers show blue, green and orange or red emission, or systems which have more than three emitting layers. It can also be a hybrid system, where one or more layers fluoresce, and one or more other layers phosphoresce. Tandem OLEDs are a preferred embodiment. White emitting organic electroluminescence can be used for lighting applications or with color filters also for full color displays.

In a preferred embodiment of the invention, the organic electroluminescent device contains the compound of the invention as an emitting compound in one or more emitting layers, in particular in a green emitting layer.

When the compound according to the invention is used as an emitting compound in an emitting layer, it is preferably used in combination with one or more matrix materials. The mixture of the compound according to the invention and the matrix material contains between 0.1 and 99 vol%, preferably between 1 and 90 vol%, particularly preferably between 3 and 40 vol%, especially between 5 and 15 vol% of the compound according to the invention relative to the total mixture of emitter and matrix material. Accordingly, the mixture contains between 99.9 and 1% by volume, preferably between 99 and 10% by volume, particularly preferably between 97 and 60% by volume, especially between 95 and 85% by volume of the matrix material based on the total mixture of emitter and matrix material.

In general, all materials known in the prior art can be used as matrix material. Preferably, the triplet level of the matrix material is higher than the triplet level of the emitter.

Suitable matrix materials for the compounds according to the invention are ketones, phosphine oxides, sulfoxides and sulfones, e.g. according to WO 2004/013080, WO 2004/093207, WO 2006/005627 or WO 2010/006680, triarylamines, carbazole derivatives, e.g. CBP (N,N-biscarbazolylbiphenyl), m-CBP or carbazole derivatives disclosed in WO 2005/039246, US 2005/0069729, JP 2004/288381, EP 1205527, WO 2008/086851 or US 2009/0134784, biscarbazole derivatives, indolocarbazole derivatives, e.g. according to WO 2007/063754 or WO 2008/056746, indenocarbazole derivatives, e.g. according to WO 2010/136109 or WO 2011/000455, azacarbazoles, e.g. according to EP 1617710, EP 1617711, EP 1731584, JP 2005/347160, bipolar matrix materials, e.g. according to WO 2007/137725, silanes, e.g. according to WO 2005/111172, azaboroles or boronic esters, e.g. according to WO 2006/117052, diazasilol derivatives, e.g. according to WO 2010/054729, diazaphosphol derivatives, e.g. according to WO 2010/054730, triazine derivatives, e.g. according to WO 2010/015306, WO 2007/063754 or WO 2008/056746, zinc complexes, e.g. according to EP 652273 or WO 2009/062578, dibenzofuran derivatives, e.g. according to WO 2009/148015 or WO 2015/169412, or bridged carbazole derivatives, e.g. according to US 2009/0136779, WO 2010/050778, WO 2011/042107 or WO 2011/088877. For solution-processed OLEDs, polymers, e.g., according to WO 2012/008550 or WO 2012/048778, oligomers or dendrimers, e.g., according to Journal of Luminescence 183 (2017), 150-158, are also suitable as matrix materials.

It may also be preferred to use several different matrix materials as a mixture, in particular at least one electron-conducting matrix material and at least one hole-conducting matrix material. For example, a preferred combination is the use of an aromatic ketone, a triazine derivative, a pyrimidine derivative, a phosphine oxide derivative or an aromatic lactam with a triarylamine derivative or a carbazole derivative as a mixed matrix for the compound according to the invention. Equally preferred is the use of a mixture of a charge transporting matrix material and an electrically inert matrix material (so-called "wide bandgap host"), which is not or not substantially involved in the charge transport, as described, for example, in WO 2010/108579 or WO 2016/184540. Equally preferred is the use of two electron transporting matrix materials, for example triazine derivatives and lactam derivatives, as described, for example, in WO 2014/094964.

Examples of compounds suitable as matrix materials for the compounds of the invention are shown below.

Preferred biscarbazoles that can be used as matrix materials for the compounds according to the invention are the structures of the following formulae (12) and (13), 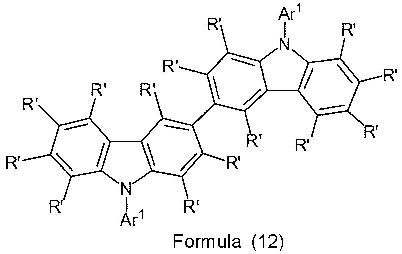 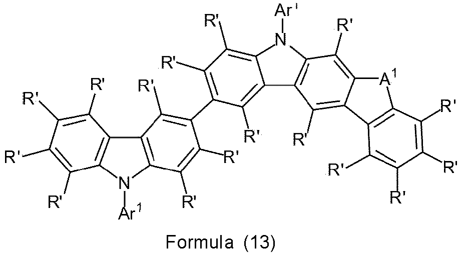 wherein the following applies to the symbols used:
- Ar¹: at each occurrence is the same or different and is an aromatic or ring system having 5 to 40 aromatic ring atoms, preferably having 6 to 30 aromatic ring atoms, particularly preferably having 6 to 24 aromatic ring atoms, each of which may be substituted with one or more radicals R', preferably non-aromatic radicals R';
- A': is NAr¹ , C(R')₂ , O or S, preferably C(R')₂ ;
- R': at each occurrence is the same or different and is H, D, F, CN, an alkyl group having 1 to 10 C atoms, preferably having 1 to 4 C atoms, or an aromatic or heteroaromatic ring system having 5 to 40 aromatic ring atoms, preferably having 6 to 30 aromatic ring atoms, particularly preferably with 6 to 24 aromatic ring atoms, which may be substituted with one or more substituents selected from the group consisting of D, F, CN or an alkyl group with 1 to 10 C atoms, preferably with 1 to 4 C atoms.

Preferred embodiments of the compounds of formulae (12) or (13) are the compounds of the following formulae (12a) or (13a), respectively, 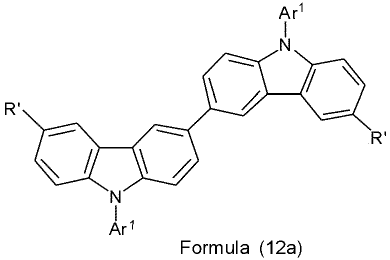 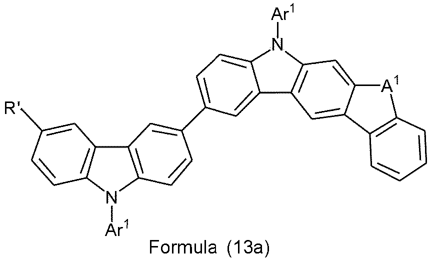 wherein the symbols used have the above meanings.

Preferred dibenzofuran derivatives are the compounds of the following formula (14), 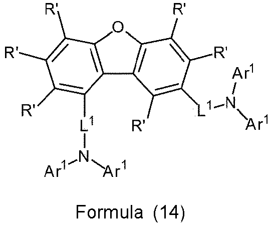 wherein the oxygen can also be replaced by sulfur, so that a dibenzothiophene is formed, L¹ is a single bond or an aromatic or heteroaromatic ring system having 5 to 30 aromatic ring atoms, preferably having 6 to 24 aromatic ring atoms, which can also be substituted by one or more radicals R', but is preferably unsubstituted, and R' and Ar¹ have the meanings given above. In this context, the two groups Ar¹ , which bind to the same nitrogen atom, or a group Ar¹ and a group L, which bind to the same nitrogen atom, can also be linked to one another, for example to form a carbazole.

Preferred carbazolamines are the structures of the following formulae (15), (16) and (17), 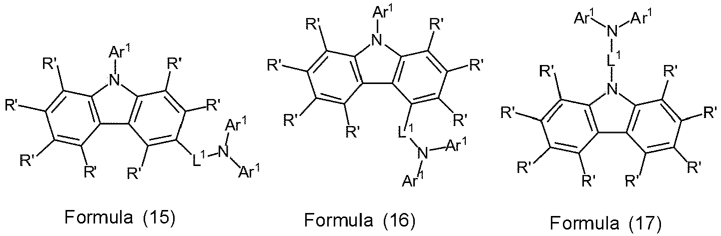 wherein L¹, R' and Ar¹ have the above meanings.

Examples of suitable hole-conducting matrix materials are the compounds shown in the following table.

| | | |
|---|---|---|
| 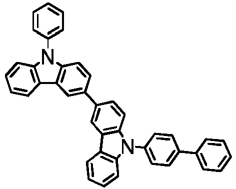 | 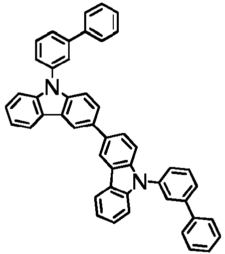 | 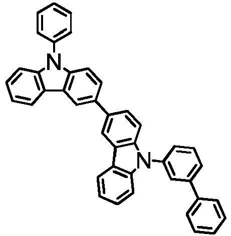 |
| H1 | H2 | H3 |
| 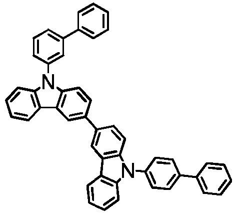 | 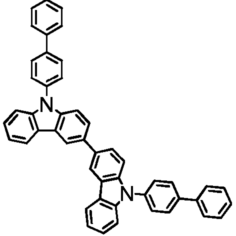 | 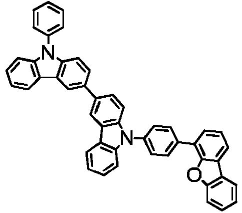 |
| H4 | H5 | H6 |
| 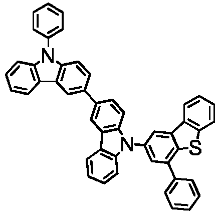 | 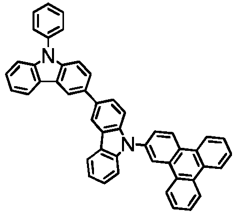 | 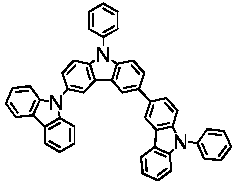 |
| H7 | H8 | H9 |
| 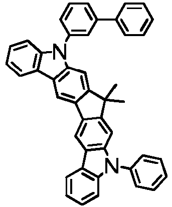 | 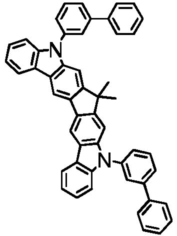 | 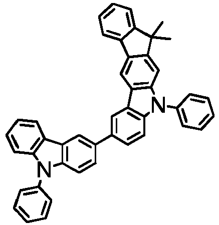 |
| H10 | H11 | H12 |
| 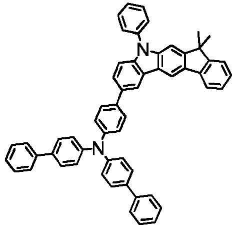 | 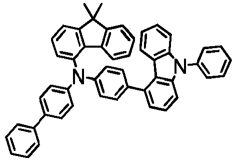 | 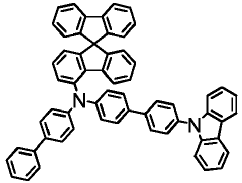 |
| H13 | H14 | H15 |
| 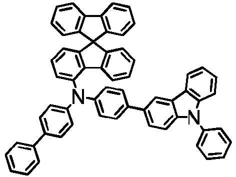 | 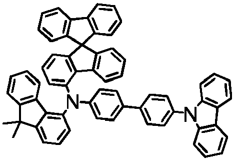 | 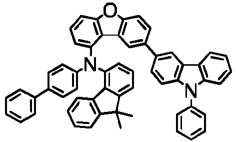 |
| H16 | H17 | H18 |
| 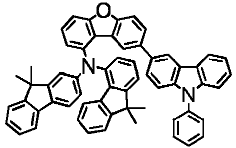 | 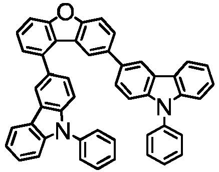 | 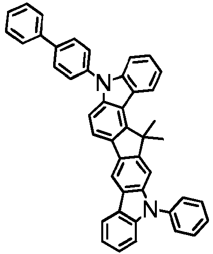 |
| H19 | H20 | H21 |
| 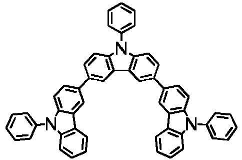 | 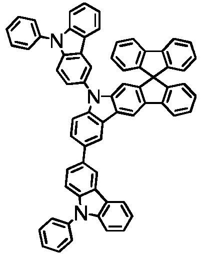 | 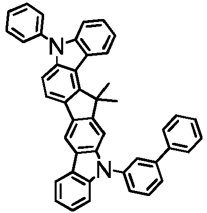 |
| H22 | H23 | H24 |
| 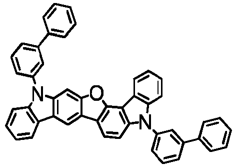 | 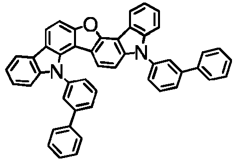 | 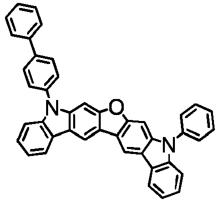 |
| H25 | H26 | H27 |
| 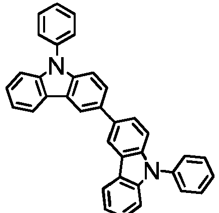 | 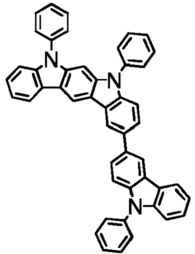 | 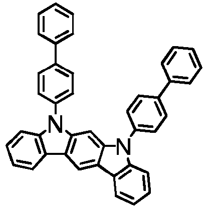 |
| H28 | H29 | H30 |
| 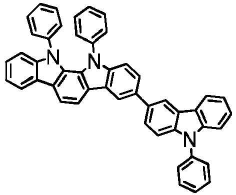 | 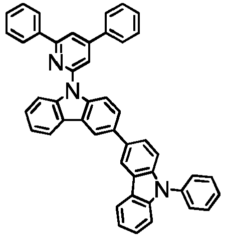 | 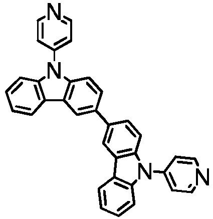 |
| H31 | H32 | H33 |
| 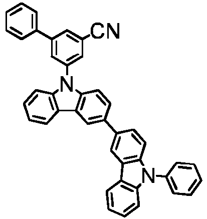 | 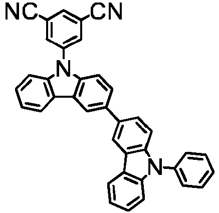 | 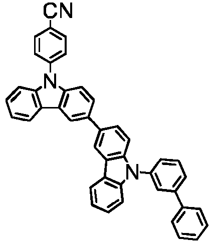 |
| H34 | H35 | H36 |
| 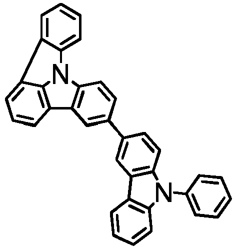 | 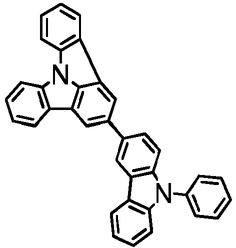 | 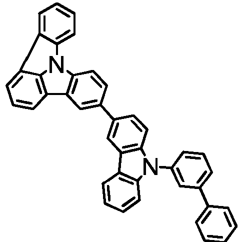 |
| H37 | H38 | H39 |
| 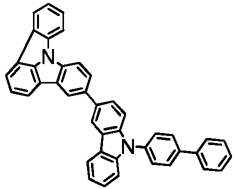 | 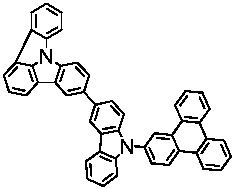 | 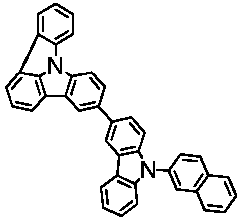 |
| H40 | H41 | H42 |
| 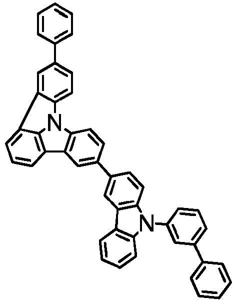 | 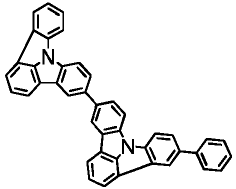 | 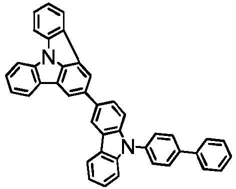 |
| H43 | H44 | H45 |
| 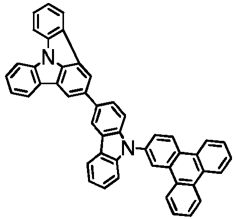 | 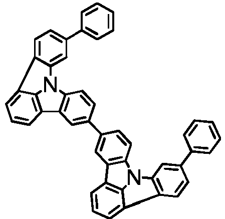 | 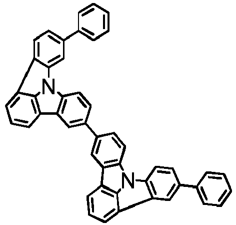 |
| H46 | H47 | H48 |
| 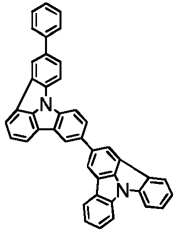 | 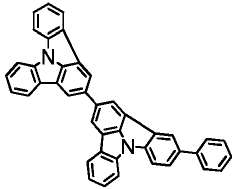 | 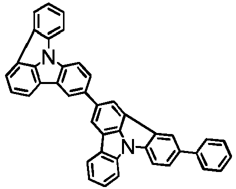 |
| H49 | H50 | H51 |
| 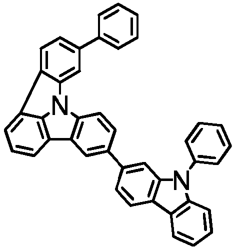 | 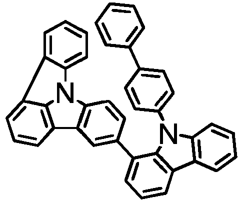 | 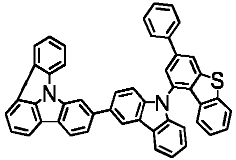 |
| H52 | H53 | H54 |
| 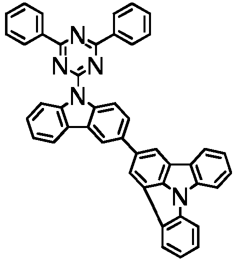 | 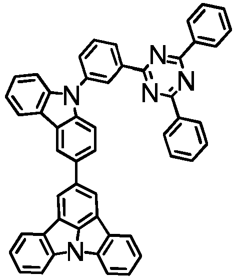 | 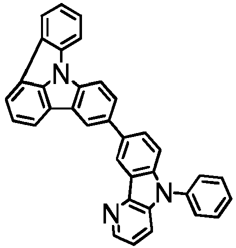 |
| H55 | H56 | H57 |

Preferred triazine or pyrimidine derivatives, which can be used as a mixture together with the compounds of the invention, are the compounds of the following formulae (18) and (19), 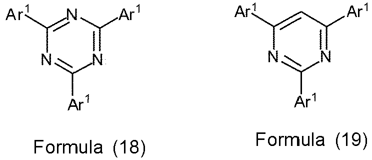 wherein Ar¹ has the meanings given above.

Particularly preferred are the triazine derivatives of formula (18).

In a preferred embodiment of the invention, each occurrence of Ar¹ in formulas (18) and (19) is the same or different and is an aromatic or heteroaromatic ring system having 6 to 30 aromatic ring atoms, in particular having 6 to 24 aromatic ring atoms, which may be substituted by one or more radicals R'.

Examples of suitable electron-transporting compounds that can be used as matrix materials together with the compounds according to the invention are the compounds shown in the following table.

| | | |
|---|---|---|
| 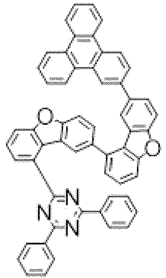 | 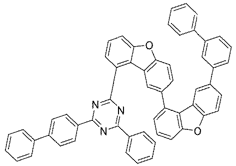 | 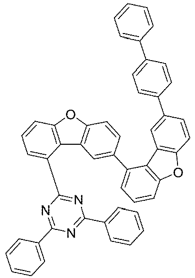 |
| E1 | E2 | E3 |
| 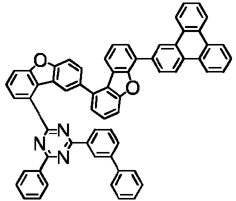 | 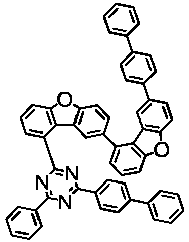 | 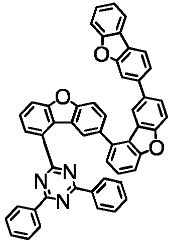 |
| E4 | E5 | E6 |
| 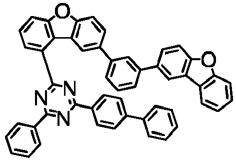 | 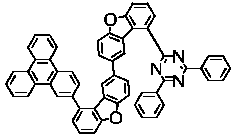 | 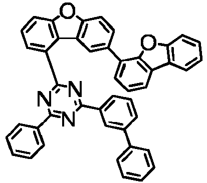 |
| E7 | E8 | E9 |
| 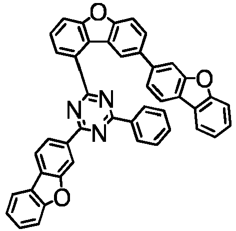 | 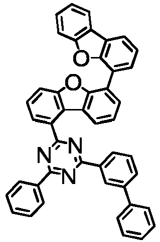 | 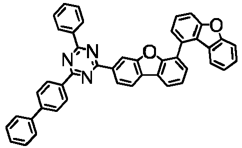 |
| E10 | E11 | E12 |
| 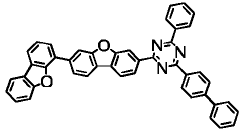 | 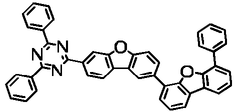 | 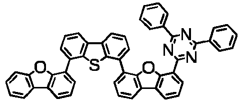 |
| E13 | E14 | E15 |
| 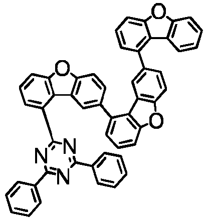 | 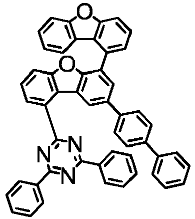 | 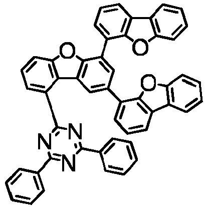 |
| E16 | E17 | E18 |
| 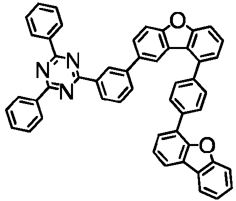 | 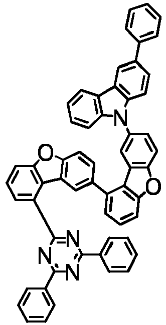 | 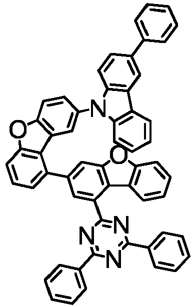 |
| E19 | E20 | E21 |
| 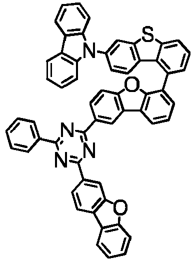 | 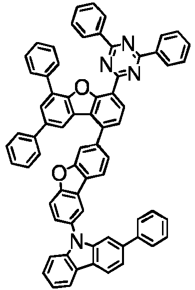 | 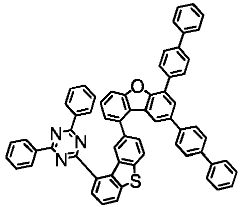 |
| E22 | E23 | E24 |
| 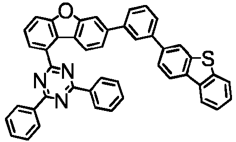 | 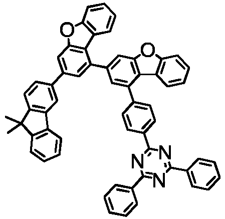 | 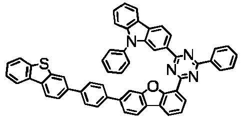 |
| E25 | E26 | E27 |
| 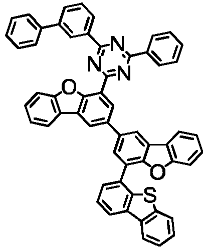 | 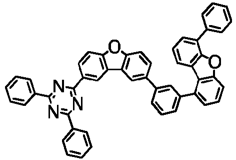 | 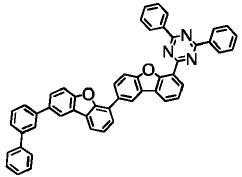 |
| E28 | E29 | E30 |
| 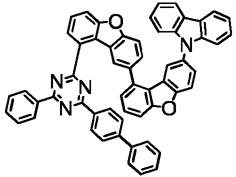 | 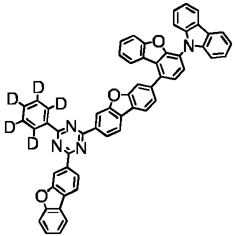 | 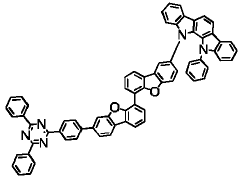 |
| E31 | E32 | E33 |
| 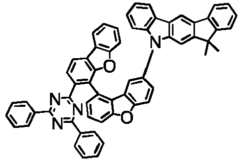 | 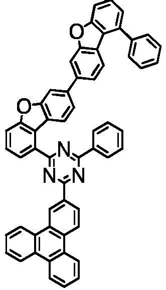 | 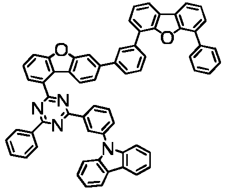 |
| E34 | E35 | E36 |
| 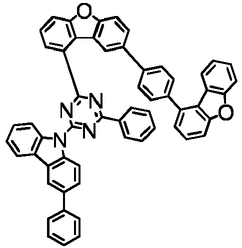 | 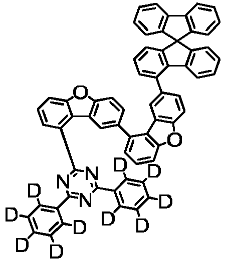 | 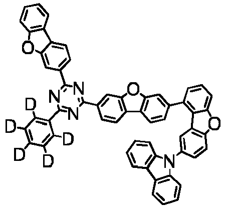 |
| E37 | E38 | E39 |
| 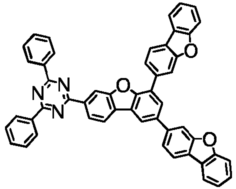 | 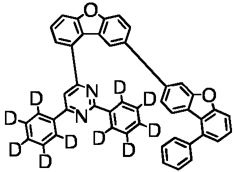 | 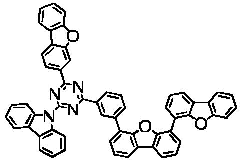 |
| E40 | E41 | E42 |
| 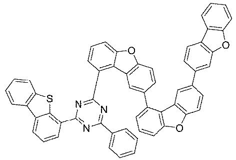 | 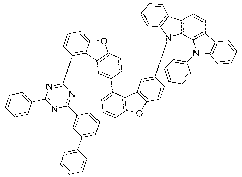 | 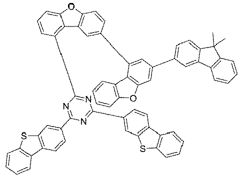 |
| E43 | E44 | E45 |
| 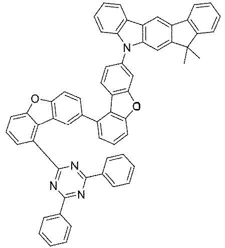 | 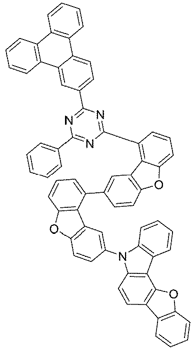 | 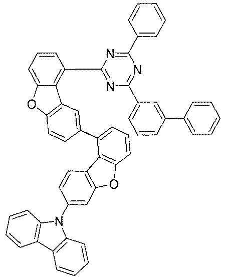 |
| E46 | E47 | E48 |
| 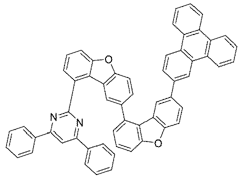 | 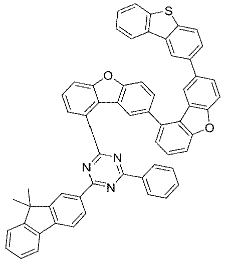 | 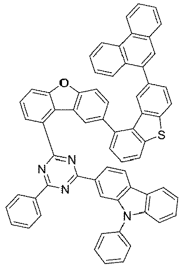 |
| E49 | E50 | E51 |
| 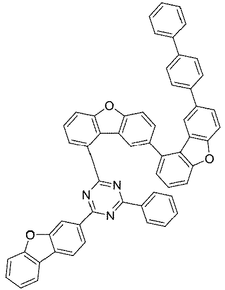 | 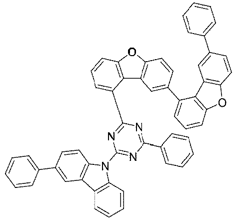 | 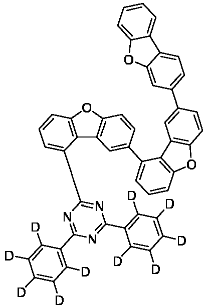 |
| E52 | E53 | E54 |
| 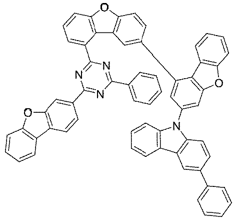 | 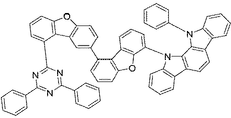 | 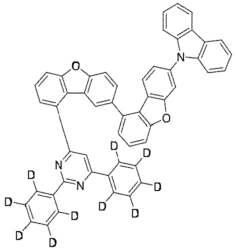 |
| E55 | E56 | E57 |
| 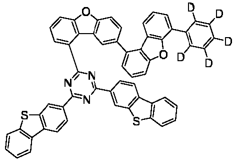 | 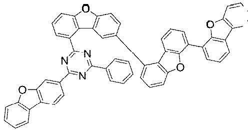 | 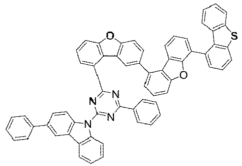 |
| E58 | E59 | E60 |
| 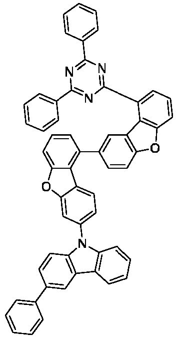 | 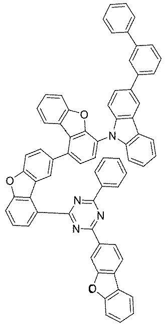 | 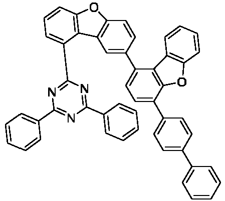 |
| E61 | E62 | E63 |
| 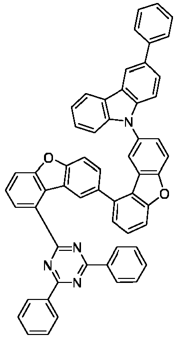 | 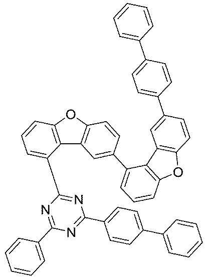 | 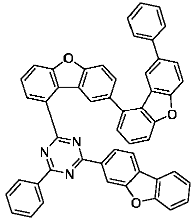 |
| E64 | E65 | E66 |
| 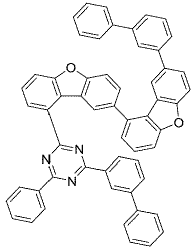 | 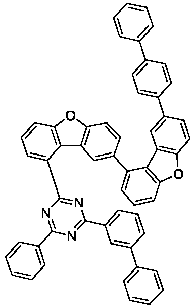 | 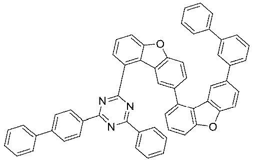 |
| E67 | E68 | E69 |
| 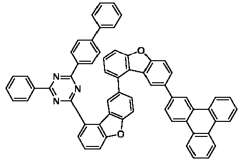 | 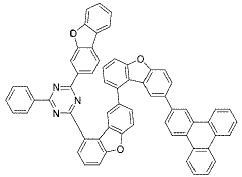 | 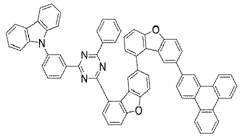 |
| E70 | E71 | E72 |
| 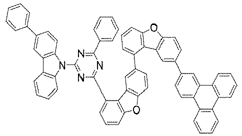 | 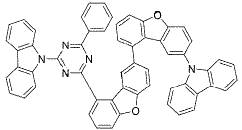 | 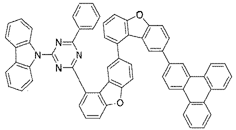 |
| E73 | E74 | E75 |
| 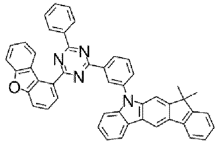 | 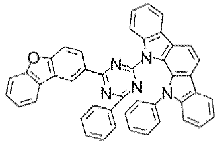 | 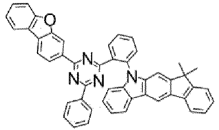 |
| E76 | E77 | E78 |
| 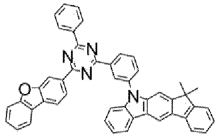 | 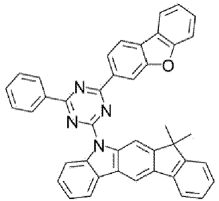 | 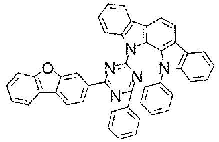 |
| E79 | E80 | E81 |
| 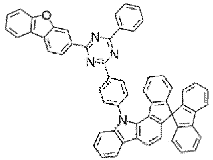 | 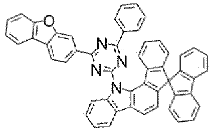 | 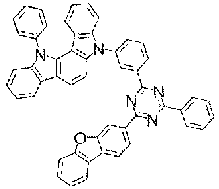 |
| E81 | E82 | E83 |
| 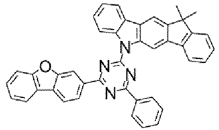 | 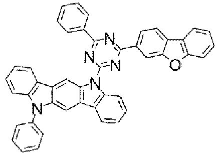 | 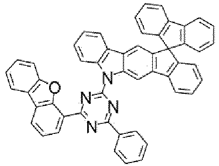 |
| E84 | E85 | E86 |
| 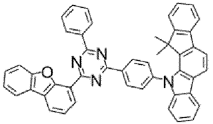 | 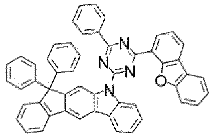 | 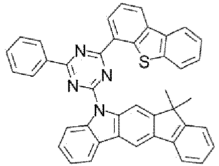 |
| E87 | E88 | E89 |
| 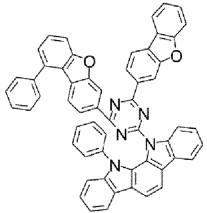 | 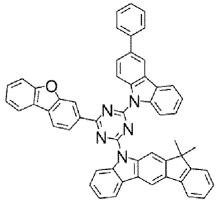 | 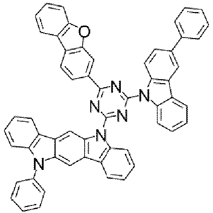 |
| E90 | E91 | E92 |
| 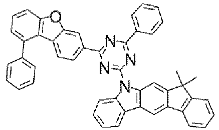 | 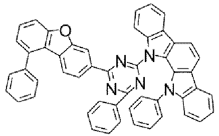 | 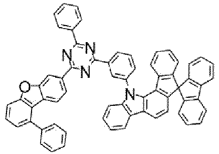 |
| E93 | E94 | E95 |
| 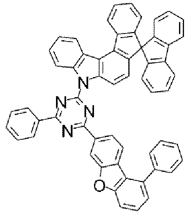 | 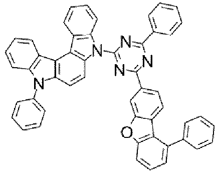 | 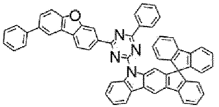 |
| E96 | E97 | E98 |
| 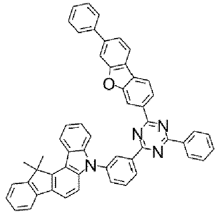 | 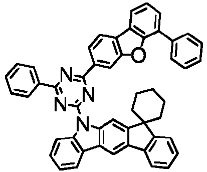 | 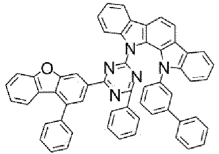 |
| E99 | E100 | E101 |
| 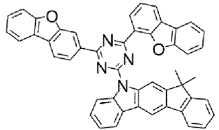 | 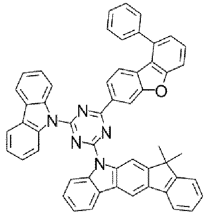 | 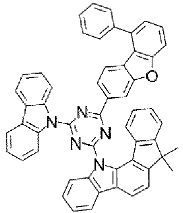 |
| E102 | E103 | E104 |
| 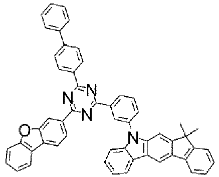 | 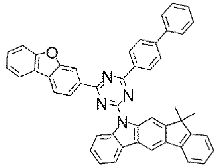 | 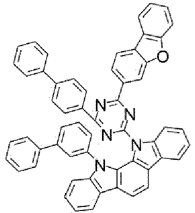 |
| E105 | E106 | E107 |
| 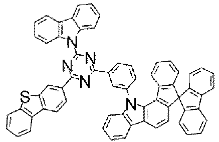 | 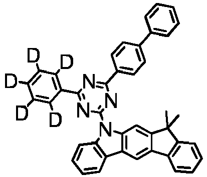 | 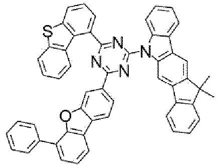 |
| E108 | E109 | E110 |
| 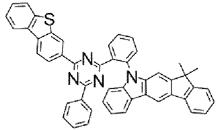 | 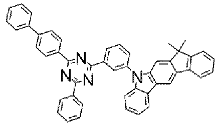 | 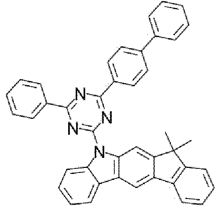 |
| E111 | E112 | E113 |
| 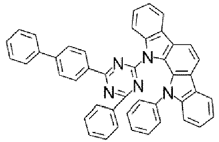 | 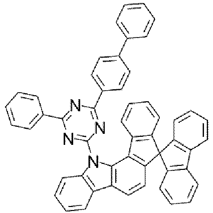 | 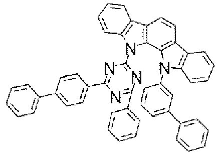 |
| E114 | E115 | E116 |
| 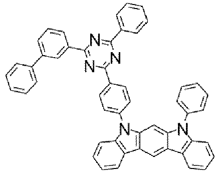 | 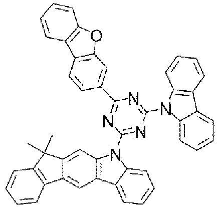 | 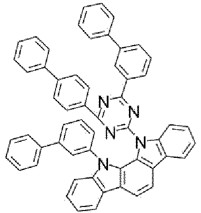 |
| E117 | E118 | E119 |
| 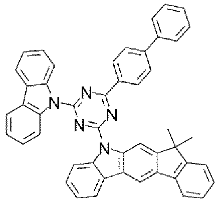 | 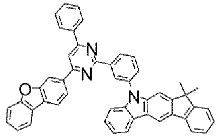 | 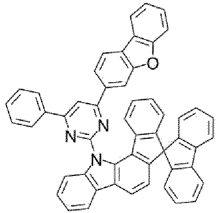 |
| E120 | E121 | E122 |
| 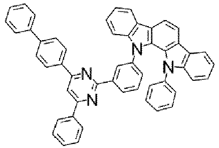 | 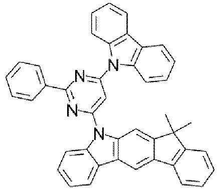 | 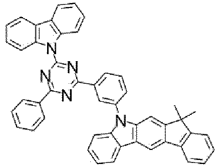 |
| E123 | E124 | E125 |
| 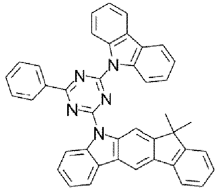 | 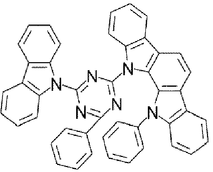 | 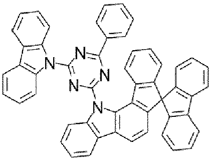 |
| E126 | E127 | E128 |
| 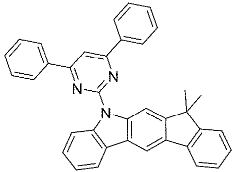 | 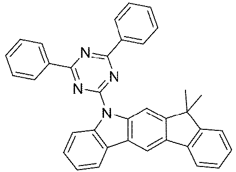 | 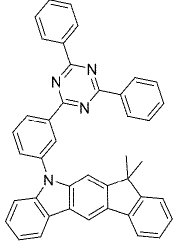 |
| E129 | E130 | E131 |
| 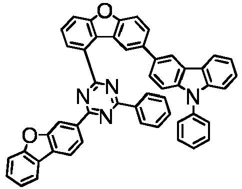 | 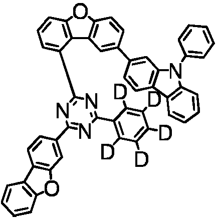 | 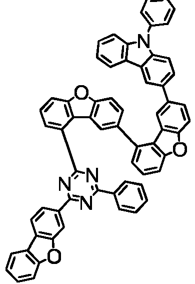 |
| E132 | E133 | E134 |
| 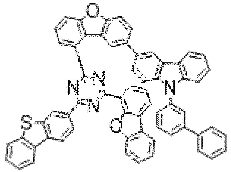 | 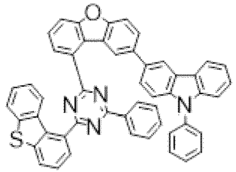 | 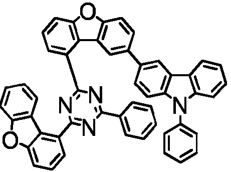 |
| E135 | E136 | E137 |
| 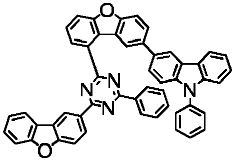 | 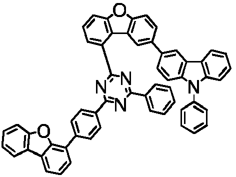 | 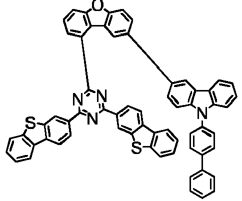 |
| E138 | E139 | E140 |
| 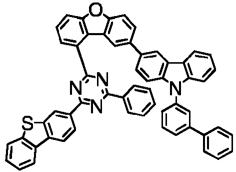 | 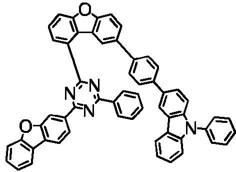 | 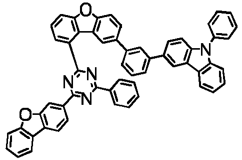 |
| E141 | E142 | E143 |
| 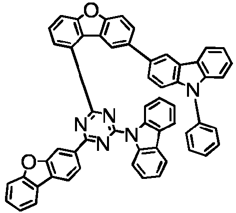 | 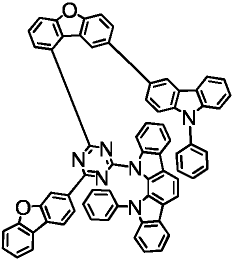 | 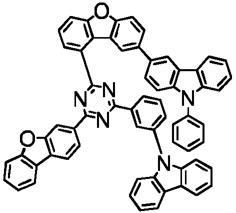 |
| E144 | E145 | E146 |
| 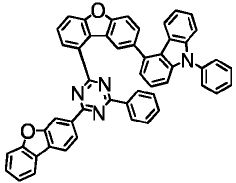 | 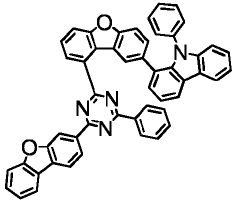 | 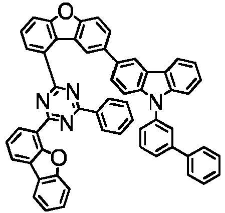 |
| E147 | E148 | E149 |
| 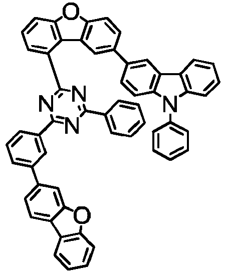 | 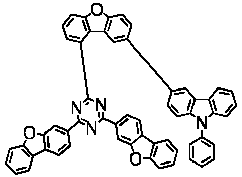 | 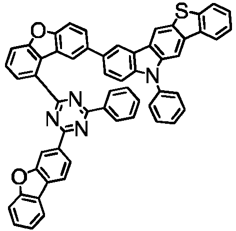 |
| E150 | E151 | E152 |
| 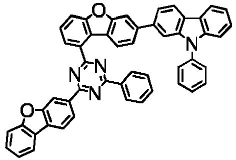 | 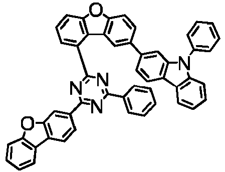 | 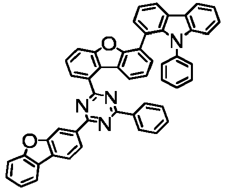 |
| E153 | E154 | E155 |
| 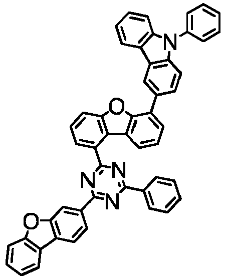 | 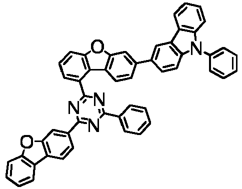 | 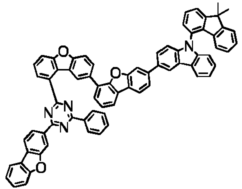 |
| E156 | E157 | E158 |
| 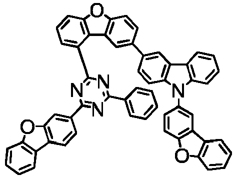 | 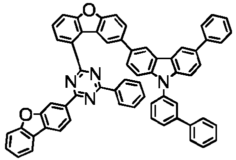 | 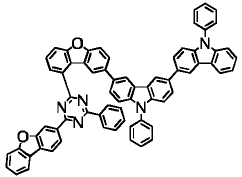 |
| E159 | E160 | E161 |
| 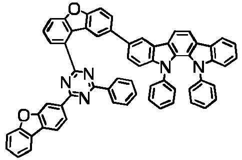 | 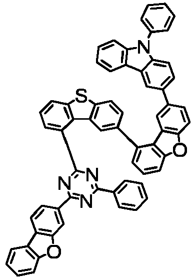 | 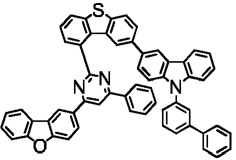 |
| E162 | E163 | E164 |
| 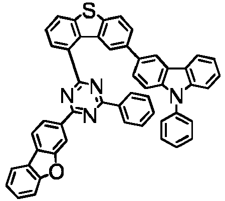 | 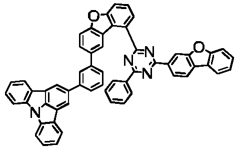 | 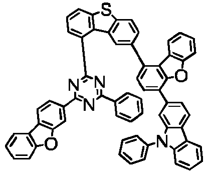 |
| E165 | E166 | E167 |
| 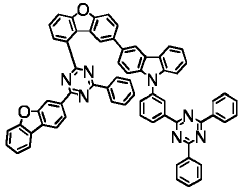 | 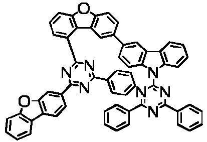 | 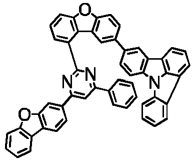 |
| E168 | E169 | E170 |
| 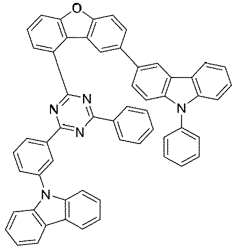 | 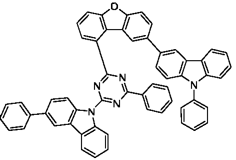 | 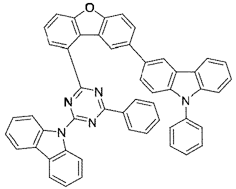 |
| E171 | E172 | E173 |
| 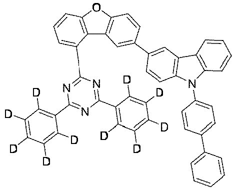 | 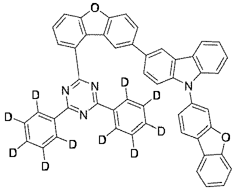 | 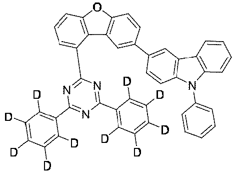 |
| E174 | E175 | E176 |
| 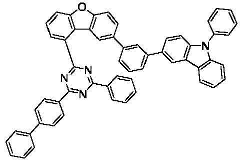 | 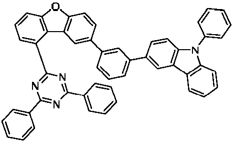 | 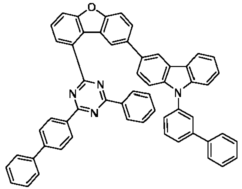 |
| E177 | E178 | E179 |
| 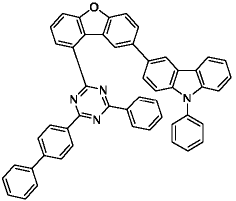 | 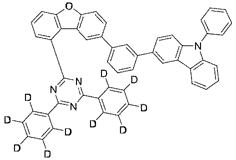 | 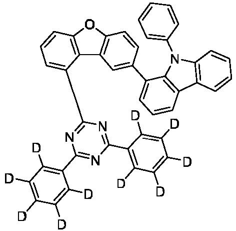 |
| E180 | E181 | E182 |
| 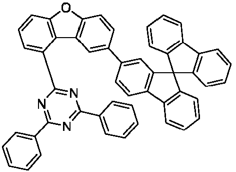 | 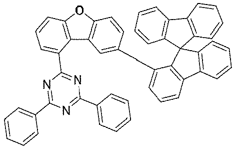 | 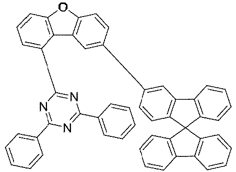 |
| E183 | E184 | E185 |
| 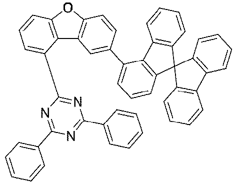 | 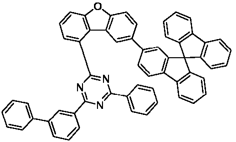 | 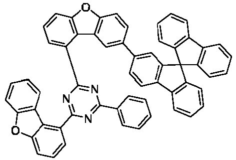 |
| E186 | E187 | E188 |
| 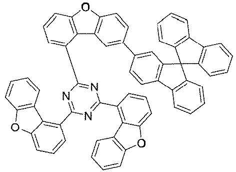 | 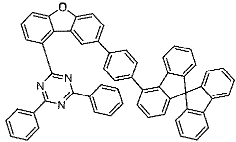 | 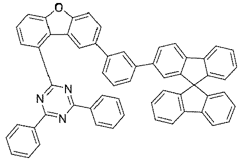 |
| E189 | E190 | E191 |
| 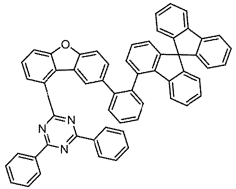 | 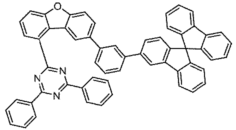 | 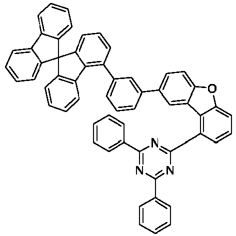 |
| E192 | E193 | E194 |
| 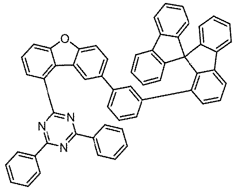 | 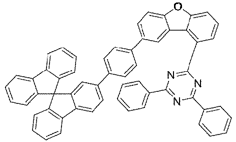 | 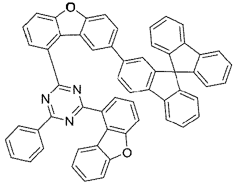 |
| E195 | E196 | E197 |
| 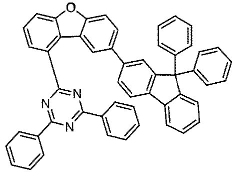 | 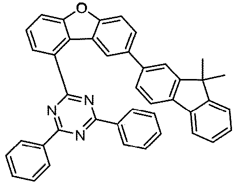 | 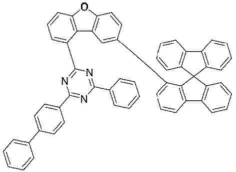 |
| E198 | E199 | E200 |
| 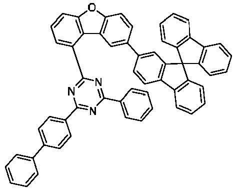 | 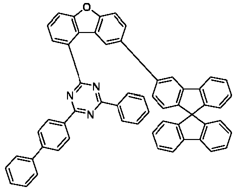 | 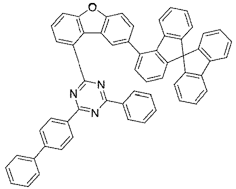 |
| E201 | E202 | E203 |
| 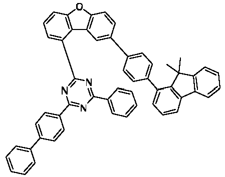 | 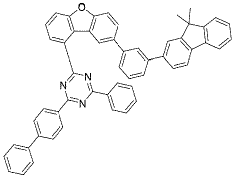 | 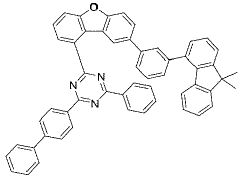 |
| E204 | E205 | E206 |
| 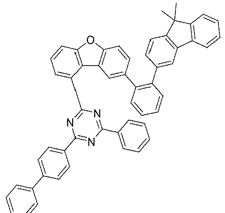 | 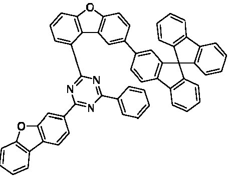 | 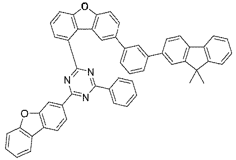 |
| E207 | E208 | E209 |
| 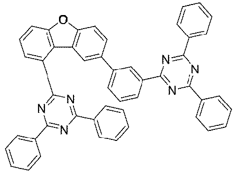 | 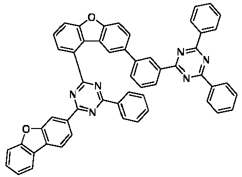 | 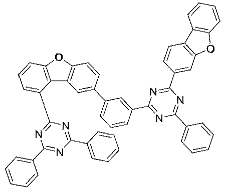 |
| E210 | E211 | E212 |
| 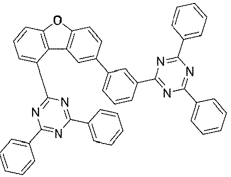 | 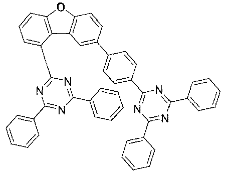 | 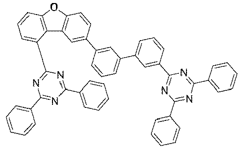 |
| E213 | E214 | E215 |
| 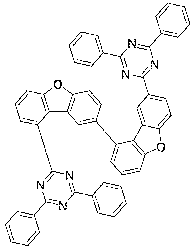 | 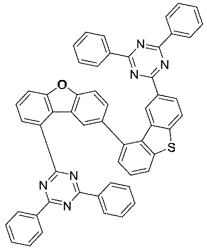 | 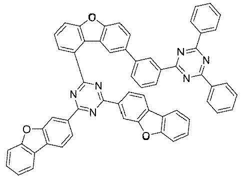 |
| E216 | E217 | E218 |
| 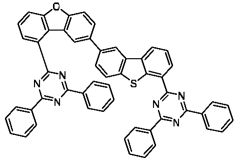 | 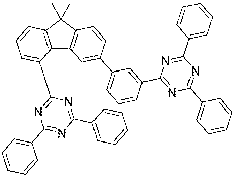 | 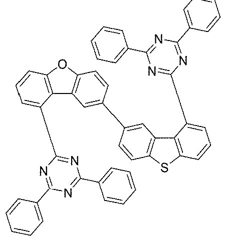 |
| E219 | E220 | E221 |
| 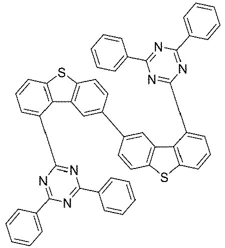 | 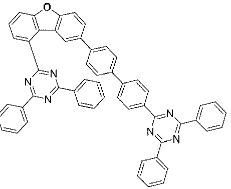 | 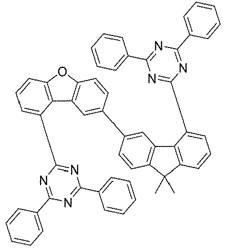 |
| E222 | E223 | E224 |
| 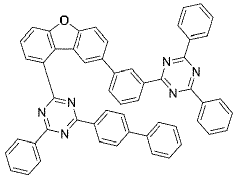 | 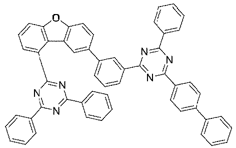 | 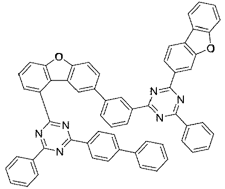 |
| E225 | E226 | E227 |
| 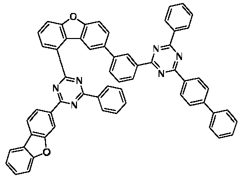 | 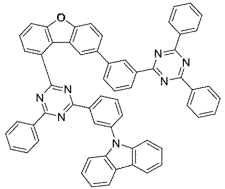 | 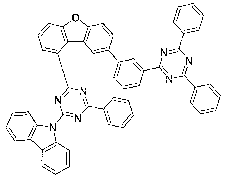 |
| E228 | E229 | E230 |
| 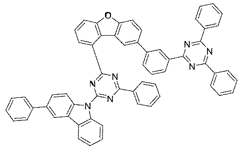 | 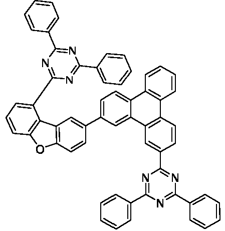 | 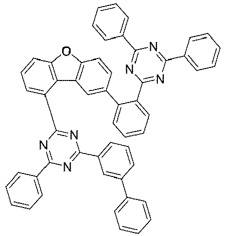 |
| E231 | E232 | E233 |
| 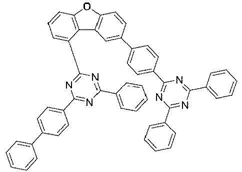 | 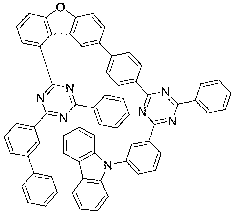 | 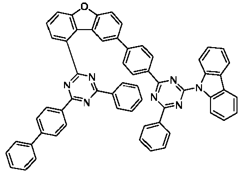 |
| E234 | E235 | E236 |
| 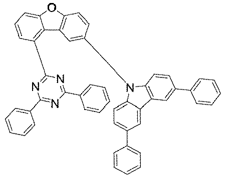 | 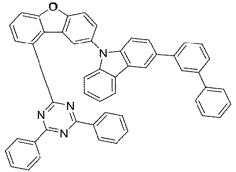 | 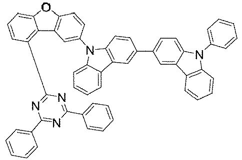 |
| E237 | E238 | E239 |
| 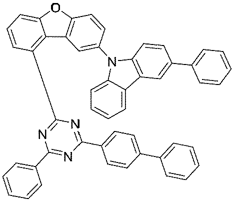 | 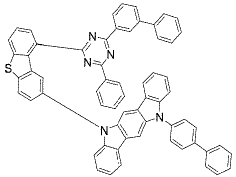 | 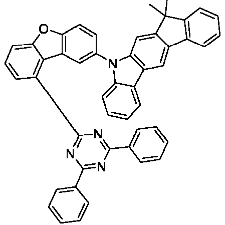 |
| E240 | E241 | E242 |
| 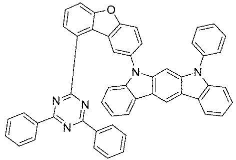 | 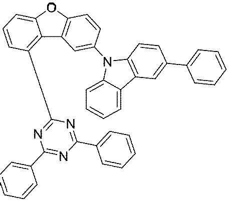 | 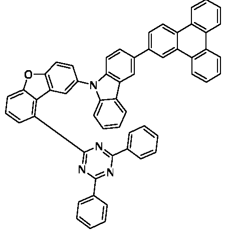 |
| E243 | E244 | E245 |
| 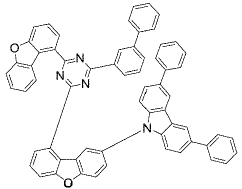 | 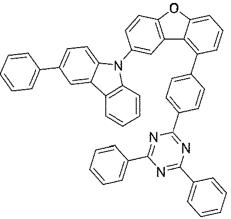 | 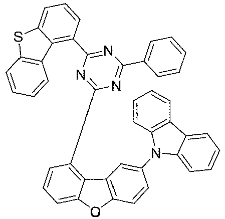 |
| E246 | E247 | E248 |
| 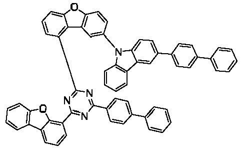 | 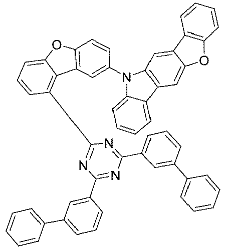 | 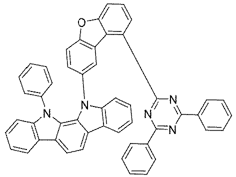 |
| E249 | E250 | E251 |
| 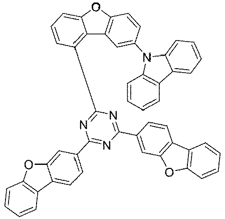 | 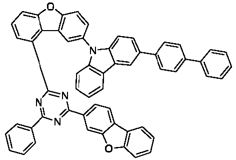 | 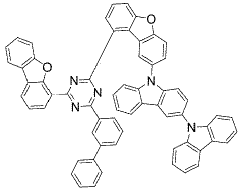 |
| E252 | E253 | E254 |
| 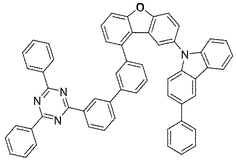 | 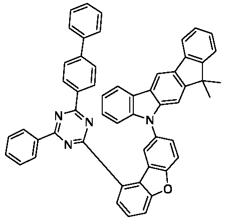 | 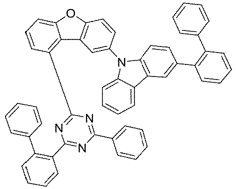 |
| E255 | E256 | E257 |
| 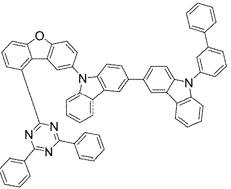 | 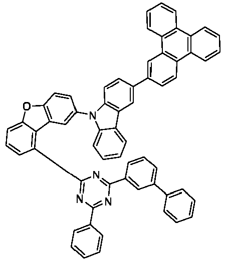 | 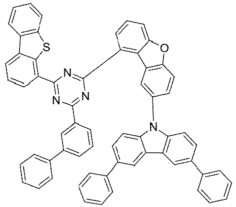 |
| E258 | E259 | E260 |
| 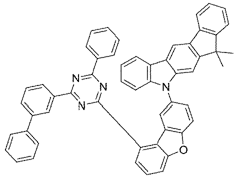 | 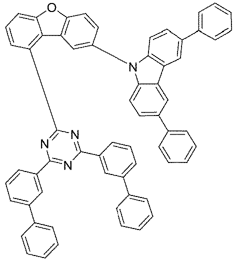 | 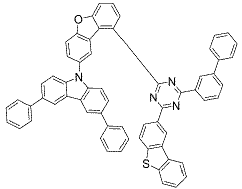 |
| E261 | E262 | E263 |
| 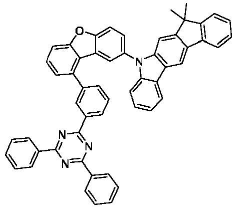 | 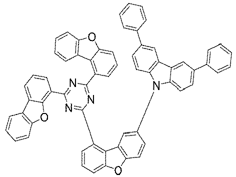 | 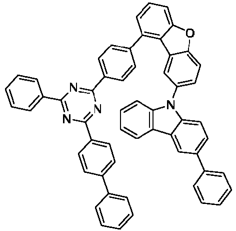 |
| E264 | E265 | E266 |
| 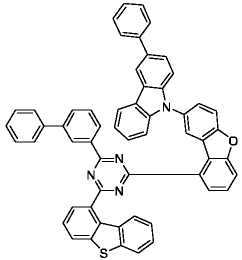 | 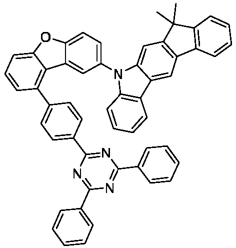 | 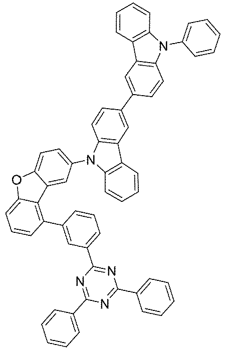 |
| E267 | E268 | E269 |
| 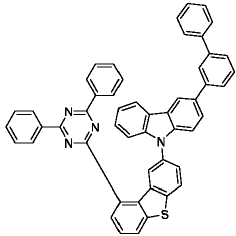 | 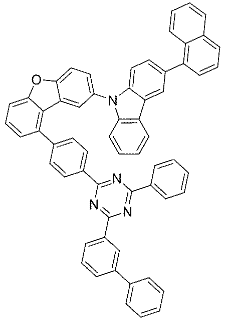 | 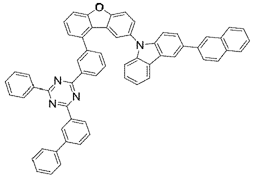 |
| E270 | E271 | E272 |
| 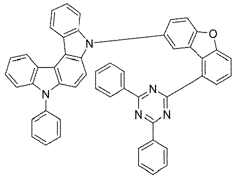 | 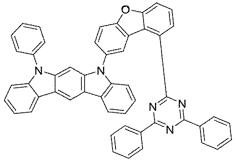 | 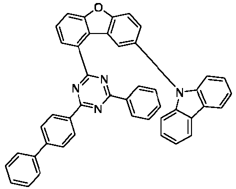 |
| E273 | E274 | E275 |
| 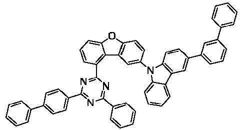 | 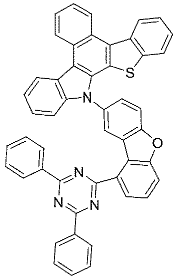 | 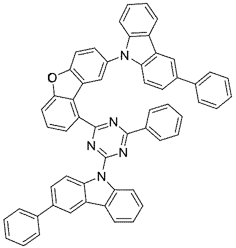 |
| E276 | E277 | E278 |
| 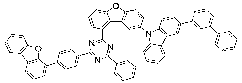 | 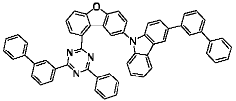 | 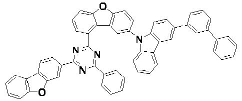 |
| E279 | E280 | E281 |
| 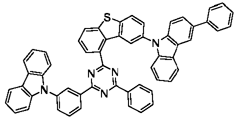 | 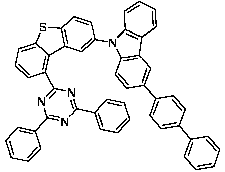 | 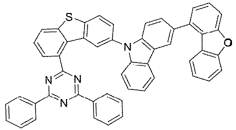 |
| E282 | E283 | E284 |
| 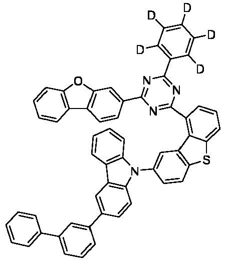 | 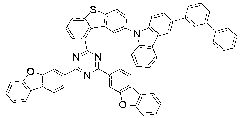 | 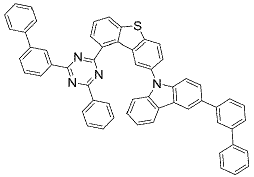 |
| E285 | E286 | E287 |
| 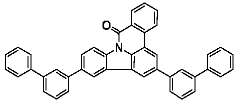 | 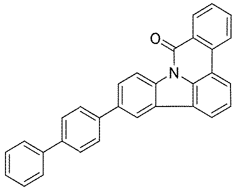 | 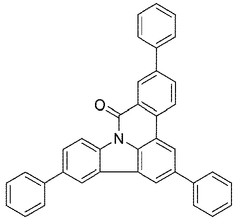 |
| E288 | E289 | E300 |
| 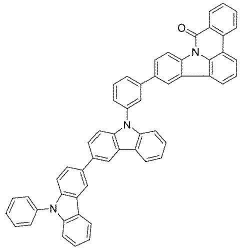 | 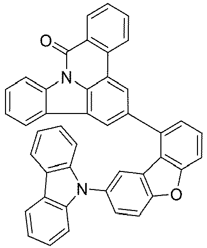 | 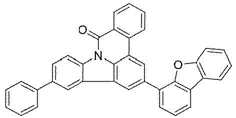 |
| E301 | E302 | E303 |

In the further layers, generally all materials can be used as they are used for the layers according to the prior art, and the skilled person can combine any of these materials in an electronic device with the materials according to the invention without any inventive intervention.

Further preferred is an organic electroluminescent device, characterized in that one or more layers are coated by a sublimation process. In this process, the materials are vapor deposited in vacuum sublimation systems at an initial pressure of usually less than 10⁻⁵ mbar, preferably less than 10⁻⁶ mbar. It is also possible for the initial pressure to be even lower or even higher, for example less than 10⁻⁷ mbar.

An organic electroluminescent device is also preferred, characterized in that one or more layers are coated using the OVPD (organic vapor phase deposition) process or with the aid of carrier gas sublimation. In this process, the materials are applied at a pressure between 10⁻⁵ mbar and 1 bar. A special case of this process is the OVJP (Organic Vapour Jet Printing) process, in which the materials are applied directly through a nozzle and thus patterned (e.g., M. S. Arnold et al., Appl. Phys. Lett. 2008, 92, 053301).

Further preferred is an organic electroluminescent device, characterized in that one or more layers are produced from solution, such as by spin coating, or by any printing process, such as screen printing, flexographic printing, offset printing or nozzle printing, but especially preferably LITI (Light Induced Thermal Imaging, Thermo trans fer printing) or ink-jet printing. Soluble compounds are required for this, which can be obtained by suitable substitution, for example.

The organic electroluminescent device can also be fabricated as a hybrid system by depositing one or more layers of solution and vapor depositing one or more other layers. For example, it is possible to deposit an emitting layer containing a metal complex of the invention and a matrix material of solution and to vacuum evaporate a hole-blocking layer and/or an electron transport layer on top of it.

These methods are generally known to those skilled in the art and can be readily applied by them to organic electroluminescent devices containing compounds according to formula (1) or the preferred embodiments listed above.

The electronic devices according to the invention, in particular organic electroluminescent devices, have the unexpected advantage over the prior art of having a significantly narrower emission spectrum than corresponding complexes not bridged by a triethylenebenzene group. This is particularly an advantage for top emission devices, as it results in a higher current efficiency (in cd/A).

The invention is explained in more detail by the following examples without wishing to limit it. The person skilled in the art can manufacture further electrical devices in accordance with the invention from the shields without the intervention of the inventor and thus implement the invention in the entire field in question.

### EXPERIMENTAL EXAMPLES

The following syntheses are carried out under an inert gas atmosphere in dried solvents, unless otherwise specified. The metal complexes are additionally handled under exclusion of light or under yellow light. The solvents and reagents can be obtained, for example, from Sigma-ALDRICH and ABCR, respectively. The respective data in square brackets or the numbers given for individual compounds refer to the CAS numbers of the compounds known from literature. For compounds that can have several enantiomers, diastereomeric or tautomeric forms, one form is shown as a representative.

### Literature-known Synthons LS:

| | | | |
|---|---|---|---|
| LS1 | 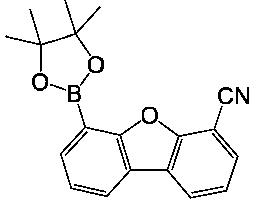 1673545-14-6 | LS2 | 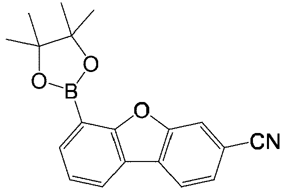 2458817-56-4 |
| LS3 | 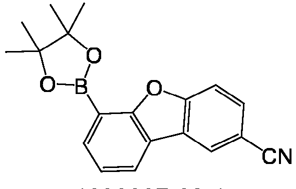 1638837-02-1 | LS4 | 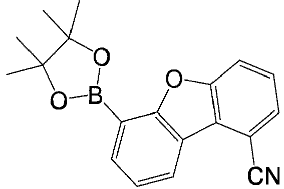 2458817-52-0 |
| LS5 | 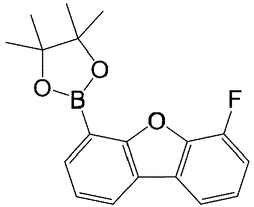 2714359-25-6 | LS6 | 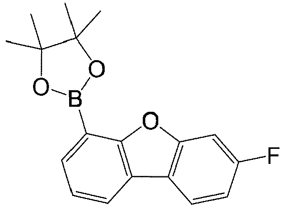 2412928-17-5 |
| LS7 | 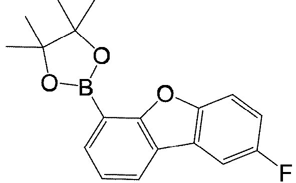 2229864-94-0 | LS8 | 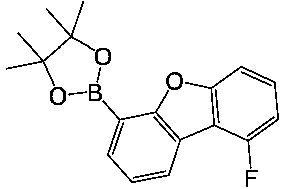 2417213-49-9 |
| LS9 | 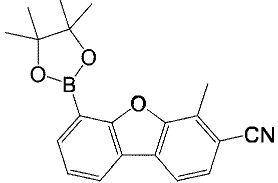 Synthesized as in US 2020/0251666 from 1349716-12-6 | | |
| LS100 | 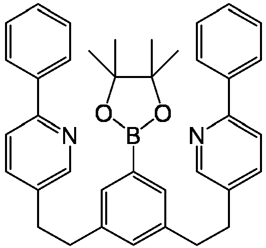 2375158-15-7 | LS101 | 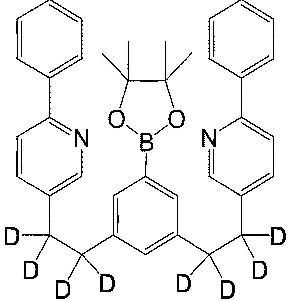 2375158-17-9 |
| LS102 | 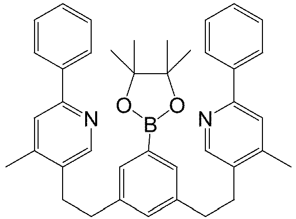 2375158-19-1 | LS103 | 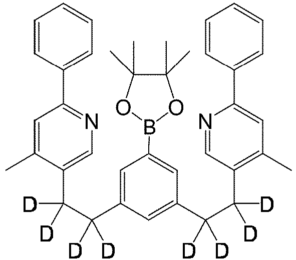 2375158-21-5 |
| LS104 | 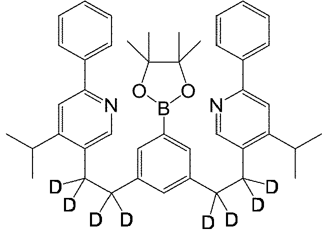 Synthesized as in WO 2019/158453, Use of 1256833-52-9 | LS105 | 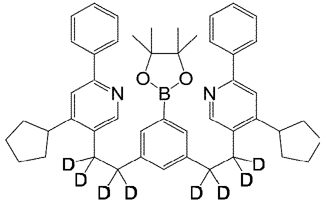 Synthesized as in WO 2019/158453, Use of 1381942-00-2 |
| LS106 | 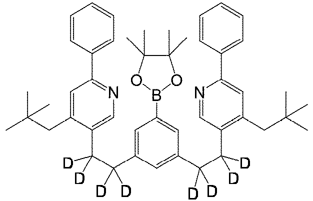 Synthesized as in WO 2019/158453, Use of LS200 | LS200 | 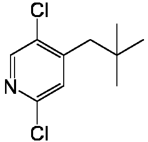 Synthesized as in CN11227980A, Use of 72990-37-5 |

### A) Synthesis of synthons S:

### Example S1:

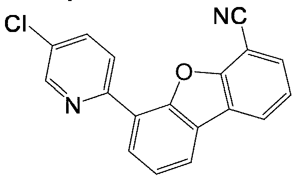

A mixture of 31.9 g (100 mmol) LS1, 14.8 g (100 mmol) 2,5- dichloropyridine [16110-09-1], 41.5 g (300 mmol) potassium carbonate, 702 mg (1 mmol) bis(triphenylphosphino)palladium dichloride [13965-03-2], 100 g glass spheres (3 mm diameter), 200 ml acetonitrile, and 200 ml methanol is heated for 16 h under weak reflux. Suction is applied while still warm over a Celite bed pre-slurried with acetonitrile, concentrate the filtrate to dryness, collect the residue in 400 ml dichloromethane (DCM) and 100 ml ethyl acetate (EA), and filter over a silica gel bed pre-slurried with DCM/EA (4:1). Add 200 ml methanol (MeOH) to the filtrate and slowly concentrate it in vacuo to about 100 ml, aspirate from the crystallized product, rewash twice with 30 ml MeOH each, and dry in vacuo. Yield: 22.6 g (74 mmol) 74 %; purity: ca. 98 % by¹H NMR.

Similarly, the following compounds can be prepared in yields of about 70-90%:

| Ex. | Educts | Product |
|---|---|---|
| S2 | LS2 | 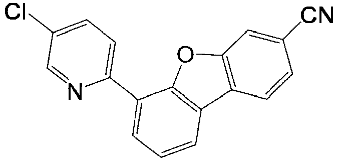 |
| | 16110-09-1 | |
| S3 | LS2 | 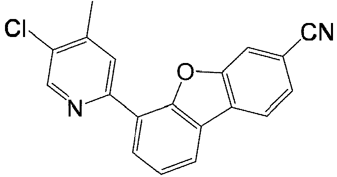 |
| | 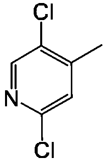 886365-00-0 | |
| S4 | LS2 | 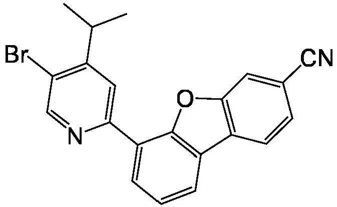 |
| | 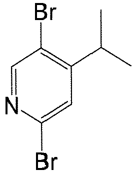 1256833-52-9 | |
| S5 | LS2 | 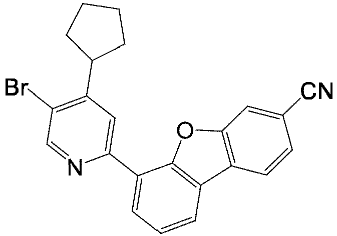 |
| | 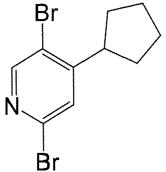 1381942-00-2 | |
| S6 | LS2 | 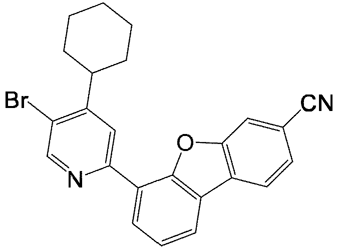 |
| | 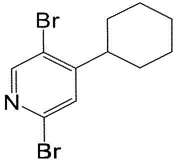 1381933-49-8 | |
| S7 | LS3 | 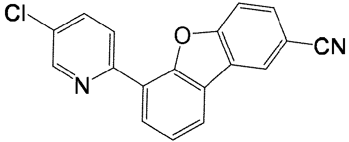 |
| | 16110-09-1 | |
| S8 | LS4 | 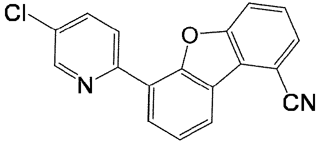 |
| | 16110-09-1 | |
| S9 | LS5 | 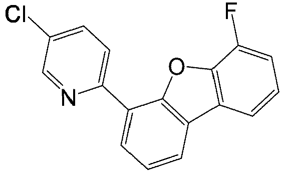 |
| | 16110-09-1 | |
| S10 | LS6 | 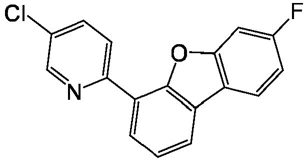 |
| | 16110-09-1 | |
| S11 | LS6 | 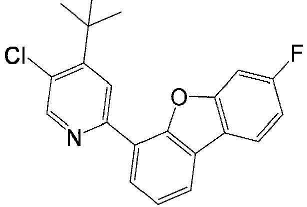 |
| | 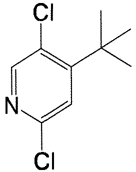 124420-75-3 | |
| S12 | LS7 | 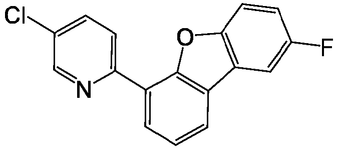 |
| | 16110-09-1 | |
| S13 | LS8 | 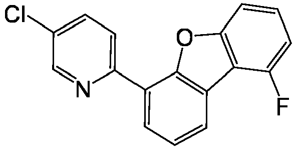 |
| | 16110-09-1 | |
| S14 | LS9 | 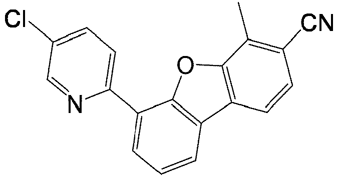 |
| | 16110-09-1 | |
| S15 | LS9 | 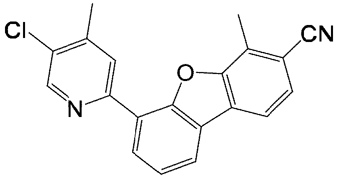 |
| | 886365-00-0 | |
| S16 | LS9 | 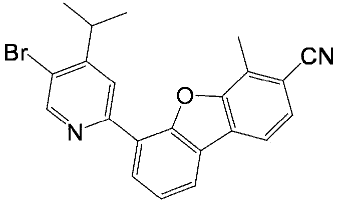 |
| | 1256833-52-9 | |
| S17 | LS9 | 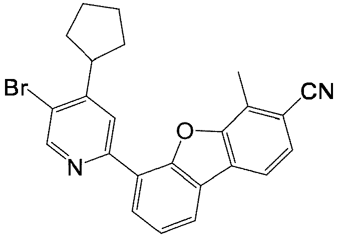 |
| | 1381942-00-2 | |
| S18 | S2 | 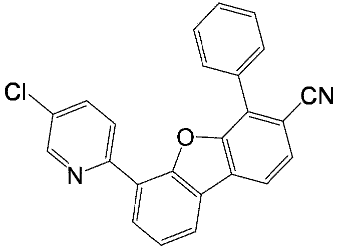 Synthesized as in US 2020/0091442 |
| S19 | S10 | 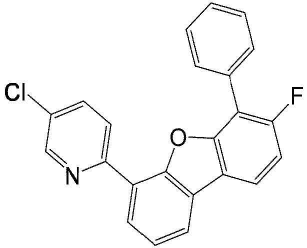 Synthesized as in US 2020/0091442 |
| S20 | LS2 | 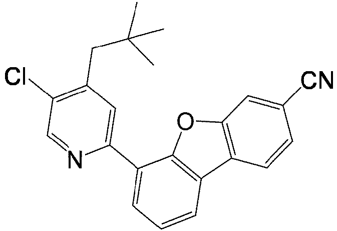 |
| | LS200 | |
| S21 | LS6 | 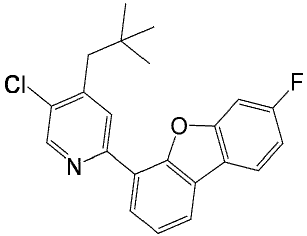 |
| | LS200 | |
| RefS1 | LS1 | 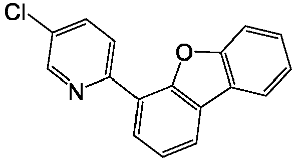 |
| | | |
| | 100124-06-9 | |

### Example S100:

### A) S100A

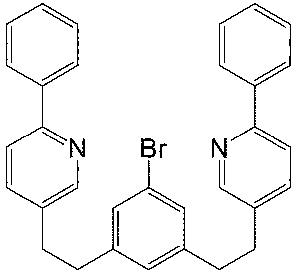

A suspension of 56.7 g (100 mmol) LS100 in 500 ml MeOH is heated to 40 °C and then a solution of 46.9 g (210 mmol) copper(II) bromide in 400 ml water is added dropwise for 30 min with good stirring. After the addition is complete, heat for 12 h under reflux, then distill off about 500 ml and substitute with 500 ml of water. Allow to cool to room temperature with stirring, aspirate from the precipitated solid, wash three times with 200 ml water each time and aspirate dry. Suspend the solid in 600 ml DCM, add 200 ml conc. ammonia, stir for 2 h, separate the aqueous phase, wash the organic phase three times with 200 ml 2.5 N ammonia solution each, twice with 200 ml water each and once with brine and dry over magnesium sulfate. Aspirate from the desiccant, add 200 ml MeOH to the filtrate and concentrate to about 200 ml. Aspirate from the crystallized product, wash twice with a little methanol and dry in vacuo. Yield: 42.3 g (81 mmol) 81%; purity: about 97% by ¹H NMR.

### B) S100

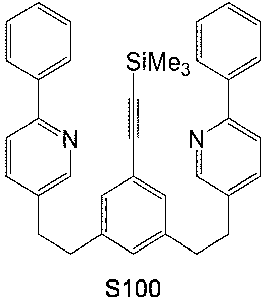

A mixture of 52.0 g (100 mmol) S100A, 28.6 ml (200 mmol) tri methyl silylacetylene [1066-54-2], 64.1 ml (500 mmol) triethylamine [121-44-8], 300 ml DMF, 572 mg (3 mmol) copper(I) iodide [7681-65-4], 2.11 g (3 mmol) bis(triphenylphosphino)palladium dichloride [13965-03-2] is stirred for 12 h at 75 °C. The reaction mixture is largely concentrated in vacuo, the residue is taken up in 500 ml DCM, washed three times each with 200 ml water and once with 200 ml total brine, and dried over magnesium sulfate. Filter off from the desiccant over a bed of Celite pre-slurried with DCM and concentrate the filtrate in vacuo. The crude product obtained is further reacted without further purification. Yield: 49.0 g (91 mmol) 91 %. Purity ca. 95 % by ¹H-NMR.

Similarly, the following compounds can be prepared in yields of about 70-90%:

| Ex. | Educts | Product |
|---|---|---|
| S101 | LS101 | 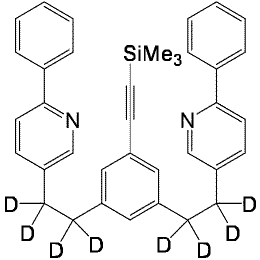 |
| S102 | LS102 | 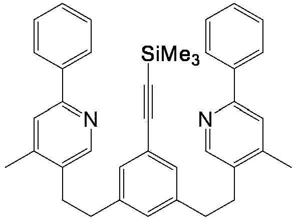 |
| S103 | LS103 | 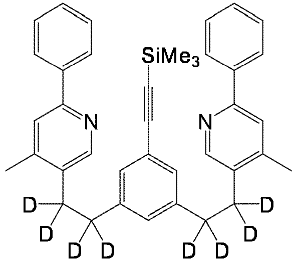 |
| S104 | LS104 | 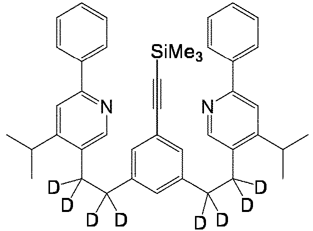 |
| S105 | LS105 | 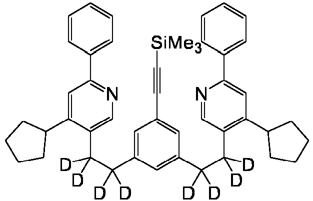 |
| S106 | LS106 | 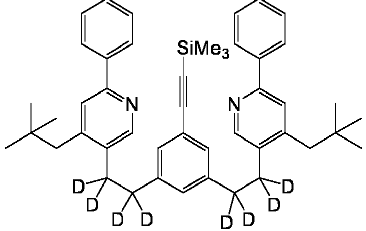 |
| S300 | S200 | 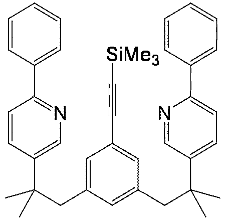 |

### Example S200:

### a) Step 200a:

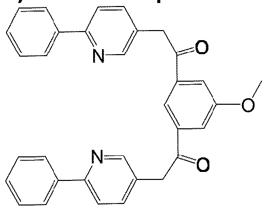

A well-stirred mixture of 9.6 g (50 mmol) 1,1'-(5-methoxy-1,3-phenylene)bis-ethanone [35227-79-3], 23.4 g (100 mmol) 5-bromo-2-phenyl pyridine [27012-25-5], and 150 ml THF is mixed with 24.0 g (250 mmol) sodium tert-butanolate [865-48-5], 577 mg (1 mmol) XantPhos [161265-03-8], and 225 mg (1 mmol) palladium(II) acetate [3375-31-3], and then heated at reflux for 3 h. After cooling, the THF is removed in vacuo, the residue is taken up in 300 ml dichloromethane (DCM), the organic phase is washed twice with 150 ml water and once with 100 ml saturated brine, and dried over magnesium sulfate. Filter off the desiccant, remove the DCM in vacuo, and chromatograph (Torrent automatic column machine from Semrau) the residue. Yield: 15.6 g (31 mmol) 62 %; purity: ca. 97 % by ¹H-NMR.

### b) Step 200b:

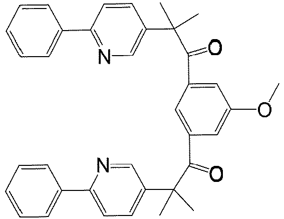

To a well-stirred solution of 18.3 g (50 mmol) 200a in 1000 ml tetrahydrofuran (THF), tempered to 25 °C, add dropwise for 5 min 100 ml (100 mmol) potassium hexamethyldisilazide (KHMDS) [40949-94-0], 1M in THF and stir for 15 min. Then add 3.4 ml (100 mmol) of methyl iodide [74-88-4] at a time and stir for 30 min. Then, 100 ml (100 mmol) of potassium hexamethyldisilazide (KHMDS), 1M in THF is added again to the reaction mixture during 5 min and stirring is continued for 15 min. Then add 3.4 ml (100 mmol) of methyl iodide at a time and stir for 30 min. Then, 10 ml (10 mmol) of potassium hexamethyldisilazaid KHMDS), 1M in THF is added to the reaction mixture again during 5 min and stirring is continued for 15 min. Then add 0.34 ml (10 mmol) of methyl iodide at a time and re-stir for 1 h. Remove the THF in vacuo, take up the residue in 300 ml dichloromethane (DCM), wash the organic phase twice with 150 ml water each and once with 100 ml saturated brine, and dry over magnesium sulfate. Filter off the desiccant, remove the DCM in vacuo, and chromatograph (Torrent automatic column machine from Semrau) the residue. Yield: 20.1 g (36 mmol) 72 %; purity: ca. 97 % by ¹H-NMR.

### c) Step 200c:

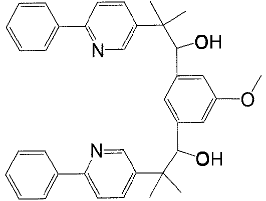

To a well-stirred solution of 55.5 g (100 mmol) 200b in 1500 ml THF, cooled to 0 °C, add 15.2 g (400 mmol) lithium aluminum-hydride [16853-85-3] in portions and stir for 15 min. Allow the reaction mixture to warm to room temperature, stir for 1 h, cool again to 0 °C, then add dropwise 15 ml water (caution: exothermic reaction, gas evolution!), 15 ml 15 wt% aqueous NaOH, and 45 ml water, and stir for 30 min. Filter off the precipitated aluminum salts, concentrate the filtrate to dryness, collect the residue in 300 ml DCM and 100 ml ethyl acetate (EA), filter over a silica gel bed pre-slurried with DCM:EA (3:1 vv), and remove the solvent in vacuo. Yield: 52.9 g (95 mmol), 95% diastereomer mixture; purity: ca. 97% by ¹H NMR.

### d) Step 200d:

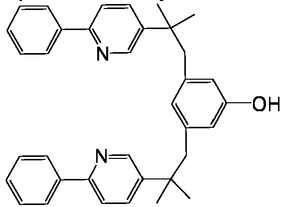

To a solution of 55.8 g (100 mmol) 200c in 500 ml glacial acetic acid, add 263.4 ml aqueous hydriodic acid (57 wt%) and 49.3 ml aqueous hypophosphoric acid (50 wt%), then stir for 60 h. The solution is then mixed with a solution of 0.5 g (100 mmol) 200c in 500 ml glacial acetic acid. After cooling, pour onto 5 kg ice and then adjust to pH ~ 7 by adding solid NaOH in portions, extract the aqueous phase three times with 300 ml DCM, wash the combined organic phases two times with 200 ml water and once with 200 ml saturated brine, and then dry over magnesium sulfate. Filter off the desiccant and concentrate the filtrate to dryness. Yield: 47.7 g (93 mmol), 93 %; purity: about 97 % by ¹H-NMR.

### e) Step 200e:

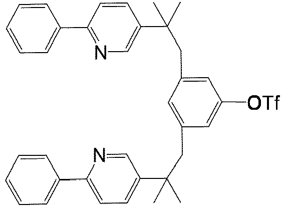

To a well-stirred mixture of 51.3 g (100 mmol) 200d, 10.5 ml (130 mmol) pyridine [110-86-1], and 300 ml DCM cooled to 0 °C, add dropwise 21.9 ml (130 mmol) trifluoromethanesulfonic anhydride [358-23-6], stir for 15 min at 0 °C and then for 16 h at room temperature. Hydrolyze by adding 200 g of ice, wash the combined organic phases twice with 150 ml of water and once with 100 ml of saturated brine, and then dry over magnesium sulfate. Filter off the desiccant and concentrate the filtrate to dryness. Yield: 61.5 g (95 mmol), 95%; purity: approximately 97% by ¹H-NMR.

### f) Step 200:

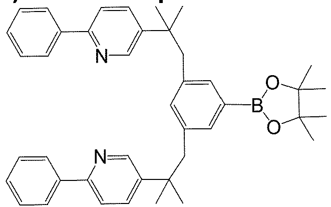

A well-stirred mixture of 64.5 g (100 mmol) 200e, 50.8 g (200 mmol) bis(pinacolato)diborane [73183-34-3], 29.5 g (300 mmol) potassium acetate, anhydrous [127-08-2], 200 g glass spheres (3 mm diameter knife), 3.7 g (5 mmol) bis(tricyclohexylphosphino)palladium(II) chloride [29934-17-6], and 1500 ml dioxane is stirred for 18 h at 100 °C. Filter off while still warm over a Celite bed pre-slurried with dioxane, concentrate the filtrate in vacuo, collect the residue in 500 ml DCM, wash the organic phase twice with 300 ml water and once with 200 ml saturated brine, and dry over magnesium sulfate. Add 100 ml of EA, draw off over a silica gel bed pre-slurried with DCM:EA (3:1, vv), concentrate the filtrate to dryness and chromatograph (Torrent automatic column machine from Semrau) the residue stand. Yield: 50.5 g (76 mmol) 76 %; purity: approx. 97 % by ¹H-NMR.

### B) Synthesis of ligands L:

### Example L1:

### A) L1A:

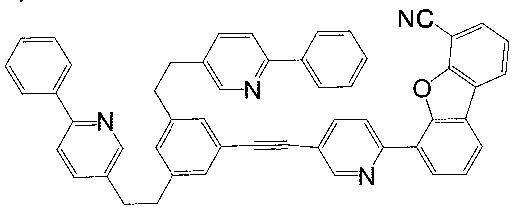

To a well-stirred solution of 53.7 g (100 mmol) S100 in 500 ml acetonitrile and 4.3 ml (105 mmol) methanol, add 13.8 g (100 mmol) potassium carbonate and 100 g glass beads at room temperature. After weakly exothermic reaction, stir for 1 h more, add 30.5 g (100 mmol) S1, 20.7 g (150 mmol) potassium carbonate, 1.91 g (4 mmol) X-Phos and 449 mg (2 mmol) palladium(II) acetate and stir for 16 h under reflux. Aspirate while still warm over a Celite bed pre-slurried with acetonitrile, condense the filtrate in vacuo at 40 °C, take up the reflux in 600 ml DCM, wash three times each with 200 ml water and once with 200 ml brine, and dry over magnesium sulfate. Add 200 ml EA, filter off over a silica gel bed pre-slurried with DCM/EA (4:1 vv), concentrate the filtrate to about 150 ml in vacuo, aspirate from the precipitated product, wash three times with 100 ml methanol each, and dry in vacuo at 40 °C. Yield: 52.0 g (71 mmol), 71 %; purity: ca. 97 % by ¹H NMR.

### B) L1:

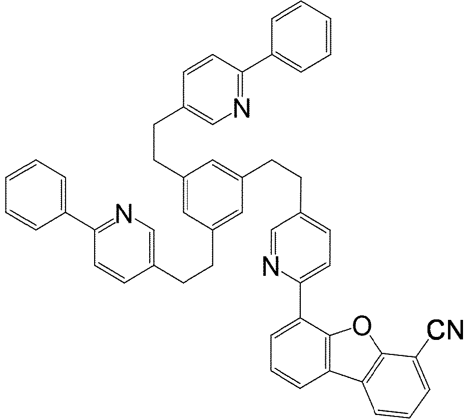

Hydrogenate 73.3 g (100 mmol) L1A in a mixture of 500 ml THF and 300 ml MeOH with the addition of 2 g palladium (5 wt%) on charcoal and 16.1 g (300 mmol) NH₄ Cl at 40 °C under 1.5 bar hydrogen atmosphere until hydrogen uptake is completed (about 12 h). Filter from the catalyst over a Celite bed pre-slurried with THF, remove the solvent in vacuo and flash-chromatograph the residue on an automated column (CombiFlashTorrent from A Semrau). Yield: 55.4 g (75 mmol), 75%; purity: approximately 97% by ¹H-NMR.

Analogously, the deuteration of the alkyne can also be carried out using deuterium D₂, H₃COD and ND₄Cl, obtaining -CD₂-CD₂ bridges instead of-CH₂-CH₂ bridges.

Analogously, the following compounds can be prepared in yields of about 40-60%:

| Ex. | Educts | Product |
|---|---|---|
| L2 | S1 | 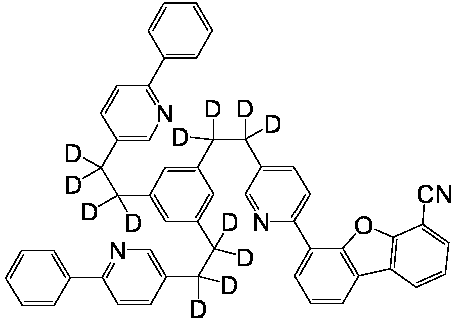 |
| | S101 | |
| L3 | S2 | 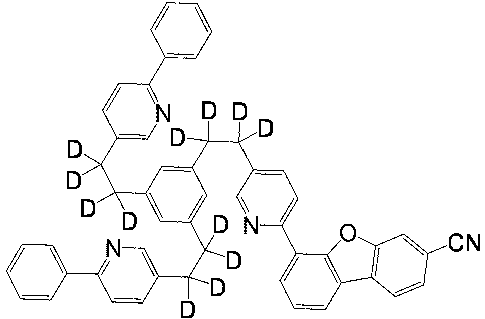 |
| | S101 | |
| L4 | S3 | 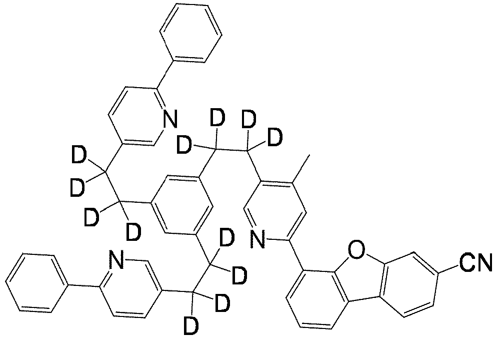 |
| | S101 | |
| L5 | S4 | 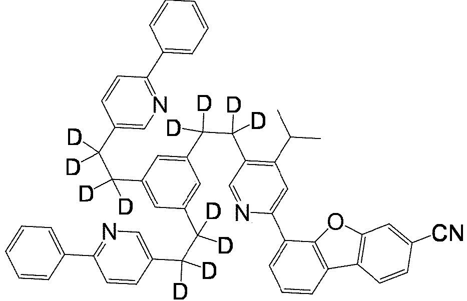 |
| | S101 | |
| L6 | S5 | 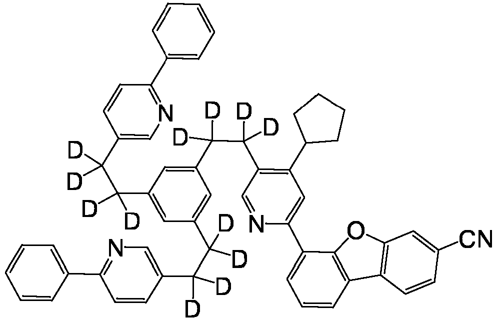 |
| | S101 | |
| L7 | S6 | 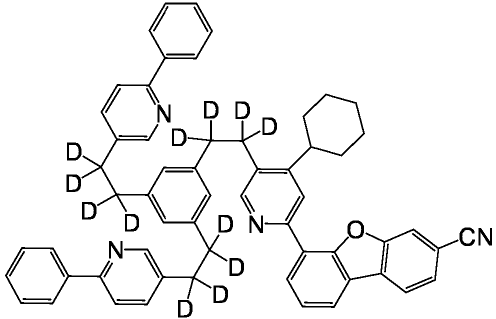 |
| | S101 | |
| L8 | S7 | 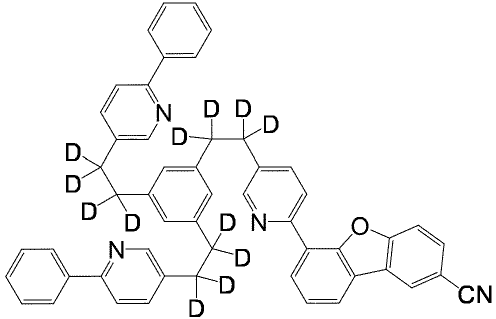 |
| | S101 | |
| L9 | S8 | 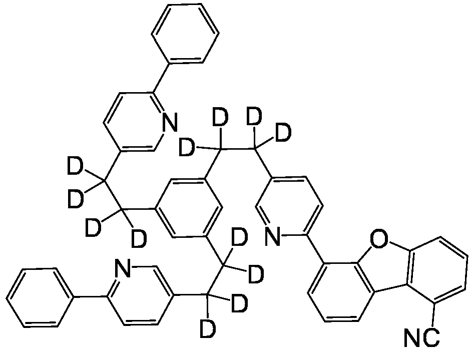 |
| | S101 | |
| L10 | S9 | 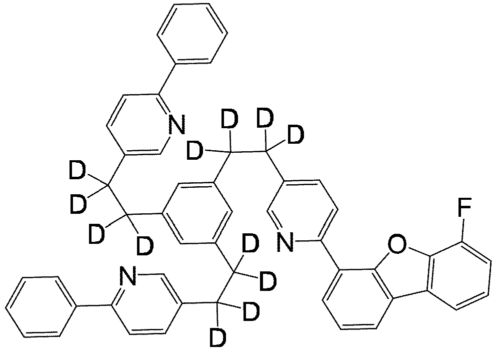 |
| | S101 | |
| L11 | S10 | 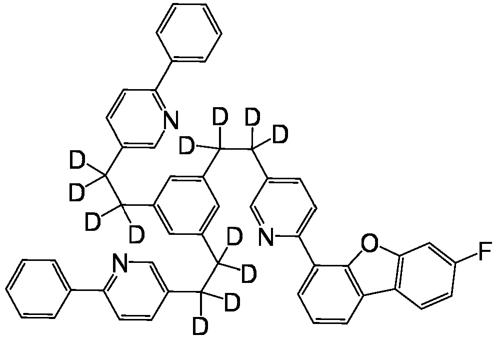 |
| | S101 | |
| L12 | S11 | 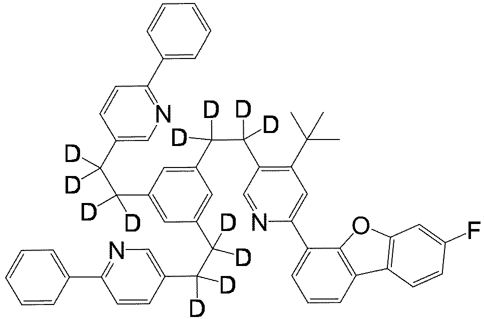 |
| | S101 | |
| L13 | S12 | 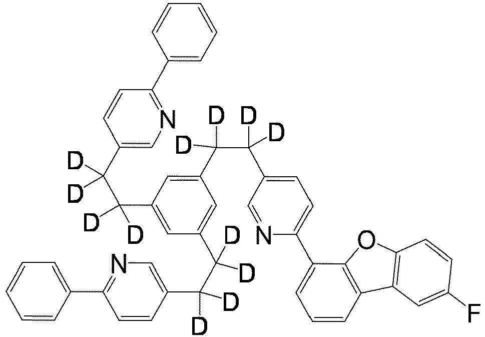 |
| | S101 | |
| L14 | S13 | 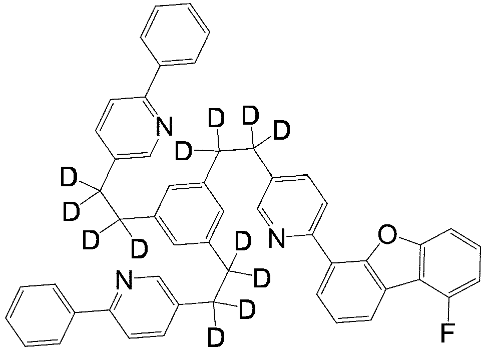 |
| | S101 | |
| L15 | S14 | 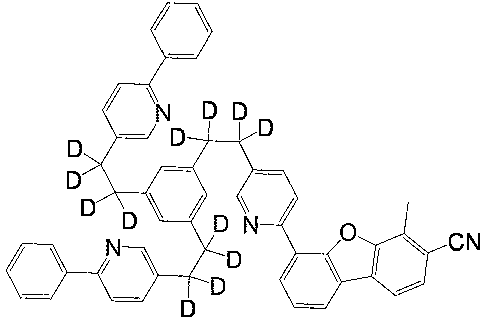 |
| | S101 | |
| L16 | S15 | 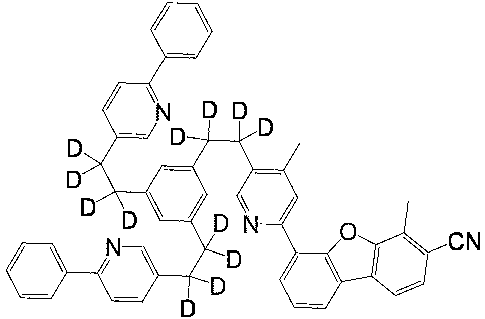 |
| | S101 | |
| L17 | S16 | 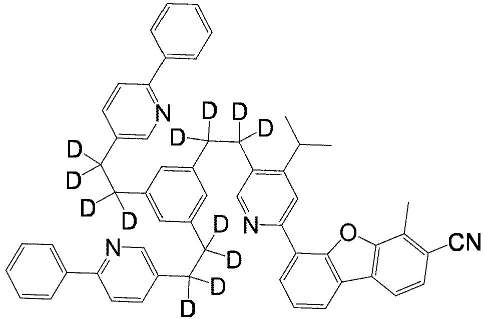 |
| | S101 | |
| L18 | S17 | 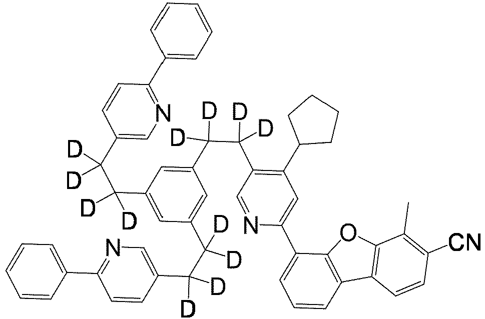 |
| | S101 | |
| L19 | S18 | 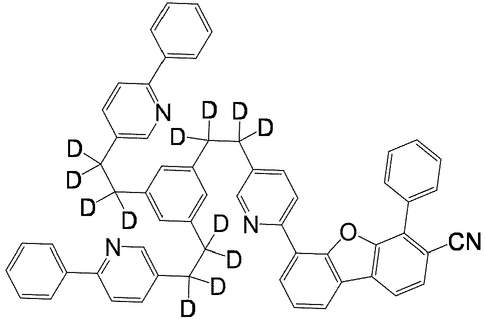 |
| | S101 | |
| L20 | S19 | 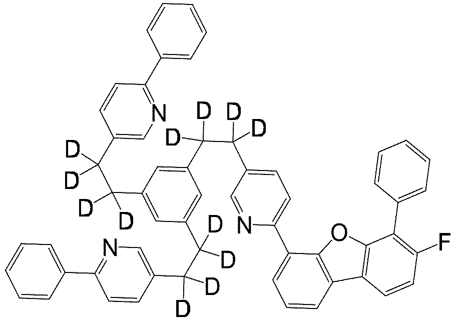 |
| | S101 | |
| L21 | S2 | 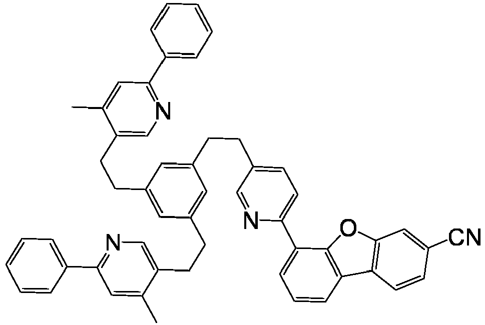 |
| | S102 | |
| L22 | S3 | 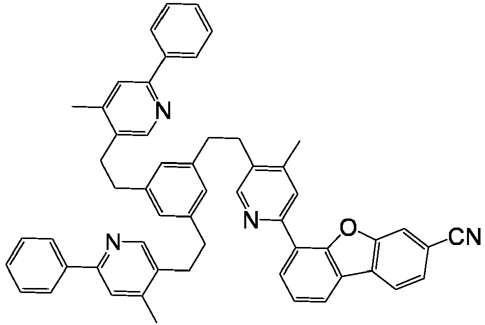 |
| | S102 | |
| L23 | S10 | 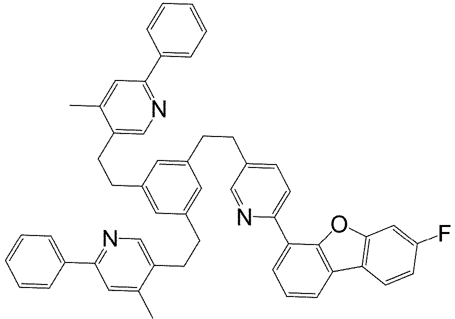 |
| | S102 | |
| L24 | S14 | 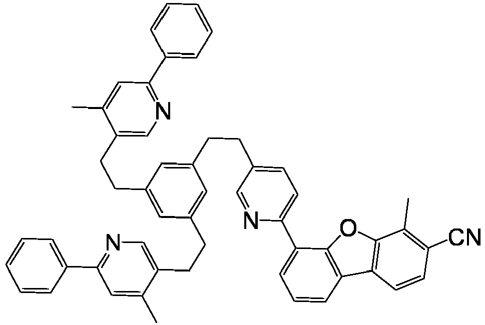 |
| | S102 | |
| L25 | S1 | 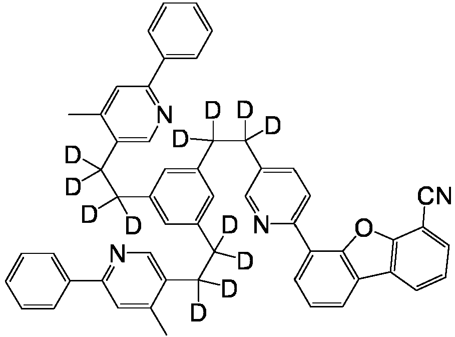 |
| | S103 | |
| L26 | S2 | 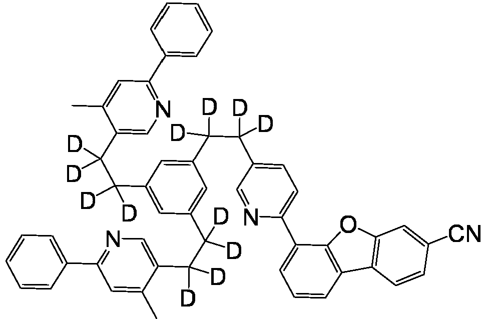 |
| | S103 | |
| L27 | S3 | 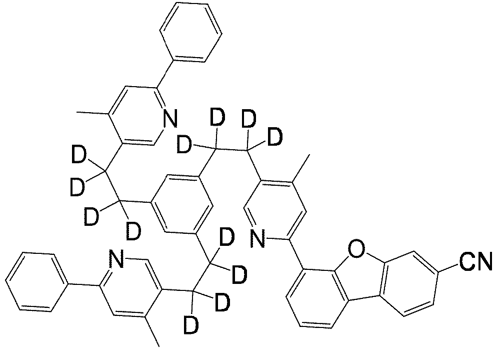 |
| | S103 | |
| L28 | S4 | 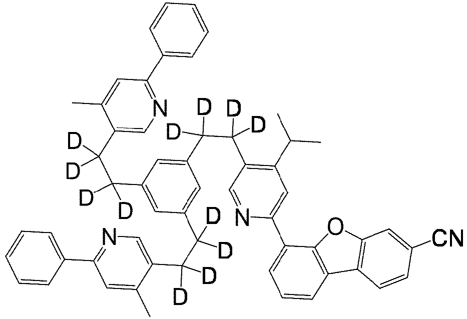 |
| | S103 | |
| L29 | S5 | 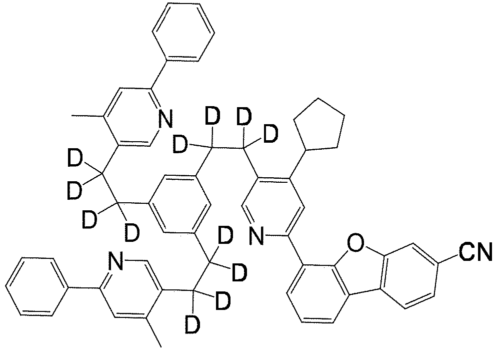 |
| | S103 | |
| L30 | S6 | 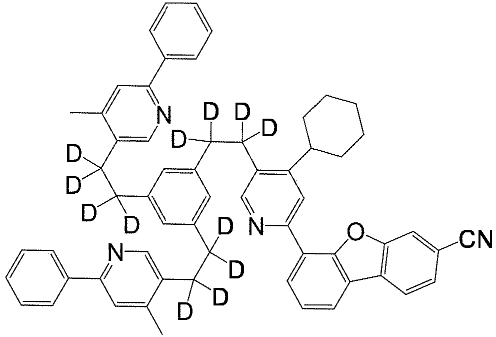 |
| | S103 | |
| L31 | S7 | 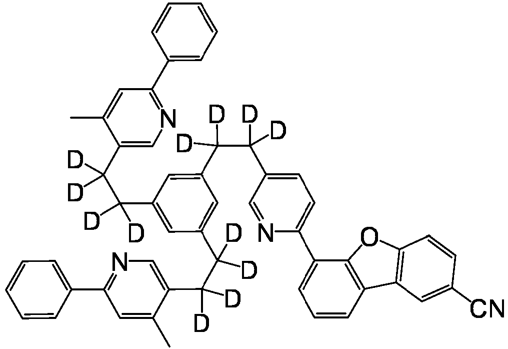 |
| | S103 | |
| L32 | S8 | 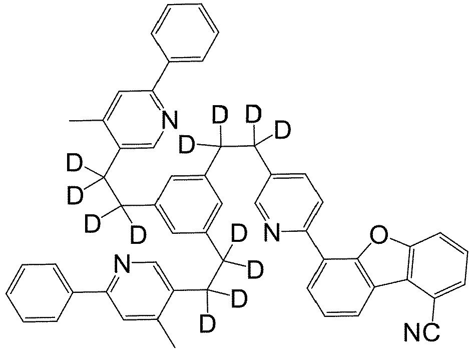 |
| | S103 | |
| L33 | S9 | 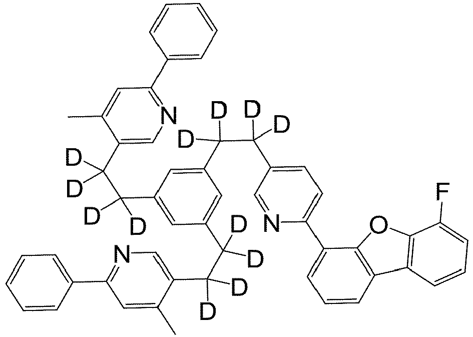 |
| | S103 | |
| L34 | S10 | 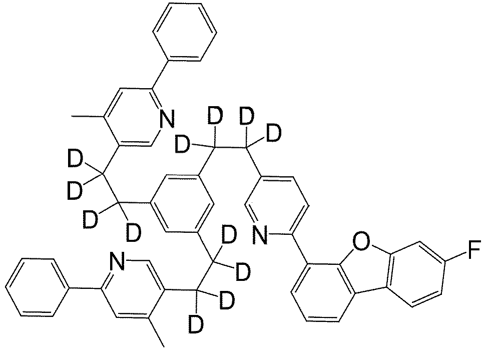 |
| | S103 | |
| L35 | S11 | 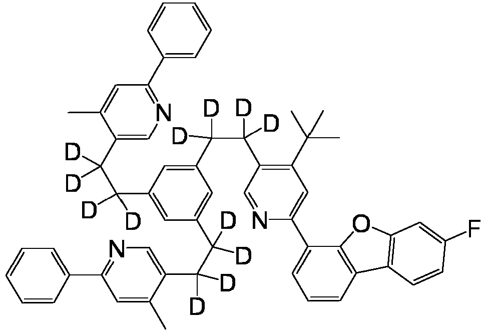 |
| | S103 | |
| L36 | S12 | 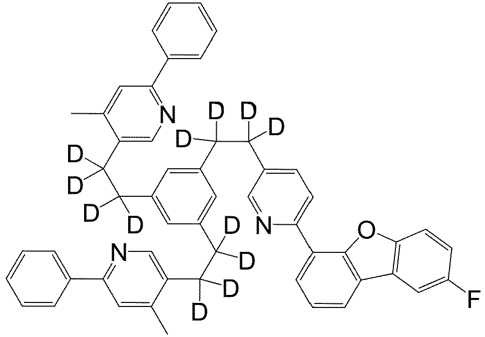 |
| | S103 | |
| L37 | S13 | 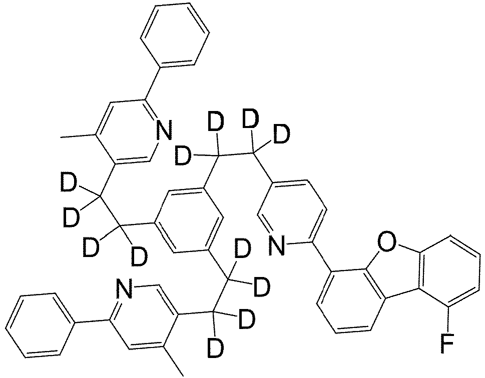 |
| | S103 | |
| L38 | S14 | 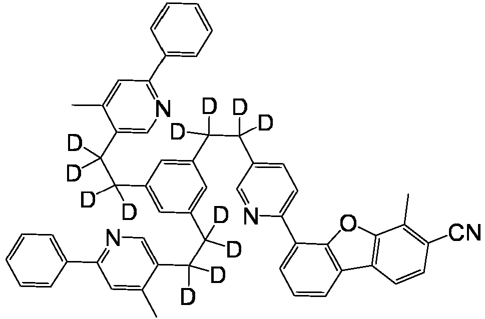 |
| | S103 | |
| L39 | S15 | 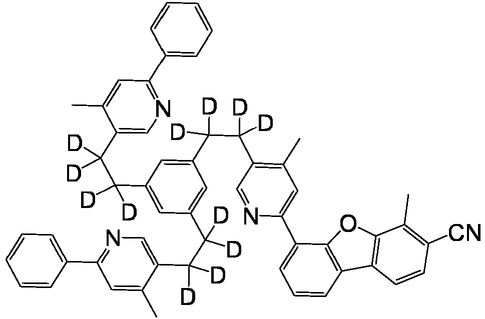 |
| | S103 | |
| L40 | S16 | 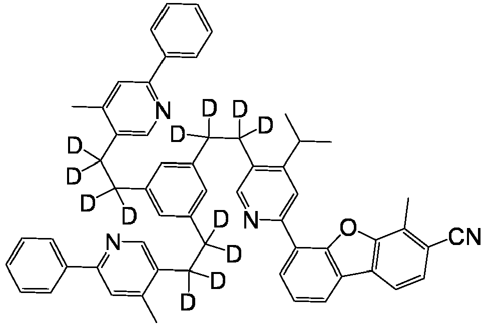 |
| | S103 | |
| L41 | S17 | 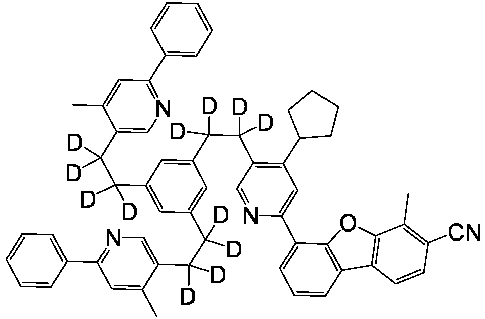 |
| | S103 | |
| L42 | S18 | 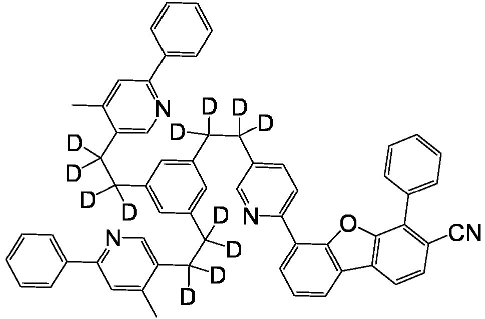 |
| | S103 | |
| L43 | S19 | 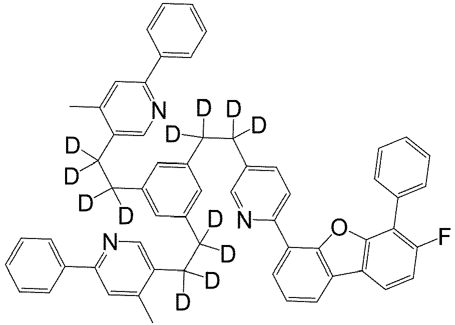 |
| | S103 | |
| L44 | S1 | 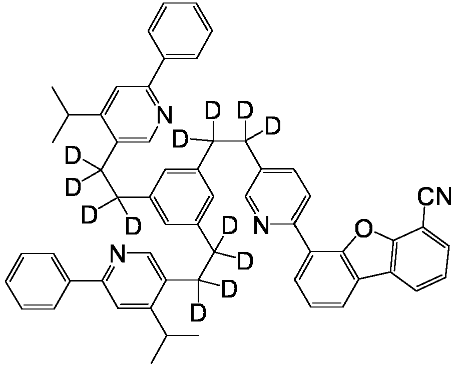 |
| | S104 | |
| L45 | S2 | 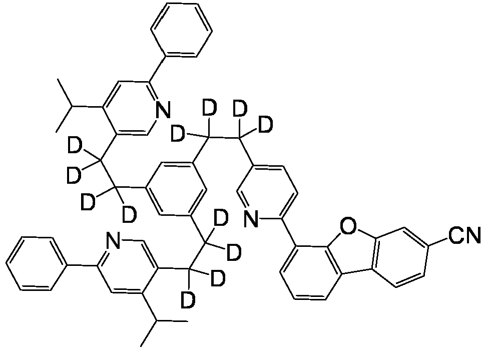 |
| | S104 | |
| L46 | S3 | 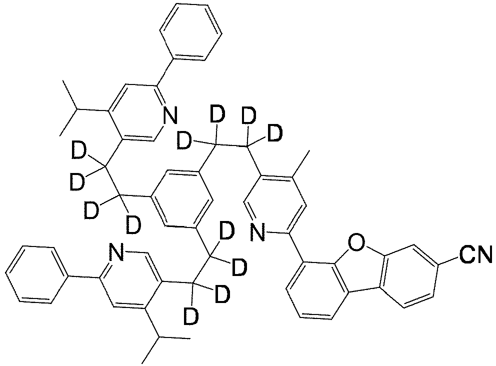 |
| | S104 | |
| L47 | S4 | 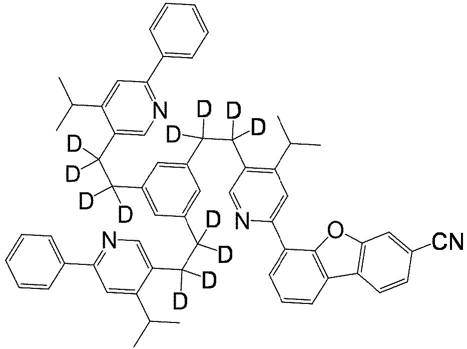 |
| | S104 | |
| L48 | S5 | 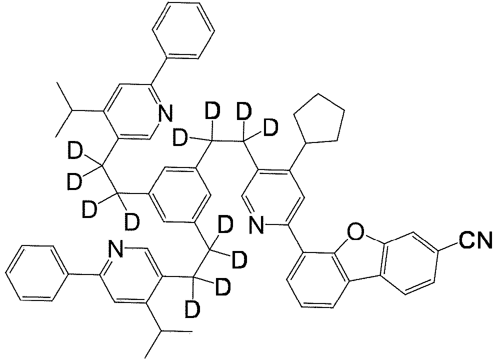 |
| | S104 | |
| L49 | S6 | 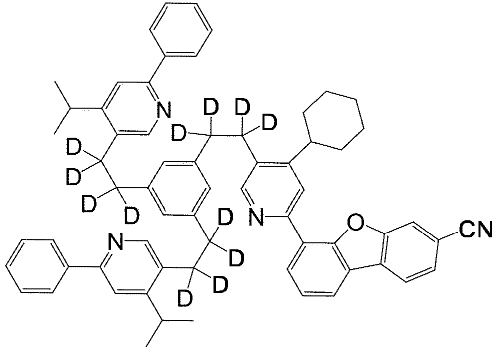 |
| | S104 | |
| L50 | S7 | 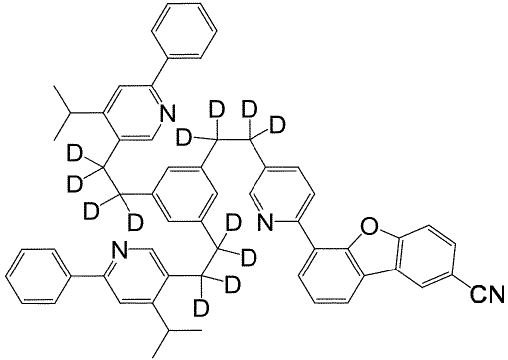 |
| | S104 | |
| L51 | S8 | 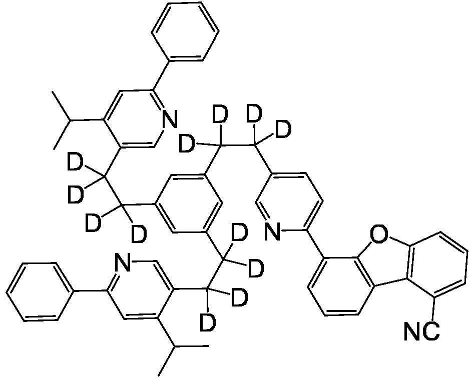 |
| | S104 | |
| L52 | S9 | 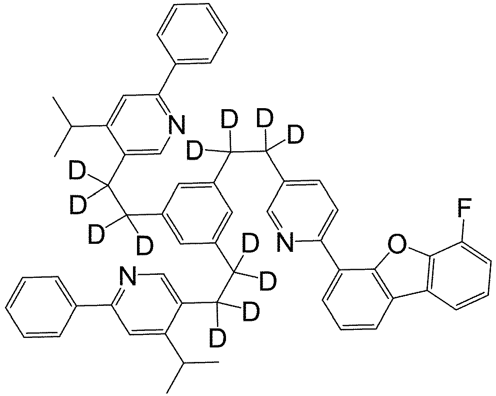 |
| | S104 | |
| L53 | S10 | 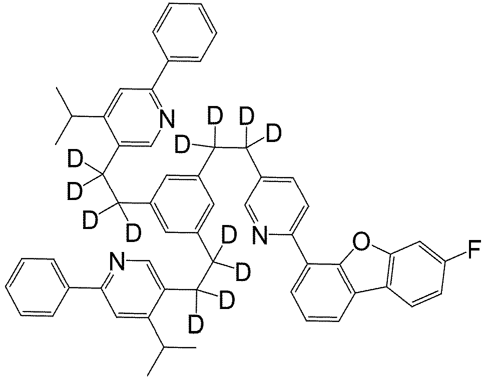 |
| | S104 | |
| L54 | S11 | 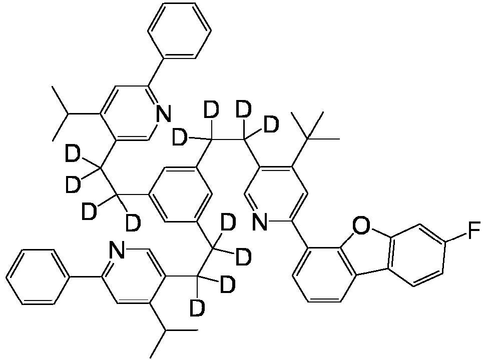 |
| | S104 | |
| L55 | S12 | 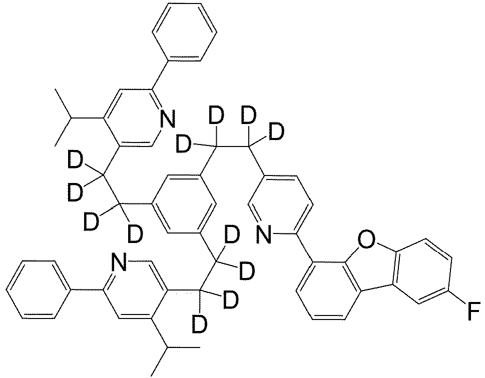 |
| | S104 | |
| L56 | S13 | 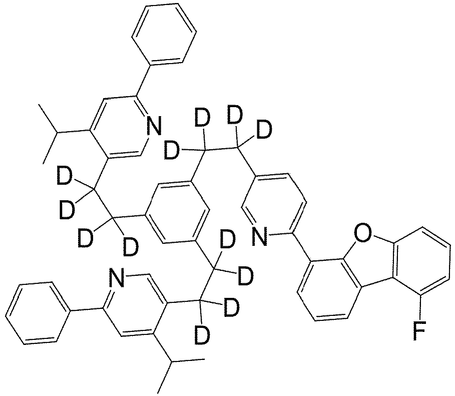 |
| | S104 | |
| L57 | S14 | 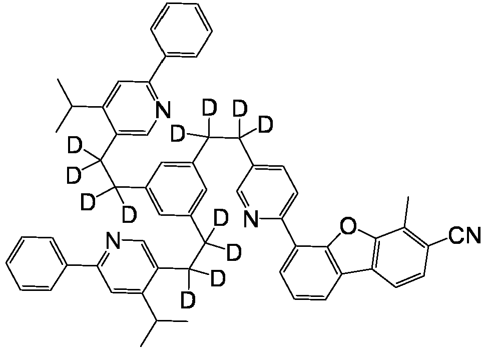 |
| | S104 | |
| L58 | S15 | 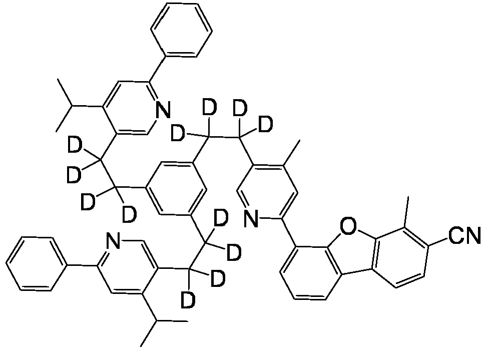 |
| | S104 | |
| L59 | S16 | 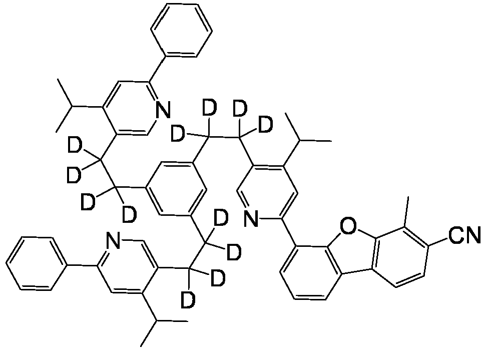 |
| | S104 | |
| L60 | S17 | 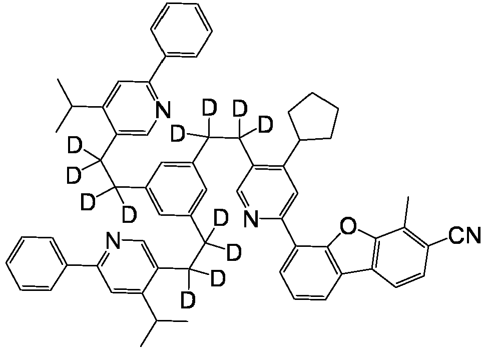 |
| | S104 | |
| L61 | S18 | 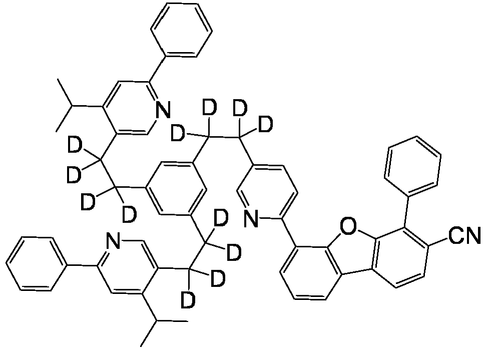 |
| | S104 | |
| L62 | S19 | 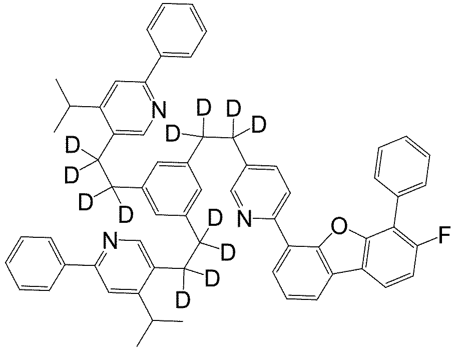 |
| | S104 | |
| L63 | S2 | 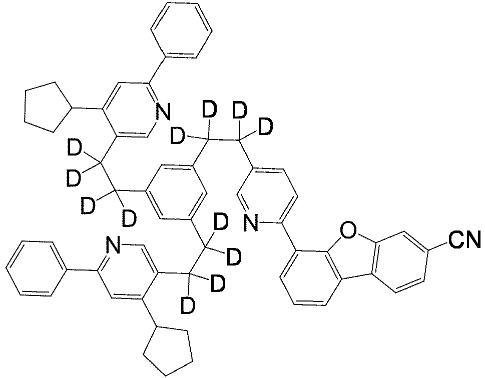 |
| | S105 | |
| L64 | S3 | 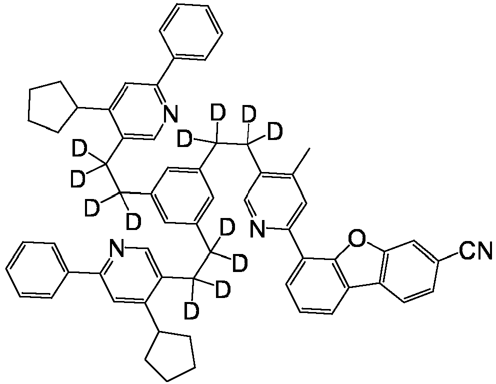 |
| | S105 | |
| L65 | S4 | 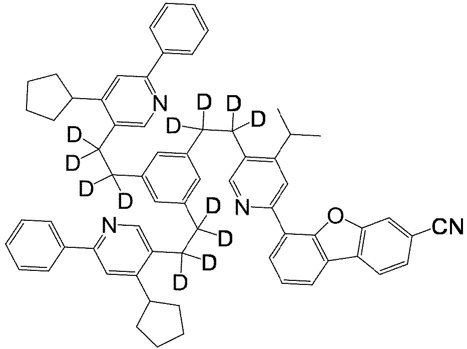 |
| | S105 | |
| L66 | S5 | 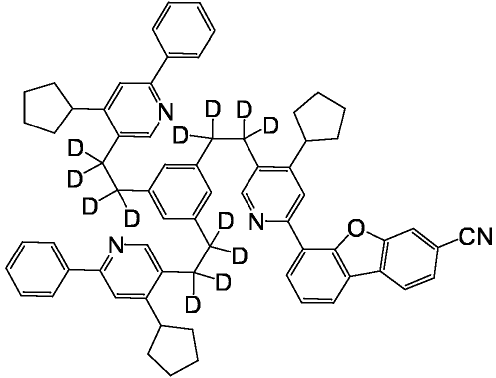 |
| | S105 | |
| L67 | S6 | 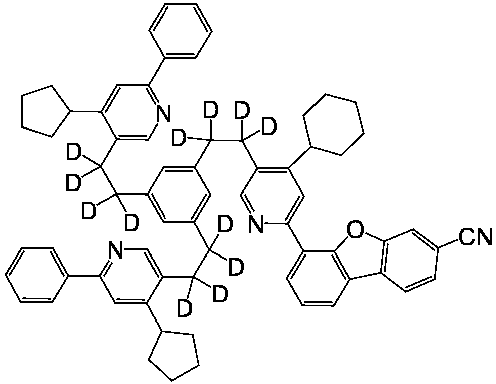 |
| | S105 | |
| L68 | S10 | 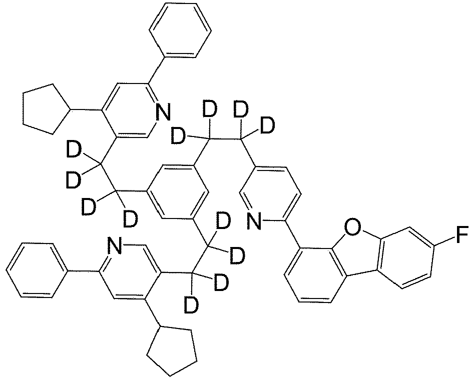 |
| | S105 | |
| L69 | S14 | 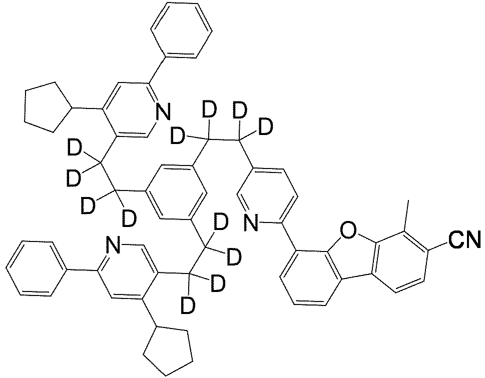 |
| | S105 | |
| L70 | S15 | 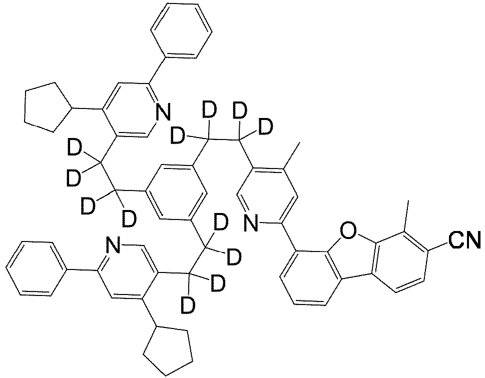 |
| | S105 | |
| L71 | S16 | 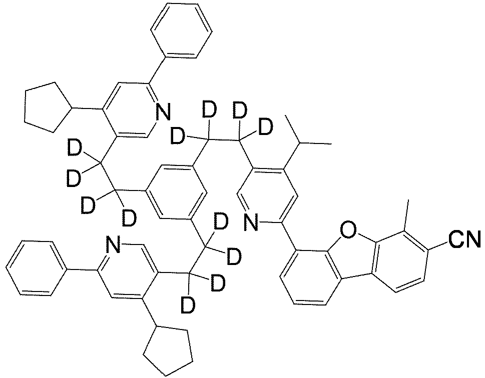 |
| | S105 | |
| L72 | S17 | 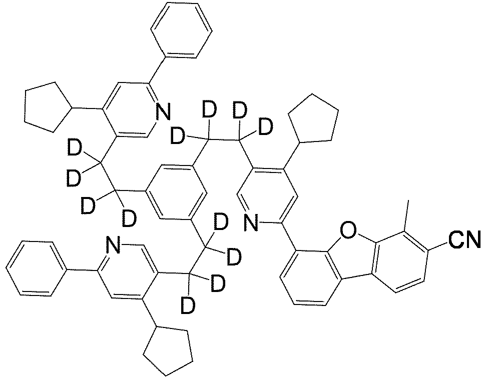 |
| | S105 | |
| L73 | S18 | 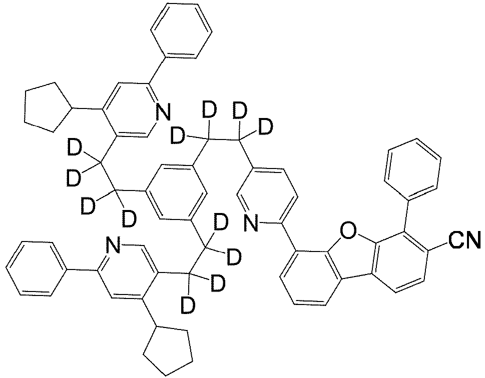 |
| | S105 | |
| L74 | S19 | 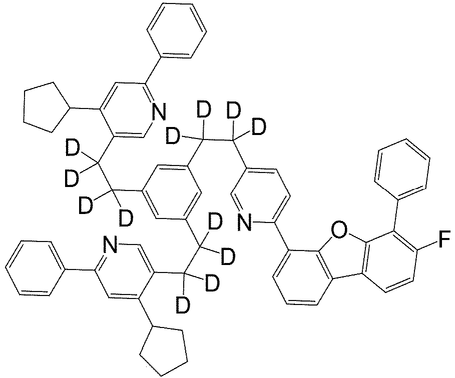 |
| | S105 | |
| L75 | S20 | 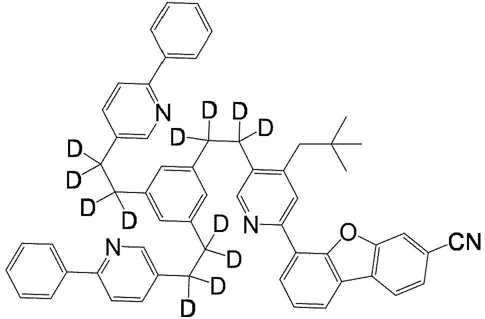 |
| | S101 | |
| L76 | S21 | 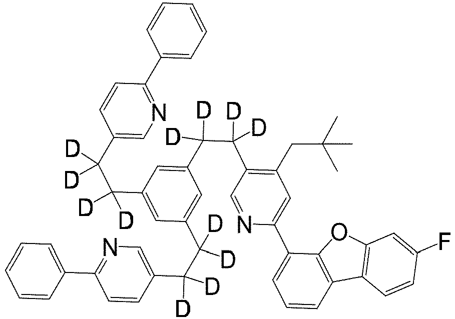 |
| | S101 | |
| L77 | S2 | 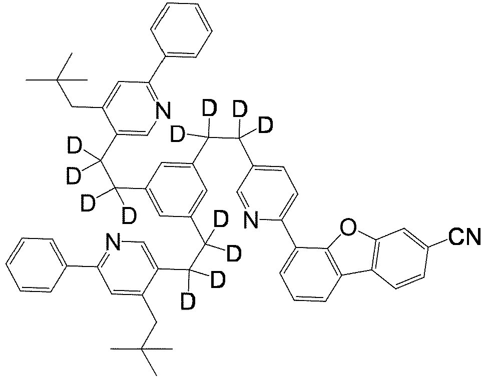 |
| | S106 | |
| L78 | S10 | 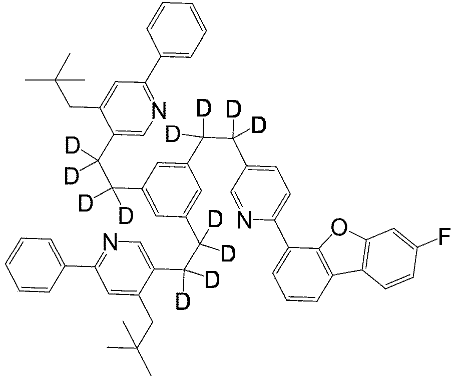 |
| | S106 | |
| L-Ref-D3 | Ref-S1 | 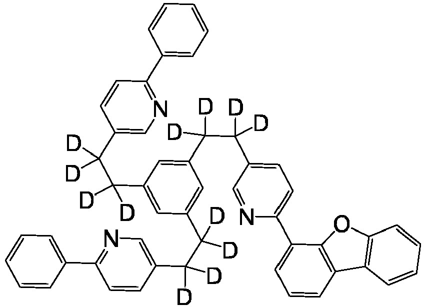 |
| | S101 | |
| L79 | S2 | 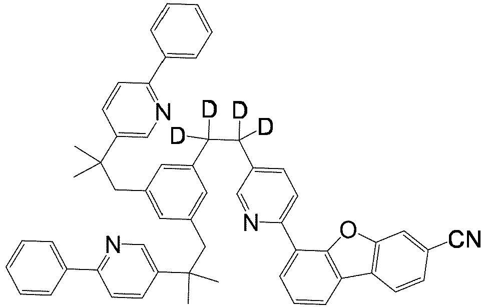 |
| | S300 | |
| L80 | S20 | 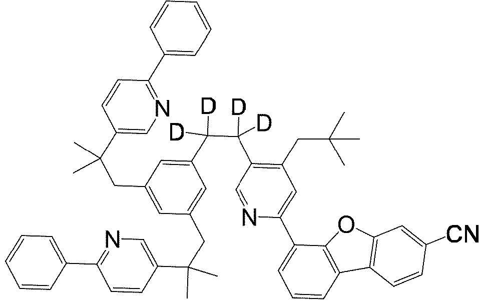 |
| | S300 | |

### C) Synthesis of iridium complexes:

The iridium complexes can be prepared, for example, according to the methods described in WO 2016/124304 or WO 2021/013775.

### Example Ir1:

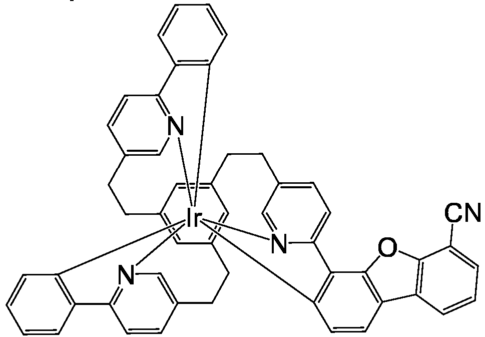

A mixture of 7.37 g (10 mmol) L1, 7.42 g (10 mmol) tris(2,2,6,6-tetramethyl-*3,5-heptanedionato-**κO***³ ,***κO***⁵ )-iridium [99581-86-9], 50 g hydroquinone [123-31-9], and 50 g 2,6-diisopropylphenol [2078-54-8] is placed in a 500 mL two-necked round-bottom flask with a glass-jacketed magnetic core. The flask is equipped with a water separator (for media of lower density than water) and an air cooler with argon overlay. The flask is placed in a metal heating dish. The apparatus is purged with argon from above via the argon overlay for 15 min, allowing the argon to flow out of the side neck of the two-necked flask. Insert a glass-jacketed Pt-100 thermocouple into the flask via the side neck of the two neck flask and place the end just above the magnetic stirrer core.

The apparatus is then thermally insulated with several loose wraps of household aluminum foil, with the insulation extending to the center of the riser tube of the water separator. The apparatus is then rapidly heated with a laboratory heating stirrer to 245-250 °C as measured by the Pt- 100 thermal probe immersed in the molten, stirred reaction mixture. During the next 1.5 h, the react ion mixture is kept at 245-250 °C, with condensate distilling off and collecting in the water separator, and tempering from time to time. After 1.5 h, allow to cool to about 100 °C and then slowly add 300 ml of ethanol (EtOH). The yellow suspension obtained is filtered through a reverse frit, the yellow solid is washed three times with 30 ml EtOH and then dried in vacuo. The solid thus obtained is dissolved in 1000 ml of dichloromethane and filtered over 800 g of silica gel pre-slurried with dichloromethane (column diameter about 12 cm) with exclusion of air and light. The core fraction is cut out and concentrated at the rotary evaporator, with EtOH being added continuously at the same time until crystallization. After aspiration, washing with a little EtOH and drying in vacuo, further purification of the yellow product is carried out by continuous hot extraction twice with dichloromethane/iso-propanol 2:1 (vv) and then hot extraction four times with dichloromethane/acetonitrile 1:1 (vv) (prefilled amount in each case approx. 200 ml, extraction sleeve: standard cellulose Soxhlet sleeves from Whatman) under careful air and light from closure. Finally, the product is fractionally sublimed under high vacuum. Yield: 6.59 g (7.1 mmol), 71 %; purity: > 99.9 % by HPLC.

### Example Ir10:

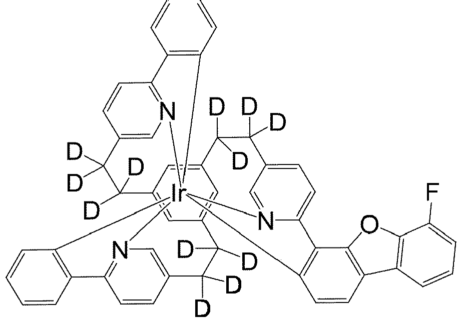

A 500 ml four-neck flask with KPG stirrer, water separator (10 ml reservoir), reflux condenser and argon overlay is charged under argon atmosphere with 7.42 g (10 mmol) L10, 3.69 g (10 mmol) iridium(III) acetate Ir(OAc)₃, 40 g salicylic acid and 40 ml mesitylene and heated for 22 h under low reflux (internal temperature about 158 °C). The initially blue solution becomes a yellow suspension with time, except that some acetic acid initially precipitates, which is drained off. After 22 h, the solution is allowed to cool to 90 °C, 200 ml ethanol is carefully added, allowed to cool to 40 °C while stirring, the yellow solid is removed by suction, washed three times with 30 ml ethanol each time and dried in vacuo. The resulting solid is dissolved in 1000 ml dichloromethane and filtered over 800 g silica gel pre-slurried with dichloromethane (column diameter approx. 12 cm) with exclusion of air and light. The core fraction is removed and concentrated at the rotary evaporator, with EtOH being continuously added at the same time until crystallization. After aspiration, washing three times with 30 ml EtOH and drying in vacuo, further purification of the yellow product is carried out by continuous hot extraction twice with dichloromethane/iso-propanol 2:1 (vv) and then hot extraction four times with dichloromethane/acetonitrile 1:1 (VV) (reference quantity in each case approx. 200 ml, extraction sleeve: standard cellulose Soxhlet sleeves from Whatman) under careful air and light from closure. Finally, the product is fractionally sublimed under high vacuum at p ~ 10⁻⁶ mbar and T ~ 340 °C. Yield: 7.73 g (8.3 mmol), 83 %. Purity: > 99.9 % by HPLC.

The metal complexes usually occur as a 1:1 mixture of the A and Δ isomers/enantiomers according to the procedures used above. The figures of complexes listed below usually show only one isomer. If ligands with three different partial ligands are used, or if chiral ligands are used as racemates, the derived metal complexes are obtained as a diastereomeric mixture. These can be separated by fractional crystallization or chromatographically, e.g., with a column auto mate (CombiFlash from A. Semrau). If chiral ligands are used enantiopure, the derived metal complexes accrue as a diastereomeric mixture, whose separation by fractional crystallization or chromatography leads to pure enantiomers. The separated diastereomers or enantiomers can be further purified as described above, e.g., by hot extraction.

Similarly, the following compounds can be prepared in yields of about 60-90%:

| Ex. | Ligand | Product |
|---|---|---|
| Ir2 | L2 | 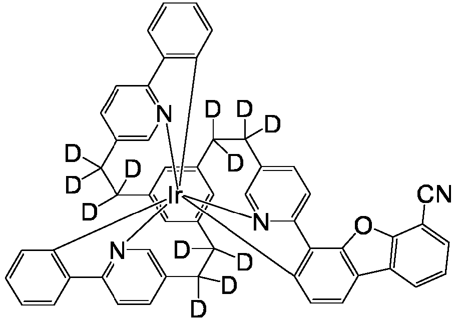 |
| Ir3 | L3 | 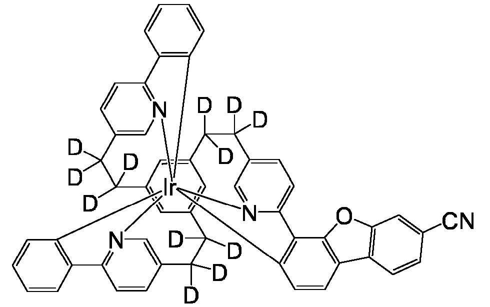 |
| Ir4 | L4 | 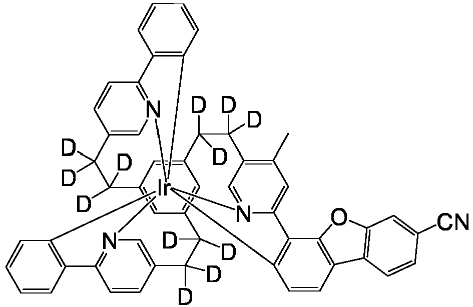 |
| Ir5 | L5 | 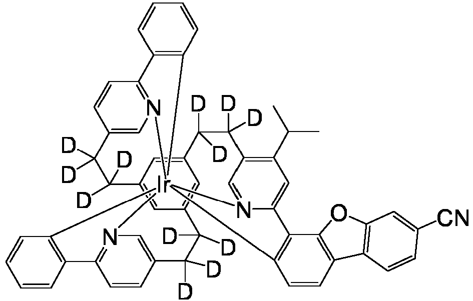 |
| Ir6 | L6 | 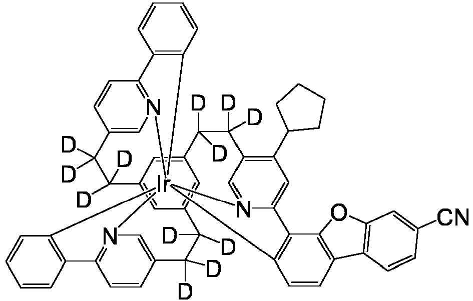 |
| Ir7 | L7 | 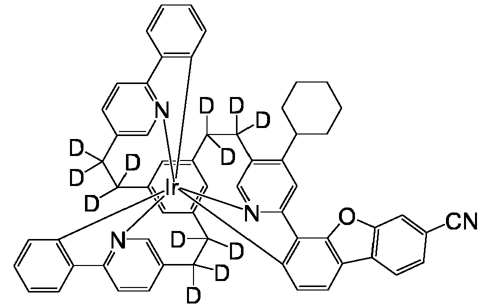 |
| Ir8 | L8 | 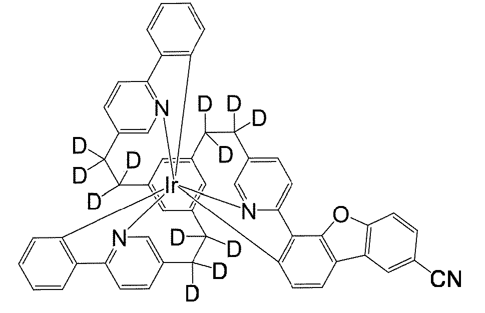 |
| Ir9 | L9 | 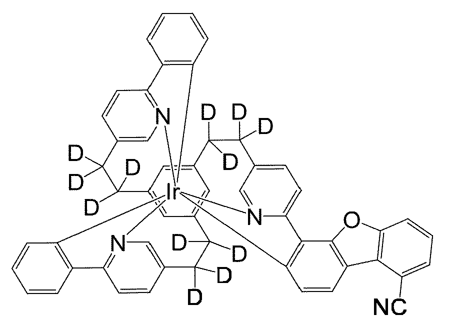 |
| Ir11 | L11 | 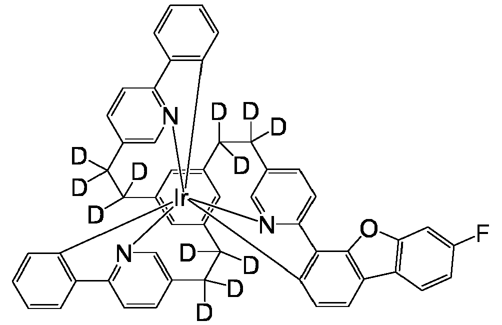 |
| Ir12 | L12 | 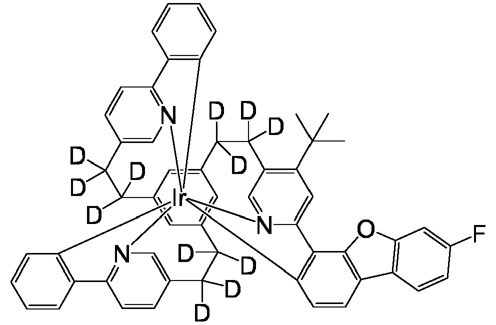 |
| Ir13 | L13 | 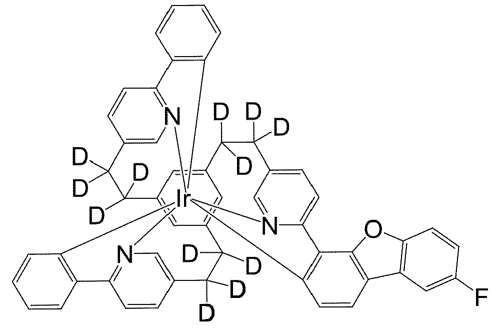 |
| Ir14 | L14 | 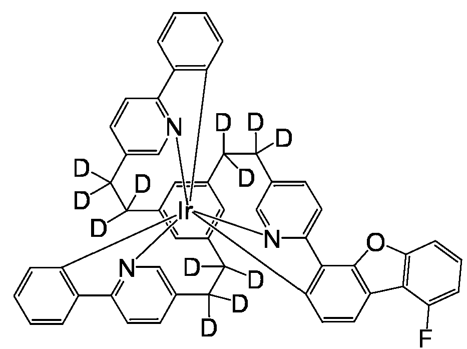 |
| Ir15 | L15 | 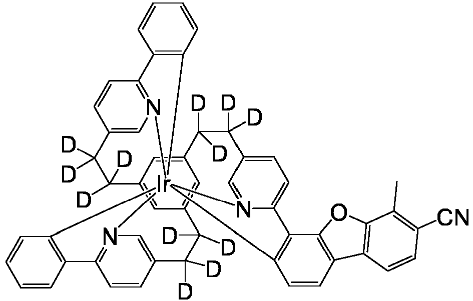 |
| Ir16 | L16 | 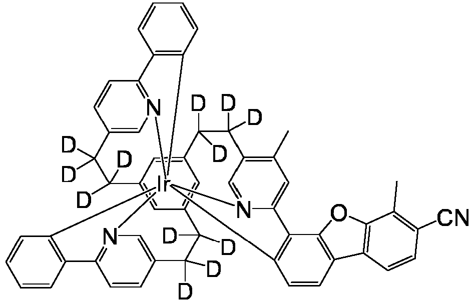 |
| Ir17 | L17 | 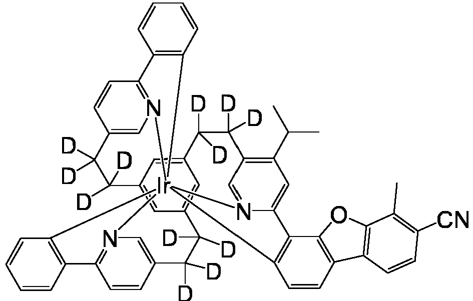 |
| Ir18 | L18 | 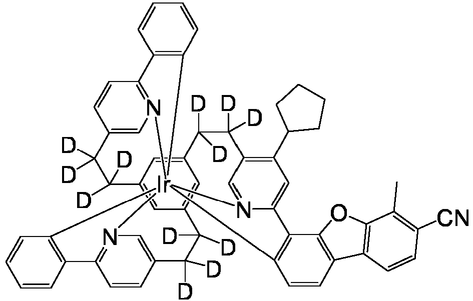 |
| Ir19 | L19 | 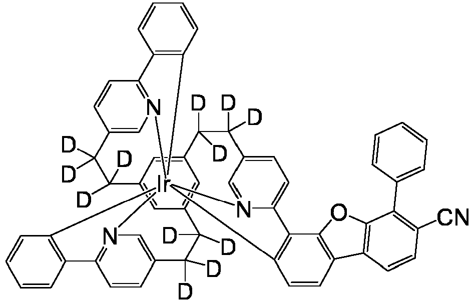 |
| lr20 | L20 | 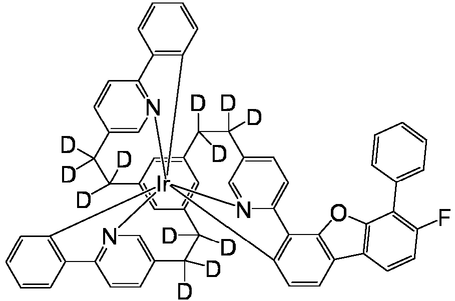 |
| Ir21 | L21 | 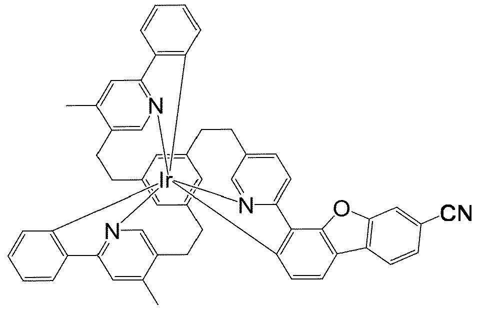 |
| Ir22 | L22 | 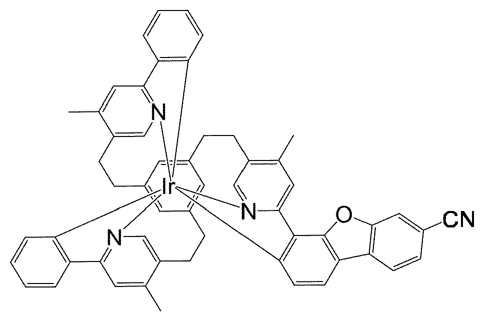 |
| Ir23 | L23 | 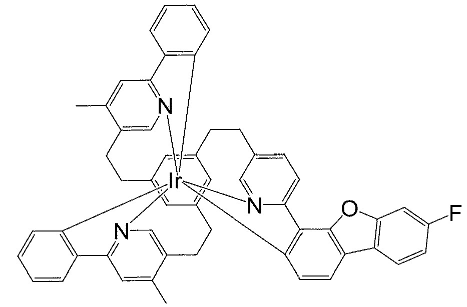 |
| Ir24 | L24 | 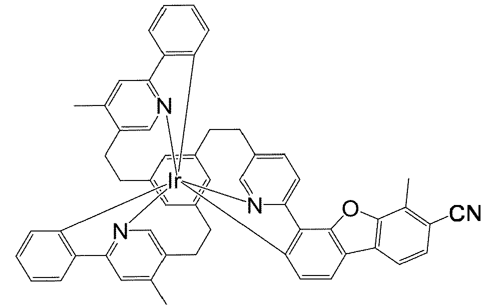 |
| Ir25 | L25 | 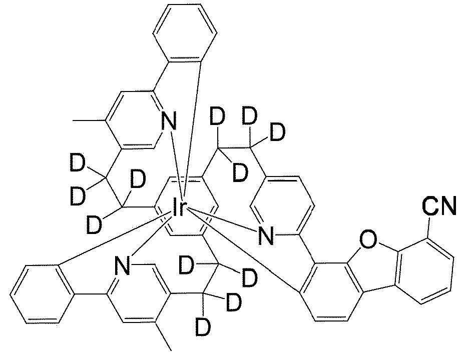 |
| Ir26 | L26 | 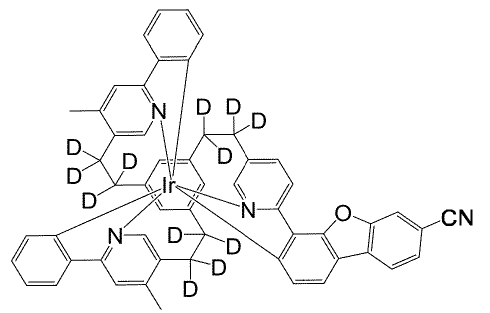 |
| Ir27 | L27 | 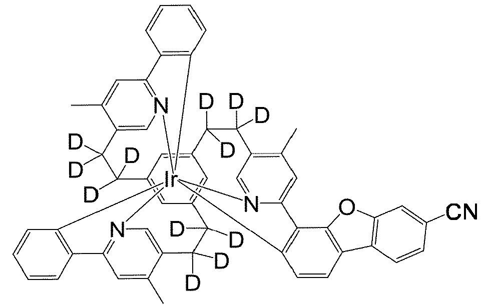 |
| Ir28 | L28 | 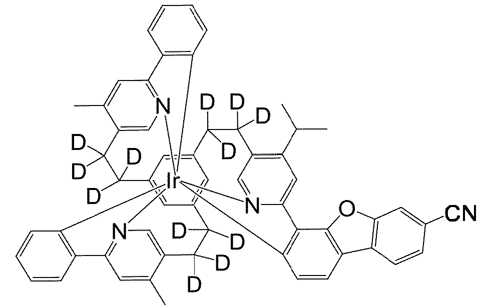 |
| Ir29 | L29 | 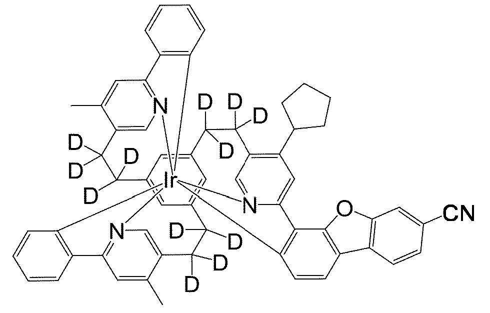 |
| Ir30 | L30 | 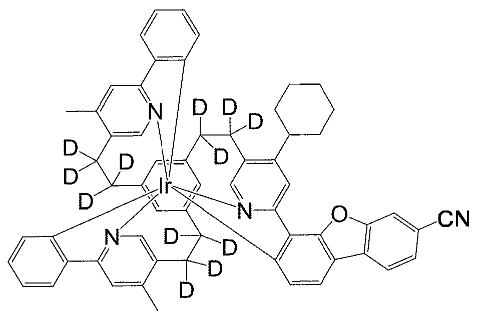 |
| Ir31 | L31 | 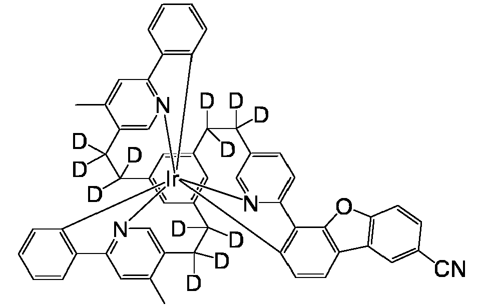 |
| Ir32 | L32 | 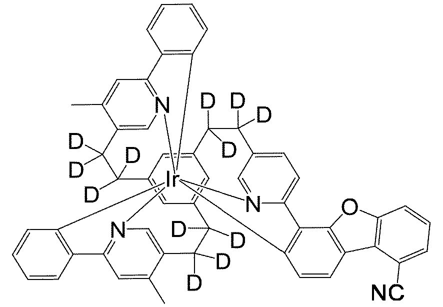 |
| Ir33 | L33 | 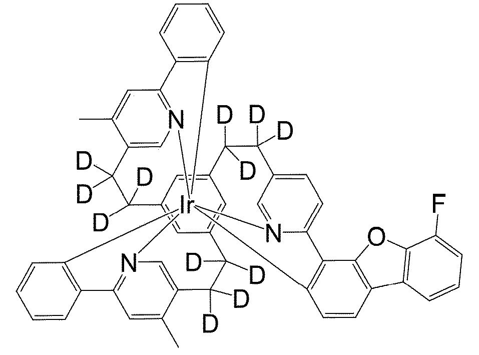 |
| Ir34 | L34 | 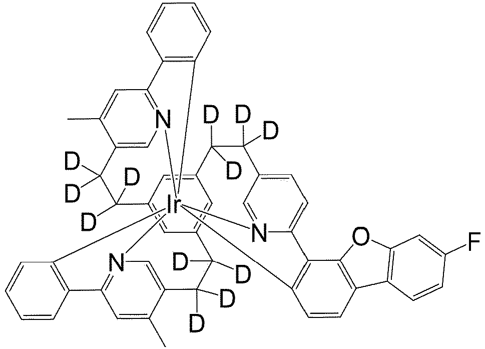 |
| Ir35 | L35 | 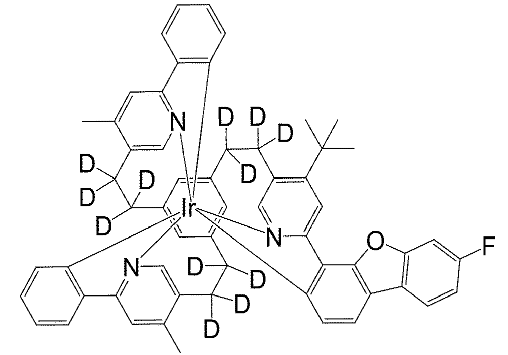 |
| Ir36 | L36 | 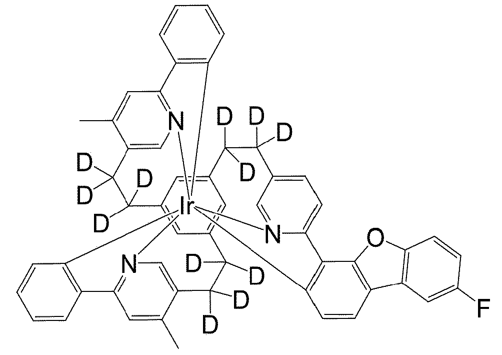 |
| Ir37 | L37 | 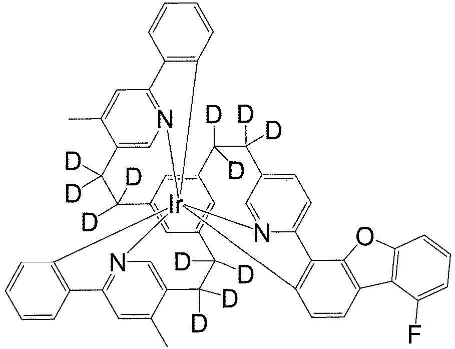 |
| Ir38 | L38 | 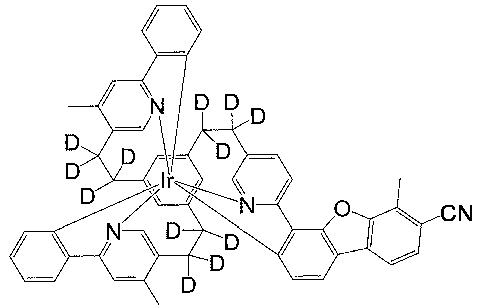 |
| Ir39 | L39 | 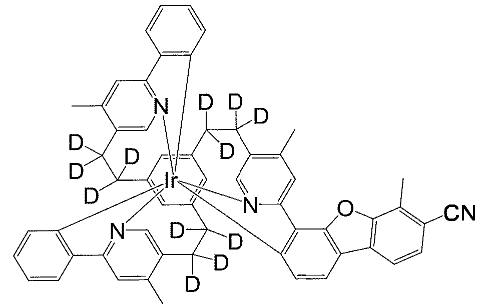 |
| Ir40 | L40 | 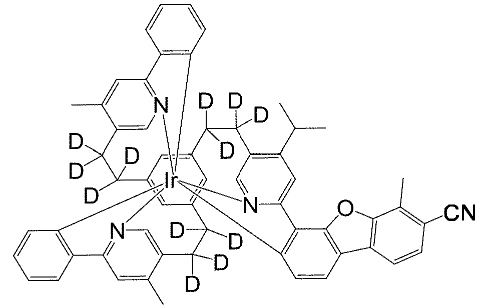 |
| Ir41 | L41 | 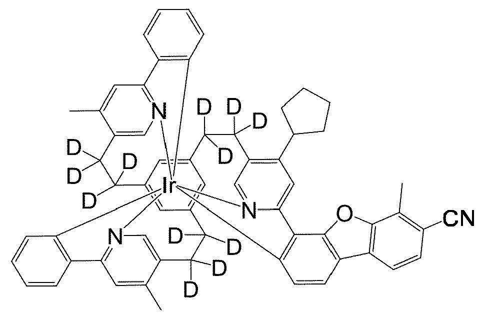 |
| Ir42 | L42 | 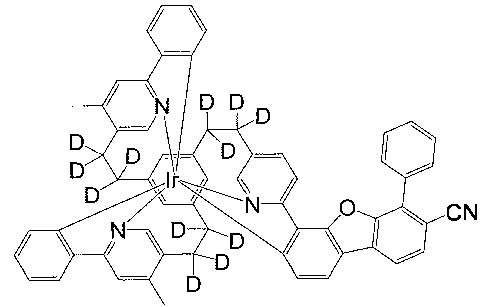 |
| Ir43 | L43 | 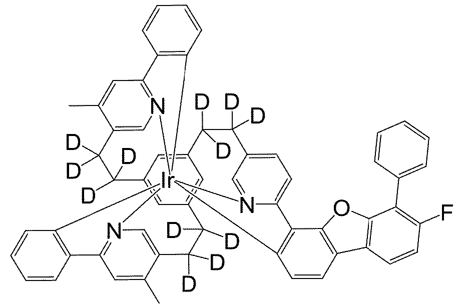 |
| Ir44 | L44 | 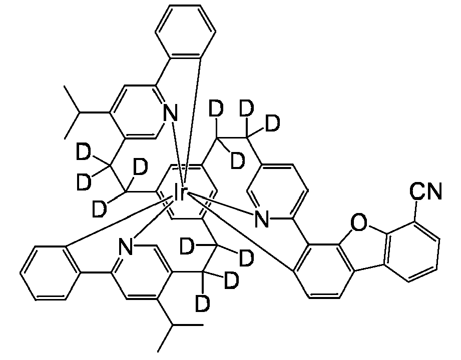 |
| Ir45 | L45 | 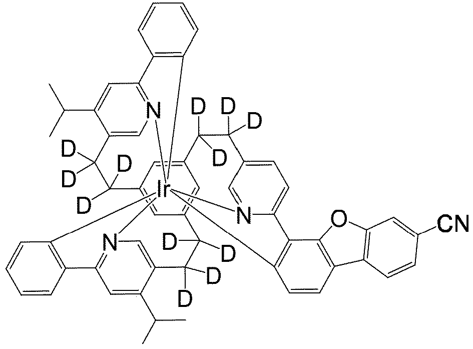 |
| Ir46 | L46 | 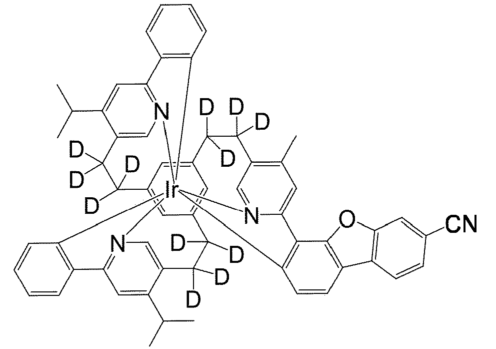 |
| Ir47 | L47 | 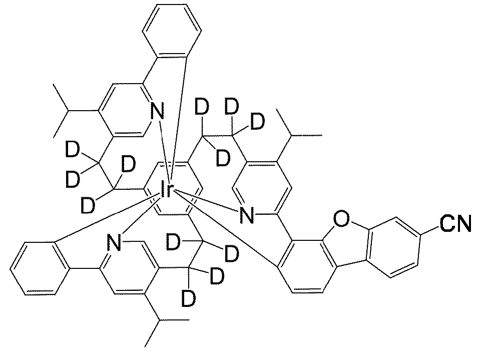 |
| Ir48 | L48 | 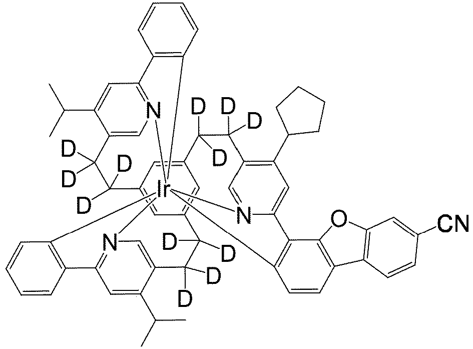 |
| Ir49 | L49 | 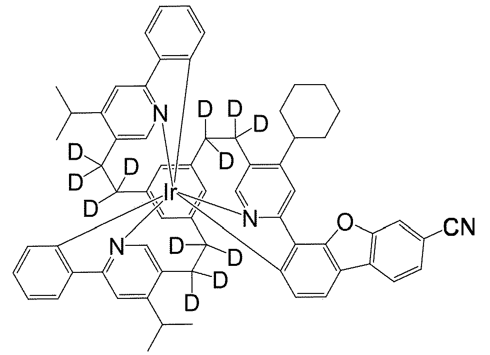 |
| Ir50 | L50 | 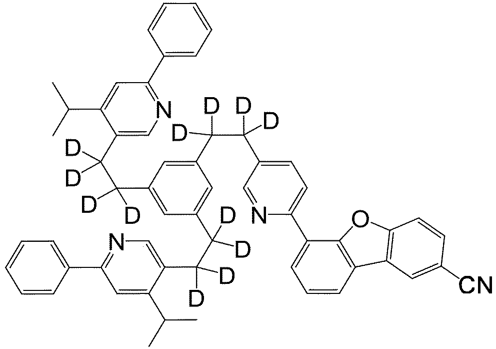 |
| Ir51 | L51 | 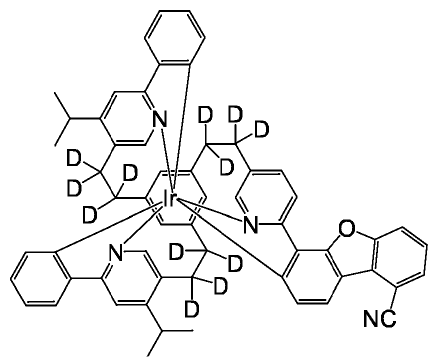 |
| Ir52 | L52 | 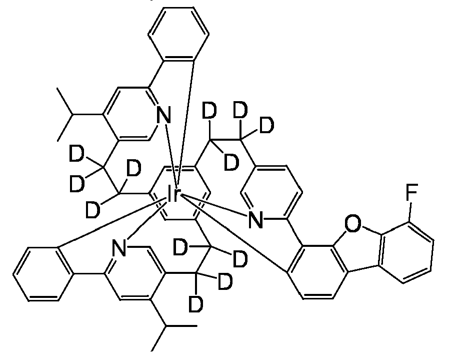 |
| Ir53 | L53 | 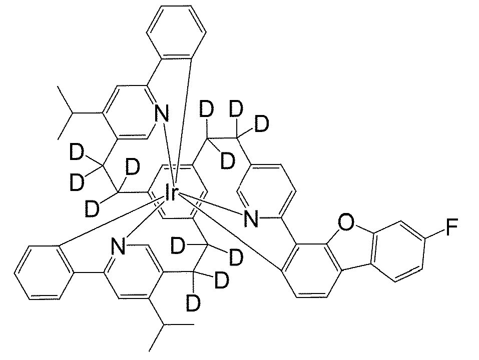 |
| Ir54 | L54 | 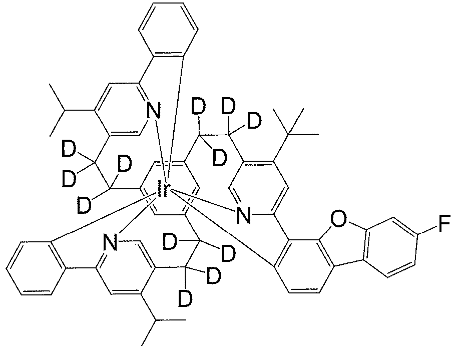 |
| Ir55 | L55 | 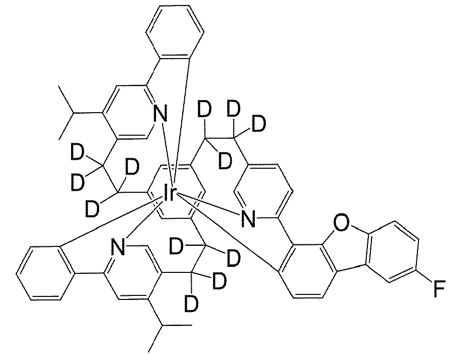 |
| Ir56 | L56 | 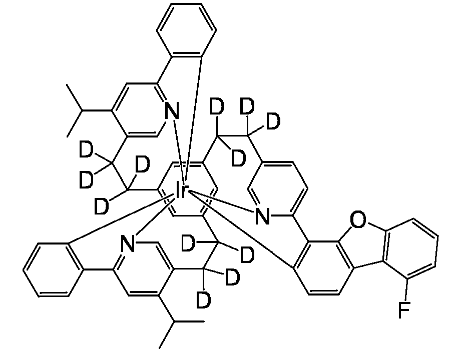 |
| Ir57 | L57 | 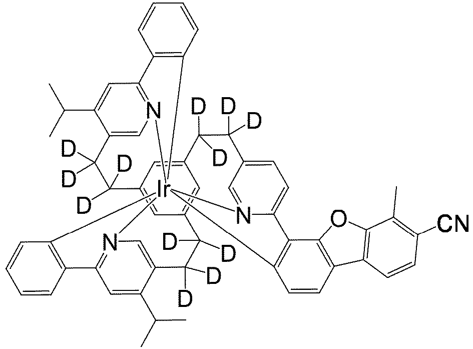 |
| Ir58 | L58 | 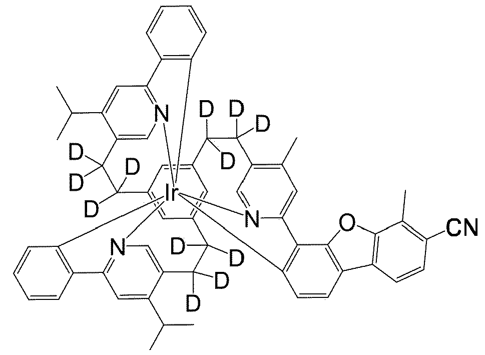 |
| Ir59 | L59 | 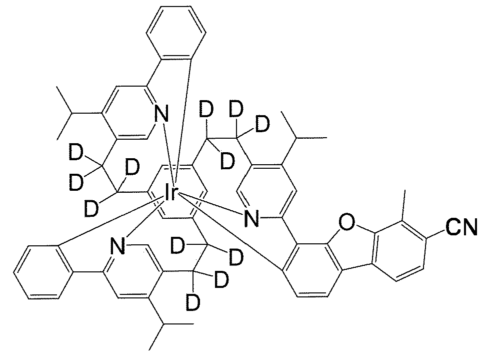 |
| Ir60 | L60 | 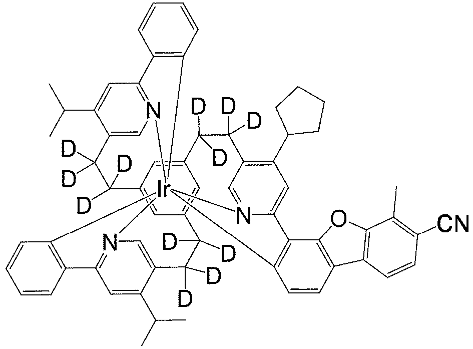 |
| Ir61 | L61 | 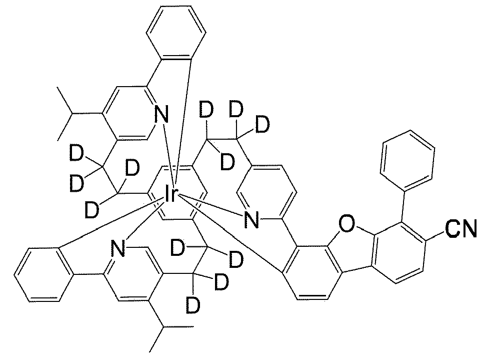 |
| Ir62 | L62 | 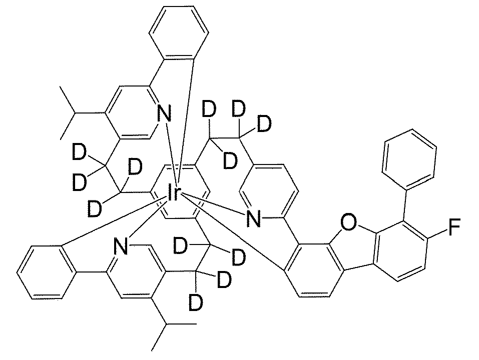 |
| Ir63 | L63 | 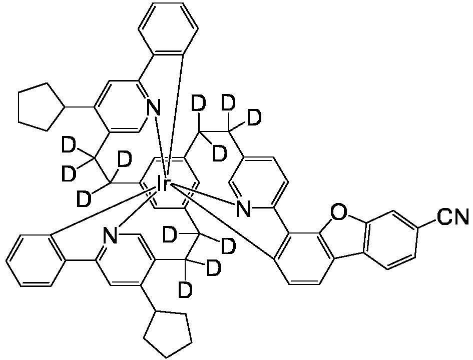 |
| Ir64 | L64 | 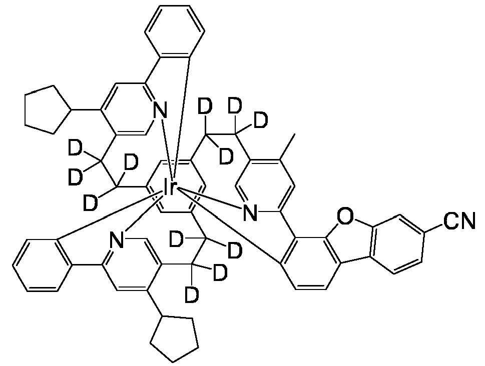 |
| Ir65 | L65 | 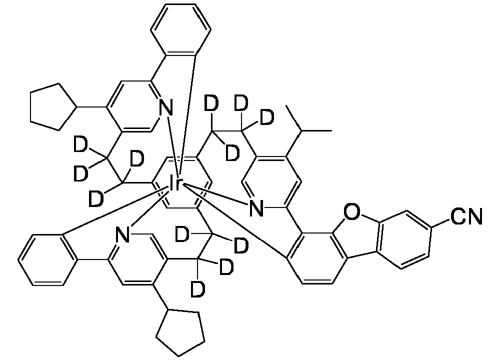 |
| Ir66 | L66 | 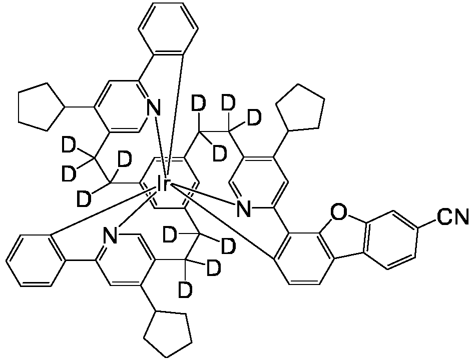 |
| Ir67 | L67 | 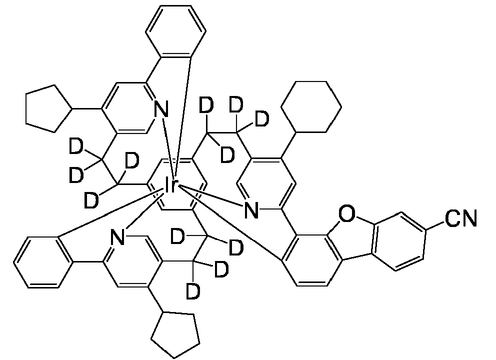 |
| Ir68 | L68 | 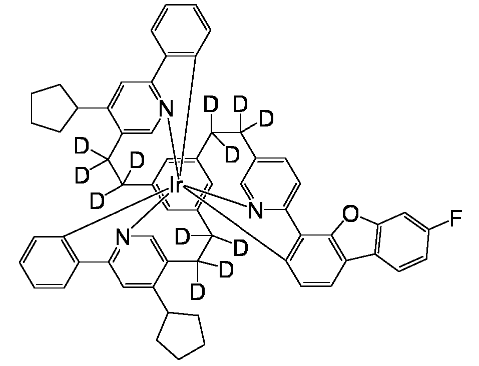 |
| Ir69 | L69 | 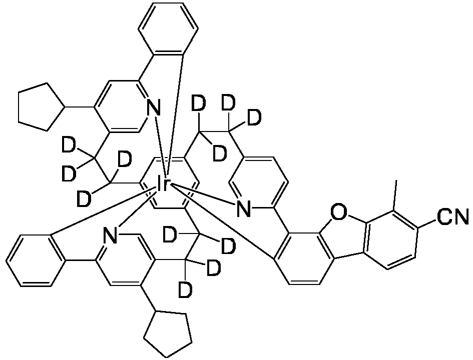 |
| Ir70 | L70 | 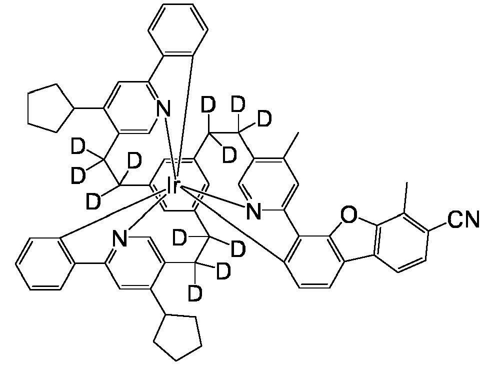 |
| Ir71 | L71 | 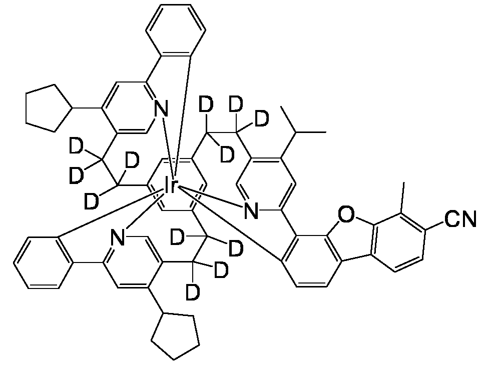 |
| Ir72 | L72 | 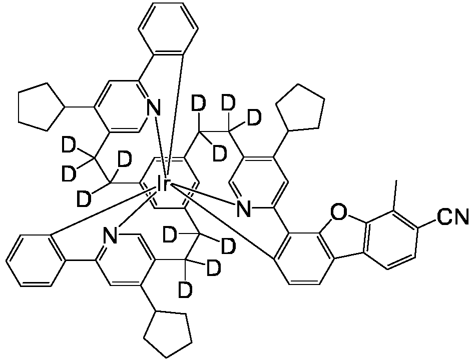 |
| Ir73 | L73 | 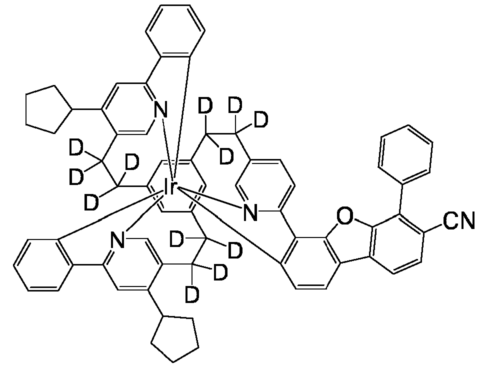 |
| Ir74 | L74 | 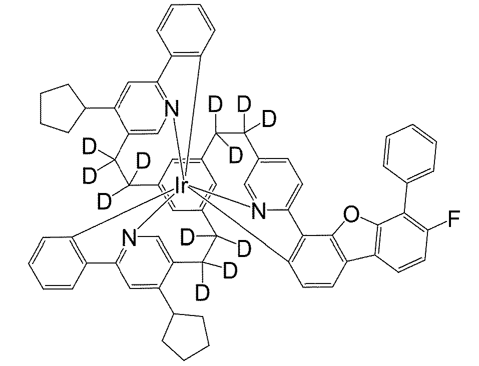 |
| Ir75 | L75 | 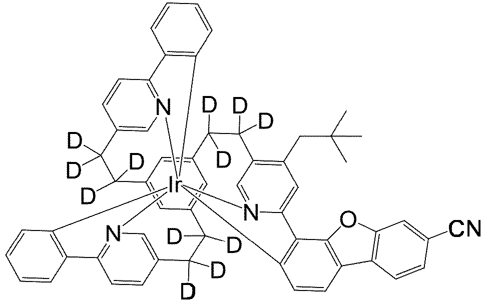 |
| Ir76 | L76 | 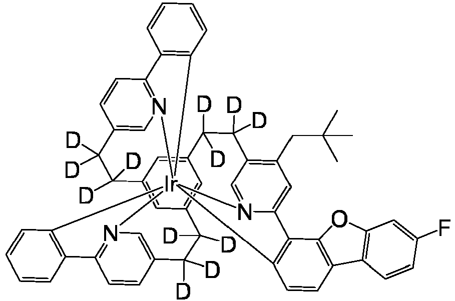 |
| Ir77 | L77 | 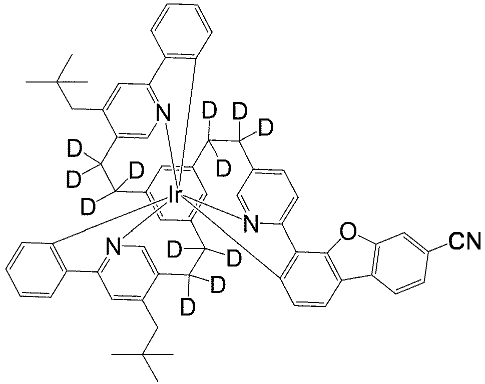 |
| Ir78 | L78 | 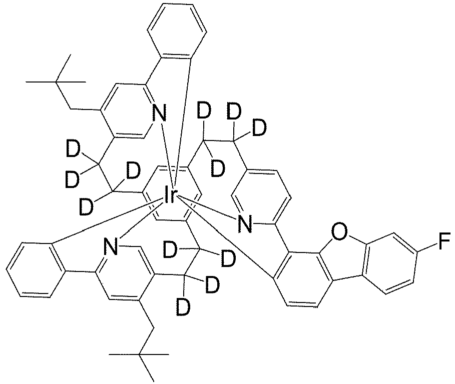 |
| Ref-D3 | L-Ref-D3 | 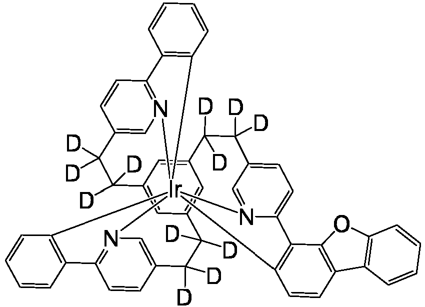 |
| Ir79 | L79 | 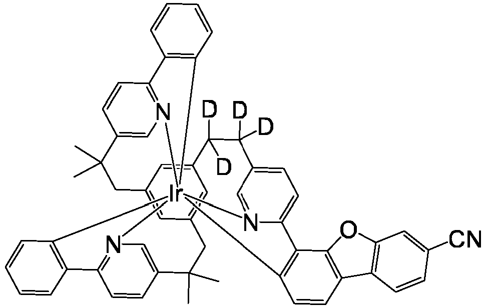 |
| Ir80 | L80 | 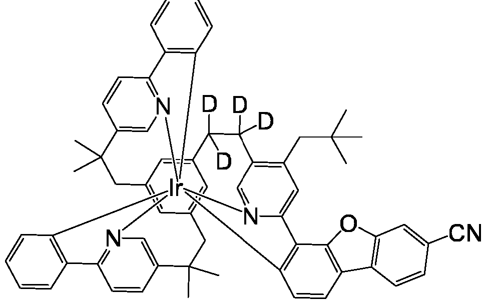 |

### D) Deuteration of the iridium complexes

The non-deuterated or partially deuterated iridium complexes can be further deuterated according to WO 2019/158453. The exact degree of deuteration can be followed spectroscopically by ¹H NMR spectroscopy or mass spectrometry. Each proton of the C1-symmetric iridium complexes has its own exchange kinetics, which depends on the reaction temperature and reaction time. In the structures shown below, deuterated alkyl positions with a degree of deuteration of about 90% or greater or deuterated aryl positions with a degree of deuteration of about 80% or greater are indicated by the element symbol D; individual further positions may also be partially deuterated.

### Example Ir100:

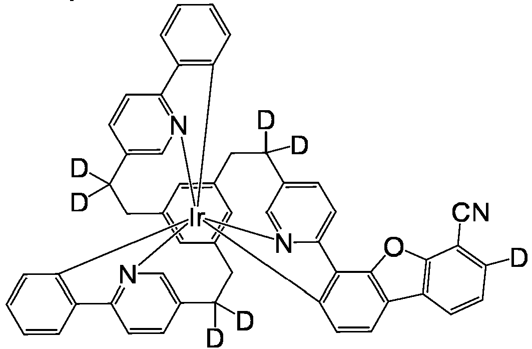

Carried out analogously to V. Salamanca, Eur. J. Org. Chem. 2020, 3206.

A well-stirred mixture of 926.4 mg (1.0) mmol of the clean complex Ir1 (purity > 99.9%), 425 mg (2.0 mmol) of tripotassium phosphate, anhydrous, 20 g of glass beads (1.5 mm diameter) and 100 ml of DMSO-D6 (degree of deuteration > 99.8%) is stirred at 100 - 120 °C for 10 - 20 h until the desired degree of deuteration (monitoring via¹ H-NMR) is achieved. Instead of tripotassium phosphate, anhydrous, cesium carbonate, anhydrous can also be used in catalytic amount (10-20 mol %) at temperatures of 70 - 100 °C, selectively exchanging the aromatic positions on the dibenzofuran ortho to the -CN or -F group. Then cool using a cold water bath, add dropwise from about 60 °C 6 ml 1N acetic acid-D1 in 12 ml D₂ O, and then 200 ml water (H₂ O), allow to cool to room temperature, stir for 5 h, aspirate from the solid and wash three times with 10 ml each of H₂ O/EtOH (1:1, vv) and then three times with 10 ml each of EtOH and dry in vacuo. The solid is dissolved in DCM, the solution is filtered over silica gel, the core fraction is cut out and confined on the rotary steamer, while at the same time EtOH is continuously added until crystallization. After aspiration, washing with a little EtOH and drying in vacuo, the yellow product is further purified by continuous hot extraction four times with dichloromethane/acetonitrile 1:1 (vv) (prefilled volume approx. 30 ml each, extraction sleeve: standard Soxhlet sleeves made of cellulose from Whatman) under careful air and light from closure. Finally, the product is fractionally sublimed under high vacuum. Yield: 813.2 mg (0.87 mmol), 87 %. Purity: > 99.9 % by HPLC.

Similarly, the following compounds can be prepared in yields of about 70-90%:

| Ex. | Educt | Product |
|---|---|---|
| Ir101 | Ir2 | 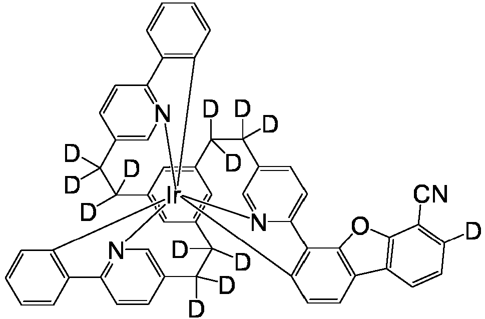 |
| Ir102 | Ir3 | 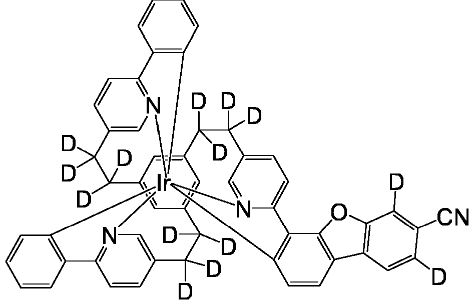 |
| Ir103 | Ir4 | 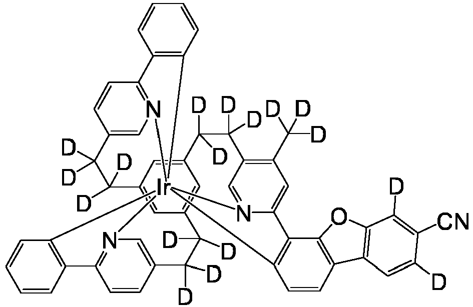 |
| Ir104 | Ir5 | 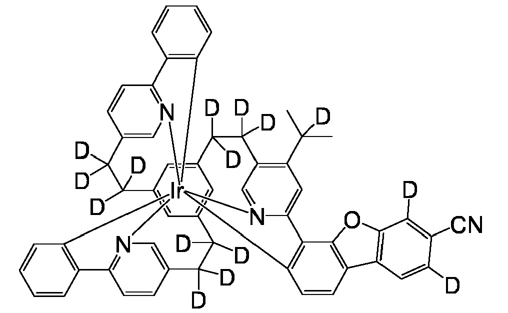 |
| Ir105 | Ir6 | 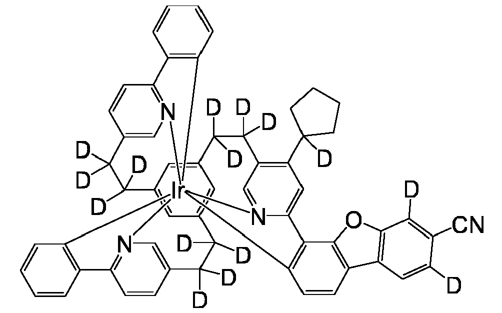 |
| Ir106 | Ir7 | 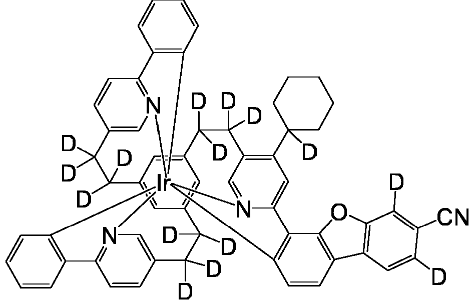 |
| Ir107 | Ir8 | 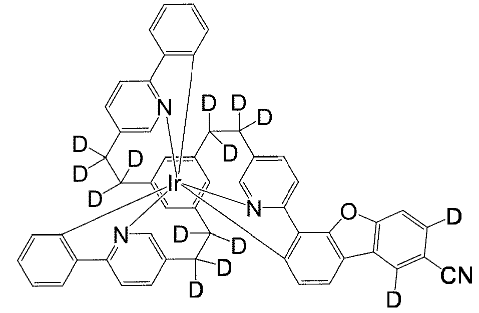 |
| Ir108 | Ir9 | 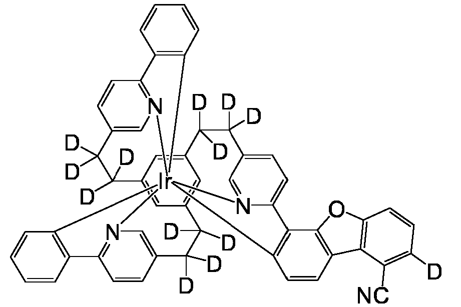 |
| Ir109 | Ir10 | 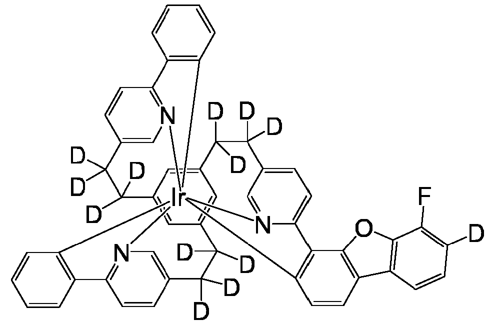 |
| Ir110 | Ir11 | 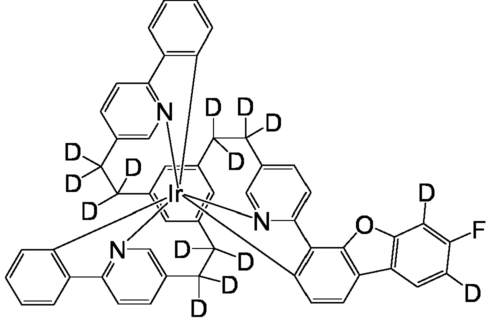 |
| Ir111 | Ir12 | 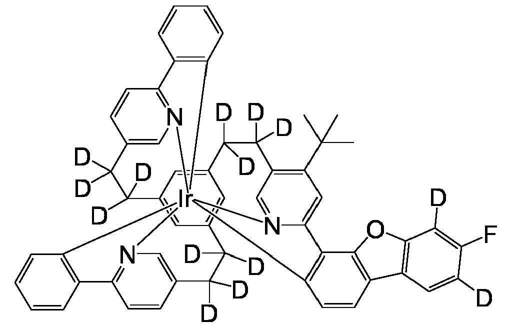 |
| Ir112 | Ir13 | 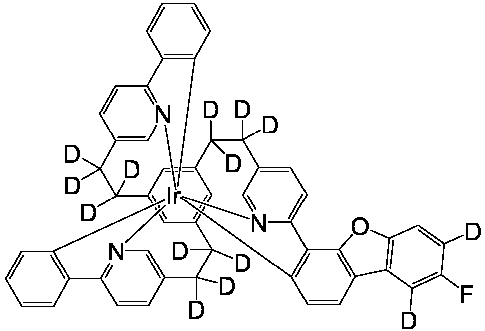 |
| Ir113 | Ir14 | 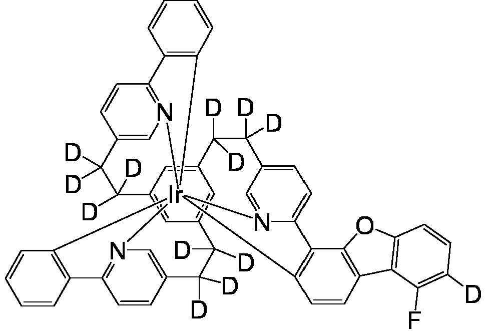 |
| Ir114 | Ir15 | 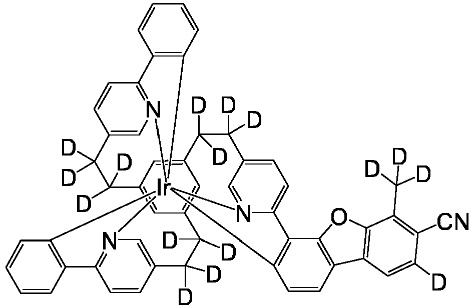 |
| Ir115 | Ir16 | 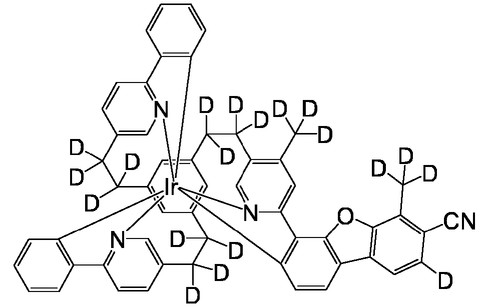 |
| Ir116 | Ir17 | 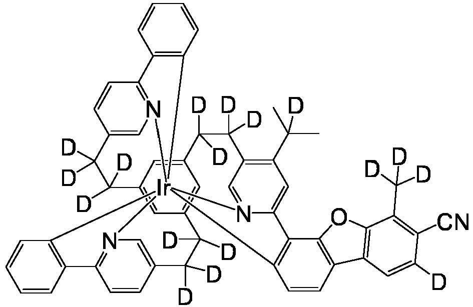 |
| Ir117 | Ir18 | 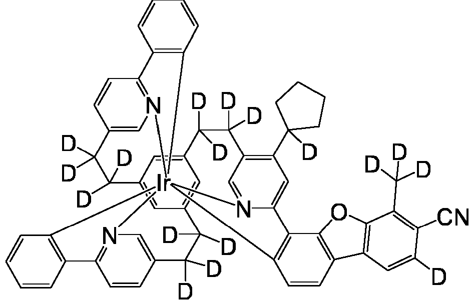 |
| Ir118 | Ir19 | 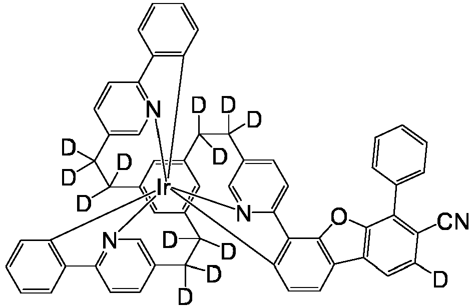 |
| Ir119 | lr20 | 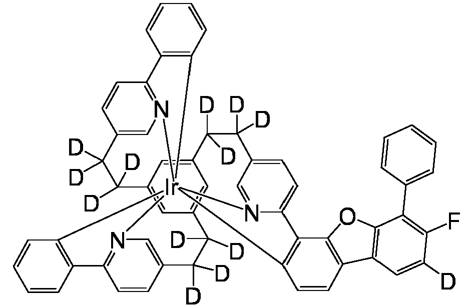 |
| Ir120 | Ir21 | 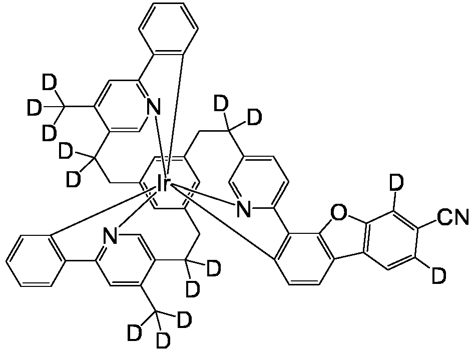 |
| Ir121 | Ir22 | 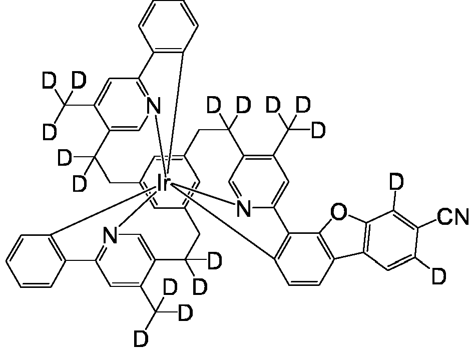 |
| Ir122 | Ir23 | 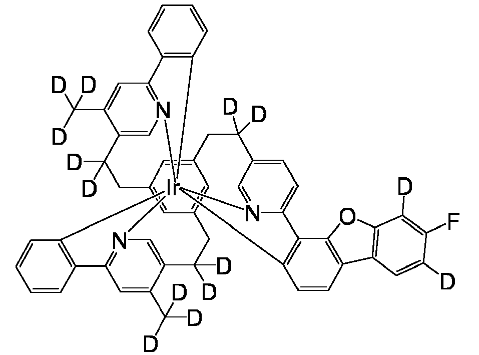 |
| Ir123 | Ir24 | 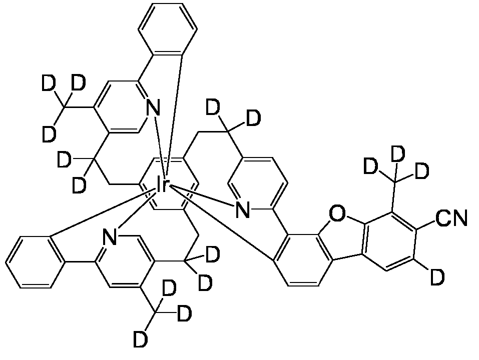 |
| Ir124 | Ir25 | 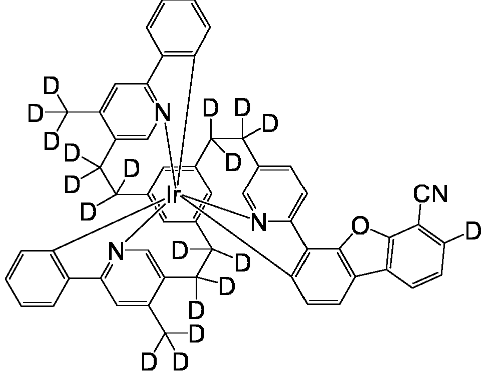 |
| Ir125 | Ir26 | 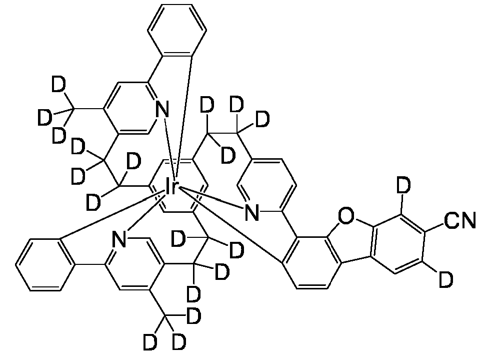 |
| Ir126 | Ir27 | 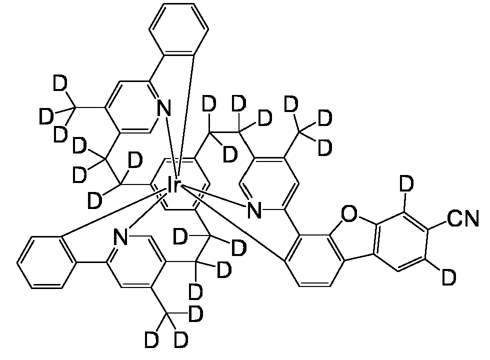 |
| Ir127 | Ir28 | 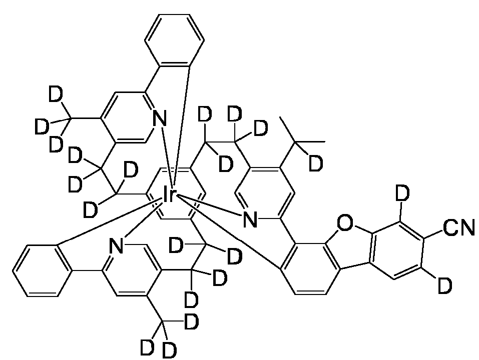 |
| Ir128 | Ir29 | 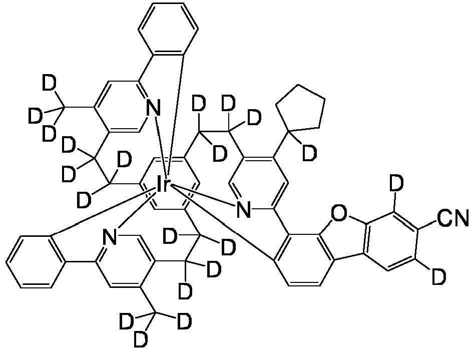 |
| Ir129 | Ir30 | 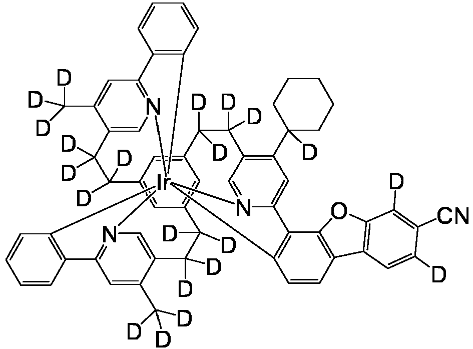 |
| Ir130 | Ir31 | 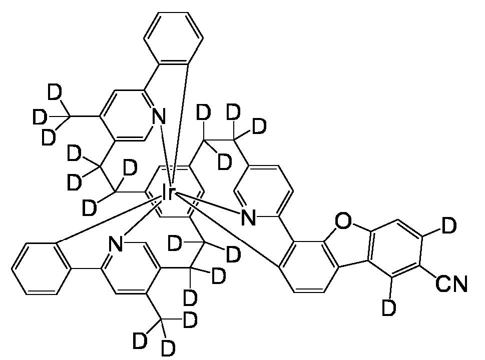 |
| Ir131 | Ir32 | 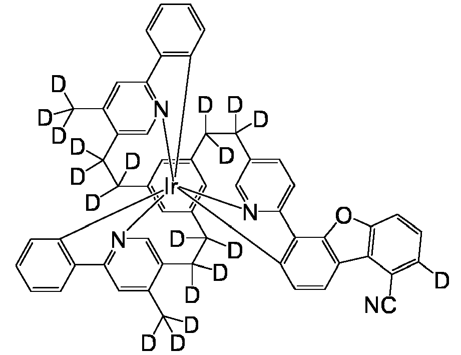 |
| Ir132 | Ir33 | 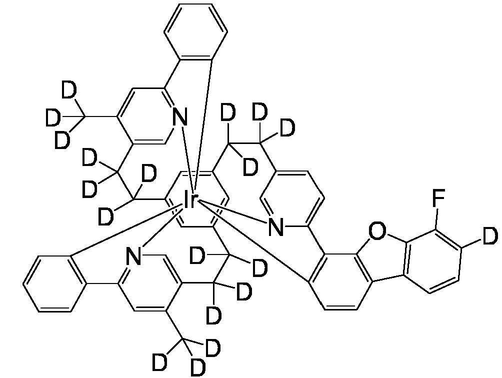 |
| Ir133 | Ir34 | 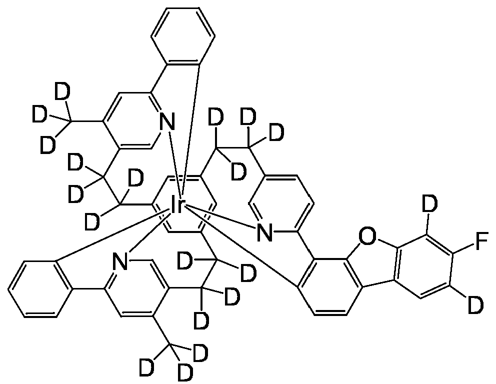 |
| Ir134 | Ir35 | 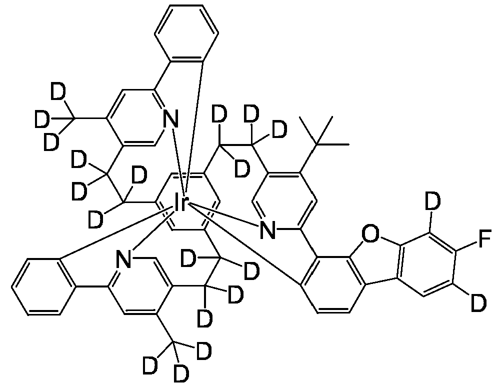 |
| Ir135 | Ir36 | 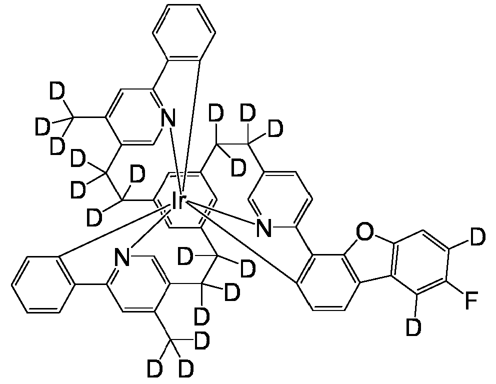 |
| Ir137 | Ir37 | 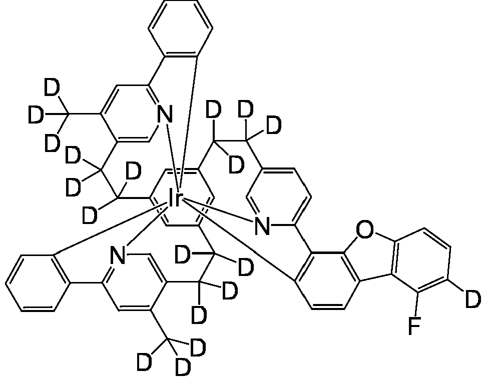 |
| Ir137 | Ir38 | 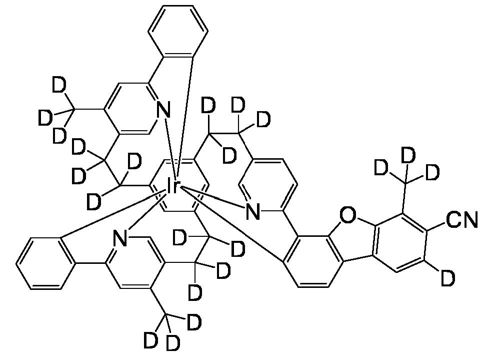 |
| Ir138 | Ir39 | 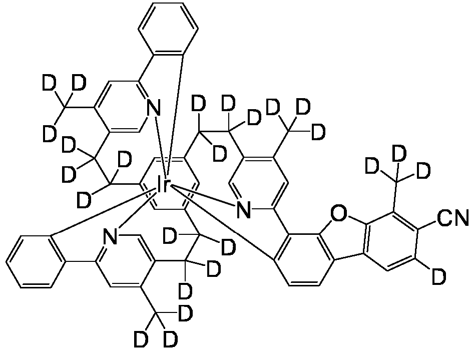 |
| Ir139 | Ir40 | 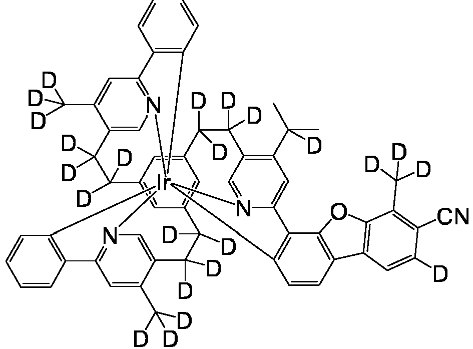 |
| Ir140 | Ir41 | 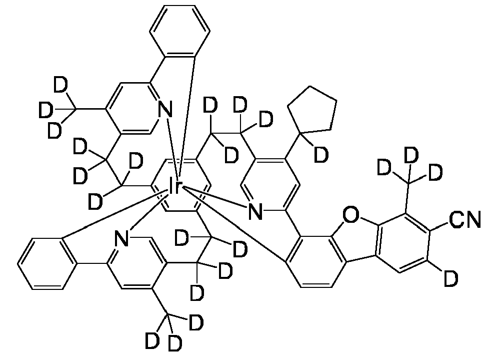 |
| Ir141 | Ir42 | 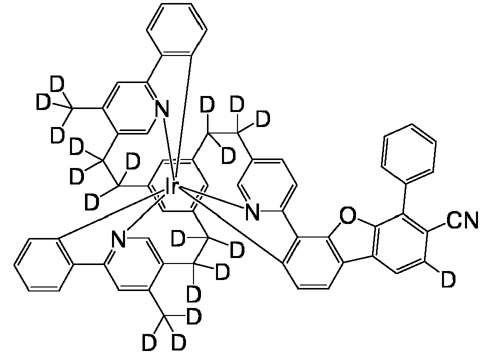 |
| Ir142 | Ir43 | 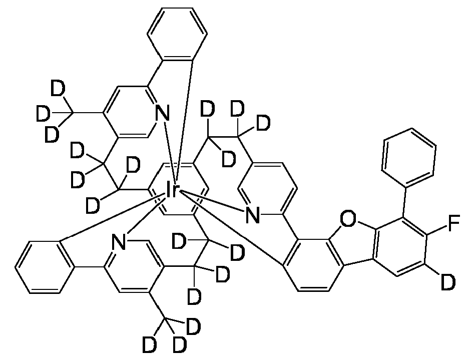 |
| Ir143 | Ir44 | 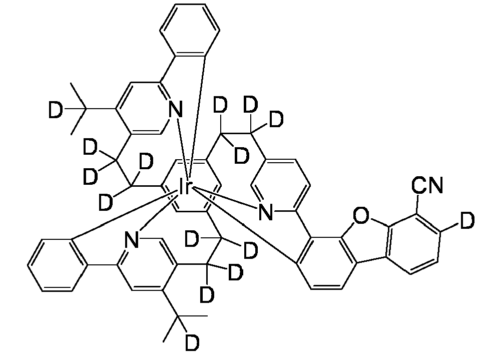 |
| Ir144 | Ir45 | 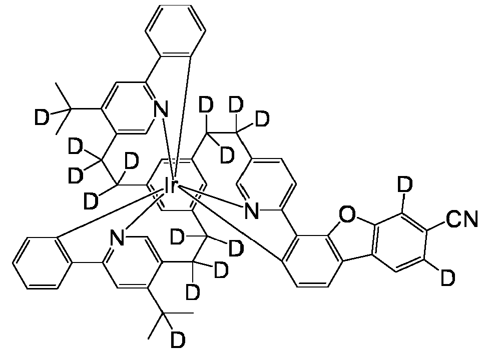 |
| Ir145 | Ir46 | 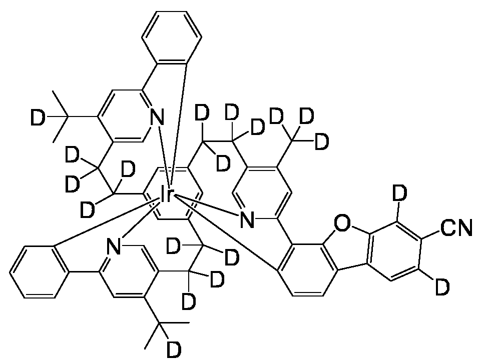 |
| Ir146 | Ir47 | 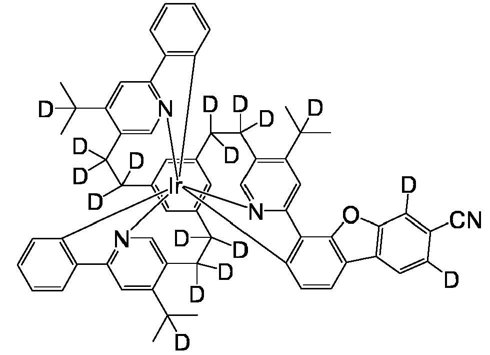 |
| Ir147 | Ir48 | 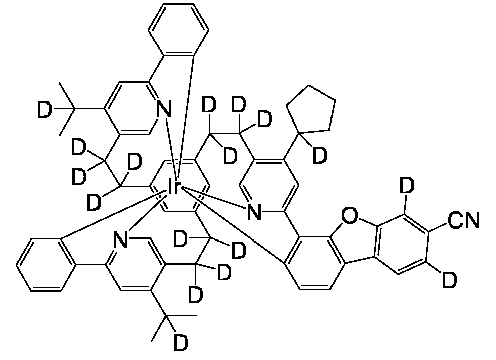 |
| Ir148 | Ir49 | 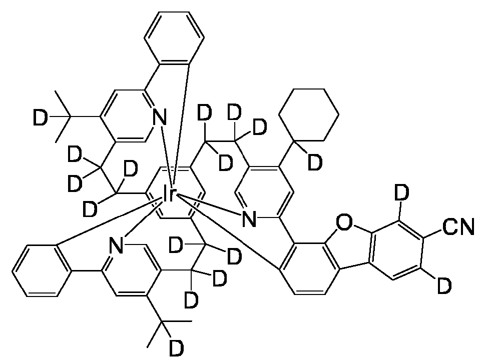 |
| Ir149 | Ir50 | 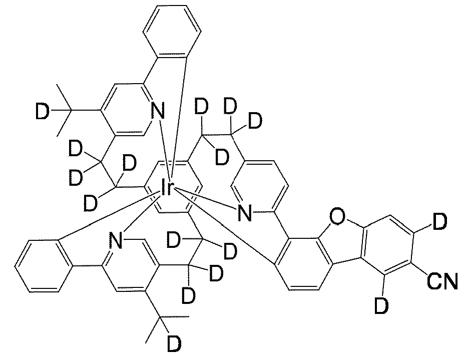 |
| Ir150 | Ir51 | 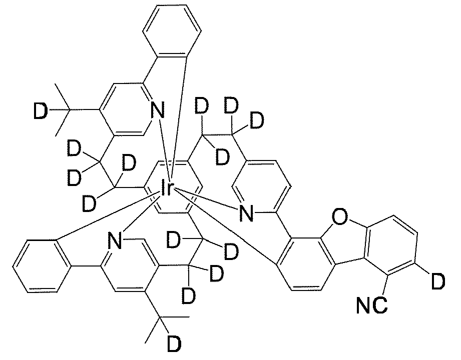 |
| Ir151 | Ir52 | 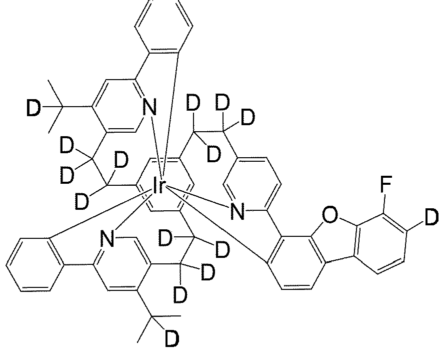 |
| Ir152 | Ir53 | 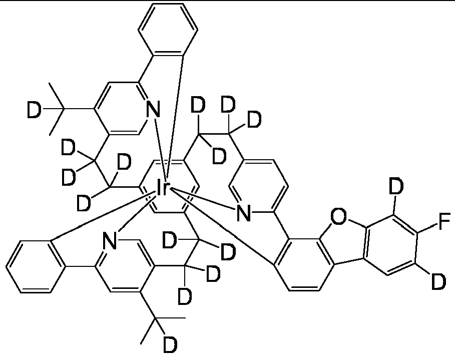 |
| Ir153 | Ir54 | 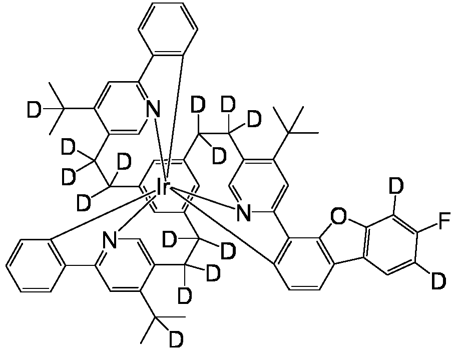 |
| Ir154 | Ir55 | 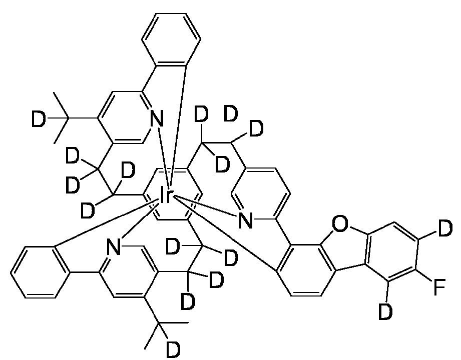 |
| Ir155 | Ir56 | 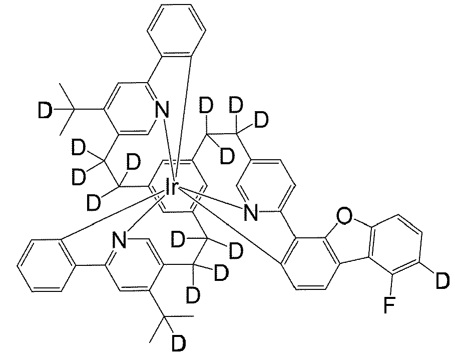 |
| Ir156 | Ir57 | 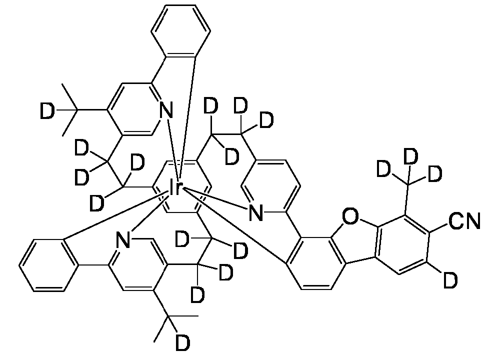 |
| Ir157 | Ir58 | 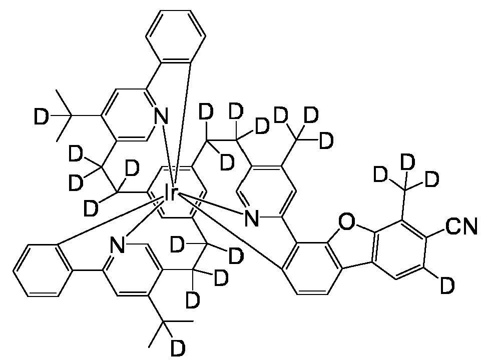 |
| Ir158 | Ir59 | 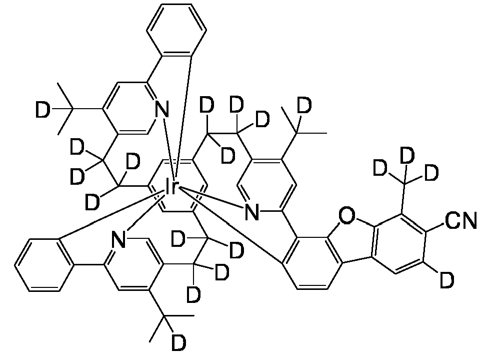 |
| Ir159 | Ir60 | 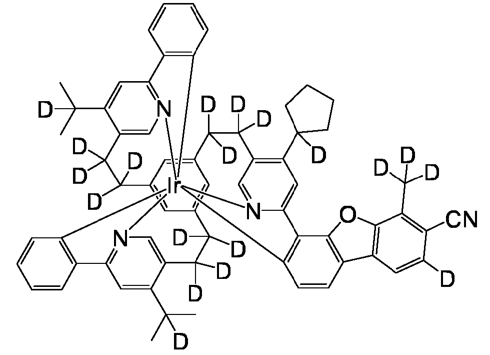 |
| Ir160 | Ir61 | 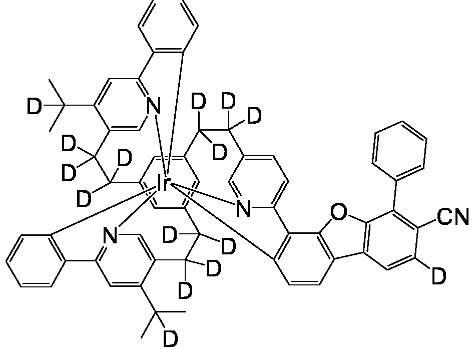 |
| Ir161 | Ir62 | 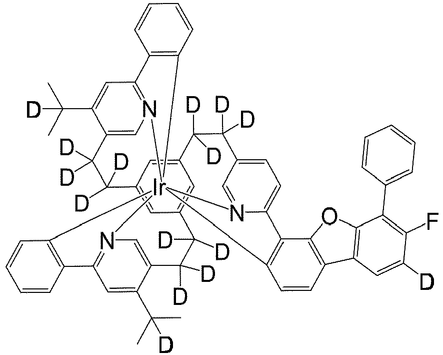 |
| Ir162 | Ir63 | 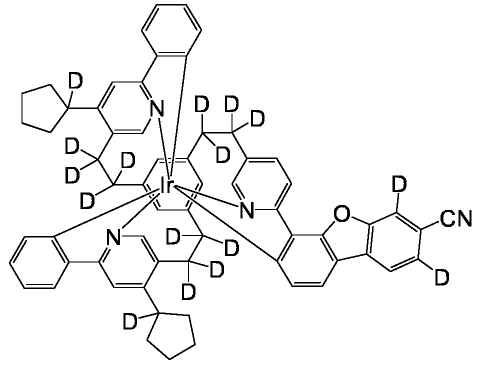 |
| Ir163 | Ir64 | 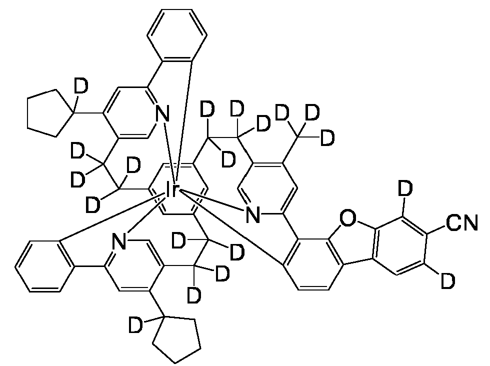 |
| Ir164 | Ir65 | 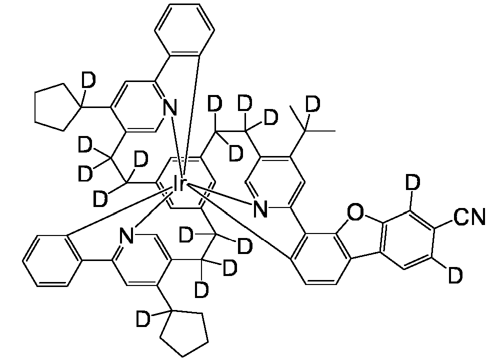 |
| Ir165 | Ir66 | 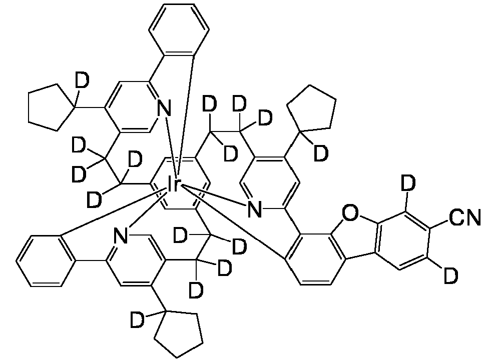 |
| Ir166 | Ir67 | 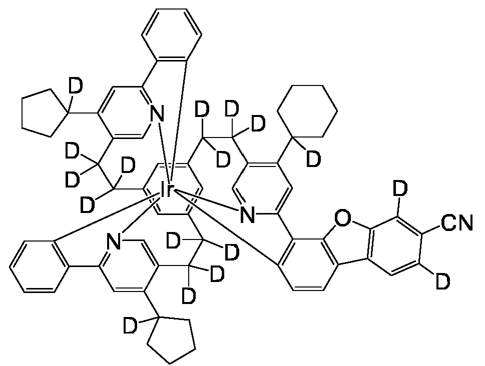 |
| Ir167 | Ir68 | 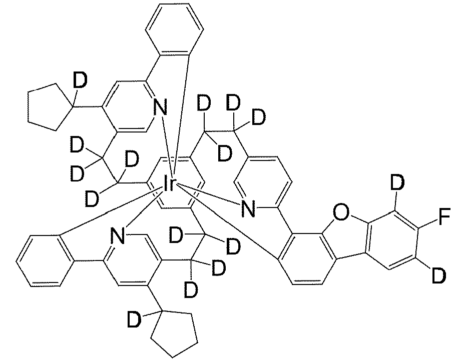 |
| Ir168 | Ir69 | 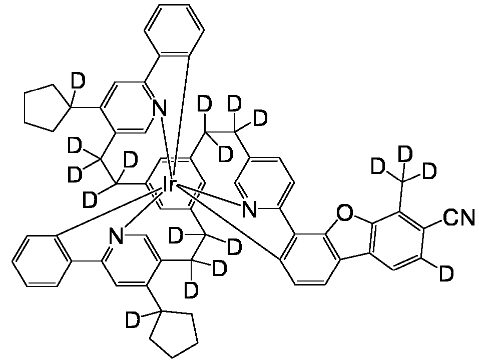 |
| Ir169 | Ir70 | 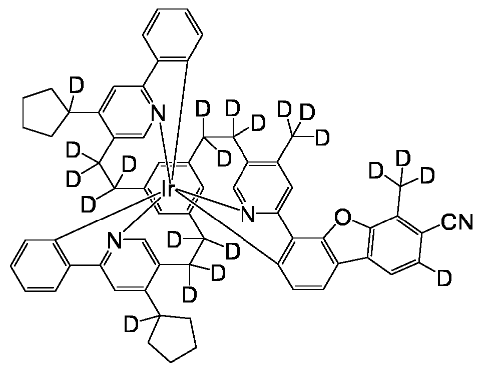 |
| Ir170 | Ir71 | 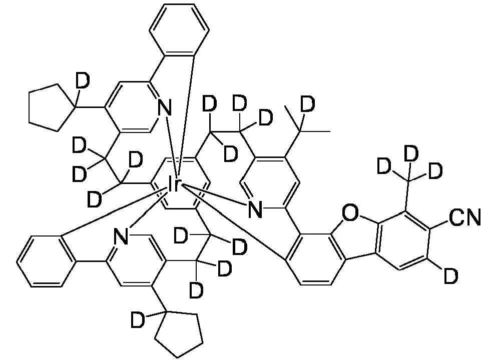 |
| Ir171 | Ir72 | 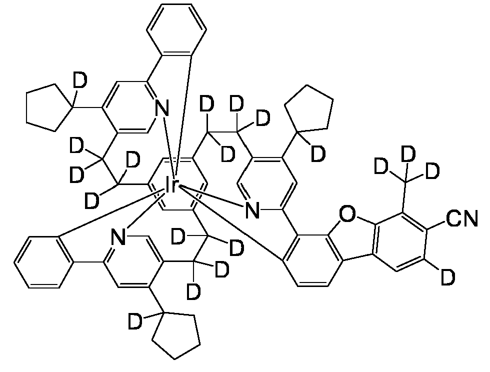 |
| Ir172 | Ir73 | 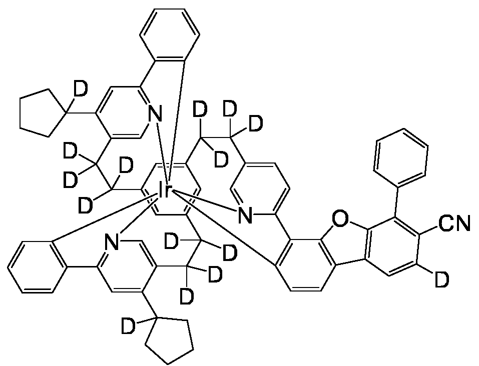 |
| Ir173 | Ir74 | 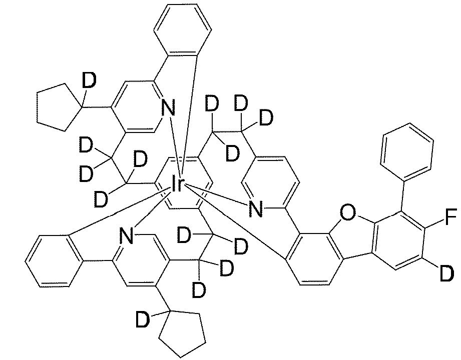 |
| Ir174 | Ir75 | 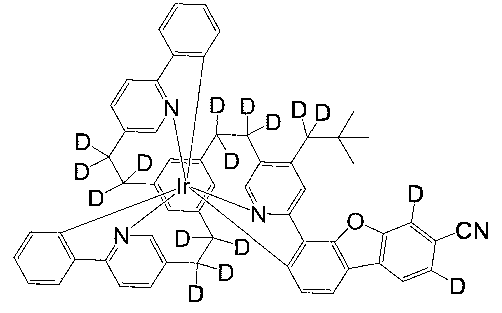 |
| Ir175 | Ir76 | 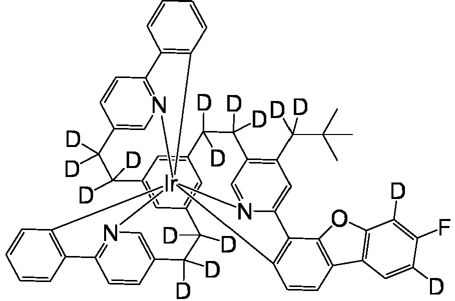 |
| Ir176 | Ir77 | 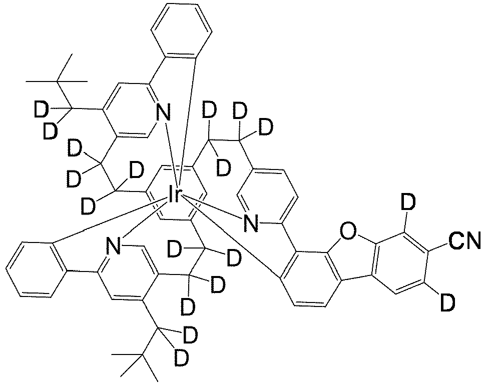 |
| Ir177 | Ir78 | 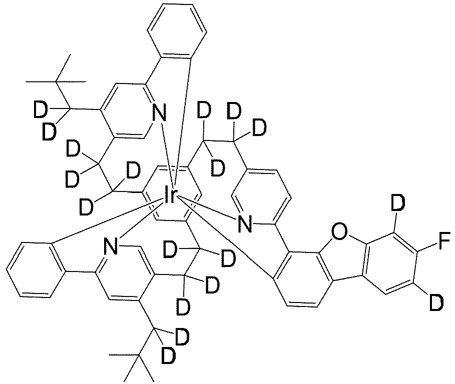 |
| Ir178 | Ir79 | 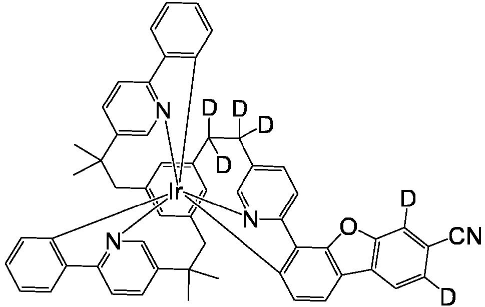 |
| Ir179 | Ir80 | 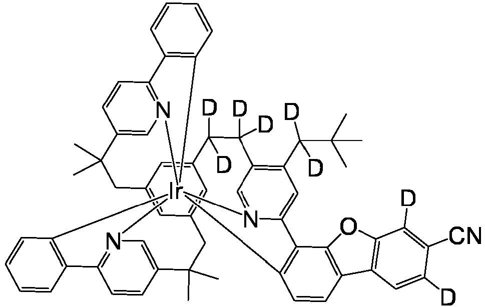 |

### Example: Luminescence properties

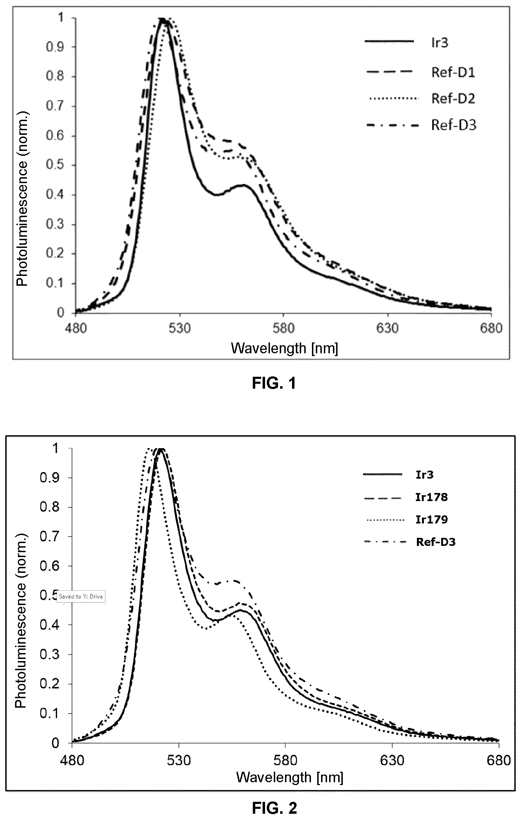

Figure 1 shows the photoluminescence spectrum (ca. 10⁻⁵ M in degassed toluene) of compound Ir3 according to the invention and the reference emitters Ref-D1, Ref-D2 and Ref-D3, whose structure is shown in Table 3 below. As can be clearly seen, the compound according to the invention exhibits a significantly narrower emission spectrum compared to the reference compounds.

Figure 2 shows the photoluminescence spectra (ca. 10⁻⁵ M in degassed toluene) of compounds Ir3, Ir178, Ir179 according to the invention and the reference emitter Ref-D3, whose structure is shown in Table 3 below. As can be clearly seen, the compounds according to the invention exhibit a significantly narrower emission spectrum compared to the reference compound.

### Example: Production of the OLEDs

### Vacuum Processed Devices:

OLEDs according to the invention as well as OLEDs according to the prior art are manufactured by a general process according to WO 2004/058911, which is adapted to the conditions described here (layer thickness variation, materials used).

In the following examples the results of different OLEDs are presented. Cleaned glass plates (cleaning in Miele laboratory dishwasher, cleaner Merck Extran) coated with structured ITO (Indium Tin Oxide) of thickness 50 nm are pretreated with UV-ozone for 25 minutes (UV-ozone generator PR-100, company UVP). These coated glass plates form the substrates onto which the OLEDs are deposited.

All materials are thermally evaporated in a vacuum chamber. The emission layer always consists of at least one or more matrix materials M and one of the phosphorescent dopants Ir according to the invention, which is added to the matrix material(s) by co-evaporation in a -certain volume fraction. A specification such as M1:M2:lr (55%:35%:10%) means here that the material M1 is present in the layer in a volume fraction of 55%, M2 in a volume fraction of 35% and Ir in a volume fraction of 10%. Similarly, the electron transport layer consists of a mixture of two materials. The exact structure of the OLEDs can be seen in Table 1. The materials used to fabricate the OLEDs are shown in Table 3.

The OLEDs are characterized as standard. For this purpose, the electroluminescence spectra, the current efficiency (measured in cd/A), the power efficiency (measured in lm/W) and the external quantum efficiency (EQE, measured in %) are determined as a function of the luminance, calculated from current-voltage-luminance curves (IUL curves) assuming a Lambertian radiation pattern, and the lifetime. The efficiency in cd/A, the EQE in %, the voltage in V, the color coordinates CIE, the maximum of the electroluminescence spectrum λₘₐₓ in nm and the spectral half width (FWHM: Full Width Half Maximum) of the electroluminescence spectrum in eV are specified at a luminance of 1000 cd/m².

### The OLEDs have the following layer structure:

- Substrate
- Hole injection layer (HIL) of HTM1 doped with 5 % NDP-9 (commercially available from Novaled), 20 nm
- Hole transport layer (HTL), see Table 1
- Electron blocking layer (EBL), see Table 1
- Emission Layer (EML), see Table 1
- Hole blocking layer (HBL), see Table 1
- Electron transport layer (ETL), made of ETM1:ETM2 (50%:50%), 30 nm
- Electron injection layer (EIL) made of ETM2, 1 nm
- Aluminum cathode, 100 nm

**Table 1: Structure of phosphorescent OLED devices**

| **Ex.** | **HTL Thickness** | **EBL Thickness** | **EML Thickness** | **HBL Thickness** |
|---|---|---|---|---|
| GP1 | HTM1 40 nm | EBM1 20 nm | M1:M2:Ir3 (46%:46%:8%) 40 nm | HBM1 5 nm |
| GP2 | HTM1 40 nm | EBM1 20 nm | M1:M2:Ir178 (46%:46%:8%) 40 nm | HBM1 5 nm |
| GP3 | HTM1 40 nm | EBM1 20 nm | M1:M2:Ir179 (46%:46%:8%) 40 nm | HBM1 5 nm |

**Table 2: Results phosphorescent OLED devices**

| **Ex.** | **Eff. [cd/A]** | **EQE (%)** | **Voltage (V)** | **CIE (x / y)** | **λₘₐₓ (nm)** | **FWHM (eV)** |
|---|---|---|---|---|---|---|
| GP1 | 91.3 | 23.5 | 2.79 | 0.33/0.64 | 526 | 0.14 |
| GP2 | 100.0 | 25.5 | 2.62 | 0.33/0.64 | 526 | 0.14 |
| GP3 | 94.4 | 24.8 | 2.83 | 0.30/0.66 | 522 | 0.13 |

**Table 3: Structural formulae of the materials used**

| | |
|---|---|
| 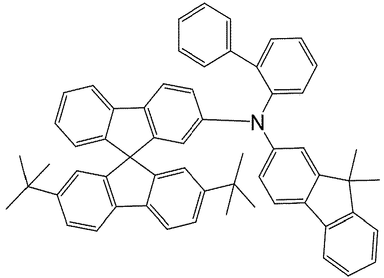 HTM1 | 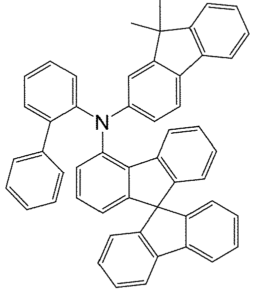 EBM1 |
| 1365840-52-3 | 1450933-44-4 |
| 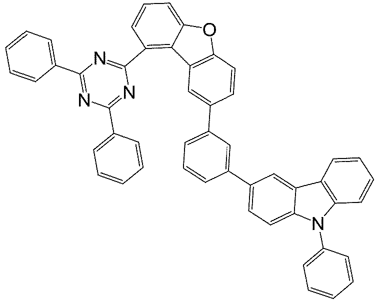 M1 | 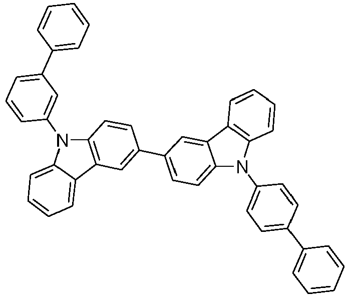 M2 |
| 1822310-86-0 | 1643479-47-3 |
| 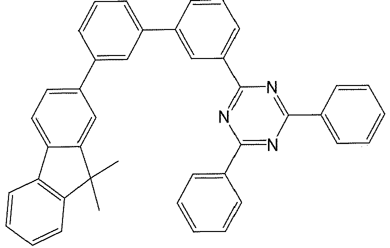 HBM1 | 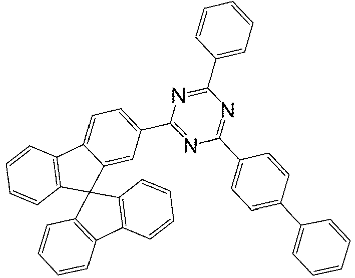 ETM1 |
| 1955543-57-3 | |
| | 1819335-36-8 |
| 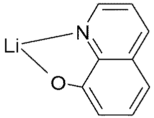 ETM2 | |
| 25387-93-3 | |
| 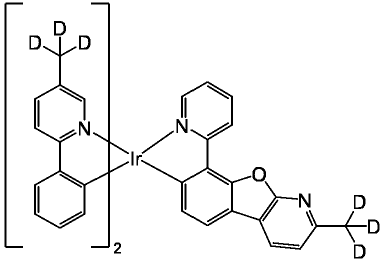 Ref-D1 | 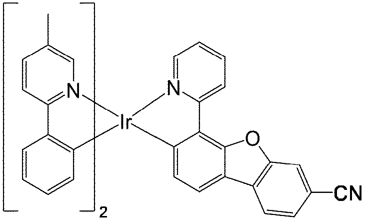 Ref-D2 |
| | 2458813-55-1 |
| 1609368-32-2 | |
| 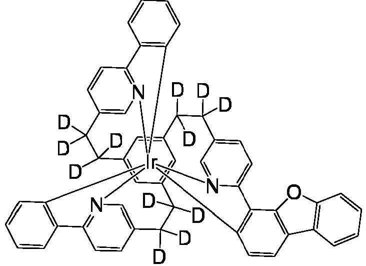 Ref-D3 | |

## Claims

1. A compound of formula (1),
Ir(L) Formula (1)
wherein the ligand L has a structure of formula (2): 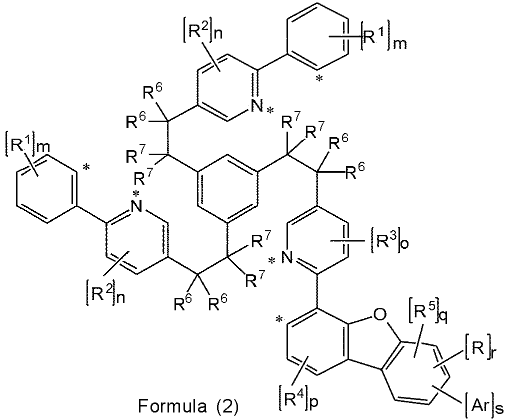 wherein the ligand L coordinates to the iridium atom via the positions marked with * and wherein the hydrogen atoms not explicitly shown may also be partially or completely replaced by deuterium, and wherein the symbols and indices used apply:
R at each occurrence is the same or different and is F or CN;
Ar is a phenyl or biphenyl group which may be unsubstituted or substituted by one or more radicals, each of which are the same or different and are selected from the group consisting of F, CN, Si(CH₃)₃ , a straight-chain alkyl group having 1 to 10 C atoms, a branched alkyl group having 3 to 10 C atoms or a cyclic alkyl group having 4 to 8 C atoms; in this case the phenyl or biphenyl group or the substituents on this phenyl or biphenyl group are optionally partially or completely deuterated;
R¹ at each occurrence is the same or different and is F, CN, a straight-chain alkyl group having 1 to 10 C atoms, a branched alkyl group having 3 to 10 C atoms, a cyclic alkyl group having 4 to 8 C atoms, phenyl or biphenyl, wherein R¹ is optionally partially or completely deuterated; and wherein when two adjacent radicals R¹ represent a straight-chain, branched or cyclic alkyl group, the two radicals R¹ may form a ring system with one another;
R², R³ at each occurrence is the same or different and is F, a straight-chain alkyl group having 1 to 10 C atoms, a branched alkyl group having 3 to 10 C atoms or a cyclic alkyl group having 4 to 8 C atoms; wherein R² and R³ are optionally partially or completely deuterated; and wherein two adjacent radicals R² or two adjacent radicals R³ may form a ring system with one another;
R⁴ at each occurrence is the same or different and is a straight-chain alkyl group having 1 to 10 C atoms, a branched alkyl group having 3 to 10 C atoms, a cyclic alkyl group having 4 to 8 C atoms, phenyl or biphenyl, wherein R⁴ is optionally partially or completely deuterated; wherein when two adjacent radicals R⁴ represent a straight-chain, branched or cyclic alkyl group, the two radicals R⁴ may form a ring system with one another;
R⁵ at each occurrence is the same or different and is a straight-chain alkyl group having 1 to 10 C atoms, a branched alkyl group having 3 to 10 C atoms or a cyclic alkyl group having 4 to 8 C atoms; wherein R⁵ is optionally partially or fully deuterated; wherein two adjacent radicals R⁵ may form a ring system with one another;
R⁶, R⁷ at each occurrence is the same or different and is H, D, CH₃ or C₂H₅ , wherein the CH₃ group or the C₂H₅ group is optionally partially or completely deuterated;
r is 1 or 2;
s is 0 or 1;
m at each occurrence is the same or different and is 0, 1, 2, 3 or 4;
n, o at each occurrence of is the same or different and is 0, 1, 2, or 3;
p is 0, 1 or 2;
q **is 0, 1, 2, or 3; with the proviso that the sum of q + r + s ≤ 4**.

2. The compound according to claim 1, **characterized in that** r = 1 and the ligand L has a structure according to formula (3), (4), (5) or (6), 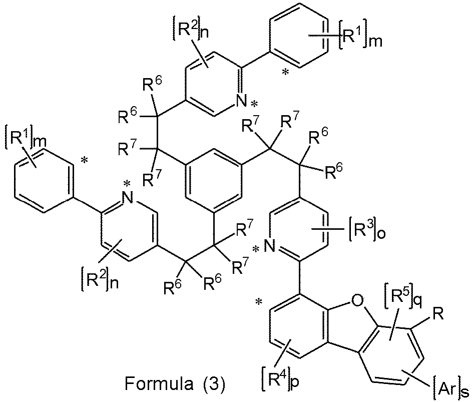 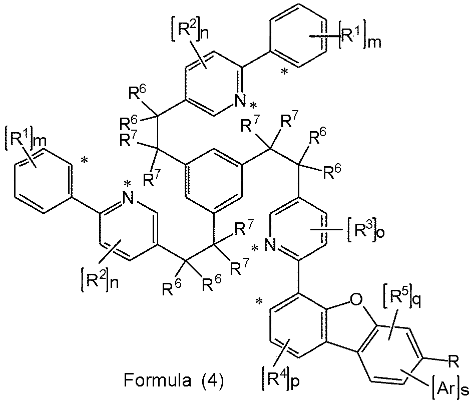 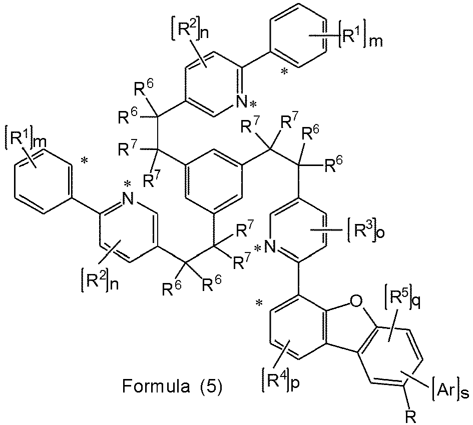 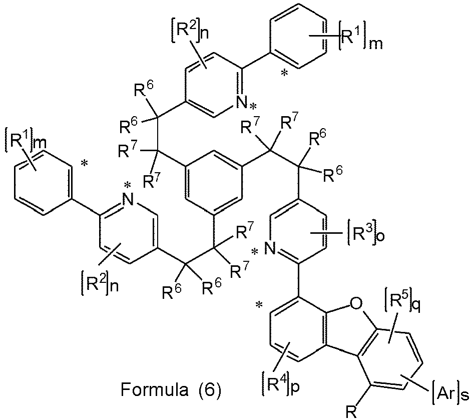 wherein the symbols and indices used have the meanings given in claim 1 and the hydrogen atoms not explicitly shown may also be partially or completely replaced by deuterium.

3. The compound according to claim 1 or 2, **characterized in that** R = CN and s = 0; or that R = F and s = 1; or that R = F, s = 0 and q = 1, wherein R⁵ represents a cyclopentyl or cyclohexyl group which is optionally partially or completely deuterated.

4. The compound according to any one of claims 1 to 3, **characterized in that** the ligand L has a structure according to one of the formulae (7), (8), (9) or (10), 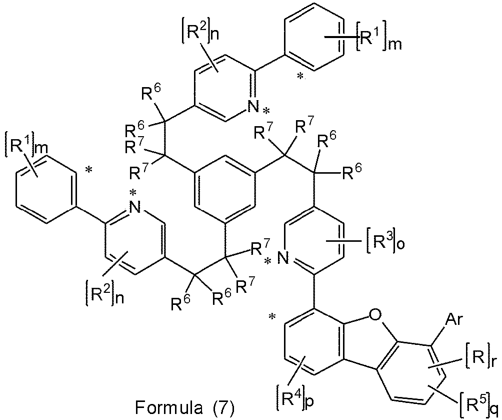 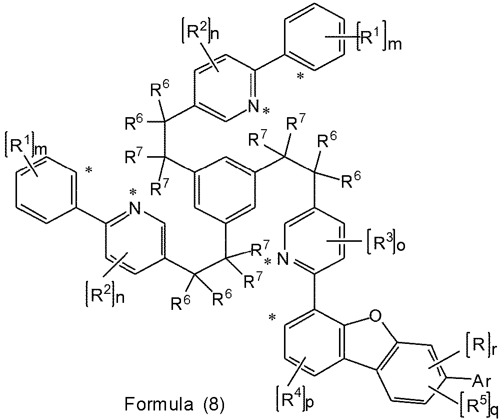 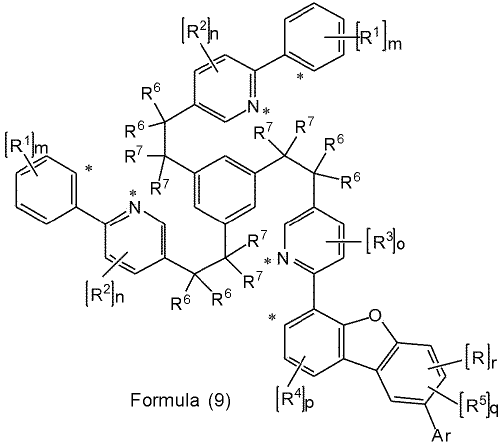 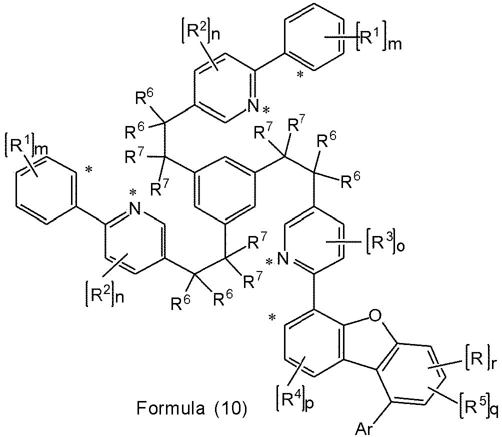 wherein the symbols and indices used have the meanings given in claim 1 and the hydrogen atoms not explicitly shown may also be partially or completely replaced by deuterium.

5. The compound of any one of claims 1 to 4, **characterized in that** the ligand L has a structure of formula (11a), (11b) or (11c), 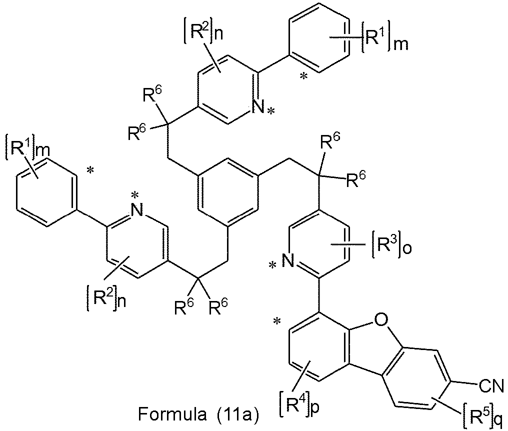 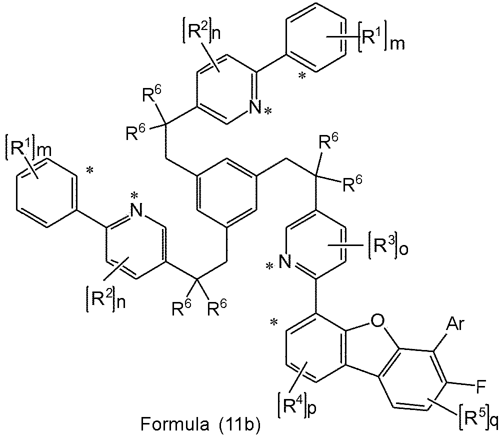 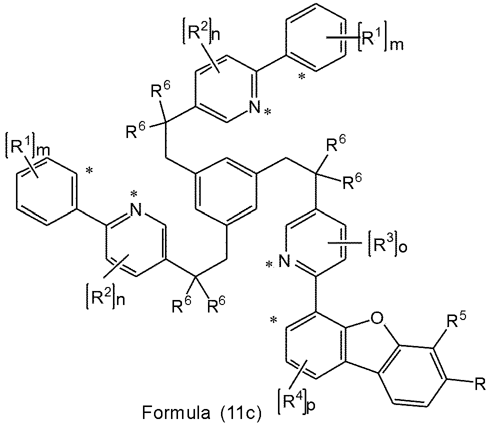 wherein the symbols and indices used have the meanings given in claim 1, the hydrogen atoms not explicitly shown may also be partially or completely replaced by deuterium, R⁶ is H, D, CH₃ or CD₃; and R⁵ in formula (11c) preferably is a cyclopentyl or cyclohexyl group which is optionally partially or completely deuterated.

6. The compound of any one of claims 1 to 5, **characterized in that** a deuterium atom is bonded in all ortho-positions to R in which Ar or R⁵ is not bonded.

7. The compound according to any one of claims 1 to 6, **characterized in that** the ligand L is selected from the structures of formulae (11a-1), (11b-1) or (11c-1), 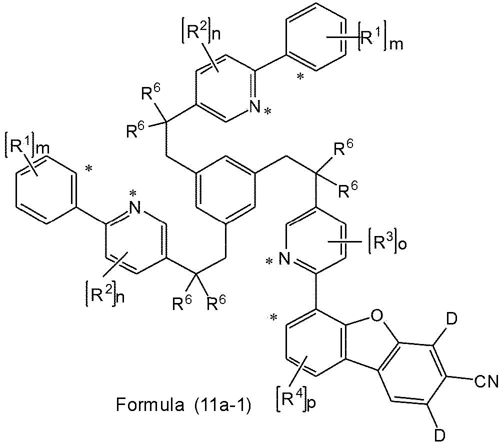 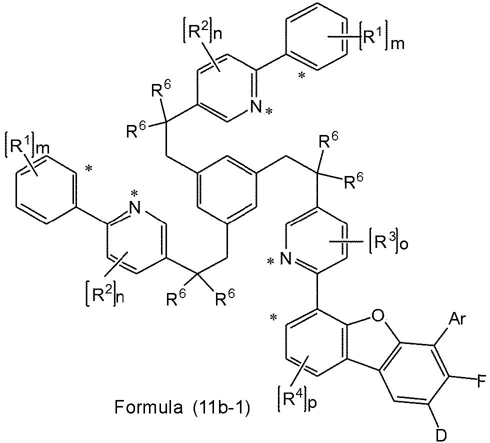 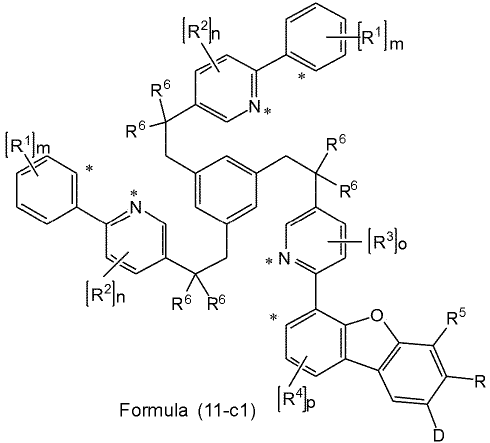 wherein the symbols and indices used have the meanings given in claim 1, the hydrogen atoms not explicitly shown may also be partially or completely replaced by deuterium, each occurrence of R⁶ is the same or different and represents H, D, CH₃ or CD₃; and R⁵ in formula (11c-1) preferably represents a cyclopentyl or cyclohexyl group which is optionally partially or completely deuterated.

8. The compound according to any one of claims 1 to 7, **characterized in that** Ar is a phenyl group which is optionally partially or fully deuterated and which is otherwise unsubstituted or substituted by a methyl group which is optionally partially or fully deuterated.

9. The compound according to any one of claims 1 to 8, **characterized in that** the symbols and indices are:
Ar is a phenyl group which is optionally partially or fully deuterated and which is optionally substituted by a methyl group which is partially or fully deuterated;
R¹ at each occurrence is the same or different and is selected from the group consisting of CN, a straight chain alkyl group having 1 to 4 C atoms, a branched alkyl group having 3 to 5 C atoms, a cyclic alkyl group having 5 or 6 C atoms, or a phenyl group, each of which groups is optionally partially or fully deuterated;
R², R³ at each occurrence is the same or different and is selected from the group consisting of a straight chain alkyl group having 1 to 4 C atoms, a branched alkyl group having 3 to 5 C atoms, or a cyclic alkyl group having 5 or 6 C atoms, each of which groups are optionally partially or fully deuterated;
R⁴ at each occurrence is the same or different and is selected from the group consisting of a straight chain alkyl group having 1 to 4 C atoms, a branched alkyl group having 3 to 5 C atoms, a cyclic alkyl group having 5 or 6 C atoms, or phenyl, each of which groups are optionally partially or fully deuterated;
R⁵ each occurrence is the same or different and is selected from the group consisting of a straight chain alkyl group having 1 to 4 C atoms, a branched alkyl group having 3 to 5 C atoms, or a cyclic alkyl group having 5 or 6 C atoms, each of which groups are optionally partially or fully deuterated;
R⁶ at each occurrence is the same or different and is H, D, or CH₃ , which is optionally partially or fully deuterated;
R⁷ at each occurrence is the same or different and is H or D;
m at each occurrence of is the same or different and is 0, 1, 2 or 3;
n, o at each occurrence of is the same or different and is 0, 1 or 2;
p is 0 or 1;
q is 0 or 1;
s is 0 for R = CN and is 1 for R = F.

10. A process for preparing a compound according to any one of claims 1 to 9 comprising the step of reacting the free ligand with an iridium alkoxide, an iridium ketoketonate, an iridium halide or an iridium carboxylate.

11. A formulation comprising at least one compound according to any one of claims 1 to 9 and at least one further compound, wherein the further compound is selected from a solvent and/or a matrix material.

12. A use of a compound according to one or more of claims 1 to 9 in an electronic device, or for generating singlet oxygen, or in photocatalysis.

13. A photocatalyst comprising at least one compound according to any one of claims 1 to 9.

14. An electronic device comprising at least one compound according to any one of claims 1 to 9.

15. The electronic device of claim 14, **characterized in that** it is an organic electroluminescent device and the compound of any one of claims 1 to 9 is used as an emitting compound in one or more emitting layers.

## Patentansprüche

1. Eine Verbindung der Formel (1),
Ir(L) Formel (1)
worin der Ligand L eine Struktur der Formel (2) aufweist: 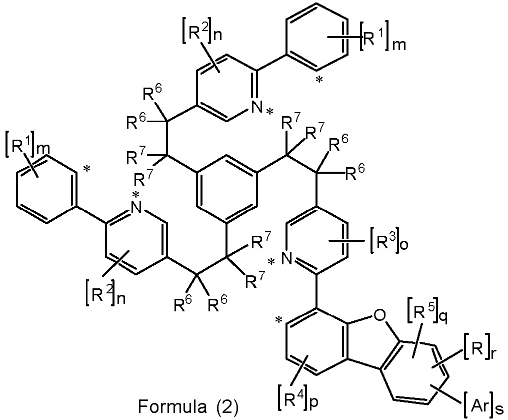 wobei der Ligand L über die mit * gekennzeichneten Positionen mit dem Iridiumatom koordiniert und wobei die nicht explizit dargestellten Wasserstoffatome auch teilweise oder vollständig durch Deuterium ersetzt sein können, und wobei für die verwendeten Symbole und Indizes gilt:
R ist bei jedem Auftreten gleich oder verschieden, und ist F oder CN;
Ar ist eine Phenyl- oder Biphenylgruppe, die unsubstituiert sein kann oder substituiert sein kann mit einem oder mehreren Resten, die gleich oder verschieden sind und ausgewählt werden aus der Gruppe bestehend aus F, CN, Si(CH₃)₃, einer geradkettigen Alkylgruppe mit 1 bis 10 C-Atomen, einer verzweigten Alkylgruppe mit 3 bis 10 C-Atomen, oder einer cyclischen Alkylgruppe mit 4 bis 8 C-Atomen; in diesem Fall sind die Phenyl- oder Biphenylgruppe oder die Substituenten an dieser Phenyl- oder Biphenylgruppe gegebenenfalls teilweise oder vollständig deuteriert;
R¹ ist bei jedem Auftreten gleich oder verschieden, und ist F, CN, eine geradkettige Alkylgruppe mit 1 bis 10 C-Atomen, eine verzweigte Alkylgruppe mit 3 bis 10 C-Atomen, eine cyclische Alkylgruppe mit 4 bis 8 C-Atomen, Phenyl oder Biphenyl, wobei R¹ gegebenenfalls teilweise oder vollständig deuteriert ist; und wobei, wenn zwei benachbarte Reste R¹ eine geradkettige, verzweigte oder cyclische Alkylgruppe darstellen, die beiden Reste R¹ miteinander ein Ringsystem bilden können;
R², R³ sind bei jedem Auftreten gleich oder verschieden und sind F, eine geradkettige Alkylgruppe mit 1 bis 10 C-Atomen, eine verzweigte Alkylgruppe mit 3 bis 10 C-Atomen, oder eine cyclische Alkylgruppe mit 4 bis 8 C-Atomen; wobei R² und R³ gegebenenfalls teilweise oder vollständig deuteriert sind; und wobei zwei benachbarte Reste R² oder zwei benachbarte Reste R³ miteinander ein Ringsystem bilden können;
R⁴ ist bei jedem Auftreten gleich oder verschieden, und ist eine geradkettige Alkylgruppe mit 1 bis 10 C-Atomen, eine verzweigte Alkylgruppe mit 3 bis 10 C-Atomen, eine cyclische Alkylgruppe mit 4 bis 8 C-Atomen, Phenyl oder Biphenyl, wobei R⁴ gegebenenfalls teilweise oder vollständig deuteriert ist; wobei, wenn zwei benachbarte Reste R⁴ eine geradkettige, verzweigte oder cyclische Alkylgruppe darstellen, die beiden Reste R⁴ miteinander ein Ringsystem bilden können;
R⁵ ist bei jedem Auftreten gleich oder verschieden, und ist eine geradkettige Alkylgruppe mit 1 bis 10 C-Atomen, eine verzweigte Alkylgruppe mit 3 bis 10 C-Atomen oder eine cyclische Alkylgruppe mit 4 bis 8 C-Atomen; wobei R⁵ gegebenenfalls teilweise oder vollständig deuteriert ist; wobei zwei benachbarte Reste R⁵ miteinander ein Ringsystem bilden können;
R⁶, R⁷ sind bei jedem Auftreten gleich oder verschieden, und sind H, D, CH₃ oder C₂H₅, wobei die CH₃ Gruppe oder die C₂H₅ Gruppe gegebenenfalls teilweise oder vollständig deuteriert ist;
r ist 1 oder 2;
s ist 0 oder 1;
m ist bei jedem Auftreten gleich oder verschieden, und ist 0, 1, 2, 3 oder 4;
n, o sind bei jedem Auftreten gleich oder verschieden, und sind 0, 1, 2 oder 3;
p ist 0, 1 oder 2;
q ist 0, 1, 2 oder 3; mit der Maßgabe, dass die Summe von q + r + s ≤ 4 ist.

2. Verbindung nach Anspruch 1, **dadurch gekennzeichnet, dass** r = 1 und der Ligand L eine Struktur gemäß Formel (3), (4), (5) oder (6) aufweist, 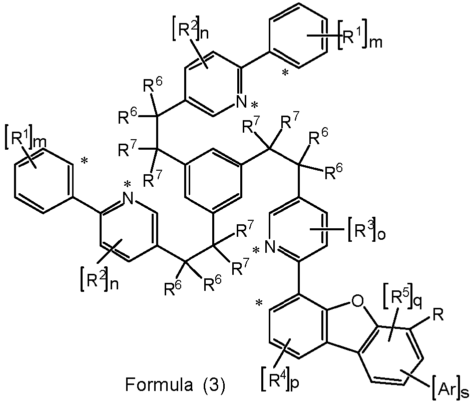 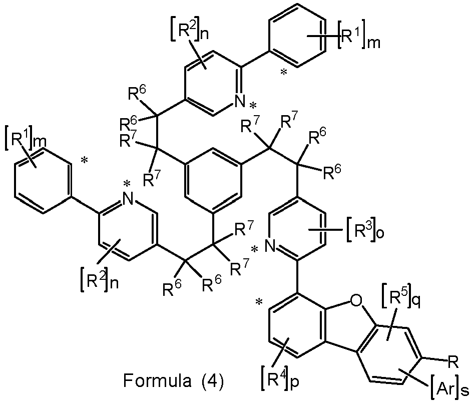 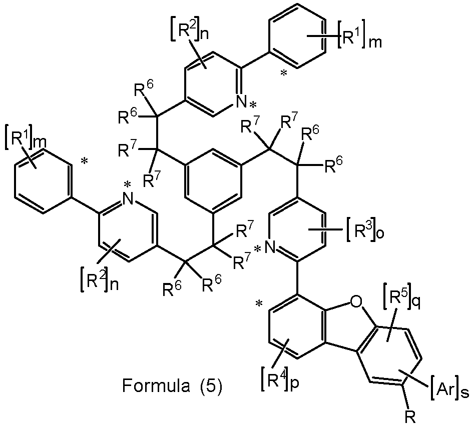 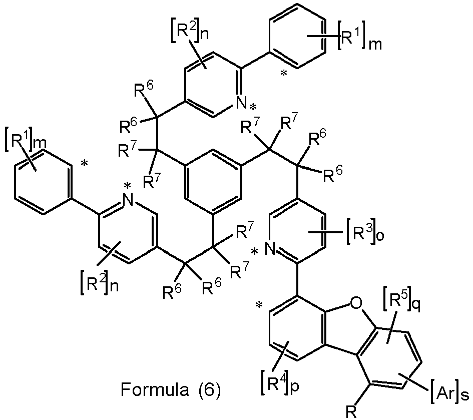 wobei die verwendeten Symbole und Indizes die in Anspruch 1 angegebene Bedeutung haben, und die nicht ausdrücklich gezeigten Wasserstoffatome auch teilweise oder vollständig durch Deuterium ersetzt sein können.

3. Verbindung nach Anspruch 1 oder 2, **dadurch gekennzeichnet, dass** R = CN und s = 0; oder dass R = F und s = 1; oder dass R = F, s = 0 und q = 1, wobei R⁵ eine Cyclopentyl- oder Cyclohexylgruppe darstellt, die gegebenenfalls teilweise oder vollständig deuteriert ist.

4. Verbindung nach einem der Ansprüche 1 bis 3, **dadurch gekennzeichnet, dass** der Ligand L eine Struktur gemäß einer der Formeln (7), (8), (9) oder (10) aufweist, 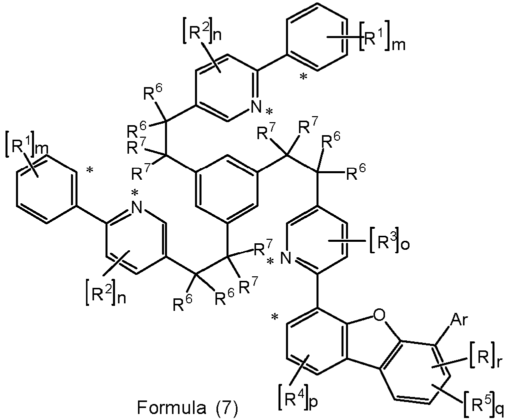 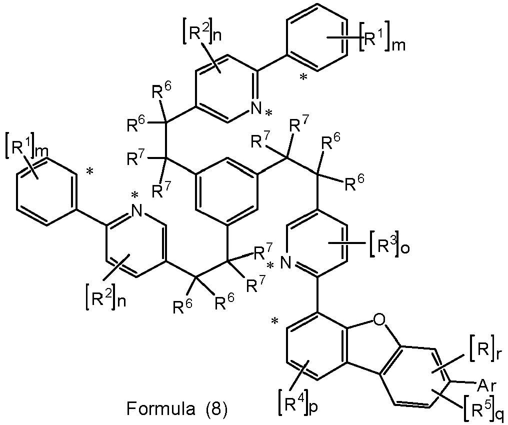 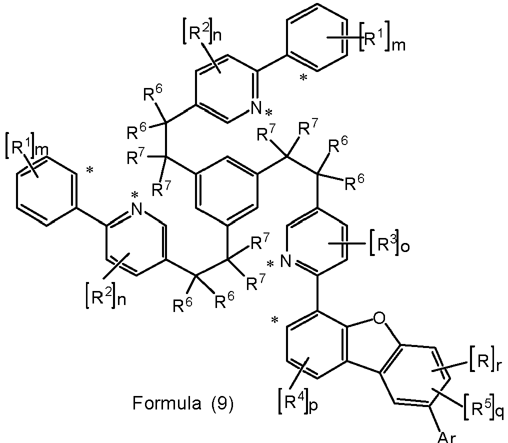 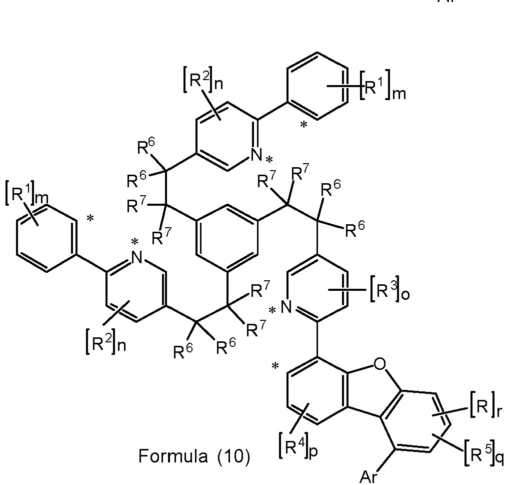 wobei die verwendeten Symbole und Indizes die in Anspruch 1 angegebene Bedeutung haben, und die nicht explizit gezeigten Wasserstoffatome auch teilweise oder vollständig durch Deuterium ersetzt sein können.

5. Verbindung nach einem der Ansprüche 1 bis 4, **dadurch gekennzeichnet, dass** der Ligand L eine Struktur der Formel (11a), (11b) oder (11c) aufweist, 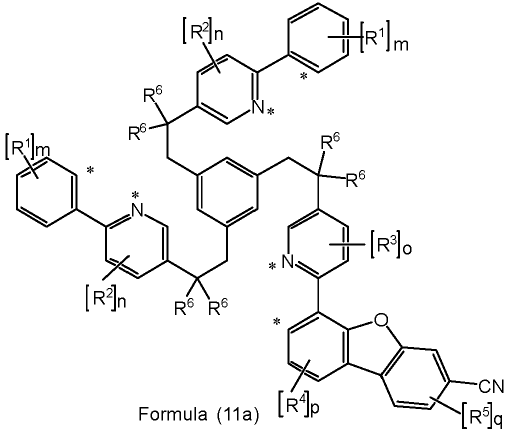 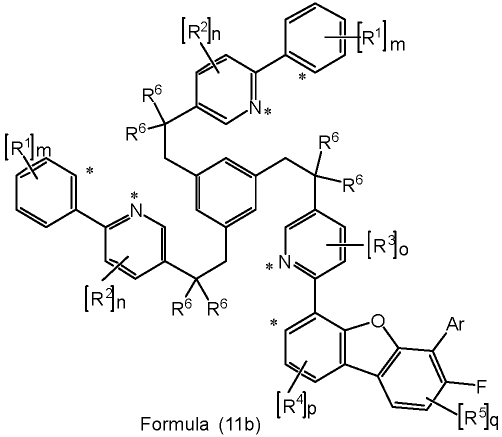 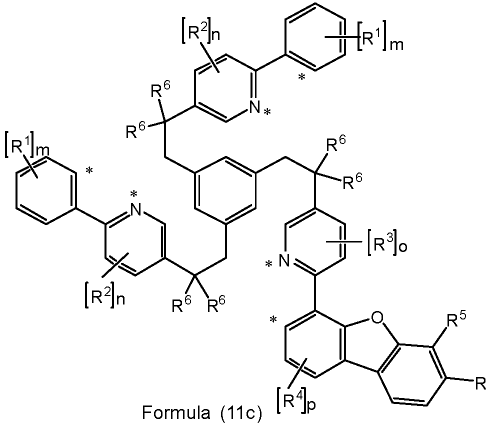 worin die verwendeten Symbole und Indizes die in Anspruch 1 angegebenen Bedeutungen haben, die nicht explizit gezeigten Wasserstoffatome auch teilweise oder vollständig durch Deuterium ersetzt sein können, R⁶ gleich H, D, CH₃ oder CD₃ ist; und R⁵ in Formel (11c) vorzugsweise eine Cyclopentyl- oder Cyclohexylgruppe ist, die gegebenenfalls teilweise oder vollständig deuteriert ist.

6. Verbindung nach einem der Ansprüche 1 bis 5, **dadurch gekennzeichnet, dass** ein Deuteriumatom in allen ortho-Positionen an R gebunden ist, in denen Ar oder R⁵ nicht gebunden ist.

7. Verbindung nach einem der Ansprüche 1 bis 6, **dadurch gekennzeichnet, dass** der Ligand L aus den Strukturen der Formeln (11a-1), (11b-1) oder (11c-1) ausgewählt ist, 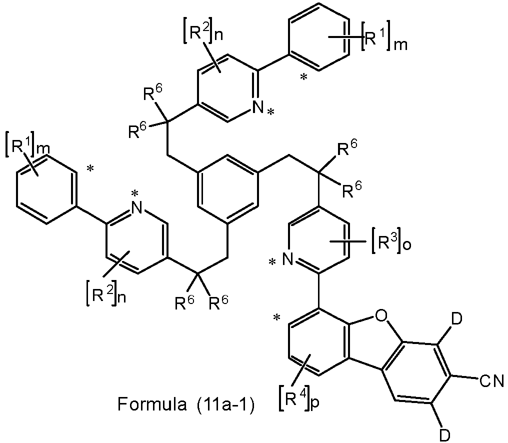 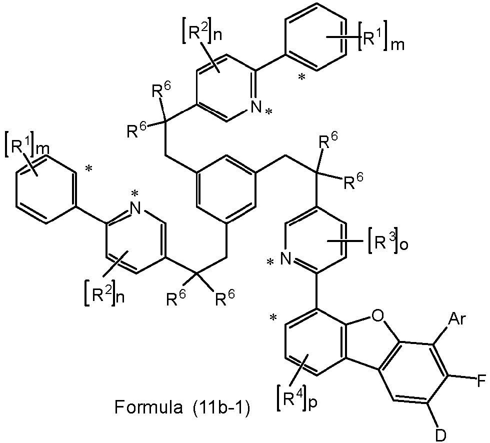 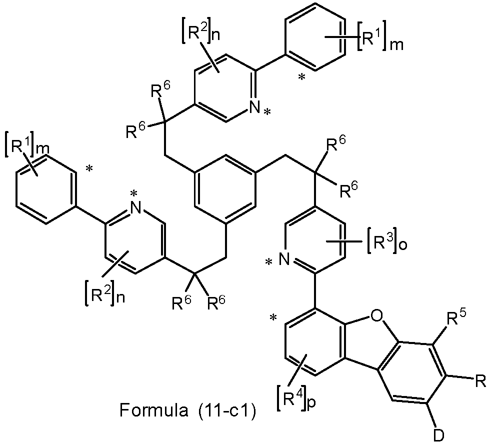 worin die verwendeten Symbole und Indizes die in Anspruch 1 angegebenen Bedeutungen haben, die nicht explizit gezeigten Wasserstoffatome auch teilweise oder vollständig durch Deuterium ersetzt sein können, jedes Auftreten von R⁶ gleich oder verschieden ist und H, D, CH₃ oder CD₃ darstellt; und R⁵ in Formel (11c-1) vorzugsweise eine Cyclopentyl- oder Cyclohexylgruppe darstellt, die gegebenenfalls teilweise oder vollständig deuteriert ist.

8. Verbindung nach einem der Ansprüche 1 bis 7, **dadurch gekennzeichnet, dass** Ar eine Phenylgruppe ist, die gegebenenfalls teilweise oder vollständig deuteriert ist und die ansonsten unsubstituiert oder durch eine Methylgruppe substituiert ist, die gegebenenfalls teilweise oder vollständig deuteriert ist.

9. Verbindung nach einem der Ansprüche 1 bis 8, **dadurch gekennzeichnet, dass** die Symbole und Indizes wie folgt sind:
Ar ist eine Phenylgruppe, die gegebenenfalls teilweise oder vollständig deuteriert ist, und die gegebenenfalls durch eine Methylgruppe substituiert ist, die teilweise oder vollständig deuteriert ist;
R¹ ist bei jedem Auftreten gleich oder verschieden, und ist ausgewählt aus der Gruppe bestehend aus CN, einer geradkettigen Alkylgruppe mit 1 bis 4 C-Atomen, einer verzweigten Alkylgruppe mit 3 bis 5 C-Atomen, einer cyclischen Alkylgruppe mit 5 oder 6 C-Atomen, oder einer Phenylgruppe, wobei jede dieser Gruppen gegebenenfalls teilweise oder vollständig deuteriert ist;
R², R³ sind bei jedem Auftreten gleich oder verschieden, und sind ausgewählt aus der Gruppe bestehend aus einer geradkettigen Alkylgruppe mit 1 bis 4 C-Atomen, einer verzweigten Alkylgruppe mit 3 bis 5 C-Atomen, oder einer cyclischen Alkylgruppe mit 5 oder 6 C-Atomen, wobei jede dieser Gruppen gegebenenfalls teilweise oder vollständig deuteriert ist;
R⁴ ist bei jedem Auftreten gleich oder verschieden, und ist ausgewählt aus der Gruppe bestehend aus einer geradkettigen Alkylgruppe mit 1 bis 4 C-Atomen, einer verzweigten Alkylgruppe mit 3 bis 5 C-Atomen, einer cyclischen Alkylgruppe mit 5 oder 6 C-Atomen, oder Phenyl, wobei jede dieser Gruppen gegebenenfalls teilweise oder vollständig deuteriert ist;
R⁵ ist bei jedem Auftreten gleich oder verschieden, und ist ausgewählt aus der Gruppe bestehend aus einer geradkettigen Alkylgruppe mit 1 bis 4 C-Atomen, einer verzweigten Alkylgruppe mit 3 bis 5 C-Atomen, oder einer cyclischen Alkylgruppe mit 5 oder 6 C-Atomen, wobei jede dieser Gruppen gegebenenfalls teilweise oder vollständig deuteriert ist;
R⁶ ist bei jedem Auftreten gleich oder verschieden und bedeutet H, D oder CH₃, das gegebenenfalls teilweise oder vollständig deuteriert ist;
R⁷ ist bei jedem Auftreten gleich oder verschieden und ist H oder D;
m ist bei jedem Auftreten von gleich oder verschieden und ist 0, 1, 2 oder 3;
n, o ist bei jedem Auftreten von gleich oder verschieden und ist 0, 1 oder 2;
p ist 0 oder 1;
q ist 0 oder 1;
s ist 0 für R = CN, und ist 1 für R = F.

10. Verfahren zur Herstellung einer Verbindung nach einem der Ansprüche 1 bis 9, umfassend den Schritt der Umsetzung des freien Liganden mit einem Iridiumalkoxid, einem Iridiumketoketonat, einem Iridiumhalogenid oder einem I ridiumcarboxylat.

11. Formulierung, umfassend mindestens eine Verbindung nach einem der Ansprüche 1 bis 9 und mindestens eine weitere Verbindung, wobei die weitere Verbindung aus einem Lösungsmittel und/oder einem Matrixmaterial ausgewählt ist.

12. Verwendung einer Verbindung nach einem oder mehreren der Ansprüche 1 bis 9 in einer elektronischen Vorrichtung, oder zur Erzeugung von Singulett-Sauerstoff, oder in der Photokatalyse.

13. Photokatalysator, umfassend mindestens eine Verbindung nach einem der Ansprüche 1 bis 9.

14. Elektronische Vorrichtung, die mindestens eine Verbindung nach einem der Ansprüche 1 bis 9 enthält.

15. Elektronische Vorrichtung nach Anspruch 14, **dadurch gekennzeichnet, dass** sie eine organische Elektrolumineszenzvorrichtung ist, und die Verbindung nach einem der Ansprüche 1 bis 9 als emittierende Verbindung in einer oder mehreren emittierenden Schichten verwendet wird.

## Revendications

1. Composé de formule (1),
Ir(L) Formule (1)
dans lequel le ligand L a une structure de formule (2) : 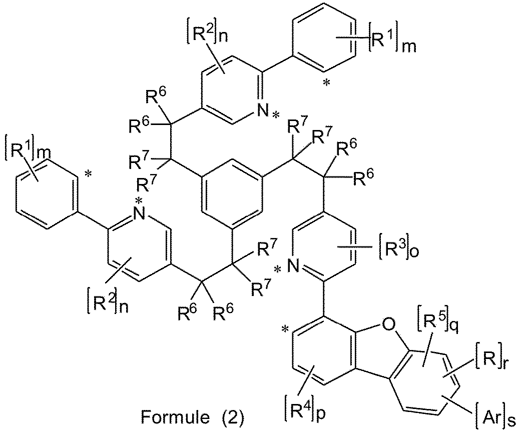
dans lequel le ligand L se coordonne à l'atome d'iridium via les positions marquées d'un * et dans lequel les atomes d'hydrogène non explicitement représentés peuvent également être partiellement ou totalement remplacés par du deutérium, et dans lequel les symboles et les indices utilisés s'appliquent :
R à chaque occurrence est identique ou différent et est F ou CN ;
Ar est un groupe phényle ou biphényle qui peut être non substitué ou substitué par un ou plusieurs radicaux identiques ou différents choisis dans le groupe constitué par F, CN, Si(CH(3)₃ un groupe alkyle à chaîne linéaire ayant de 1 à 10 atomes de carbone, un groupe alkyle ramifié, ayant de 3 à 10 atomes de carbone ou un groupe alkyle cyclique ayant de 4 à 8 atomes de carbone ; dans ce cas, le groupe phényle ou biphényle ou les substituants de ce groupe phényle ou biphényle sont éventuellement partiellement ou totalement deutérés ;
R¹ à chaque occurrence est identique ou différent et représente F, CN, un groupe alkyle à chaîne linéaire ayant 1 à 10 atomes de carbone, un groupe alkyle ramifié ayant 3 à 10 atomes de carbone, un groupe alkyle cyclique ayant 4 à 8 atomes de carbone, un phényle ou un biphényle, dans lequel R¹ est éventuellement partiellement ou totalement deutéré ; et dans lequel, lorsque deux radicaux adjacents R¹ représentent un groupe alkyle à chaîne linéaire, ramifié ou cyclique, les deux radicaux R¹ peuvent former un système cyclique l'un avec l'autre ;
R², R³ à chaque occurrence est identique ou différent et est F, un groupe alkyle à chaîne linéaire ayant de 1 à 10 atomes de carbone, un groupe alkyle ramifié ayant de 3 à 10 atomes de carbone ou un groupe alkyle cyclique ayant de 4 à 8 atomes de carbone ; dans lequel R² et R³sont éventuellement partiellement ou totalement deutérés ; et dans lequel deux radicaux adjacents R² ou deux radicaux adjacents R³ peuvent former un système cyclique l'un avec l'autre ;
R⁴ à chaque occurrence est identique ou différent et représente un groupe alkyle à chaîne linéaire ayant de 1 à 10 atomes de carbone, un groupe alkyle ramifié ayant de 3 à 10 atomes de carbone, un groupe alkyle cyclique ayant de 4 à 8 atomes de carbone, un phényle ou un biphényle, dans lequel R⁴ est éventuellement partiellement ou totalement deutéré ; dans lequel lorsque deux radicaux adjacents R⁴ représentent un groupe alkyle à chaîne linéaire, ramifié ou cyclique, les deux radicaux R⁴ peuvent former l'un avec l'autre un système cyclique ;
R⁵ à chaque occurrence est identique ou différent et est un groupe alkyle à chaîne linéaire ayant de 1 à 10 atomes de carbone, un groupe alkyle ramifié ayant de 3 à 10 atomes de carbone ou un groupe alkyle cyclique ayant de 4 à 8 atomes de carbone ; dans lequel R⁵ est éventuellement partiellement ou totalement deutéré ; dans lequel deux radicaux adjacents R⁵ peuvent former un système cyclique l'un avec l'autre ;
R⁶, R⁷ à chaque occurrence est identique ou différent et est H, D, CH₃ ou C₂H₅, dans lequel le groupe CH₃ ou le groupe C₂H₅ est éventuellement partiellement ou totalement deutéré ;
r est égal à 1 ou 2 ;
s est 0 ou 1 ;
m à chaque occurrence est identique ou différente et vaut 0, 1, 2, 3 ou 4 ;
n, o à chaque occurrence est identique ou différent et vaut 0, 1, 2 ou 3 ;
p est 0, 1 ou 2 ;
q est 0, 1, 2, ou 3 ; à condition que la somme de q + r + s s 4.

2. Composé selon la revendication 1, **caractérisé en ce que** r = 1 et que le ligand L a une structure selon la formule (3), (4), (5) ou (6), 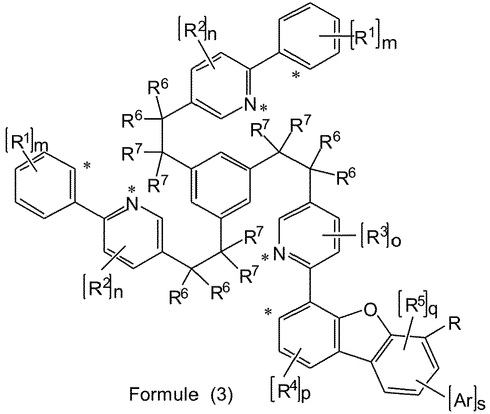 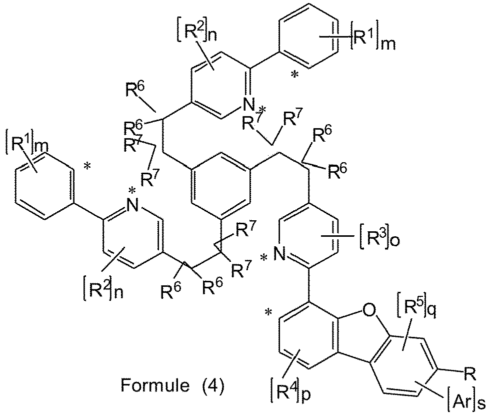 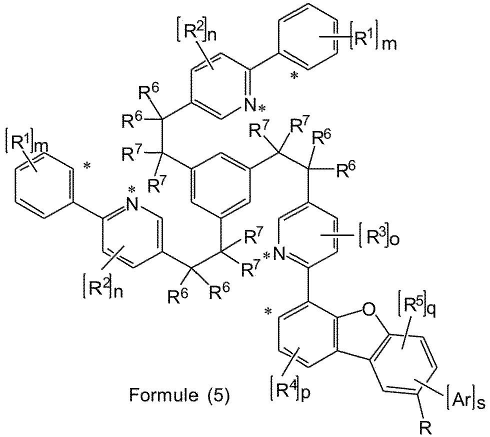 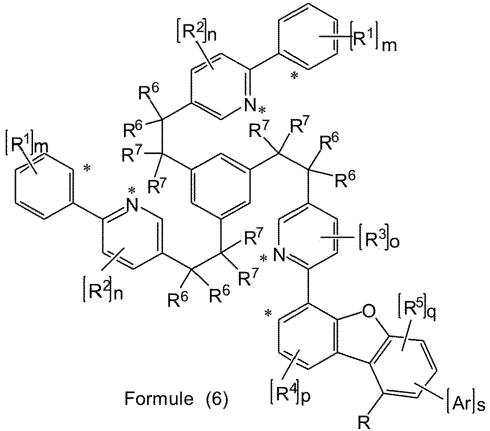 dans laquelle les symboles et indices utilisés ont la signification donnée dans la revendication 1 et les atomes d'hydrogène non explicitement représentés peuvent également être partiellement ou totalement remplacés par du deutérium.

3. Composé selon la revendication 1 ou 2, **caractérisé en ce que** R = CN et s = 0 ; ou que R = F et s = 1 ; ou que R = F, s = 0 et q = 1, dans lequel R⁵ représente un groupe cyclopentyle ou cyclohexyle qui est éventuellement partiellement ou complètement deutéré.

4. Composé selon l'une quelconque des revendications 1 à 3, **caractérisé par le fait que** le ligand L a une structure selon l'une des formules (7), (8), (9) ou (10), 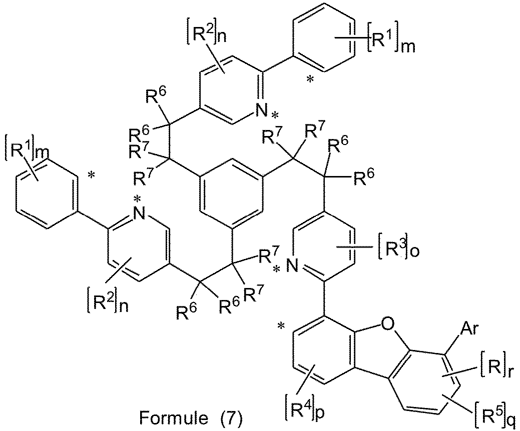 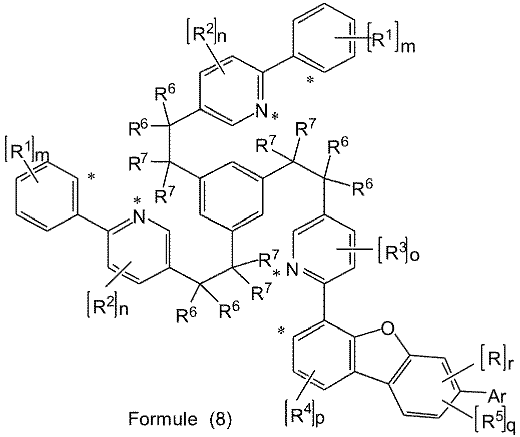 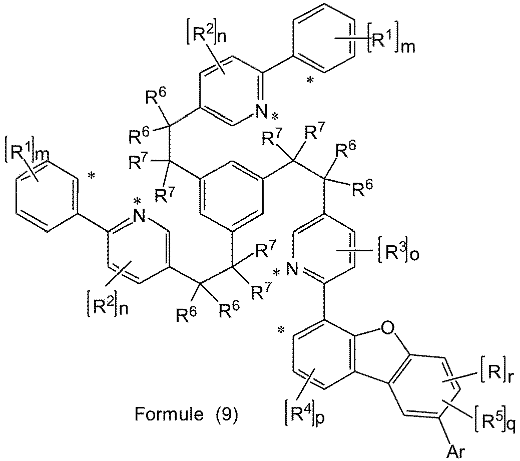 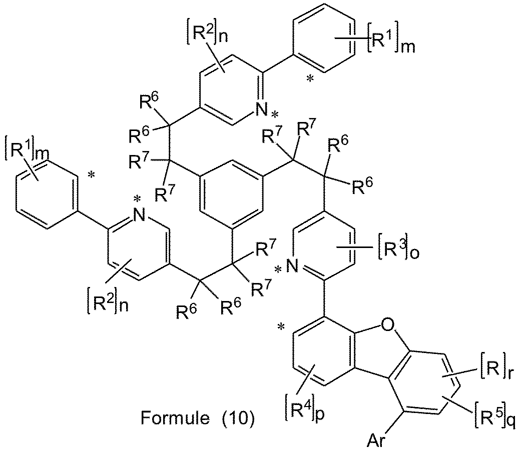 dans laquelle les symboles et indices utilisés ont la signification donnée dans la revendication 1 et les atomes d'hydrogène non explicitement représentés peuvent également être partiellement ou totalement remplacés par du deutérium.

5. Composé de l'une quelconque des revendications 1 à 4, **caractérisé en ce que** le ligand L a une structure de formule (11a), (11b) ou (11c), 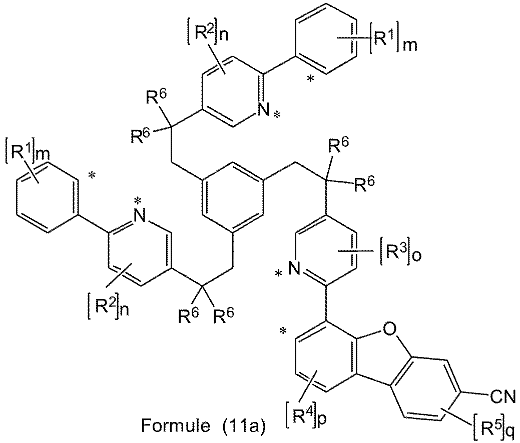 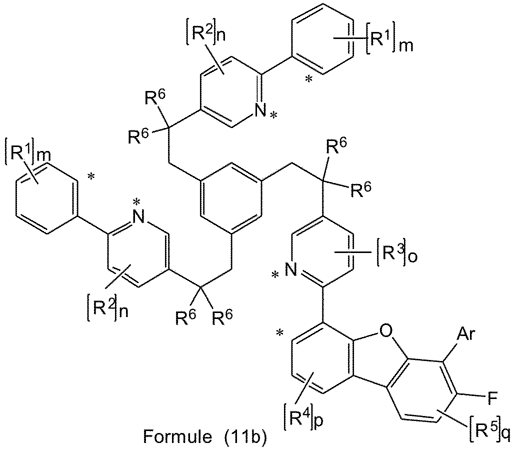 dans laquelle les symboles et indices utilisés ont la signification donnée dans la revendication 1, les atomes d'hydrogène non explicitement indiqués peuvent également être partiellement ou complètement remplacés par du deutérium, R⁶ est H, D, CH₃ ou CD₃ ; et R⁵ dans la formule (11c) est de préférence un groupe cyclopentyle ou cyclohexyle qui est optionnellement partiellement ou complètement deutéré.

6. Composé de l'une quelconque des revendications 1 à 5, **caractérisé en ce qu'**un atome de deutérium est lié dans toutes les positions ortho à R dans lequel Ar ou R⁵ n'est pas lié.

7. Composé selon l'une quelconque des revendications 1 à 6, **caractérisé en ce que** le ligand L est choisi parmi les structures des formules (11a-1), (11b-1) ou (11c-1), 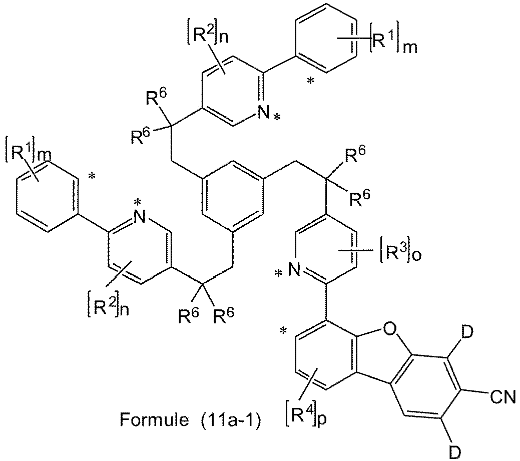 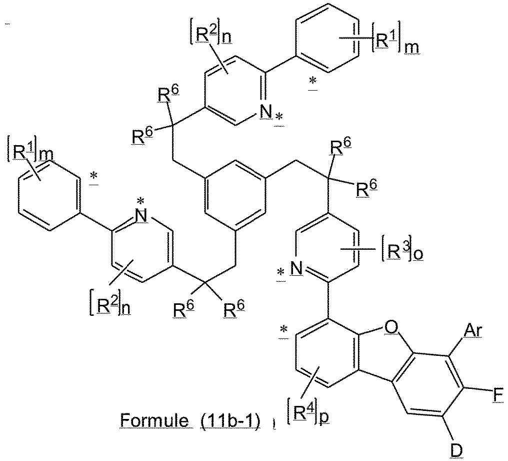 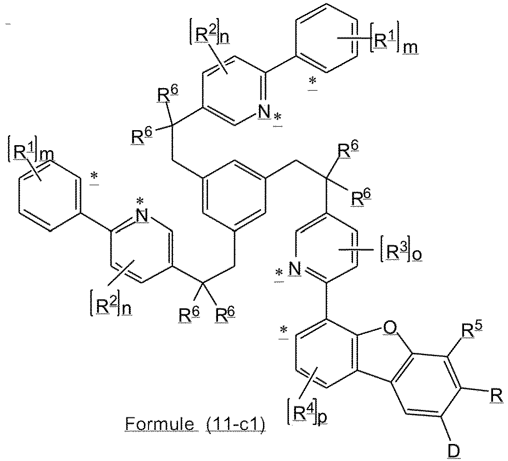 dans laquelle les symboles et indices utilisés ont la signification donnée dans la revendication 1, les atomes d'hydrogène non explicitement indiqués peuvent également être partiellement ou complètement remplacés par du deutérium, chaque occurrence de R⁶ est identique ou différente et représente H, D, CH₃ ou CD₃ ; et R⁵ dans la formule (11c-1) représente de préférence un groupe cyclopentyle ou cyclohexyle qui est optionnellement partiellement ou complètement deutéré.

8. Composé selon l'une des revendications 1 à 7, **caractérisé en ce que** Ar est un groupe phényle éventuellement partiellement ou totalement deutéré et qui est par ailleurs non substitué ou substitué par un groupe méthyle éventuellement partiellement ou totalement deutéré.

9. Composé selon l'une quelconque des revendications 1 à 8, **caractérisé en ce que** les symboles et les indices sont :
Ar est un groupe phényle éventuellement partiellement ou totalement deutéré et qui est éventuellement substitué par un groupe méthyle partiellement ou totalement deutéré ;
R¹ à chaque occurrence est identique ou différent et est choisi parmi le groupe constitué de CN, d'un groupe alkyle à chaîne linéaire ayant 1 à 4 atomes de carbone, d'un groupe alkyle ramifié ayant 3 à 5 atomes de carbone, d'un groupe alkyle cyclique ayant 5 ou 6 atomes de carbone, ou d'un groupe phényle, chacun de ces groupes étant éventuellement partiellement ou totalement deutéré ;
R², R³ à chaque occurrence est identique ou différent et est choisi dans le groupe constitué d'un groupe alkyle à chaîne linéaire ayant 1 à 4 atomes de carbone, d'un groupe alkyle ramifié ayant 3 à 5 atomes de carbone ou d'un groupe alkyle cyclique ayant 5 ou 6 atomes de carbone, chacun de ces groupes étant éventuellement partiellement ou totalement deutéré ;
R⁴ à chaque occurrence est identique ou différent et est choisi parmi le groupe constitué d'un groupe alkyle à chaîne linéaire ayant 1 à 4 atomes de carbone, d'un groupe alkyle ramifié ayant 3 à 5 atomes de carbone, d'un groupe alkyle cyclique ayant 5 ou 6 atomes de carbone, ou d'un groupe phényle, chacun de ces groupes étant éventuellement partiellement ou totalement deutéré ;
R⁵ chaque occurrence est identique ou différente et est choisie dans le groupe constitué d'un groupe alkyle à chaîne linéaire ayant 1 à 4 atomes de carbone, d'un groupe alkyle ramifié ayant 3 à 5 atomes de carbone ou d'un groupe alkyle cyclique ayant 5 ou 6 atomes de carbone, chacun de ces groupes étant éventuellement partiellement ou totalement deutéré ;
R⁶ à chaque occurrence est identique ou différente et est H, D ou CH₃ , qui est éventuellement partiellement ou totalement deutéré ;
R⁷ à chaque occurrence est identique ou différent et est H ou D ;
m à chaque occurrence de est identique ou différent et vaut 0, 1, 2 ou 3 ;
n, o à chaque occurrence de est identique ou différent et vaut 0, 1 ou 2 ;
p est 0 ou 1 ;
q est 0 ou 1 ;
s est 0 pour R = CN et est 1 pour R = F.

10. Procédé de préparation d'un composé selon l'une quelconque des revendications 1 à 9, comprenant l'étape de réaction du ligand libre avec un alcoxyde d'iridium, un cétokétonate d'iridium, un halogénure d'iridium ou un carboxylate d'iridium.

11. Formulation comprenant au moins un composé selon l'une quelconque des revendications 1 à 9 et au moins un autre composé, dans laquelle l'autre composé est choisi parmi un solvant et/ou un matériau de matrice.

12. Utilisation d'un composé selon une ou plusieurs des revendications 1 à 9 dans un dispositif électronique, ou pour générer de l'oxygène singulet, ou en photocatalyse.

13. Photocatalyseur comprenant au moins un composé selon l'une des revendications 1 à 9.

14. Dispositif électronique comprenant au moins un composé selon l'une quelconque des revendications 1 à 9.

15. Le dispositif électronique de la revendication 14, **caractérisé en ce qu'**il s'agit d'un dispositif électroluminescent organique et que le composé de l'une quelconque des revendications 1 à 9 est utilisé comme composé émetteur dans une ou plusieurs couches émettrices.
